# EUROPÄISCHE PATENTSCHRIFT

(11) **EP 3 526 228 B1**
(45) Veröffentlichungstag und Bekanntmachung des Hinweises auf die Patenterteilung: **25.11.2020**
(21) Anmeldenummer: 17794232.3
(22) Anmeldetag: 09.10.2017
(51) Int. Cl.: C07F 15/00, C09K 11/06, H01L 51/00

(54) **METALLKOMPLEXE**
METAL COMPLEXES
COMPLEXES MÉTALLIQUES

(30) Priorität: 12.10.2016 EP 16193529
(43) Veröffentlichungstag der Anmeldung: 21.08.2019
(73) Patentinhaber: Merck Patent GmbH, 64293 Darmstadt (DE)
(72) Erfinder: STOESSEL, Philipp, 60389 Frankfurt Am Main (DE); KOENEN, Nils, 64347 Griesheim (DE); EHRENREICH, Christian, 64285 Darmstadt (DE)
(86) Internationale Anmeldenummer: PCT/EP2017/075581
(87) Internationale Veröffentlichungsnummer: WO 2018/069197

(56) Entgegenhaltungen:
- WO-A1-2016/124304

## Beschreibung

Die vorliegende Erfindung betrifft binukleare Metallkomplexe, welche sich für den Einsatz als Emitter in organischen Elektrolumineszenzvorrichtungen eignen.

Gemäß dem Stand der Technik werden in phosphoreszierenden organischen Elektrolumineszenzvorrichtungen (OLEDs) als Triplettemitter vor allem bis- und tris-ortho-metallierte Iridiumkomplexe mit aromatischen Liganden eingesetzt, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)-iridium(III) und Derivate davon, wobei als Liganden beispielsweise 1- oder 3-Phenylisochinoline, 2-Phenylchinoline oder Phenylcarbene einsetzt werden. Bei diesen Materialien gibt es generell noch Verbesserungsbedarf, insbesondere im Hinblick auf Effizienz und Lebensdauer. Dies gilt insbesondere auch für die Effizienz rot phosphoreszierender Emitter. Durch das geringere Triplettniveau T₁ liegt bei üblichen rot phosphoreszierenden Emittern die Photolumineszenzquantenausbeute häufig deutlich unter dem theoretisch möglichen Wert, da bei kleinem T₁ auch nicht-radiative Kanäle eine größere Rolle spielen, insbesondere wenn der Komplex eine hohe Lumineszenzlebensdauer aufweist. Hier ist eine Verbesserung durch Erhöhung der radiativen Raten wünschenswert.

Eine Verbesserung der Stabilität der Komplexe konnte durch die Verwendung polypodaler Liganden erreicht werden, wie beispielsweise in WO 2004/081017, US 7,332,232 und WO 2016/124304 beschrieben. Auch wenn diese Komplexe Vorteile gegenüber Komplexen zeigen, die ansonsten die gleiche Ligandenstruktur aufweisen, deren einzelne Liganden jedoch nicht polypodal verbrückt sind, gibt es auch noch Verbesserungsbedarf. So sind auch bei Komplexen mit polypodalen Liganden noch Verbesserungen in Bezug auf die Eigenschaften bei Verwendung in einer organischen Elektrolumineszenzvorrichtung, insbesondere in Bezug auf Lumineszenzlebensdauer des angeregten Zustands, Effizienz, Spannung und/oder Lebensdauer, wünschenswert.

Aufgabe der vorliegenden Erfindung ist daher die Bereitstellung neuer Metallkomplexe, welche sich als Emitter für die Verwendung in OLEDs eignen. Insbesondere ist die Aufgabe, Emitter bereitzustellen, welche verbesserte Eigenschaften in Bezug auf Effizienz, Betriebsspannung und/oder Lebensdauer zeigen.

Überraschend wurde gefunden, dass die unten beschriebenen binuklearen Rhodium- und Iridiumkomplexe deutliche Verbesserungen der photophysikalischen Eigenschaften zeigen und zu verbesserten Eigenschaften bei Verwendung in einer organischen Elektrolumineszenzvorrichtung führen. Insbesondere weisen die erfindungsgemäßen Verbindungen eine verbesserte Photolumineszenzquantenausbeute auf. Diese Komplexe und organische Elektrolumineszenzvorrichtungen, welche diese Komplexe enthalten, sind der Gegenstand der vorliegenden Erfindung.

Gegenstand der Erfindung ist somit eine Verbindung gemäß der folgenden Formel (1), 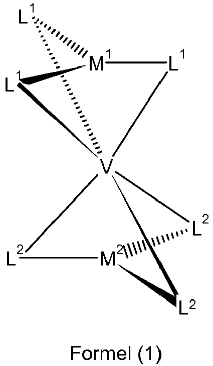 wobei für die verwendeten Symbole gilt:
- M¹, M²: ist gleich oder verschieden Iridium oder Rhodium;
- V: ist eine Gruppe der folgenden Formel (2) oder (3), 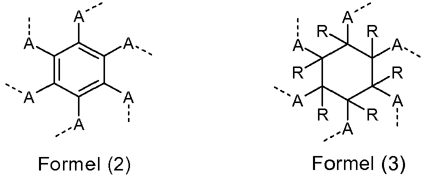
wobei die gestrichelten Bindungen in 1-, 3- und 5-Position die Bindungen zu L¹ darstellen und die gestrichelten Bindungen in 2-, 4- und 6-Position die Bindungen zu L² darstellen;
- L¹, L²: ist bei jedem Auftreten gleich oder verschieden ein bidentater, monoanionischer Teilligand;
- A: ist bei jedem Auftreten gleich oder verschieden -CR=CR-, -C(=O)-NR'-, -C(=O)-O-, -CR₂-CR₂-, -CR₂-O- oder eine Gruppe der folgenden Formel (4), 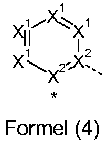
wobei die gestrichelte Bindung die Position der Bindung eines bidentaten Teilliganden L¹ bzw. L² an diese Struktur darstellt und * die Position der Verknüpfung der Einheit der Formel (4) mit der Benzol- bzw. Cyclohexangruppe in Formel (2) bzw. (3) darstellt;
- X¹: ist bei jedem Auftreten gleich oder verschieden CR oder N oder zwei benachbarte Gruppen X¹ stehen zusammen für NR, O oder S, so dass ein Fünfring entsteht, und die verbleibenden X¹ stehen gleich oder verschieden bei jedem Auftreten für CR oder N; oder zwei benachbarte Gruppen X¹ stehen zusammen für CR oder N, wenn in dem Cyclus eine der Gruppen X² für N steht, so dass ein Fünfring entsteht; mit der Maßgabe, dass maximal zwei benachbarte Gruppen X¹ für N stehen;
- X²: ist bei jedem Auftreten C oder eine Gruppe X² steht für N und die andere Gruppe X² in demselben Cyclus steht für C; mit der Maßgabe, dass zwei benachbarte Gruppen X¹ zusammen für CR oder N stehen, wenn in dem Cyclus eine der Gruppen X² für N steht;
- R: ist bei jedem Auftreten gleich oder verschieden H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)², S(=O)R¹, S(=O)²R¹, OSO₂R¹, COO(Kation), SO₃(Kation), OSO₃(Kation), OPO₃(Kation)₂, O(Kation), N(R¹)₃(Anion), P(R¹)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
- R': ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann;
- R¹: ist bei jedem Auftreten gleich oder verschieden H, D, F, Cl, Br, I, N(R²)₂, CN, NO₂, OR², SR₂, Si(R²)³, B(OR²)₂, C(=O)R², P(=O)(R²)₂, S(=O)R², S(=O)₂R², OSO₂R², COO(Kation), SO₃(Kation), OSO₃(Kation), OPO₃(Kation)₂, O(Kation), N(R²)₃(Anion), P(R²)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
- R²: ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können;
- Kation: ist bei jedem Auftreten gleich oder verschieden ausgewählt aus der Gruppe bestehend aus Proton, Deuteron, Alkaliionen, Erdalkaliionen, Ammonium, Tetraalkylammonium und Tetraalkylphosphonium;
- Anion: ist bei jedem Auftreten gleich oder verschieden ausgewählt aus der Gruppe bestehend aus Halogeniden, Carboxylaten R²-COO⁻, Cyanid, Cyanat, Isocyanat, Thiocyanat, Thioisocyanat, Hydroxid, BF₄⁻, PF₆⁻, B(C₆F₅)₄⁻, Carbonat und Sulfonaten.

Wenn zwei Reste R bzw. R¹ miteinander ein Ringsystem bilden, so kann dieses mono- oder polycyclisch, aliphatisch, heteroaliphatisch, aromatisch oder heteroaromatisch sein. Dabei können die Reste, die miteinander ein Ringsystem bilden, benachbart sein, d. h. dass diese Reste an dasselbe Kohlenstoffatom oder an Kohlenstoffatome, die direkt aneinander gebunden sind, gebunden sind, oder sie können weiter voneinander entfernt sein. Bevorzugt ist eine solche Ringbildung bei Resten, die an direkt aneinander gebundene Kohlenstoffatome oder an dasselbe Kohlenstoffatom gebunden sind.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

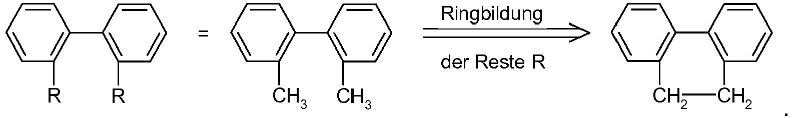

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

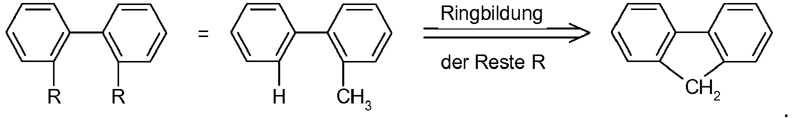

Die Bildung eines aromatischen Ringsystems soll durch das folgende Schema verdeutlicht werden:

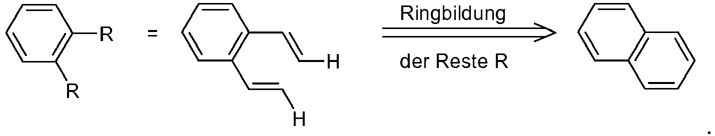

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden.

Unter einer cyclischen Alkylgruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1 -Dimethyl-n-oct-1-yl-, 1,1-Dimethyl-n-dec-1-yl-, 1,1-Dimethyl-n-dodec-1-yl-, 1,1 -Dimethyl-n-tetradec-1 -yl-, 1,1 -Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1 -Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer C₁- bis C₂₀-Alkoxygruppe, wie sie für OR¹ bzw. OR² vorliegt, werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Zur weiteren Veranschaulichung der Verbindung wird im Folgenden eine Struktur gemäß Formel (1) vollständig dargestellt und erläutert, wobei hier für V eine Gruppe der Formel (2) gewählt wurde. Die sechs Gruppen A, welche an die Benzolgruppe in Formel (2) gebunden sind, sind nicht koplanar mit der Benzolgruppe, sondern sind gegenüber der Benzolgruppe aus der Ebene herausgedreht, so dass die Teilliganden L¹ oberhalb der der Benzolgruppe und die Teilliganden L² unterhalb der Benzolgruppe zeigen, wie im Folgenden schematisch dargestellt für einen Liganden, in dem die Gruppen A jeweils für Phenylengruppen stehen:

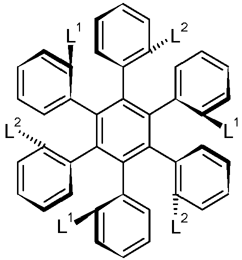

Dadurch sind die drei Teilliganden L¹ so angeordnet, dass sie an ein erstes Metall M¹ oberhalb der Ebene des zentralen Benzolrings koordinieren können, und die drei Teilliganden L² sind so angeordnet, dass sie an ein zweites Metall M² unterhalb der Ebene des zentralen Benzolrings koordinieren können. Dies ist nachfolgend für A = CH=CH schematisch dargestellt:

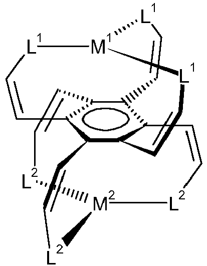

Nachfolgend ist die Struktur eines erfindungsgemäßen Metallkomplexes vollständig abgebildet:

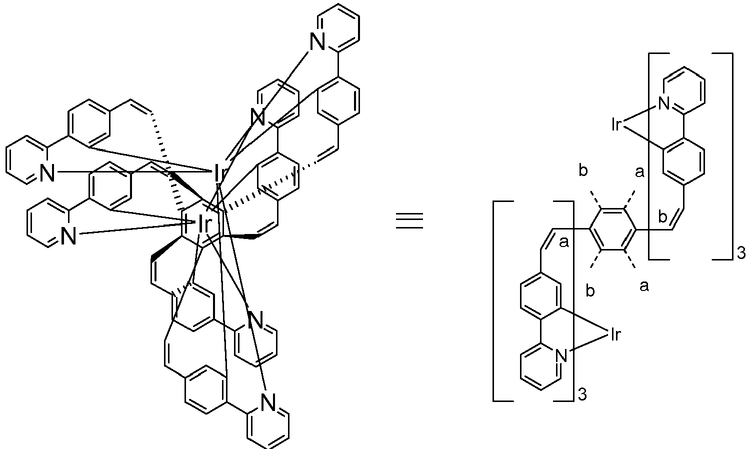

In dieser Struktur steht V für eine Gruppe der Formel (2). A steht jeweils für eine Gruppe CH=CH. Dabei zeigen die Gruppen CH=CH in der 1-, 3- und 5-Position (im Schema oben rechts mit "a" bezeichnet) unterhalb der Ebene des Benzolrings, und die Gruppen CH=CH in der 2-, 4- und 6-Position (im Schema oben rechts mit "b" bezeichnet) zeigen oberhalb der Ebene des Benzolrings. An jede der Alkenylgruppen ist jeweils ein Teilligand L¹ bzw. L² gebunden, wobei die Teilliganden L¹ in 1,3,5-Position und die Teilliganden L² in 2,4,6-Position über die CH=CH-Gruppe an das zentrale Benzol gebunden sind. Dabei stehen alle Teilliganden L¹ und L² im oben abgebildeten Schema für Phenylpyridin. Die drei Teilliganden L¹ sind an ein erstes Iridiumatom koordiniert, und die drei Teilliganden L² sind an ein zweites Iridiumatom koordiniert. Jedes der beiden Iridiumatome ist somit an jeweils drei Phenylpyridin-Teilliganden koordiniert. Dabei sind die Teilliganden über die zentrale hexasubstituierte Benzoleinheit zu einem polypodalen System verknüpft.

Wenn V für eine Gruppe der Formel (3) steht, so handelt es sich bei dem zentralen Cyclus um eine Cyclohexangruppe. Diese liegt in einer Sesselform vor. In diesem Fall sind die Gruppen A jeweils äquatorial gebunden, so dass es sich um ein trans,cis,trans,cis,trans-substituiertes Cyclohexan handelt, wie nachfolgend schematisch dargestellt:

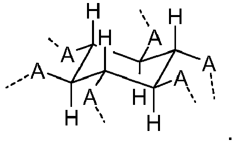

Dabei stellt die gestrichelte Bindung jeweils die Bindung an L¹ bzw. L² dar.

Der Begriff "bidentater Teilligand" für L¹ und L² bedeutet im Sinne dieser Anmeldung, dass es sich bei dieser Einheit um einen bidentaten Liganden handeln würde, wenn die Gruppe der Formel (2) bzw. (3) nicht vorhanden wäre. Durch die formale Abstraktion eines Wasserstoffatoms an diesem bidentaten Liganden und die Verknüpfung an die Brücke der Formel (2) bzw. (3) ist dieser jedoch kein separater Ligand, sondern ein Teil des so entstehenden dodekadentaten Liganden, also eines Liganden mit insgesamt 12 Koordinationsstellen, so dass daher für L¹ und L² der Begriff "Teilligand" verwendet wird.

Die Bindung des Liganden an M¹ bzw. M² kann sowohl eine Koordinationsbindung als auch eine kovalente Bindung sein bzw. der kovalente Anteil an der Bindung kann je nach Ligand variieren. Wenn in der vorliegenden Anmeldung die Rede davon ist, dass der Ligand bzw. der Teilligand an M¹ bzw. M² koordiniert oder bindet, so bezeichnet dies im Sinne der vorliegenden Anmeldung jede Art der Bindung des Liganden bzw. Teilliganden an M¹ bzw. M², unabhängig vom kovalenten Anteil der Bindung.

Die erfindungsgemäßen Verbindungen sind bevorzugt nicht geladen, d. h. sie sind elektrisch neutral. Dies wird dadurch erreicht, dass Rh bzw. Ir jeweils in der Oxidationsstufe +III vorliegen. Jedes der Metalle M¹ und M² ist dann von drei monoanionischen bidentaten Teilliganden koordiniert, so dass die Teilliganden die Ladung des komplexierten Metallatoms kompensieren.

Wie oben beschrieben, können die beiden Metalle M¹ und M² in der erfindungsgemäßen Verbindung gleich oder verschieden sein und liegen bevorzugt in der Oxidationsstufe +III vor. Es kommen daher die Kombinationen Ir / Ir, Ir / Rh und Rh / Rh in Frage. In einer bevorzugten Ausführungsform der Erfindung stehen beide Metalle M¹ und M² für Ir(III).

Nachfolgend werden bevorzugte Ausführungsformen für V, also die Gruppe der Formel (2) bzw. (3) ausgeführt.

Für bevorzugte Reste R in Formel (2) bzw. Formel (3) gilt:
- R: ist bei jedem Auftreten gleich oder verschieden H, D, F, CN, OR¹, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R¹ substituiert sein kann, oder ein aromatisches oder heteroaromatisches Ringsystem mit 5 bis 24 aromatischen Ringatomen, das jeweils durch einen oder mehrere Reste R¹ substituiert sein kann;
- R¹: ist bei jedem Auftreten gleich oder verschieden H, D, F, CN, OR², eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, die jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch F ersetzt sein können.

Für besonders bevorzugte Reste R in Formel (2) bzw. Formel (3) gilt:
- R: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R¹ substituiert sein kann, oder ein aromatisches oder heteroaromatisches Ringsystem mit 6 bis 12 aromatischen Ringatomen, das jeweils durch einen oder mehrere Reste R¹ substituiert sein kann;
- R¹: ist bei jedem Auftreten gleich oder verschieden H, D, F, CN, eine geradkettige Alkylgruppe mit 1 bis 4 C-Atomen oder eine verzweigte oder cyclische Alkylgruppe mit 3 bis 6 C-Atomen, die jeweils mit einem oder mehreren Resten R² substituiert sein kann, oder ein aromatisches oder heteroaromatisches Ringsystem mit 6 bis 12 aromatischen Ringatomen, das jeweils durch einen oder mehrere Reste R² substituiert sein kann; dabei können zwei oder mehrere benachbarte Reste R¹ miteinander ein Ringsystem bilden;
- R²: ist bei jedem Auftreten gleich oder verschieden H, D, F oder ein aliphatischer oder aromatischer Kohlenwasserstoffrest mit 1 bis 12 C-Atomen.

Ganz besonders bevorzugt stehen alle Reste R in Formel (2) und in Formel (3) für H.

Im Folgenden werden bevorzugte Gruppen A beschrieben, wie sie in den Strukturen der Formeln (2) und (3) vorkommen. Die Gruppe A kann gleich oder verschieden bei jedem Auftreten eine Alkenylgruppe, eine Amidgruppe, eine Estergruppe, eine Alkylengruppe, eine Methylenethergruppe oder eine ortho-verknüpfte Arylen- bzw. Heteroarylengruppe der Formel (4) darstellen. Wenn A für eine Alkenylgruppe steht, dann handelt es sich um eine cis-verknüpfte Alkenylgruppe. Bei unsymmetrischen Gruppen A ist jede Orientierung der Gruppen möglich. Wenn also A beispielsweise für eine Estergruppe -C(=O)-O- steht, kann gleich oder verschieden bei jedem Auftreten das Kohlenstoffatom der Estergruppe an den zentralen Benzol- bzw. Cyclohexanring in Formel (2) bzw. (3) und das Sauerstoffatom an den Teilliganden L¹ bzw. L² gebunden sein, oder das Sauerstoffatom der Estergruppe kann an den zentralen Benzol- bzw. Cyclohexanring in Formel (2) bzw. (3) und das Kohlenstoffatom an den Teilliganden L¹ bzw. L² gebunden sein.

In einer bevorzugten Ausführungsform der Erfindung ist A gleich oder verschieden, bevorzugt gleich, bei jedem Auftreten ausgewählt aus der Gruppe bestehend aus -C(=O)-O-, -C(=O)-NR'- oder einer Gruppe der Formel (4).

In einer weiteren bevorzugten Ausführungsform sind alle A gleich gewählt, wobei sie dann auch bevorzugt gleich substituiert sind. Diese Bevorzugung ist begründet durch die bessere synthetische Zugänglichkeit der Verbindungen.

Besonders bevorzugt stehen alle Gruppen A für -C(=O)-O-, oder alle Gruppen A stehen für -C(=O)-NR'- oder alle Gruppen A stehen für eine Gruppe der Formel (4), wobei die Gruppen der Formel (4) jeweils identisch gewählt sind. Ganz besonders bevorzugt stehen alle Gruppen A für identische Gruppen der Formel (4), wobei es sich hierbei bevorzugt um gegebenenfalls substituierte Phenylengruppen handelt.

Wenn A für -C(=O)-NR'- steht, dann steht R' bevorzugt gleich oder verschieden bei jedem Auftreten für eine geradkettige Alkylgruppe mit 1 bis 10 C-Atomen oder eine verzweigte oder cyclische Alkylgruppe mit 3 bis 10 C-Atomen oder ein aromatisches oder heteroaromatisches Ringsystem mit 6 bis 24 aromatischen Ringatomen, das jeweils durch einen oder mehrere Reste R¹ substituiert sein kann. Besonders bevorzugt steht R' gleich oder verschieden bei jedem Auftreten für eine geradkettige Alkylgruppe mit 1 bis 5 C-Atomen oder eine verzweigte oder cyclische Alkylgruppe mit 3 bis 6 C-Atomen oder ein aromatisches oder heteroaromatisches Ringsystem mit 6 bis 12 aromatischen Ringatomen, das jeweils durch einen oder mehrere Reste R¹ substituiert sein kann, bevorzugt aber unsubstituiert ist.

Im Folgenden werden bevorzugte Ausführungsformen der Gruppe der Formel (4) beschrieben. Die Gruppe der Formel (4) kann einen heteroaromatischen Fünfring oder einen aromatischen oder heteroaromatischen Sechsring darstellen. In einer bevorzugten Ausführungsform der Erfindung enthält die Gruppe der Formel (4) maximal zwei Heteroatome in der aromatischen bzw. heteroaromatischen Einheit, besonders bevorzugt maximal ein Heteroatom. Dies schließt nicht aus, dass Substituenten, die gegebenenfalls an dieser Gruppe gebunden sind, auch Heteroatome enthalten können. Weiterhin schließt diese Definition nicht aus, dass durch die Ringbildung von Substituenten kondensierte aromatische oder heteroaromatische Strukturen entstehen, wie beispielsweise Naphthalin, Benzimidazol, etc..

Wenn alle Gruppen X² in Formel (4) für Kohlenstoffatome stehen, sind bevorzugte Ausführungsformen der Gruppe der Formel (4) die Strukturen der folgenden Formeln (5) bis (21), und wenn eine Gruppe X² für ein Stickstoffatom und die anderen Gruppen X² in demselben Cyclus für ein Kohlenstoffatom steht, sind bevorzugte Ausführungsformen der Gruppe der Formel (4) die Strukturen der folgenden Formeln (22) bis (29), 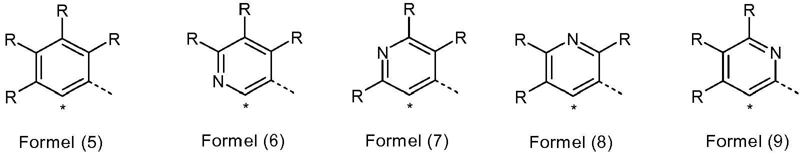 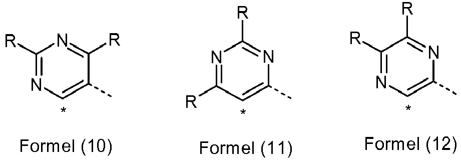 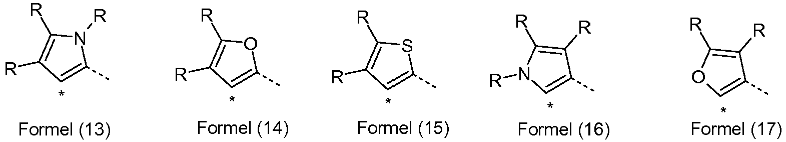 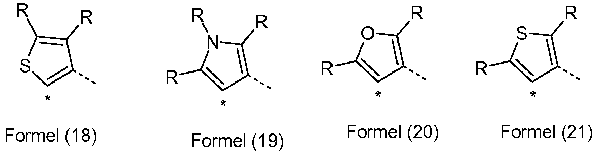 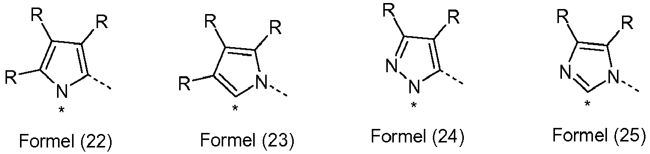 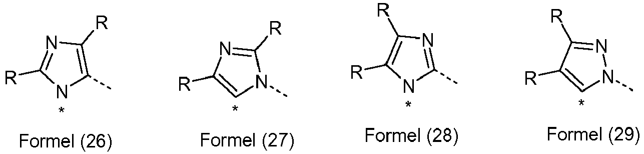 wobei die Symbole die oben genannten Bedeutungen aufweisen.

Besonders bevorzugt sind die Sechsring-Aromaten und -Heteroaromaten der oben abgebildeten Formeln (5) bis (9). Ganz besonders bevorzugt ist ortho-Phenylen, also eine Gruppe der oben genannten Formel (5).

Dabei können auch benachbarte Substituenten R miteinander ein Ringsystem bilden, so dass kondensierte Strukturen, auch kondensierte Aryl- und Heteroarylgruppen, wie beispielsweise Naphthalin, Chinolin, Benzimidazol, Carbazol, Dibenzofuran oder Dibenzothiophen, entstehen können. Eine solche Ringbildung ist im Folgenden schematisch an Gruppen der oben genannten Formel (5) aufgeführt, was beispielsweise zu Gruppen der folgenden Formeln (5a) bis (5j) führen kann: 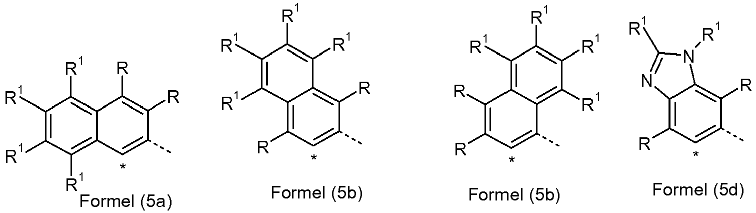 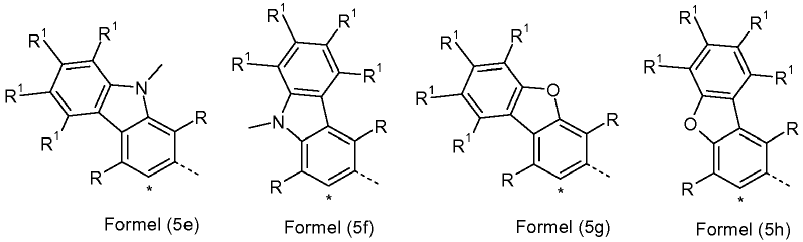 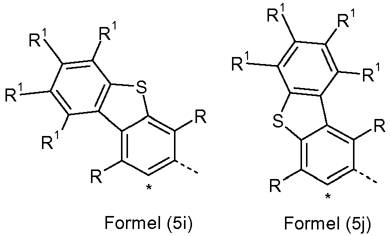 wobei die Symbole die oben genannten Bedeutungen aufweisen.

Generell können die ankondensierten Gruppen an jeder Position der Einheit gemäß Formel (4) ankondensiert sein, wie durch die ankondensierte Benzogruppe in den Formeln (5a) bis (5c) dargestellt. Die Gruppen, wie sie in den Formeln (5d) bis (5j) an die Einheit der Formel (4) ankondensiert sind, können daher auch an anderen Positionen der Einheit der Formel (4) ankondensiert werden.

Die Gruppe der Formel (2) kann besonders bevorzugt durch die folgenden Formeln (2a) bis (2e) dargestellt werden, und die Gruppe der Formel (3) kann besonders bevorzugt durch die folgenden Formeln (3a) bis (3e) dargestellt werden: 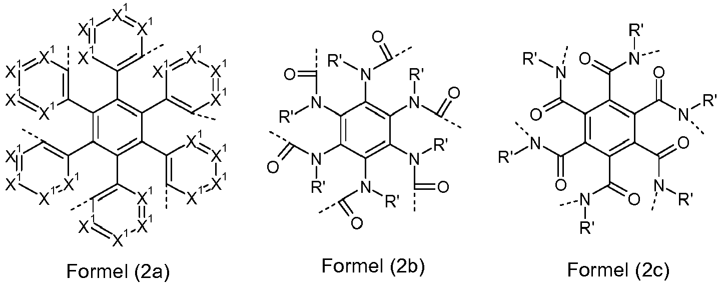 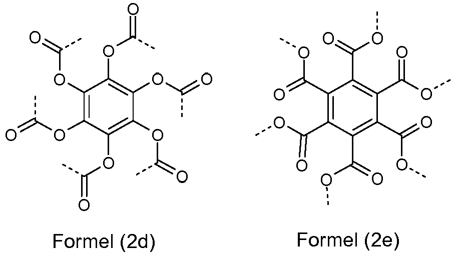 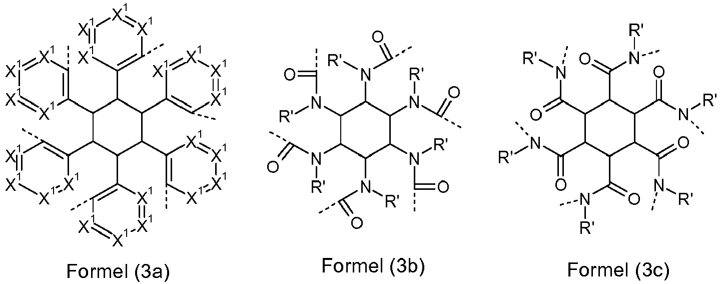 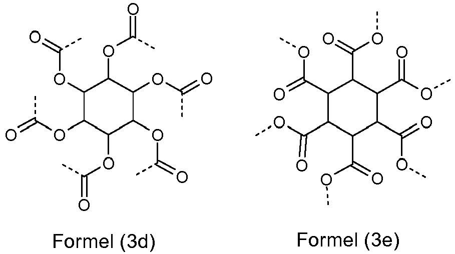 wobei die Symbole die oben genannten Bedeutungen aufweisen. Bevorzugt steht X¹ gleich oder verschieden bei jedem Auftreten für CR. Dabei ist es aus synthetischen Gründen bevorzugt, wenn in Formel (2a) und (3a) die jeweils in 1,3,5-Position gebundenen Gruppen identisch sind und die jeweils in 2,4,6-Position gebundenen Gruppen identisch sind.

Eine bevorzugte Ausführungsform der Gruppen der Formel (2a) und (3a) sind ist die Gruppen der folgenden Formeln (2a') und (3a'), 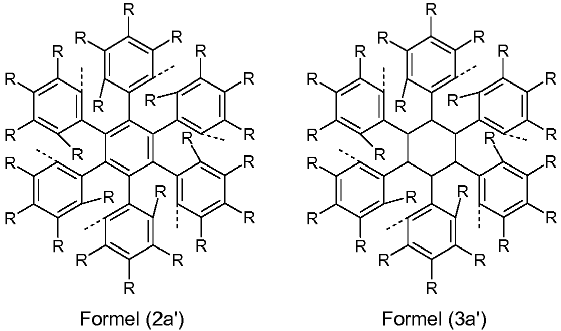 wobei die Symbole die oben genannten Bedeutungen aufweisen.

Besonders bevorzugt sind die Gruppen R in den oben genannten Formeln gleich oder verschieden H, D oder eine Alkylgruppe mit 1 bis 4 C-Atomen. Ganz besonders bevorzugt ist R = H. Ganz besonders bevorzugt sind also die Strukturen der folgenden Formeln (2a") und (3a"), insbesondere die Struktur der Formel (2a"), 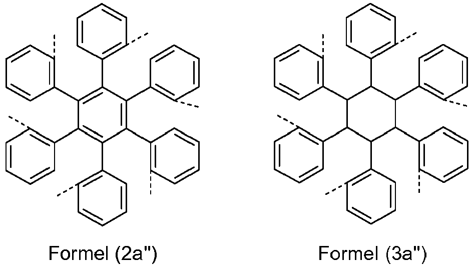 wobei die Symbole die oben genannten Bedeutungen aufweisen.

Im Folgenden werden die bidentaten, monoanionischen Teilliganden L¹ und L² beschrieben. Die Teilliganden L¹ und L² können unabhängig voneinander gleich oder verschieden sein. Dabei ist es bevorzugt, wenn zwei Teilliganden L¹ gleich sind und der dritte Teilligand L¹ gleich oder verschieden ist, wobei "gleich" bedeutet, dass diese auch gleich substituiert sind. Weiterhin ist es bevorzugt, wenn zwei Teilliganden L² gleich sind und der dritte Teilligand L² gleich oder verschieden ist, wobei "gleich" bedeutet, dass diese auch gleich substituiert sind. In einer besonders bevorzugten Ausführungsform der Erfindung sind alle drei Teilliganden L¹ gleich, und alle drei Teilliganden L² sind gleich. Dabei kann es gleichmaßen bevorzugt sein, dass L¹ = L² ist oder dass L¹ ≠ L² ist.

In einer weiteren bevorzugten Ausführungsform der Erfindung sind die koordinierenden Atome der bidentaten Teilliganden L¹ und L² gleich oder verschieden bei jedem Auftreten ausgewählt aus C, N, P, O, S und/oder B, besonders bevorzugt C, N und/oder O und ganz besonders bevorzugt C und/oder N. Dabei weisen die bidentaten Teilliganden L¹ und L² bevorzugt ein Kohlenstoffatom und ein Stickstoffatom oder zwei Kohlenstoffatome oder zwei Stickstoffatome oder zwei Sauerstoffatome oder ein Sauerstoffatom und ein Stickstoffatom als koordinierende Atome auf. Dabei können die koordinierenden Atome von jedem der Teilliganden L¹ bzw. L² gleich sein, oder sie können unterschiedlich sein. Bevorzugt weisen mindestens zwei der bidentaten Teilliganden L¹ und mindestens zwei der bidentaten Teilliganden L² ein Kohlenstoffatom und ein Stickstoffatom oder zwei Kohlenstoffatome als koordinierende Atome auf, insbesondere ein Kohlenstoffatom und ein Stickstoffatom. Besonders bevorzugt weisen mindestens alle bidentaten Teilliganden L¹ und L² ein Kohlenstoffatom und ein Stickstoffatom oder zwei Kohlenstoffatome als koordinierende Atome auf, insbesondere ein Kohlenstoffatom und ein Stickstoffatom. Besonders bevorzugt handelt es sich somit um einen Metallkomplex, in dem alle Teilliganden ortho-metalliert sind, d. h. mit dem Metall einen Metallacyclus bilden, in dem mindestens zwei Metall-Kohlenstoff-Bindungen vorliegen.

Es ist weiterhin bevorzugt, wenn es sich bei dem Metallacyclus, der aus dem Metall und dem bidentaten Teilliganden L¹ bzw. L² aufgespannt wird, um einen Fünfring handelt, der vor allem dann bevorzugt ist, wenn die koordinierenden Atome C und N, N und N oder N und O sind. Wenn es sich bei den koordinierenden Atomen um O handelt, kann auch ein Metallasechsring bevorzugt sein. Dies wird im Folgenden schematisch dargestellt: 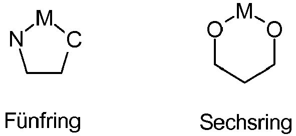 wobei N ein koordinierendes Stickstoffatom, C ein koordinierendes Kohlenstoffatom und O koordinierende Sauerstoffatome darstellen, die eingezeichneten Kohlenstoffatome Atome des bidentaten Teilliganden L darstellen und M für das Metall M¹ bzw. M² steht.

In einer bevorzugten Ausführungsform der Erfindung ist mindestens einer der Teilliganden L¹ und mindestens einer der Teilliganden L², bevorzugt mindestens zwei der Teilliganden L¹ und mindestens zwei der Teilliganden L² und besonders bevorzugt alle bidentaten Teilliganden L¹ und L² gleich oder verschieden bei jedem Auftreten ausgewählt aus den Strukturen der folgenden Formeln (L-1), (L-2) oder (L-3), 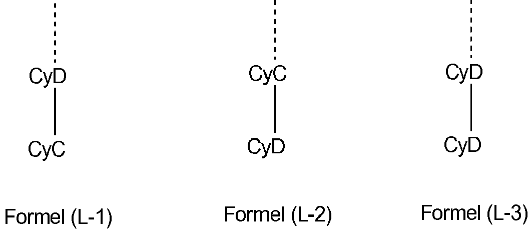 wobei die gestrichelte Bindung die Bindung des Teilliganden L¹ bzw. L² an V, also an die Gruppe der Formel (2) bzw. (3) bzw. der bevorzugten Ausführungsformen darstellt und für die weiteren verwendeten Symbole gilt:
- CyC: ist gleich oder verschieden bei jedem Auftreten eine substituierte oder unsubstituierte Aryl- oder Heteroarylgruppe mit 5 bis 14 aromatischen Ringatomen, welche über ein Kohlenstoffatom an M koordiniert und welche über eine kovalente Bindung mit CyD verbunden ist;
- CyD: ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an M koordiniert und welche über eine kovalente Bindung mit CyC verbunden ist;
dabei können mehrere der optionalen Substituenten miteinander ein Ringsystem bilden. Die optionalen Reste sind bevorzugt ausgewählt aus den oben genannten Resten R.

Dabei koordiniert CyD in den Teilliganden der Formeln (L-1) und (L-2) bevorzugt über ein neutrales Stickstoffatom oder über ein Carben-Kohlenstoffatom, insbesondere über ein neutrales Stickstoffatom. Weiterhin bevorzugt koordiniert eine der beiden Gruppen CyD in dem Liganden der Formel (L-3) über ein neutrales Stickstoffatom und und die andere der beiden Gruppen CyD über ein anionisches Stickstoffatom. Weiterhin bevorzugt koordiniert CyC in den Teilliganden der Formeln (L-1) und (L-2) über anionische Kohlenstoffatome.

Wenn mehrere der Substituenten, insbesondere mehrere Reste R, miteinander ein Ringsystem bilden, so ist die Bildung eines Ringsystems aus Substituenten, die an direkt benachbarten Kohlenstoffatomen gebunden sind, möglich. Weiterhin ist es auch möglich, dass die Substituenten an CyC und CyD in den Formeln (L-1) und (L-2) bzw. die Substituenten an den beiden Gruppen CyD in Formel (L-3) miteinander einen Ring bilden, wodurch CyC und CyD bzw. die beiden Gruppen CyD auch zusammen eine einzige kondensierte Aryl- bzw. Heteroarylgruppe als bidentaten Liganden bilden können.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, insbesondere eine Phenylgruppe, welche über ein Kohlenstoffatom an das Metall koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-20), 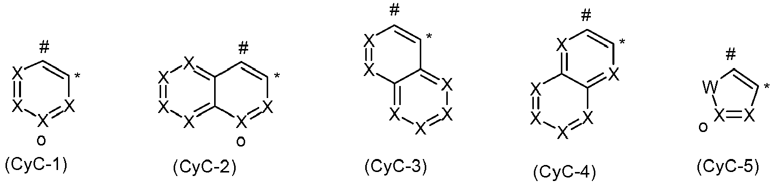 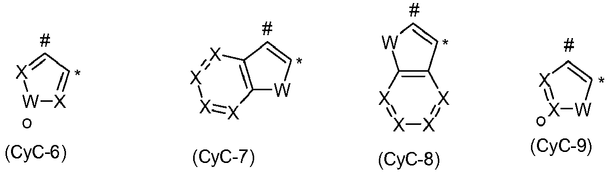 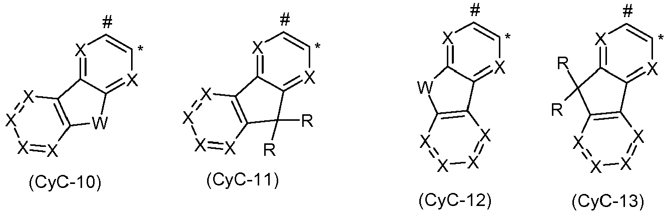 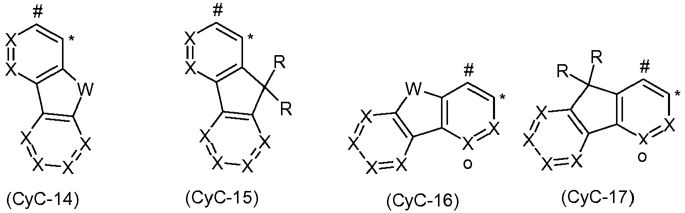 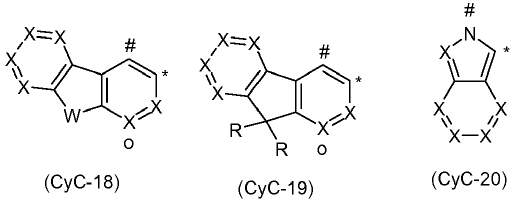 wobei CyC jeweils an der durch # gekennzeichneten Position an CyD bindet und an der durch * gekennzeichneten Position an das Metall koordiniert, R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist NR, O oder S;
mit der Maßgabe, dass, wenn der Teilligand L über CyC innerhalb der Gruppe der Formel (2) bzw. (3) gebunden ist, ein Symbol X für C steht und die Brücke der Formeln (2) bzw. (3) bzw. die bevorzugten Ausführungsformen an dieses Kohlenstoffatom gebunden ist. Wenn der Teilligand L über die Gruppe CyC an die Gruppe der Formel (2) bzw. (3) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht an die Gruppe der Formel (2) bzw. (3) gebunden, da eine solche Bindung an die Brücke aus sterischen Gründen nicht vorteilhaft ist.

Bevorzugt stehen insgesamt maximal zwei Symbole X in CyC für N, besonders bevorzugt steht maximal ein Symbol X in CyC für N, ganz besonders bevorzugt stehen alle Symbole X für CR, mit der Maßgabe, dass, wenn CyC direkt innerhalb der Gruppe der Formel (2) bzw. (3) gebunden ist, ein Symbol X für C steht und die Brücke der Formel (2) bzw. (3) bzw. die bevorzugten Ausführungsformen an dieses Kohlenstoffatom gebunden ist.

Besonders bevorzugte Gruppen CyC sind die Gruppen der folgenden Formeln (CyC-1a) bis (CyC-20a), 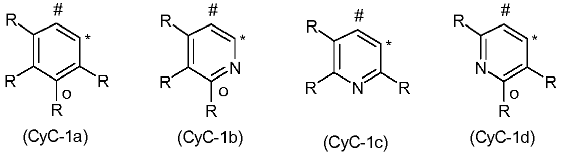 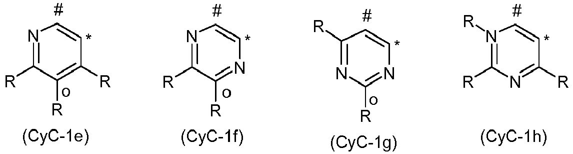 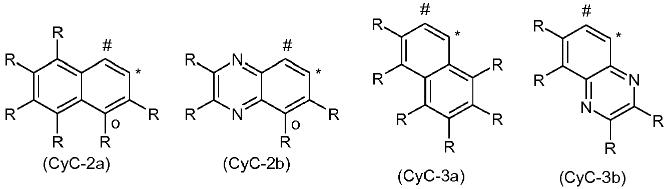 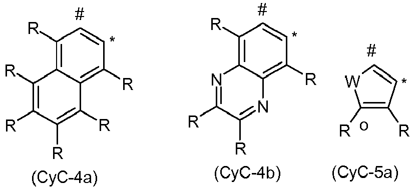 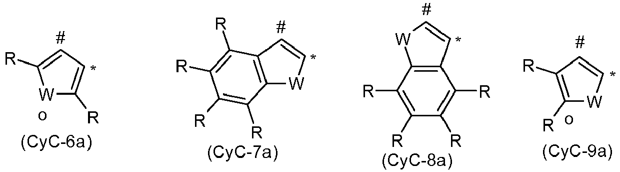 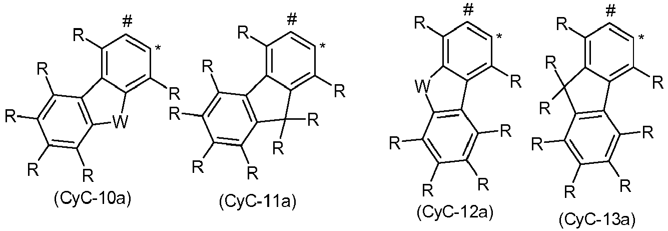 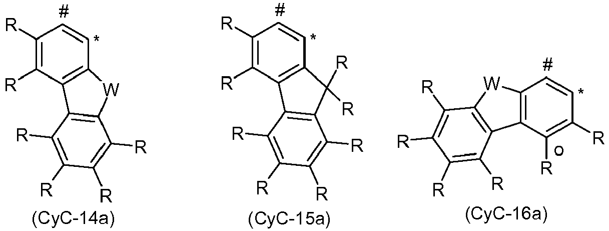 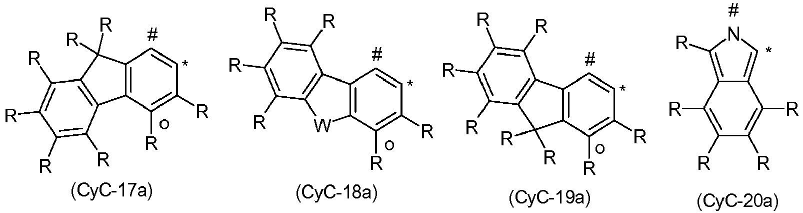 wobei die Symbole die oben genannten Bedeutungen aufweisen und, wenn CyC direkt innerhalb der Gruppe der Formel (2) bzw. (3) gebunden ist, ein Rest R nicht vorhanden ist und die Gruppe der Formel (2) bzw. (3) bzw. die bevorzugten Ausführungsformen an das entsprechende Kohlenstoffatom gebunden ist. Wenn die Gruppe CyC direkt an die Gruppe der Formel (2) bzw. (3) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Gruppe der Formel (2) bzw. (3) gebunden.

Bevorzugte Gruppen unter den Gruppen (CyC-1) bis (CyC-20) sind die Gruppen (CyC-1), (CyC-3), (CyC-8), (CyC-10), (CyC-12), (CyC-13) und (CyC-16), und besonders bevorzugt sind die Gruppen (CyC-1a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-14), 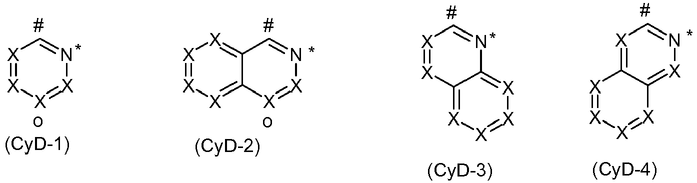 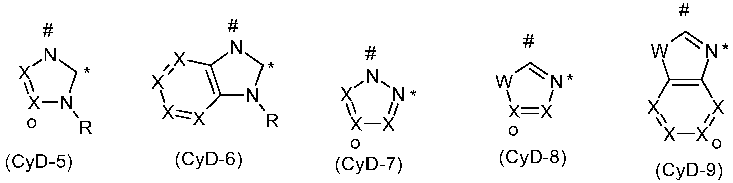 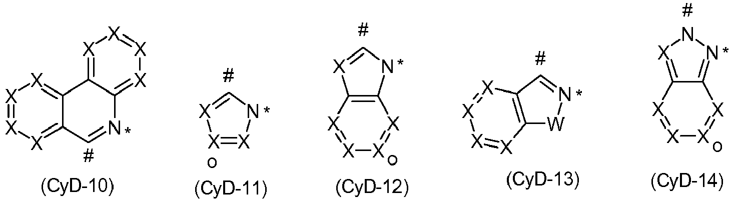 wobei die Gruppe CyD jeweils an der durch # gekennzeichneten Position an CyC bindet und an der durch * gekennzeichneten Position an das Metall koordiniert und wobei X, W und R die oben genannten Bedeutungen aufweisen, mit der Maßgabe, dass, wenn CyD direkt innerhalb der Gruppe der Formel (2) bzw. (3) gebunden ist, ein Symbol X für C steht und die Brücke der Formeln (2) bzw. (3) bzw. die bevorzugten Ausführungsformen an dieses Kohlenstoffatom gebunden ist. Wenn die Gruppe CyD direkt an die Gruppe der Formel (2) bzw. (3) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Gruppe der Formel (2) bzw. (3) gebunden, da eine solche Bindung an die Brücke aus sterischen Gründen nicht vorteilhaft ist.

Dabei koordinieren die Gruppen (CyD-1) bis (CyD-4), (CyD-7) bis (CyD-10), (CyD-13) und (CyD-14) über ein neutrales Stickstoffatom, (CyD-5) und (CyD-6) über ein Carben-Kohlenstoffatom und (CyD-11) und (CyD-12) über ein anionisches Stickstoffatom an das Metall.

Bevorzugt stehen insgesamt maximal zwei Symbole X in CyD für N, besonders bevorzugt steht maximal ein Symbol X in CyD für N, insbesondere bevorzugt stehen alle Symbole X für CR, mit der Maßgabe, dass, wenn CyD direkt innerhalb der Gruppe der Formel (2) bzw. (3) gebunden ist, ein Symbol X für C steht und die Brücke der Formeln (2) bzw. (3) bzw. die bevorzugten Ausführungsformen an dieses Kohlenstoffatom gebunden ist.

Besonders bevorzugte Gruppen CyD sind die Gruppen der folgenden Formeln (CyD-1 a) bis (CyD-14b), 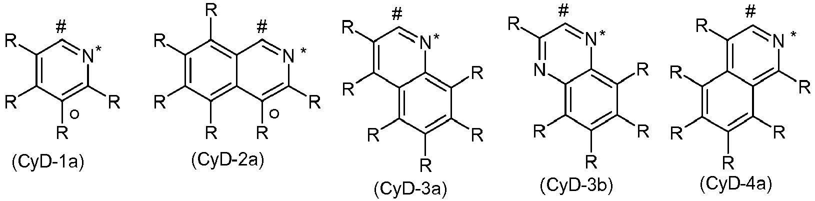 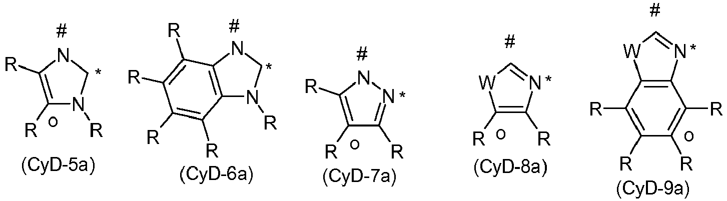 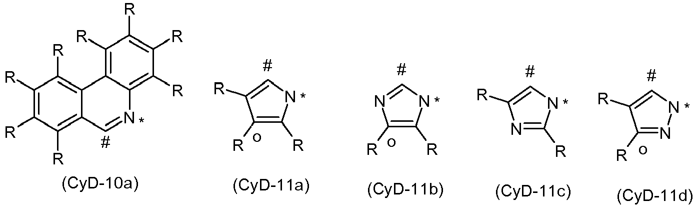 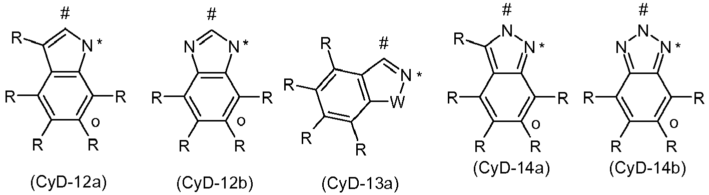 wobei die verwendeten Symbole die oben genannten Bedeutungen aufweisen und, wenn CyD direkt innerhalb der Gruppe der Formel (2) bzw. (3) gebunden ist, ein Rest R nicht vorhanden ist und die Brücke der Formel (2) bzw. (3) bzw. die bevorzugten Ausführungsformen an das entsprechende Kohlenstoffatom gebunden ist. Wenn CyD direkt an die Gruppe der Formel (2) bzw. (3) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Gruppe der Formel (2) bzw. (3) gebunden.

Bevorzugte Gruppen unter den Gruppen (CyD-1) bis (CyD-14) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1 a), (CyD-2a), (CyD-3a), (CyD-4a), (CyD-5a) und (CyD-6a), insbesondere (CyD-1 a), (CyD-2a) und (CyD-3a).

In einer bevorzugten Ausführungsform der vorliegenden Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen, insbesondere Phenyl, und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-14) können in den Teilliganden der Formeln (L-1) und (L-2) beliebig miteinander kombiniert werden, sofern mindestens eine der Gruppen CyC bzw. CyD eine geeignete Anknüpfungsstelle an die Gruppe der Formel (2) bzw. (3) aufweist, wobei geeignete Anknüpfungsstellen in den oben genannten Formeln mit "o" gekennzeichnet sind. Insbesondere bevorzugt ist es, wenn die oben als besonders bevorzugt genannten Gruppen CyC und CyD, also die Gruppen der Formeln (CyC-1a) bis (CyC-20a) und die Gruppen der Formeln (CyD1-a) bis (CyD-14b) miteinander kombiniert werden, sofern mindestens eine der bevorzugten Gruppen CyC bzw. CyD eine geeignete Anknüpfungsstelle an die Gruppe der Formel (2) bzw. (3) aufweist, wobei geeignete Anknüpfungsstellen in den oben genannten Formeln mit "o" gekennzeichnet sind. Kombinationen, in denen weder CyC noch CyD eine solche geeignete Anknüpfungsstelle an die Brücke der Formel (2) bzw. (3) aufweist, sind daher nicht bevorzugt.

Ganz besonders bevorzugt ist es, wenn eine der Gruppen (CyC-1), (CyC-3), (CyC-8), (CyC-10), (CyC-12), (CyC-13) und (CyC-16), und insbesondere die Gruppen (CyC-1a), (CyC-3a), (CyC-8a), (CyC-10a), (CyC-12a), (CyC-13a) und (CyC-16a), mit einer der Gruppen (CyD-1), (CyD-2) und (CyD-3), und insbesondere mit einer der Gruppen (CyD-1a), (CyD-2a) und (CyD-3a), kombiniert wird.

Bevorzugte Teilliganden (L-1) sind die Strukturen der folgenden Formeln (L-1-1) und (L-1-2), und bevorzugte Teilliganden (L-2) sind die Strukturen der folgenden Formeln (L-2-1) bis (L-2-3), 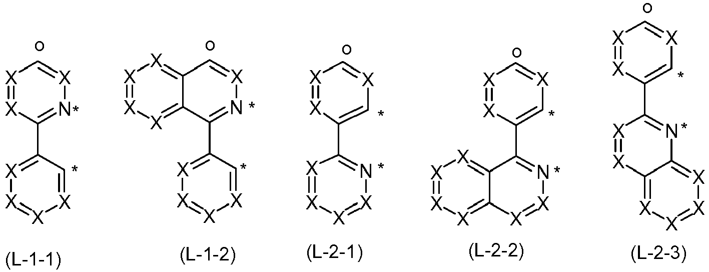 wobei die verwendeten Symbole die oben genannten Bedeutungen aufweisen, * die Position der Koordination an das Iridium andeutet und "o" die Position der Bindung an die Gruppe der Formel (2) bzw. (3) darstellt.

Besonders bevorzugte Teilliganden (L-1) sind die Strukturen der folgenden Formeln (L-1-1a) und (L-1-2b), und besonders bevorzugte Teilliganden (L-2) sind die Strukturen der folgenden Formeln (L-2-1 a) bis (L-2-3a), 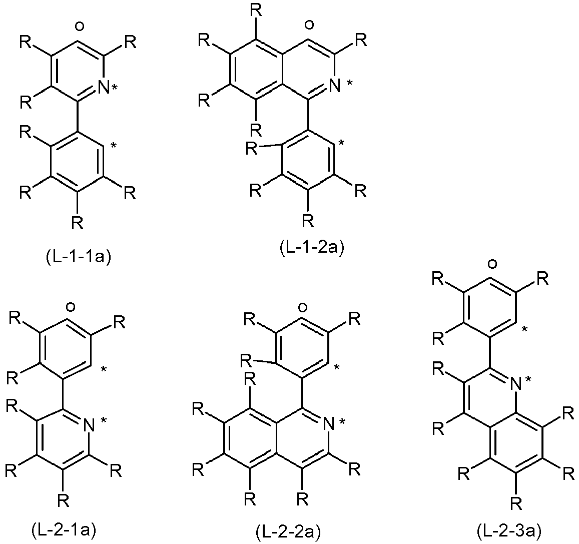 wobei die verwendeten Symbole die oben genannten Bedeutungen aufweisen und "o" die Position der Bindung an die Gruppe der Formel (2) bzw. (3) darstellt.

Ebenso können die oben genannten bevorzugten Gruppen CyD in den Teilliganden der Formel (L-3) beliebig miteinander kombiniert werden, wobei eine neutrale Gruppe CyD, also eine Gruppe (CyD-1) bis (CyD-10), (CyD-13) oder (CyD-14), mit einer anionischen Gruppe CyD, also einer Gruppe (CyD-11) oder CyD-12) kombiniert wird, sofern mindestens eine der bevorzugten Gruppen CyD eine geeignete Anknüpfungsstelle an die Gruppe der Formel (2) bzw. (3) aufweist, wobei geeignete Anknüpfungsstellen in den oben genannten Formeln mit "o" gekennzeichnet sind.

Wenn zwei Reste R, von denen einer an CyC und der andere an CyD in den Formeln (L-1) und (L-2) gebunden sind bzw. von denen einer an die eine Gruppe CyD und der andere an die andere Gruppe CyD in Formel (L-3) gebunden sind, miteinander ein aromatisches Ringsystem bilden, können sich überbrückte Teilliganden und auch Teilliganden ergeben, die insgesamt eine einzige größere Heteroarylgruppe darstellen, wie beispielsweise Benzo[h]chinolin, etc.. Die Ringbildung zwischen den Substituenten an CyC und CyD in den Formeln (L-1) und (L-2) bzw. zwischen den Substituenten an den beiden Gruppen CyD in Formel (L-3) erfolgt dabei bevorzugt durch eine Gruppe gemäß einer der folgenden Formeln (30) bis (39), 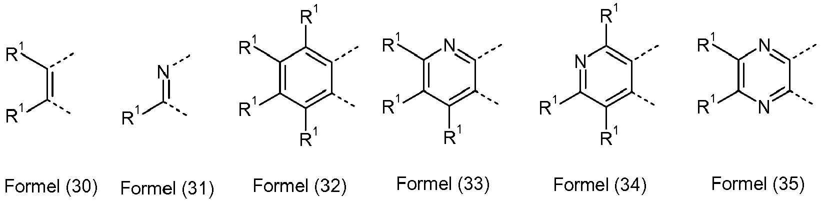 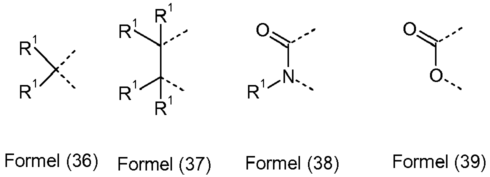 wobei R¹ die oben genannten Bedeutungen aufweist und die gestrichelten Bindungen die Bindungen an CyC bzw. CyD andeuten. Dabei können die unsymmetrischen der oben genannten Gruppen in jeder der beiden Orientierungen eingebaut werden, beispielsweise kann bei der Gruppe der Formel (39) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Dabei ist die Gruppe der Formel (36) besonders dann bevorzugt, wenn sich dadurch die Ringbildung zu einem Sechsring ergibt, wie beispielsweise unten durch die Formeln (L-22) und (L-23) dargestellt.

Bevorzugte Liganden, die durch Ringbildung zweier Reste R an den unterschiedlichen Cyclen entstehen, sind die im Folgenden aufgeführten Strukturen der Formeln (L-4) bis (L-31), 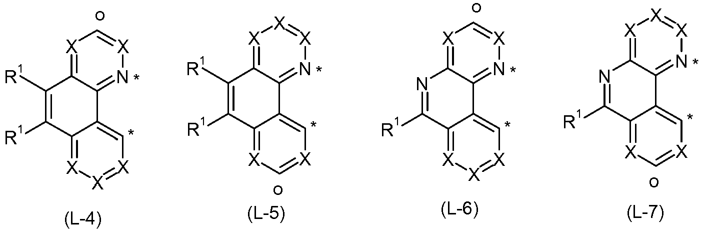 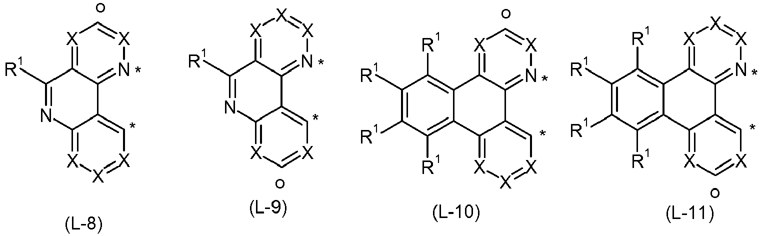 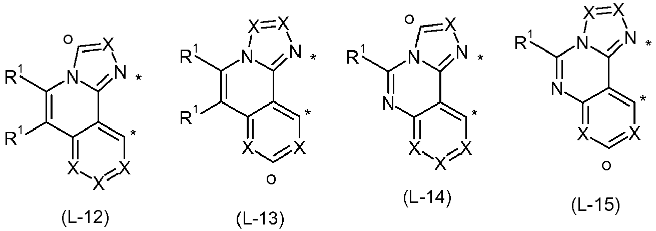 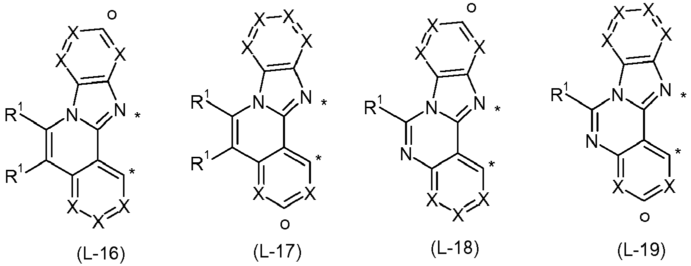 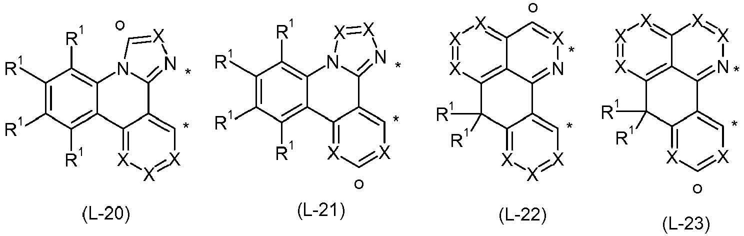 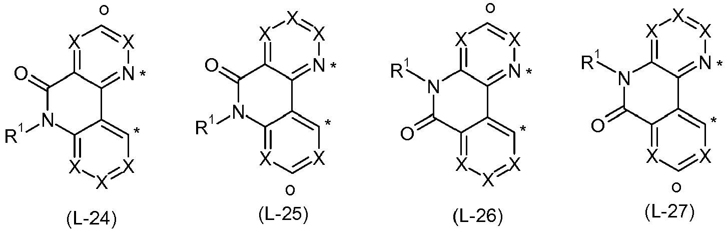 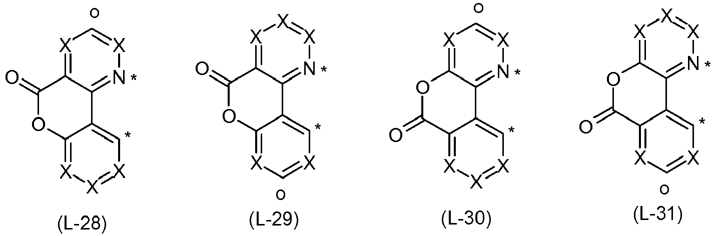 wobei die verwendeten Symbole die oben genannten Bedeutungen aufweisen und "o" die Position angibt, an denen dieser Teilligand mit der Gruppe der Formel (2) bzw. (3) verknüpft ist.

In einer bevorzugten Ausführungsform der Teilliganden der Formeln (L-4) bis (L-31) steht insgesamt ein Symbol X für N und die anderen Symbole X stehen für CR, oder alle Symbole X stehen für CR.

In einer weiteren Ausführungsform der Erfindung ist es bevorzugt, falls in den Gruppen (CyC-1) bis (CyC-20) oder (CyD-1) bis (CyD-14) oder in den Teilliganden (L-1-1) bis (L-2-3), (L-4) bis (L-31) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1a) bis (CyC-20a) oder (CyD-1 a) bis (CyD-14b), in denen bevorzugt benachbart zu einem nicht koordinierenden Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, OR¹ wobei R¹ für eine Alkylgruppe mit 1 bis 10 C-Atomen steht, Alkylgruppen mit 1 bis 10 C-Atomen, insbesondere verzweigten oder cyclischen Alkylgruppen mit 3 bis 10 C-Atomen, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

Ein weiterer geeigneter bidentater Teilligand ist der Teilligand der folgenden Formel (L-32) oder (L-33), 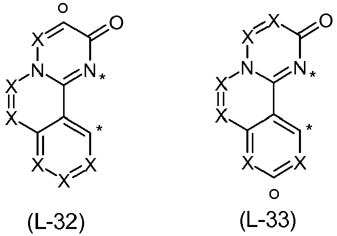 wobei R die oben genannten Bedeutungen aufweist, * die Position der Koordination an das Metall darstellt, "o" die Position der Verknüpfung des Teilliganden mit der Gruppe der Formel (2) bzw. (3) darstellt und für die weiteren verwendeten Symbole gilt:
- X: ist bei jedem Auftreten gleich oder verschieden CR oder N mit der Maßgabe, dass maximal ein Symbol X pro Cyclus für N steht und weiterhin mit der Maßgabe, dass ein Symbol X für C steht und der Teilligand über dieses Kohlenstoffatom innerhalb der Gruppe der Formel (2) bzw. (3) gebunden sind.

Wenn zwei Reste R, die in den Teilliganden (L-32) bzw. (L-33) an benachbarten Kohlenstoffatomen gebunden sind, miteinander einen aromatischen Cyclus bilden, so ist dieser zusammen mit den beiden benachbarten Kohlenstoffatomen bevorzugt eine Struktur der folgenden Formel (40), 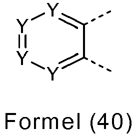 wobei die gestrichelten Bindungen die Verknüpfung dieser Gruppe im Teilliganden symbolisieren und Y gleich oder verschieden bei jedem Auftreten für CR¹ oder N steht und bevorzugt maximal ein Symbol Y für N steht. In einer bevorzugten Ausführungsform des Teilliganden (L-32) bzw. (L-33) ist maximal eine Gruppe der Formel (40) vorhanden. In einer bevorzugten Ausführungsform der Erfindung stehen im Teilliganden der Formel (L-32) und (L-33) insgesamt 0, 1 oder 2 der Symbole X und, falls vorhanden, Y für N. Besonders bevorzugt stehen insgesamt 0 oder 1 der Symbole X und, falls vorhanden, Y für N.

Weitere geeignete bidentate Teilliganden sind die Strukturen der folgenden Formeln (L-34) bis (L-38), wobei bevorzugt maximal eine der beiden bidentaten Teilliganden L pro Metall für eine dieser Strukturen steht, 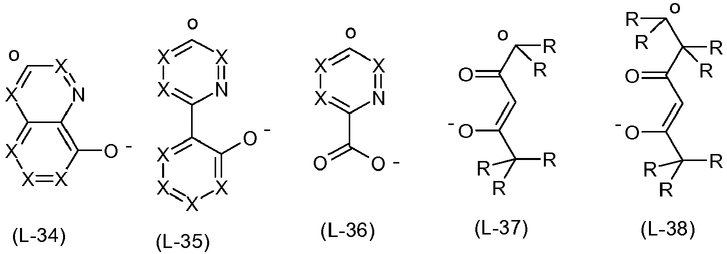 wobei die Teilliganden (L-34) bis (L-36) jeweils über das explizit eingezeichnete Stickstoffatom und das negativ geladene Sauerstoffatom und die Teilliganden (L-37) und (L-38) über die beiden Sauerstoffatome an das Metall koordinieren, X die oben genannten Bedeutungen aufweist und "o" die Position angibt, über die der Teilligand L mit der Gruppe der Formel (2) bzw. (3) verknüpft ist.

Die oben ausgeführten bevorzugten Ausführungsformen für X sind auch bevorzugt für die Teilliganden der Formeln (L-34) bis (L-36).

Bevorzugte Teilliganden der Formeln (L-34) bis (L-36) sind daher die Teilliganden der folgenden Formeln (L-34a) bis (L-36a), 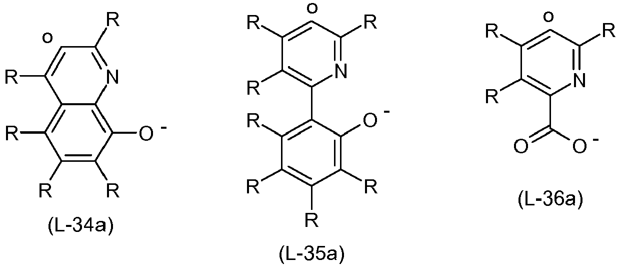 wobei die verwendeten Symbole die oben genannten Bedeutungen aufweisen und "o" die Position angibt, über die der Teilligand L mit der Gruppe der Formel (2) bzw. (3) verknüpft ist.

Besonders bevorzugt steht in diesen Formeln R für Wasserstoff, wobei "o" die Position angibt, über die der Teilligand L innerhalb der Gruppe der Formel (2) bzw. (3) bzw. den bevorzugten Ausführungsformen verknüpft ist, so dass es sich um die Strukturen der folgenden Formeln (L-34b) bis (L-36b) handelt, 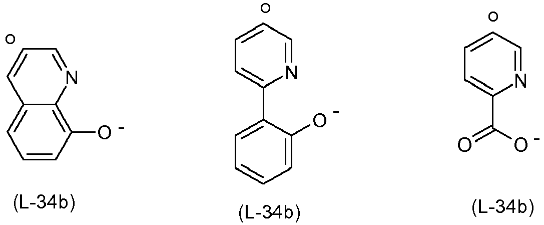 wobei die verwendeten Symbole die oben genannten Bedeutungen aufweisen.

Im Folgenden werden bevorzugte Substituenten beschrieben, wie sie an den oben beschriebenen Teilliganden, aber auch an A, wenn A für eine Gruppe der Formel (4) steht, vorliegen können.

In einer bevorzugten Ausführungsform der Erfindung enthält die erfindungsgemäße Verbindung zwei Substituenten R, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an der Brücke der Formeln (2) bzw. (3) bzw. den bevorzugten Ausführungsformen vorliegen und/oder an einem oder mehreren der bidentaten Teilliganden L vorliegen. Der aliphatische Ring, der durch die Ringbildung von zwei Substituenten R miteinander gebildet wird, wird bevorzugt durch eine der folgenden Formeln (41) bis (47) beschrieben, 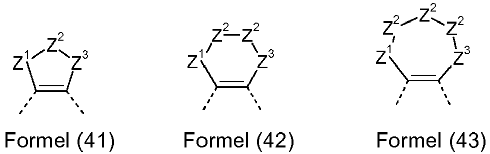 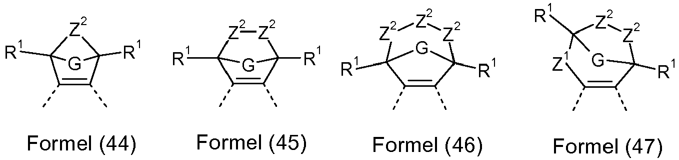 wobei R¹ und R² die oben genannten Bedeutungen aufweisen, die gestrichelten Bindungen die Verknüpfung der beiden Kohlenstoffatome im Liganden andeuten und weiterhin gilt:
- Z¹, Z³: ist gleich oder verschieden bei jedem Auftreten C(R³)₂, O, S, NR³ oder C(=O);
- Z²: ist C(R¹)₂, O, S, NR³ oder C(=O);
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

In einer bevorzugten Ausführungsform der Erfindung ist R³ ungleich H.

In den oben abgebildeten Strukturen der Formeln (41) bis (47) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (41) bis (43) dadurch erreicht, dass Z¹ und Z³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (44) bis (47) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (44) bis (47) für H steht, handelt es sich dabei daher um ein nicht-azides Proton im Sinne der vorliegenden Anmeldung.

In einer bevorzugten Ausführungsform der Struktur gemäß Formel (41) bis (47) steht maximal eine der Gruppen Z¹, Z² und Z³ für ein Heteroatom, insbesondere für O oder NR³, und die anderen Gruppen stehen für C(R³)₂ bzw. C(R¹)₂ oder Z¹ und Z³ stehen gleich oder verschieden bei jedem Auftreten für O oder NR³ und Z² steht für C(R¹)₂. In einer besonders bevorzugten Ausführungsform der Erfindung stehen Z¹ und Z³ gleich oder verschieden bei jedem Auftreten für C(R³)₂ und Z² steht für C(R¹)₂ und besonders bevorzugt für C(R³)₂ oder CH₂.

Bevorzugte Ausführungsformen der Formel (41) sind somit die Strukturen der Formel (41-A), (41-B), (41-C) und (41-D), und eine besonders bevorzugte Ausführungsform der Formel (41-A) sind die Strukturen der Formel (41-E) und (41-F), 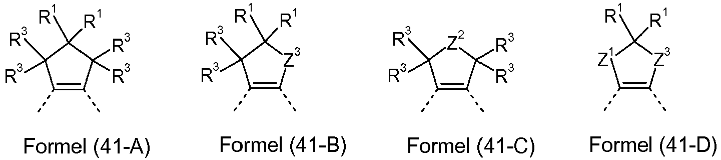 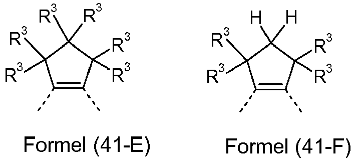 wobei R¹ und R³ die oben genannten Bedeutungen aufweisen und Z¹, Z² und Z³ gleich oder verschieden bei jedem Auftreten für O oder NR³ steht.

Bevorzugte Ausführungsformen der Formel (42) sind die Strukturen der folgenden Formeln (42-A) bis (42-F), 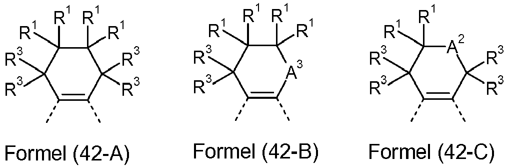 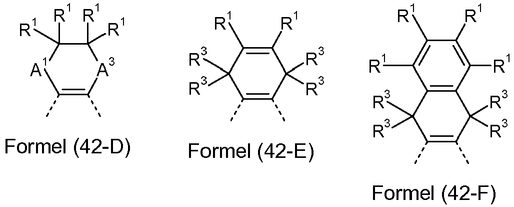 wobei R¹ und R³ die oben genannten Bedeutungen aufweisen und Z¹, Z² und Z³ gleich oder verschieden bei jedem Auftreten für O oder NR³ steht.

Bevorzugte Ausführungsformen der Formel (43) sind die Strukturen der folgenden Formeln (43-A) bis (43-E), 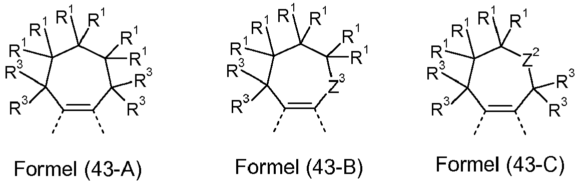 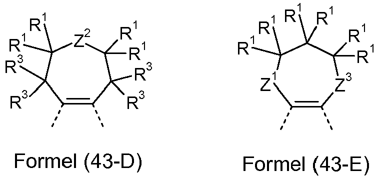 wobei R¹ und R³ die oben genannten Bedeutungen aufweisen und Z¹, Z² und Z³ gleich oder verschieden bei jedem Auftreten für O oder NR³ steht.

In einer bevorzugten Ausführungsform der Struktur gemäß Formel (44) stehen die Reste R¹, die an den Brückenkopf gebunden sind, für H, D, F oder CH₃. Weiterhin bevorzugt steht Z² für C(R¹)₂ oder O, und besonders bevorzugt für C(R³)₂. Bevorzugte Ausführungsformen der Formel (44) sind somit eine Strukturen der Formel (44-A) und (44-B), und eine besonders bevorzugte Ausführungsform der Formel (44-A) ist eine Struktur der Formel (44-C), 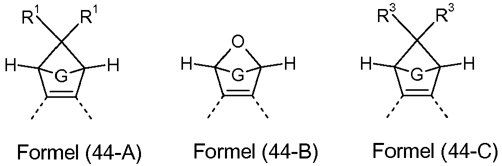 wobei die verwendeten Symbole die oben genannten Bedeutungen aufweisen.

In einer bevorzugten Ausführungsform der Struktur gemäß Formel (45), (46) und (47) stehen die Reste R¹, die an den Brückenkopf gebunden sind, für H, D, F oder CH₃. Weiterhin bevorzugt steht Z² für C(R¹)₂. Bevorzugte Ausführungsformen der Formel (45), (46) und (47) sind somit die Strukturen der Formeln (45-A), (46-A) und (47-A), 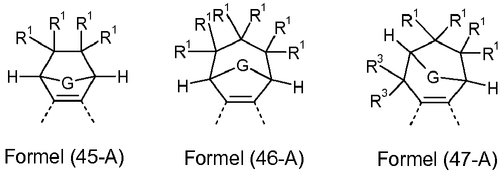 wobei die verwendeten Symbole die oben genannten Bedeutungen aufweisen.

Weiterhin bevorzugt steht die Gruppe G in den Formeln (44), (44-A), (44-B), (44-C), (45), (45-A), (46), (46-A), (47) und (47-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (41) bis (47) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder ein aromatisches oder heteroaromatisches Ringsystem mit 5 bis 14 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (41) bis (47) und in den bevorzugten Ausführungsformen gleich oder verschieden bei jedem Auftreten für F, eine geradkettige Alkylgruppe mit 1 bis 3 C-Atomen, insbesondere Methyl, oder ein aromatisches oder heteroaromatisches Ringsystem mit 5 bis 12 aromatischen Ringatomen, das jeweils durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (41) sind die im Folgenden abgebildeten Gruppen:

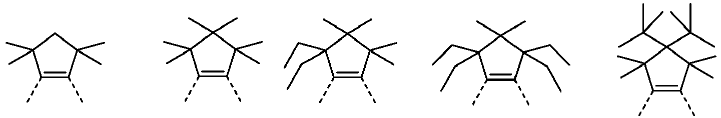

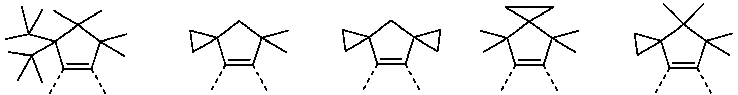

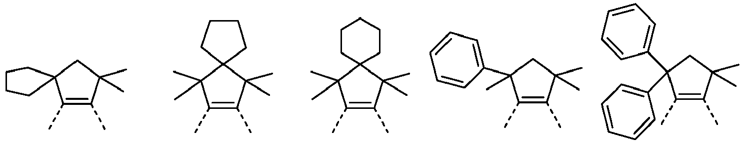

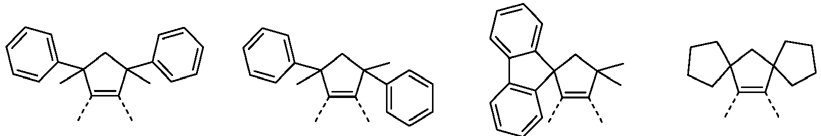

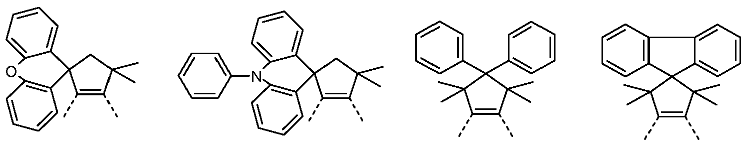

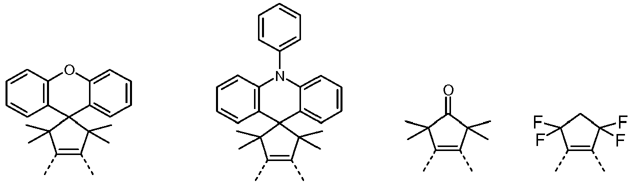

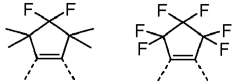

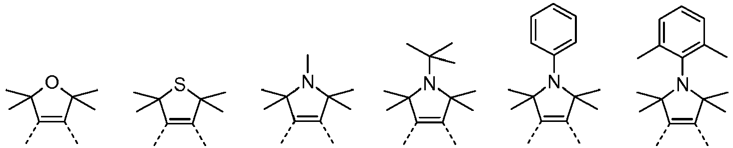

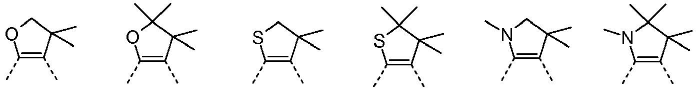

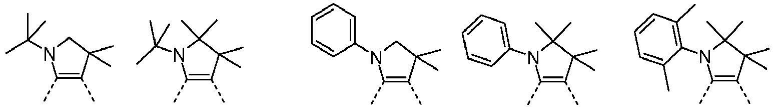

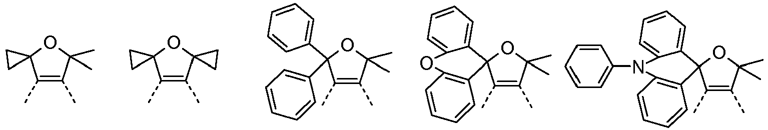

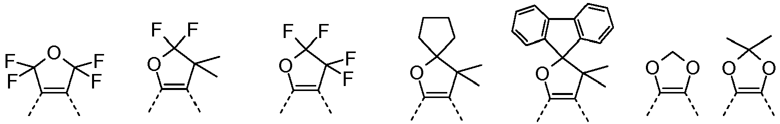

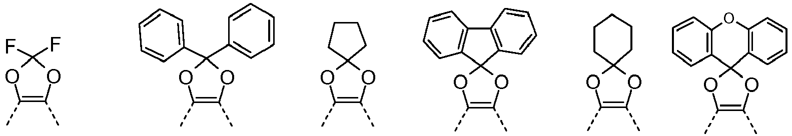

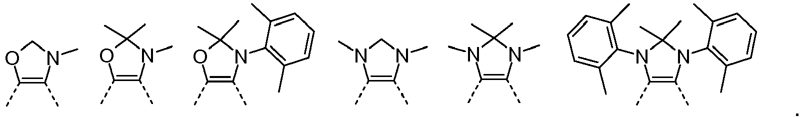

Beispiele für besonders geeignete Gruppen der Formel (42) sind die im Folgenden abgebildeten Gruppen:

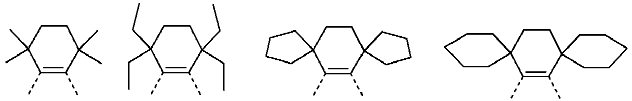

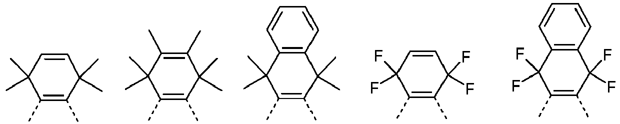

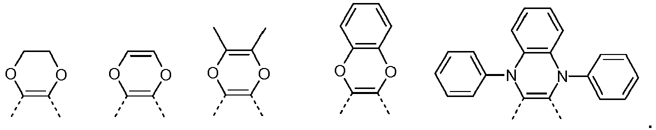

Beispiele für besonders geeignete Gruppen der Formel (43), (46) und (47) sind die im Folgenden abgebildeten Gruppen:

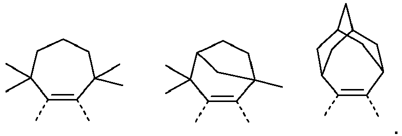

Beispiele für besonders geeignete Gruppen der Formel (44) sind die im Folgenden abgebildeten Gruppen:

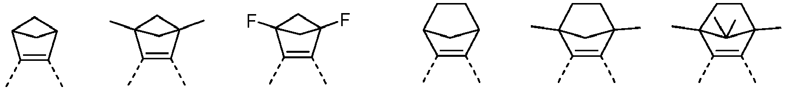

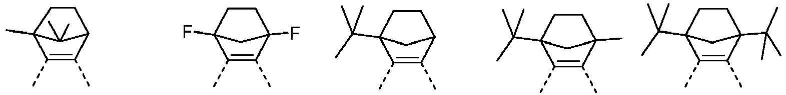

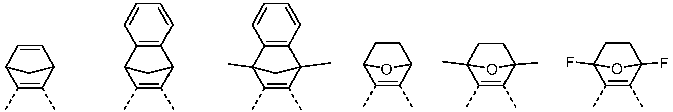

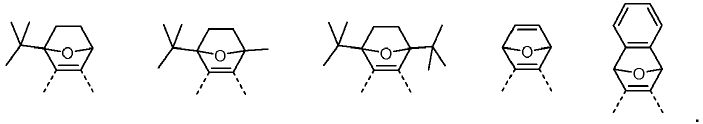

Beispiele für besonders geeignete Gruppen der Formel (45) sind die im Folgenden abgebildeten Gruppen:

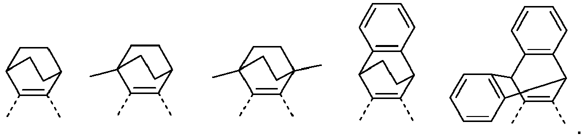

Wenn in den bidentaten Teilliganden bzw. Liganden bzw. in den bivalenten Arylen- bzw. Heteroarylengruppen der Formel (4), welche in den Formeln (2) bzw. (3) bzw. den bevorzugten Ausführungsformen gebunden sind, Reste R gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹, die an R gebunden sind, sind bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Beispiele für erfindungsgemäße Verbindungen sind die nachfolgend aufgeführten Strukturen:

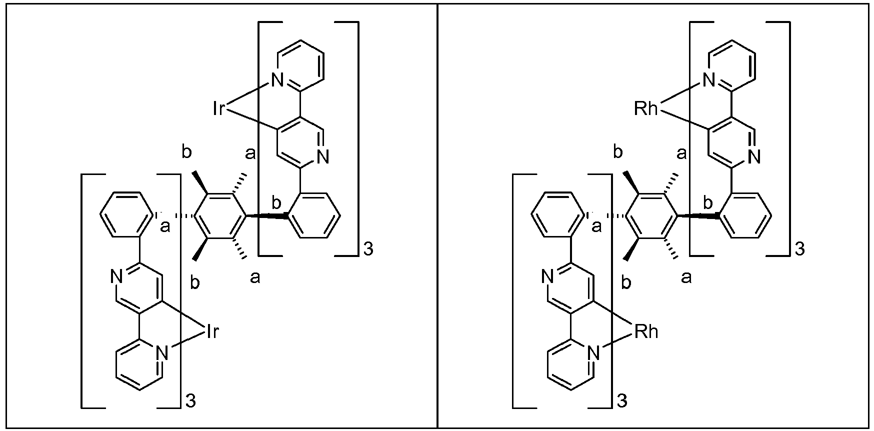

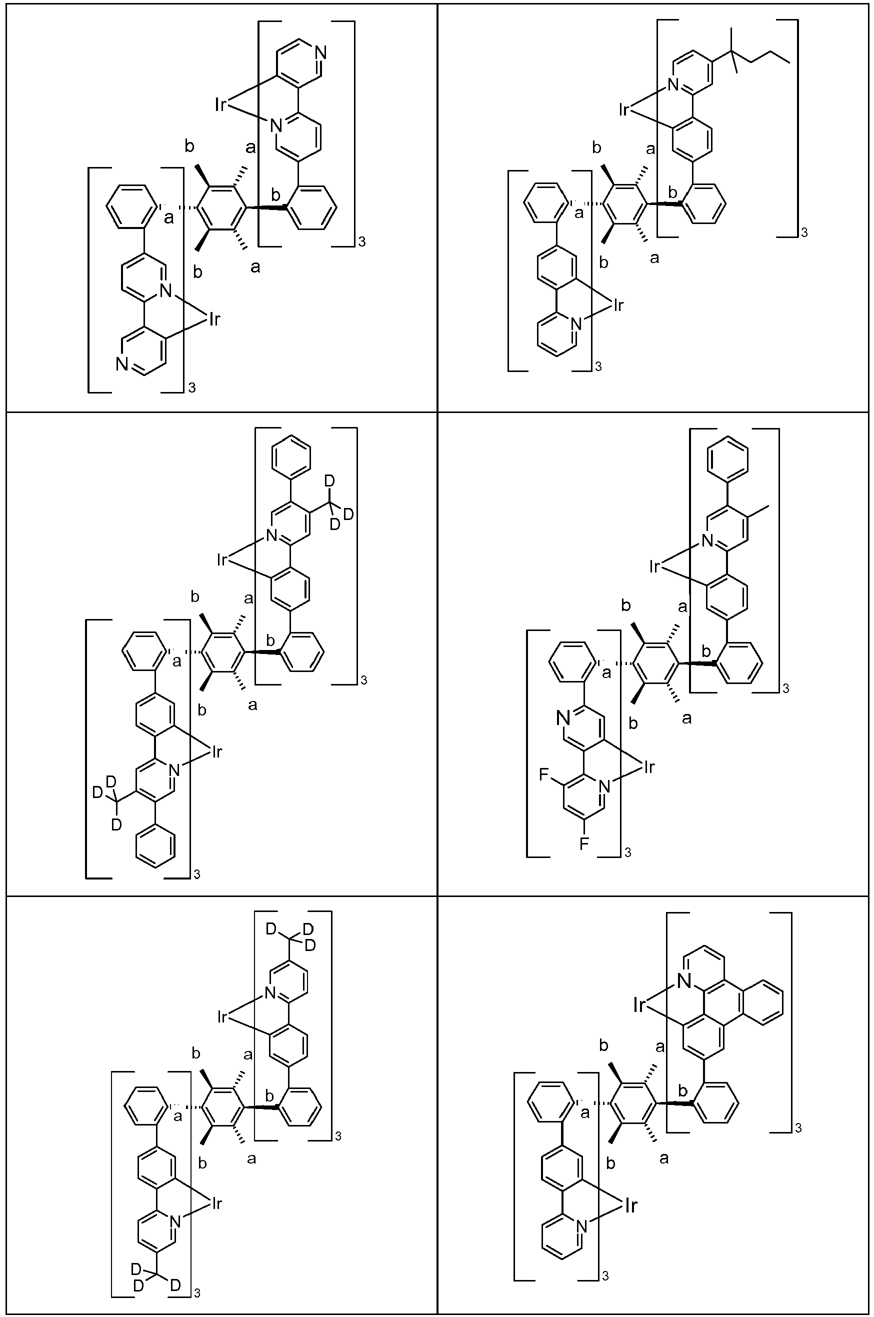

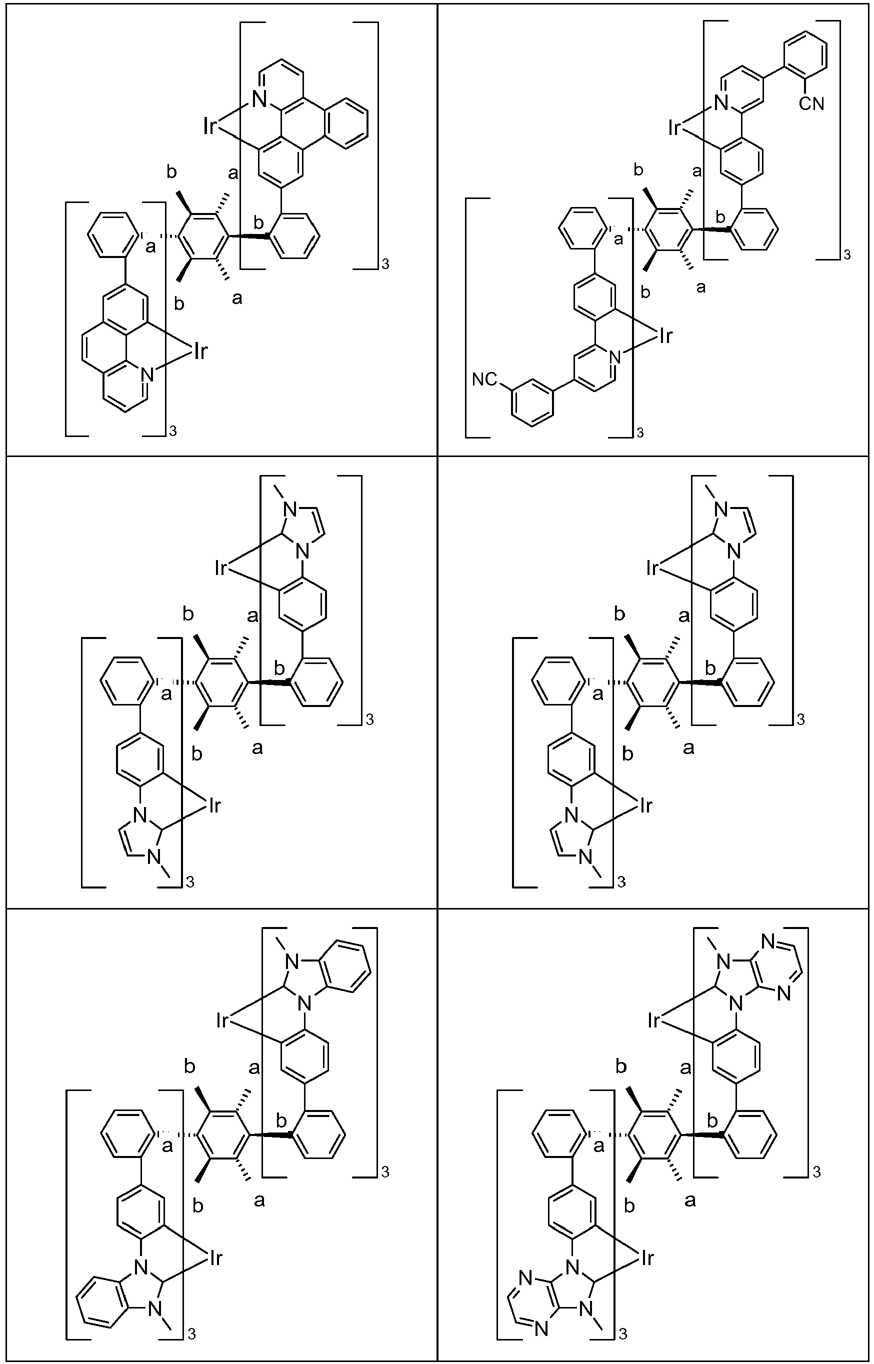

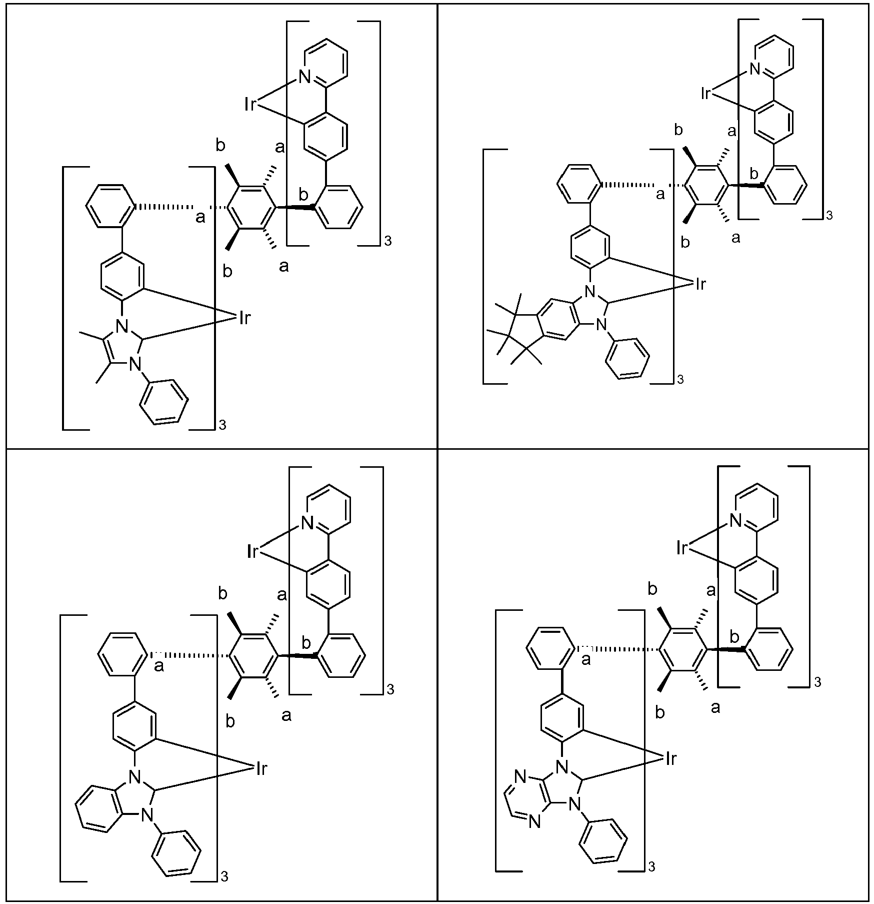

Bei den erfindungsgemäßen Verbindungen handelt es sich um chirale Strukturen. Je nach genauer Struktur der Komplexe und Liganden ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Die erfindungsgemäßen Komplexe können insbesondere durch den nachfolgend beschriebenen Weg dargestellt werden. Dazu wird der 12-zähnige Ligand dargestellt und dann an die Metalle M durch eine ortho-Metallierungsreaktion koordiniert. Generell wird hierzu ein Iridium- bzw. Rhodiumsalz mit dem entsprechenden freien Liganden umgesetzt.

Daher ist ein weiterer Gegenstand der vorliegenden Erfindung ein Verfahren zur Herstellung der erfindungsgemäßen Verbindung durch Umsetzung der entsprechenden freien Liganden mit Metallalkoholaten der Formel (48), mit Metallketoketonaten der Formel (49), mit Metallhalogeniden der Formel (50) oder mit Metallcarboxylaten der Formel (51),

| | | | |
|---|---|---|---|
| M(OR)₃ Formel (48) | 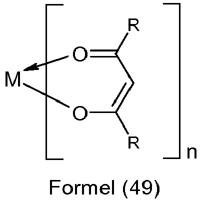 | MHal₃ Formel (50) | M(OOCR)₃ Formel (51) |

wobei M für Iridium oder Rhodium steht, R die oben angegebenen Bedeutungen aufweist, Hal = F, Cl, Broder I ist und die Iridium- bzw. Rhodiumedukte auch als die entsprechenden Hydrate vorliegen können. Dabei steht R bevorzugt für eine Alkylgruppe mit 1 bis 4 C-Atomen.

Es können ebenfalls Iridium- bzw. Rhodiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris-(2,2,6,6-Tetramethylheptan-3,5-dionato)iridium, und IrCl3·xH₂O, wobei x üblicherweise für eine Zahl zwischen 2 und 4 steht.

Die Synthese der Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, iso-Chinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bis-phenoxybenzol, Triphenylphosphinoxid, 18-Krone-6, Phenol, 1-Naphthol, Hydrochinon, etc.. Dabei ist die Verwendung von Hydrochinon besonders bevorzugt.

Ein weiteres geeignetes Verfahren zur Synthese der erfindungsgemäßen Komplexe besteht darin, zunächst eine Vorstufe des Liganden zu synthetisieren, welche die Gruppe V sowie die drei Teilliganden L¹ enthält, jedoch statt der drei Teilliganden L² reaktive Abgangsgruppen, beispielsweise Halogengruppen, enthält. Diese Vorstufe des endgültigen Liganden kann dann an das Metall M¹ koordiniert werden. In einem nächsten Schritt werden dann durch eine Kupplungsreaktion, beispielsweise eine Suzuki-Kupplung, die drei Teilliganden L² an V gekuppelt und in einer weiteren Reaktion mit M² zum erfindungsgemäßen Komplex umgesetzt.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (41) bis (47) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Für die Verarbeitung der erfindungsgemäßen Metallkomplexe aus flüssiger Phase, beispielsweise durch Spin-Coating oder durch Druckverfahren, sind Formulierungen der erfindungsgemäßen Metallkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Der oben beschriebene erfindungsgemäße Metallkomplex bzw. die oben aufgeführten bevorzugten Ausführungsformen können in der elektronischen Vorrichtung als aktive Komponente oder als Sauerstoff-Sensibilisatoren verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator. Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Metallkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens einen erfindungsgemäßen Metallkomplex. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃ oder mit (per)fluorierten elektronenarmen Aromaten, und/oder dass eine oder mehrere Elektronentransportschichten n-dotiert sind. Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern. Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen bzw. Systeme, welche mehr als drei emittierende Schichten aufweisen. Bevorzugt sind weiterhin auch Tandem-OLEDs. Es kann sich auch um ein Hybrid-System handeln, wobei eine oder mehrere Schichten fluoreszieren und eine oder mehrere andere Schichten phosphoreszieren. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Metallkomplex als emittierende Verbindung in einer oder mehreren emittierenden Schichten.

Wenn der erfindungsgemäße Metallkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Metallkomplex und dem Matrixmaterial enthält zwischen 0.1 und 99 Gew.-%, vorzugsweise zwischen 1 und 90 Gew.-%, besonders bevorzugt zwischen 3 und 40 Gew.-%, insbesondere zwischen 5 und 25 Gew.-% des erfindungsgemäßen Metallkomplexes bezogen auf die Gesamtmischung aus Emitter und Matrixmaterial. Entsprechend enthält die Mischung zwischen 99.9 und 1 Gew.-%, vorzugsweise zwischen 99 und 10 Gew.-%, besonders bevorzugt zwischen 97 und 60 Gew.-%, insbesondere zwischen 95 und 75 Gew.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, WO 2015/169412 oder den noch nicht offen gelegten Anmeldungen EP16158460.2 oder EP16159829.7, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Nachfolgend sind Beispiele für Verbindungen abgebildet, die sich als Matrixmaterialien für die erfindungsgemäßen Verbindungen eignen.

Beispiele für Triazine und Pyrimidine, welche als elektronentransportierende Matrixmaterialien eingesetzt werden können, sind die folgenden Verbindungen:

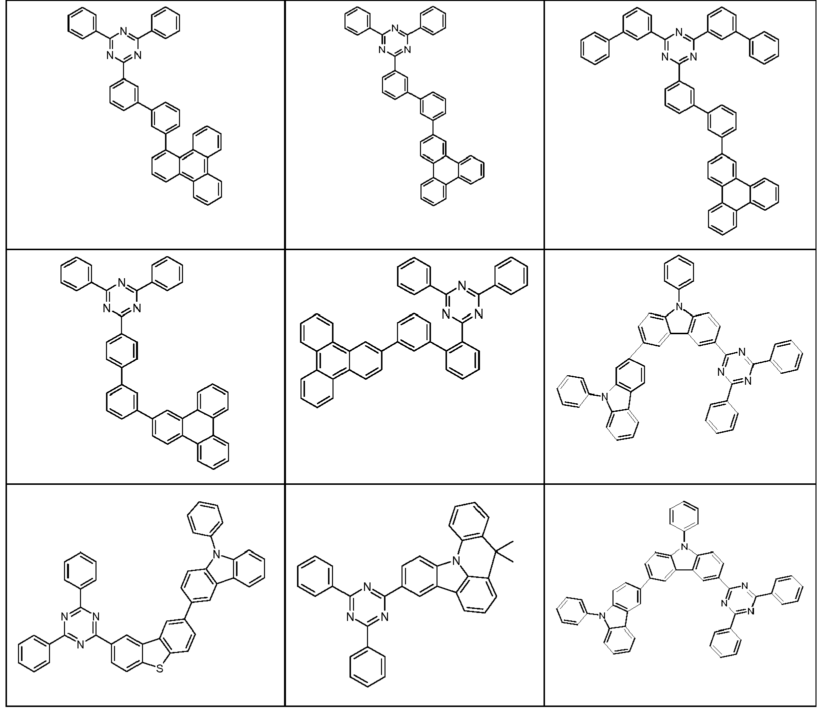

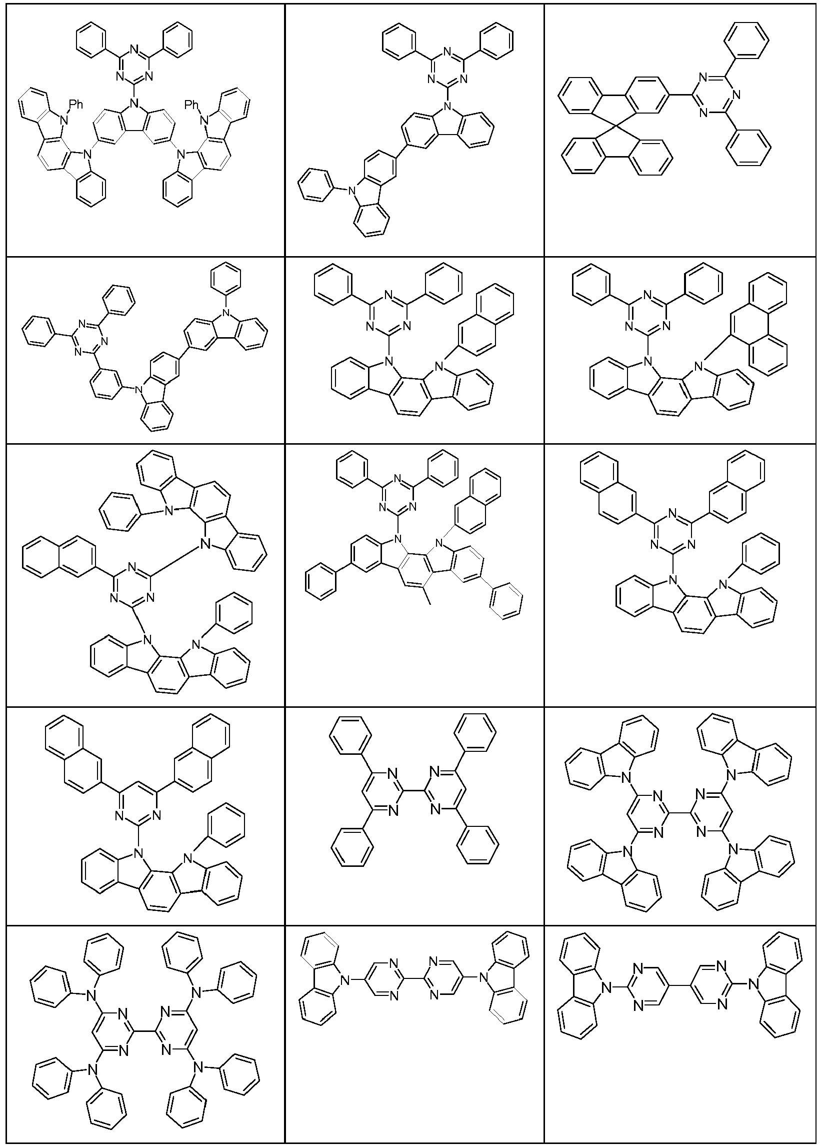

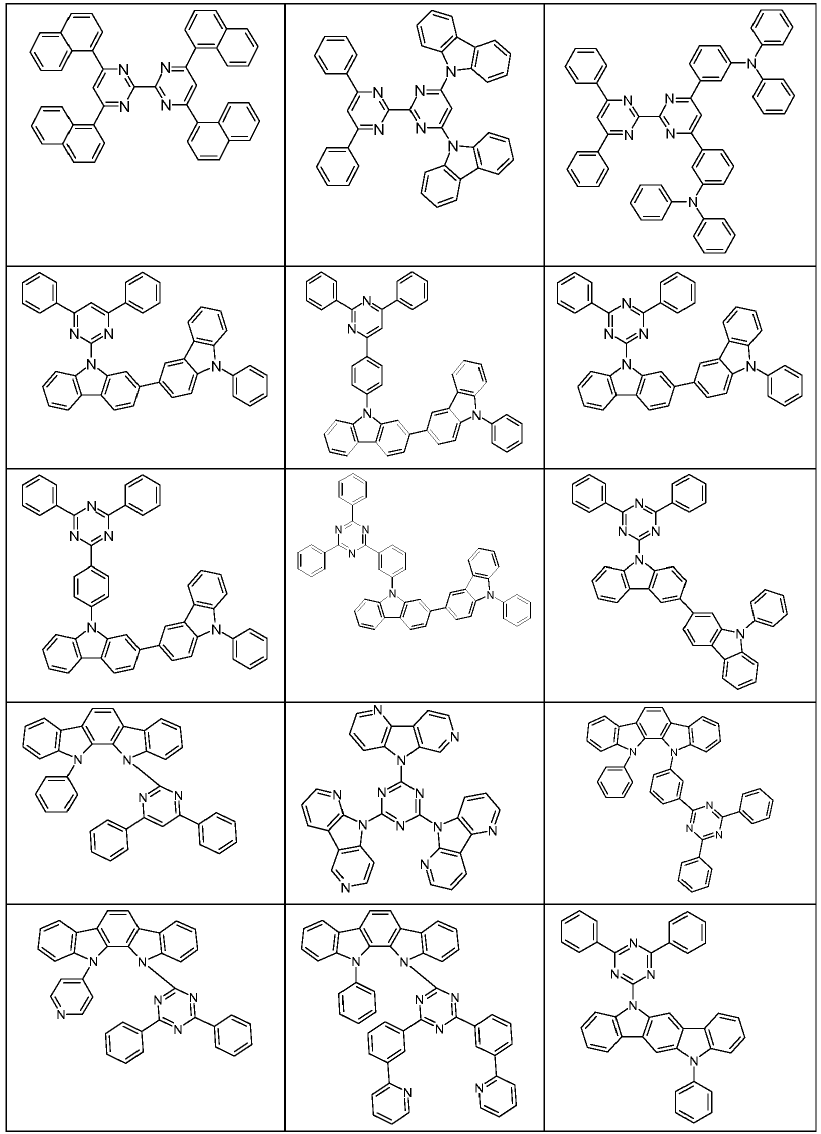

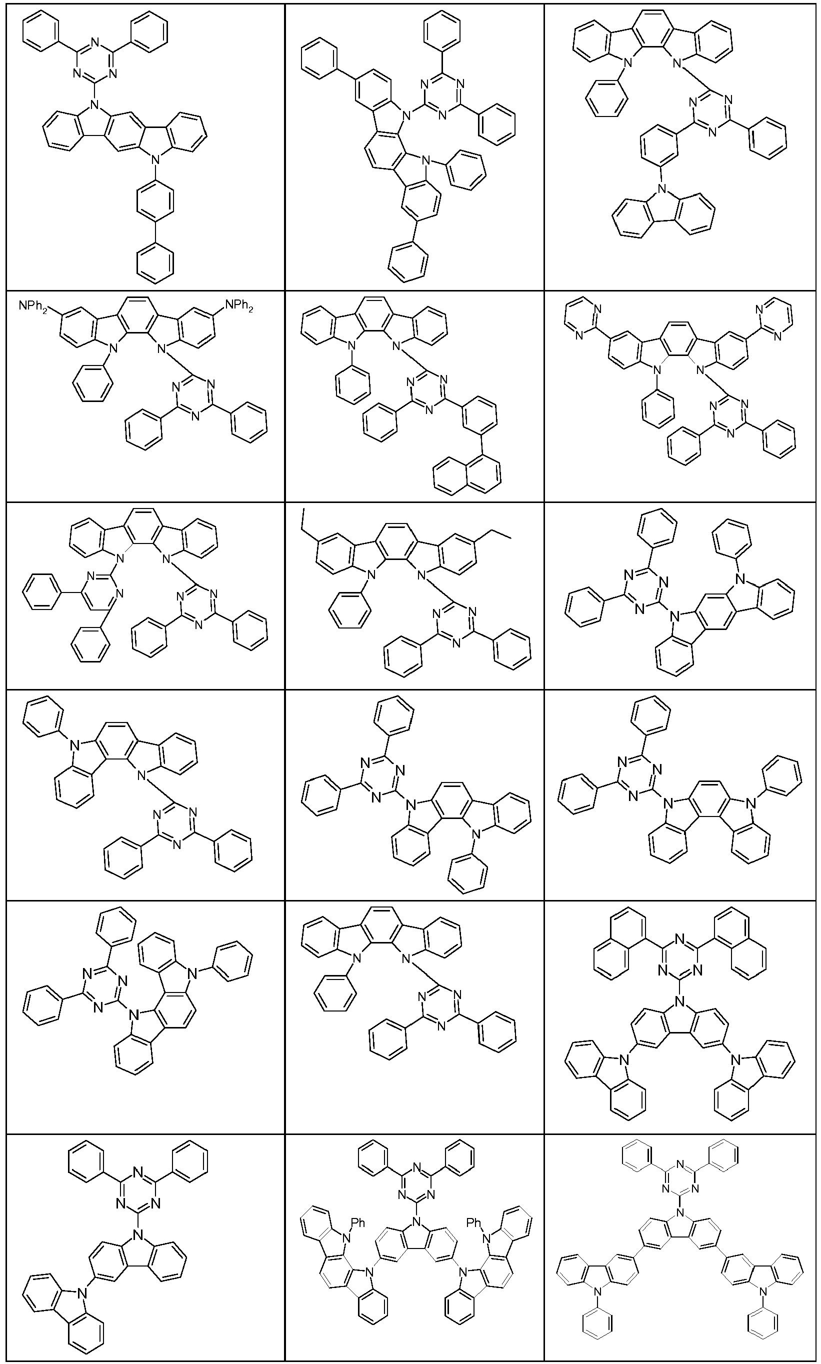

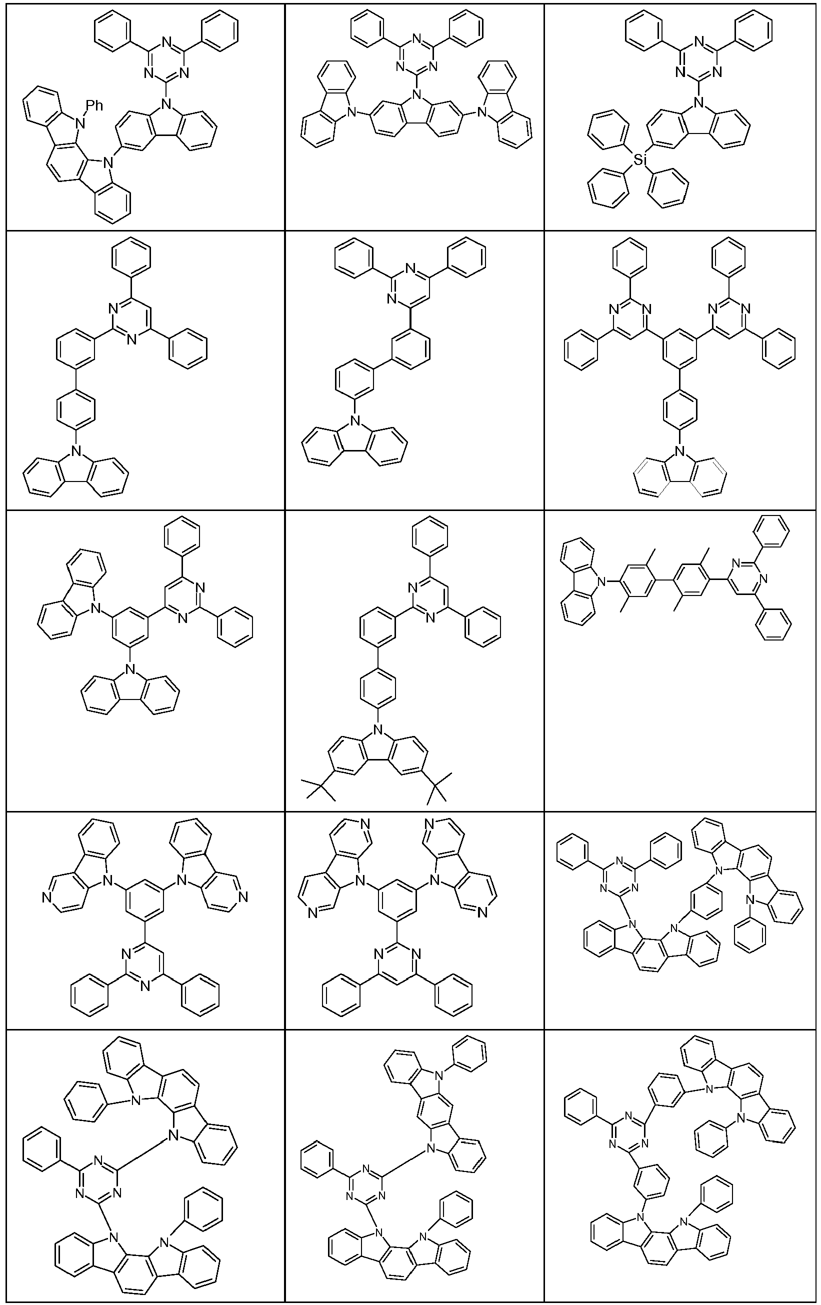

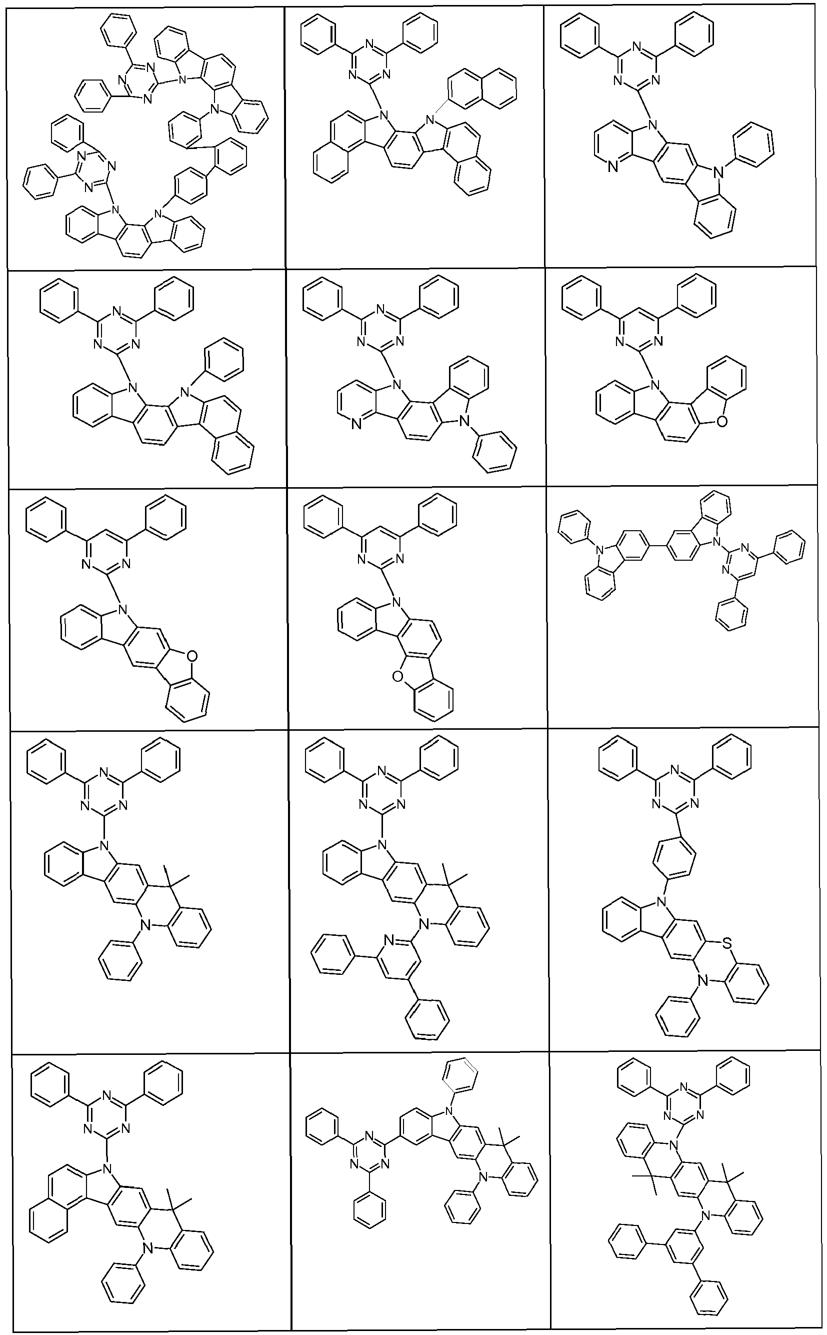

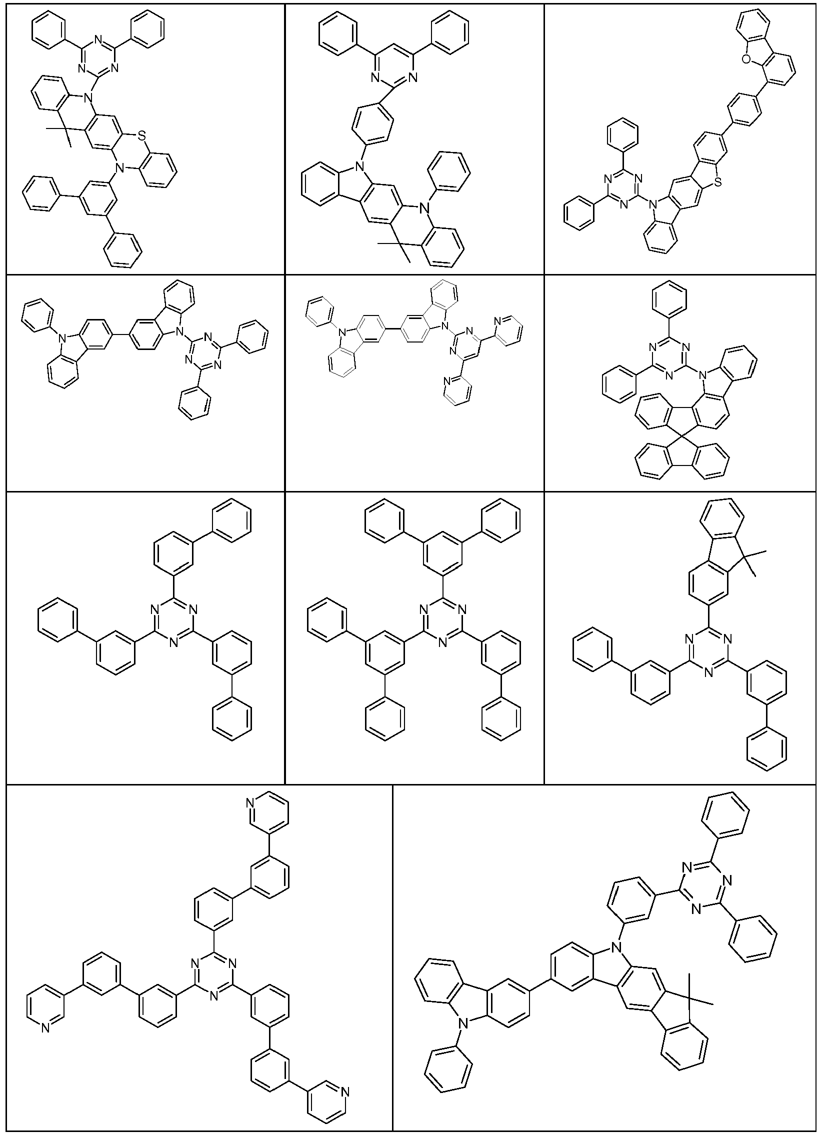

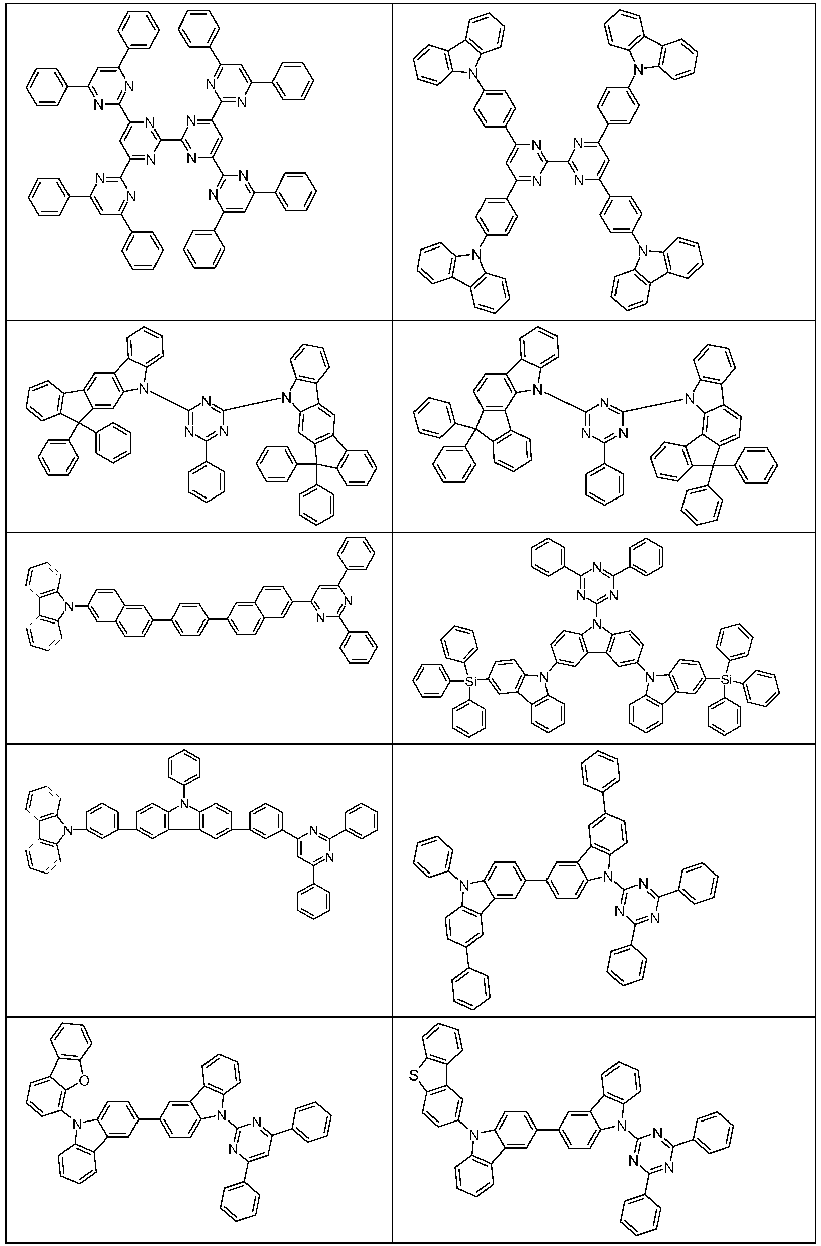

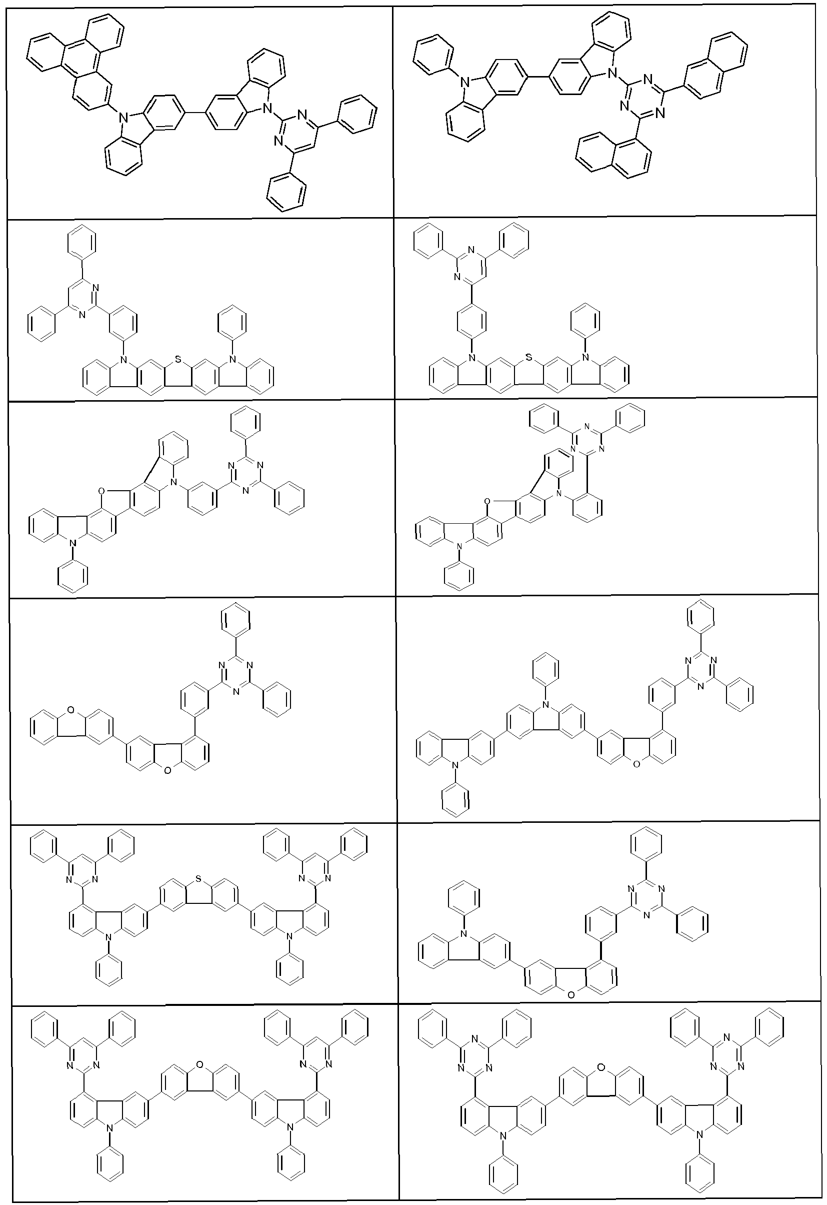

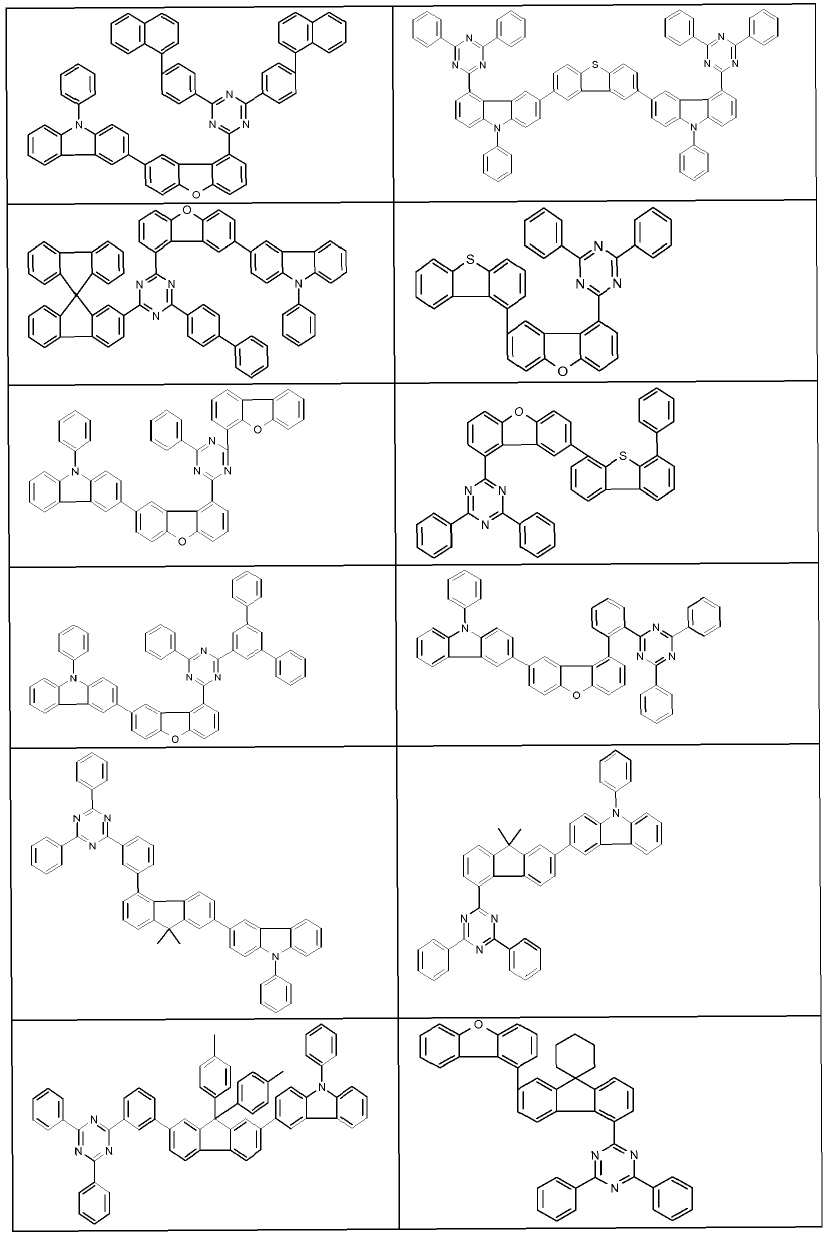

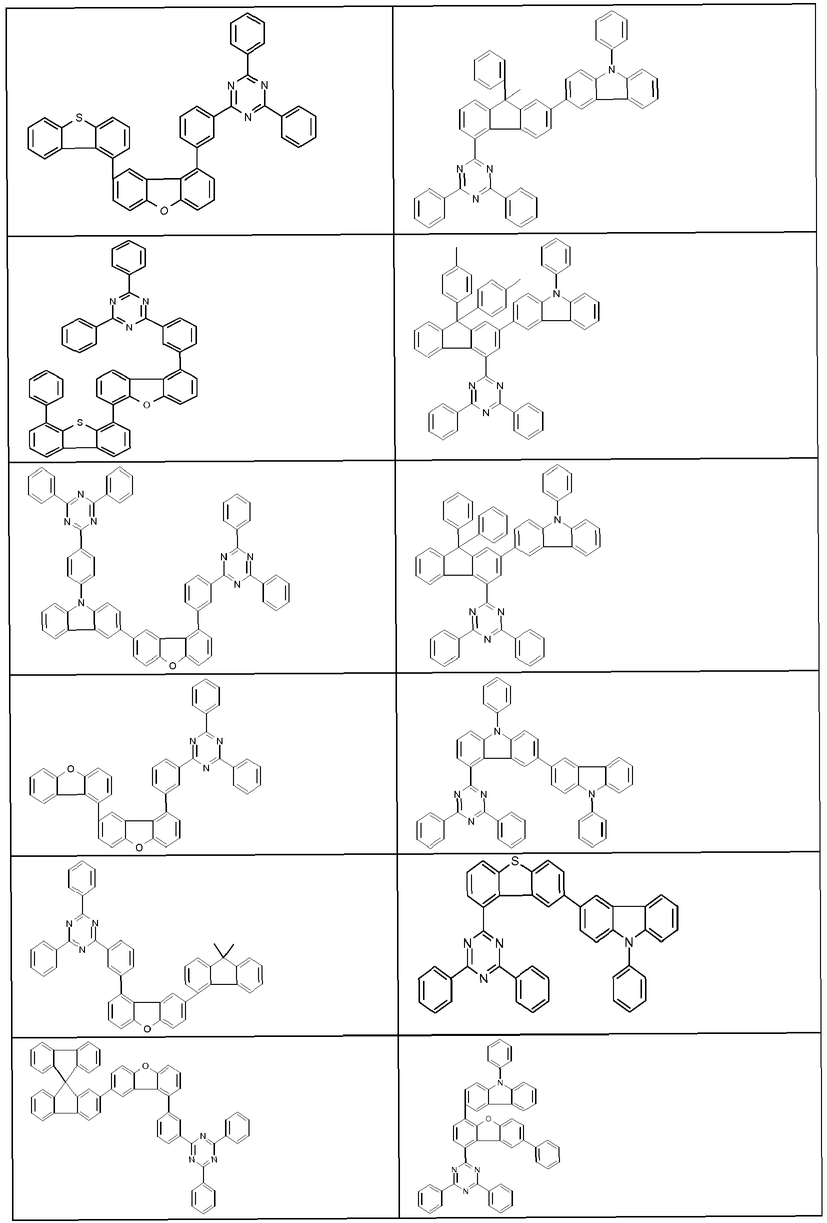

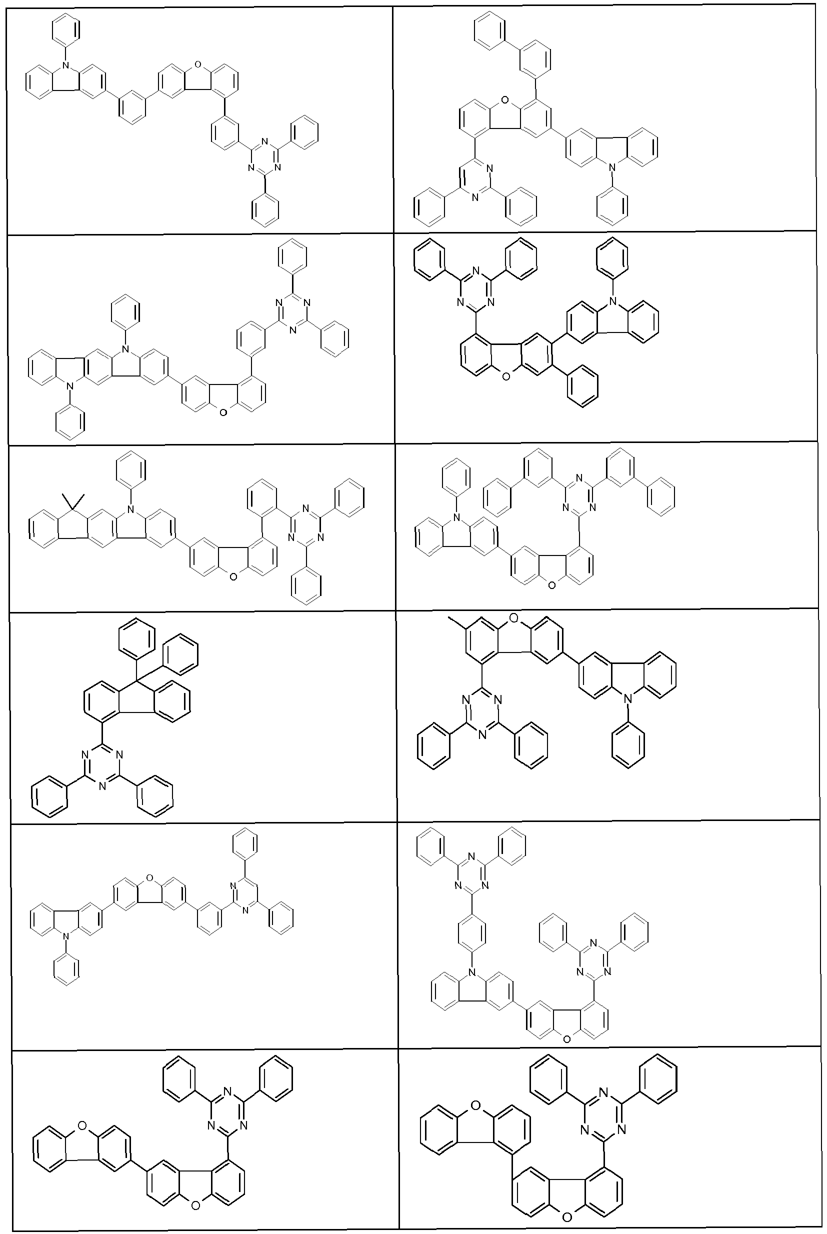

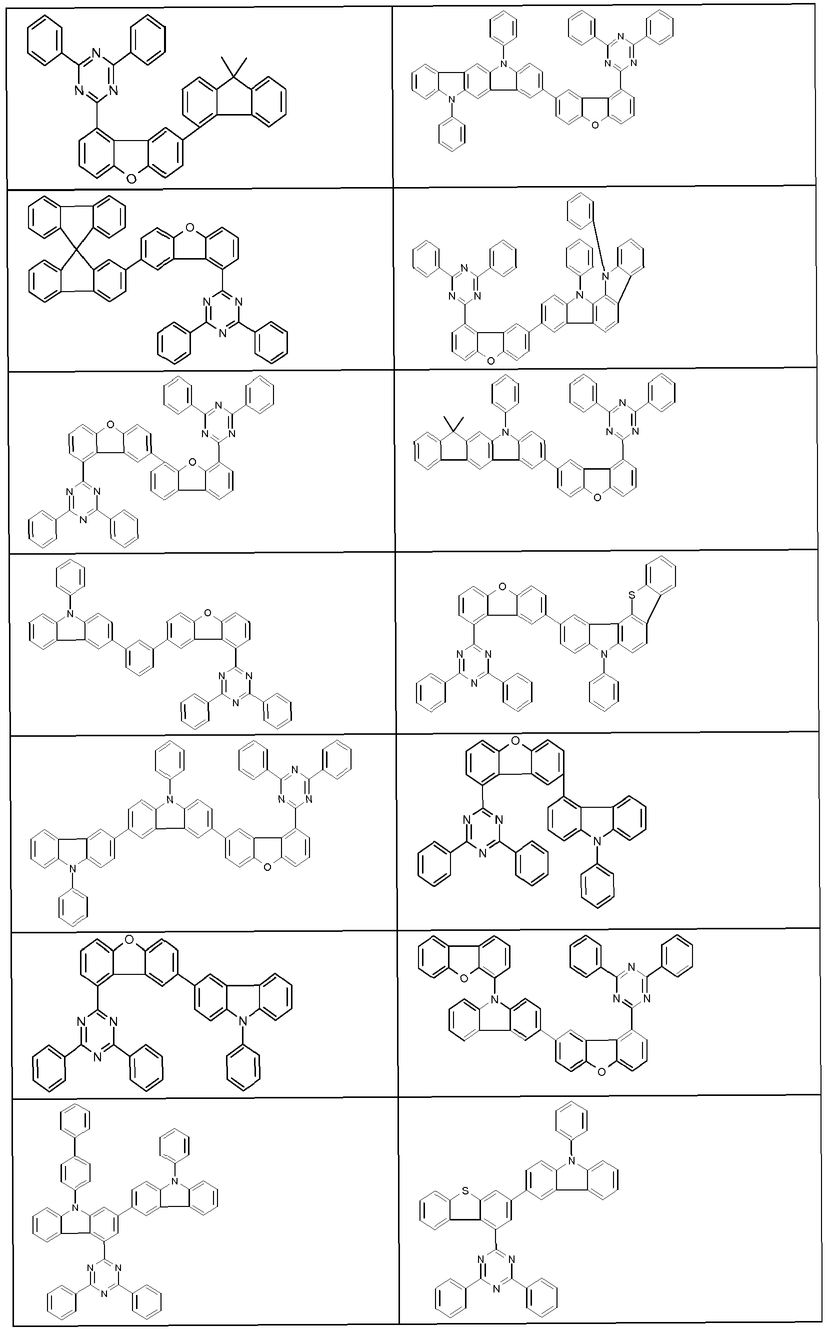

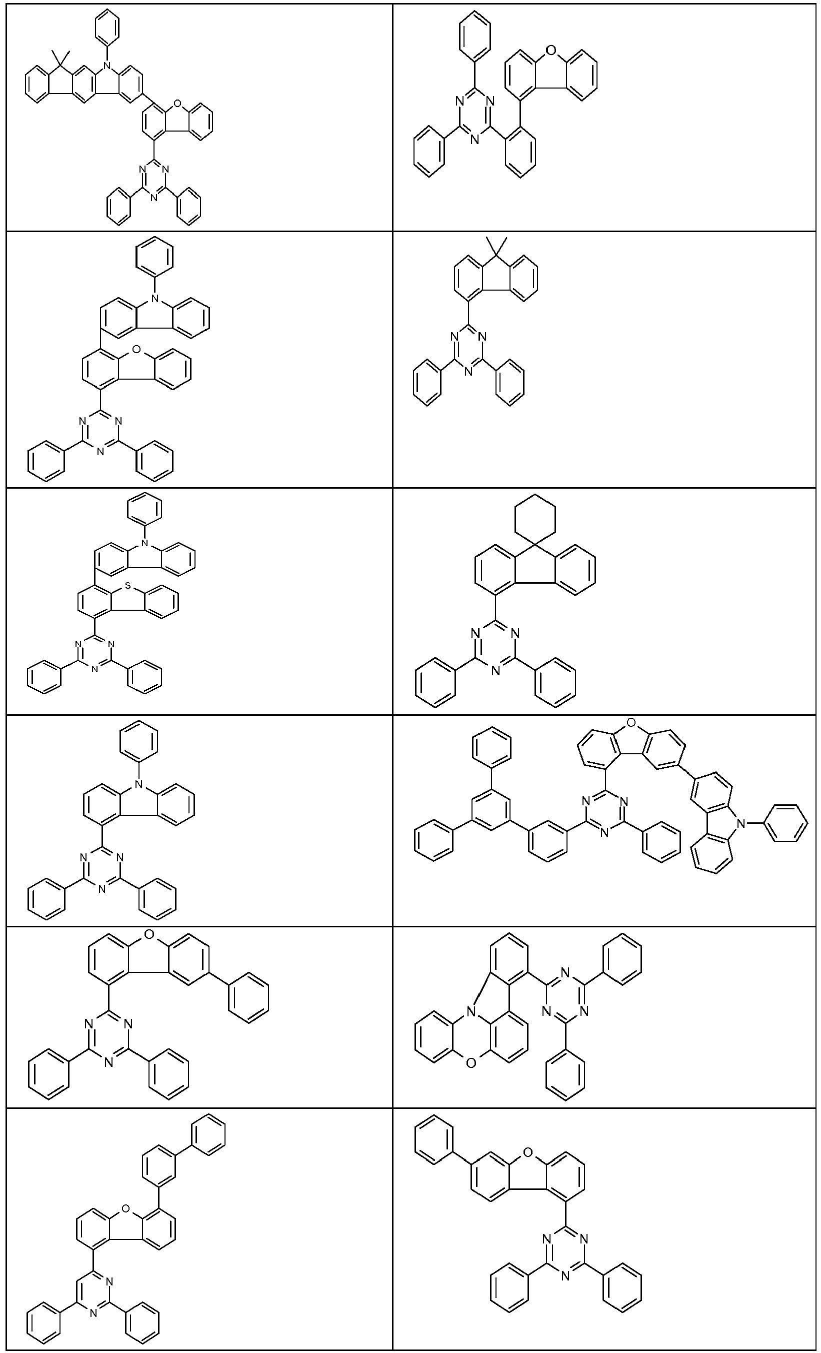

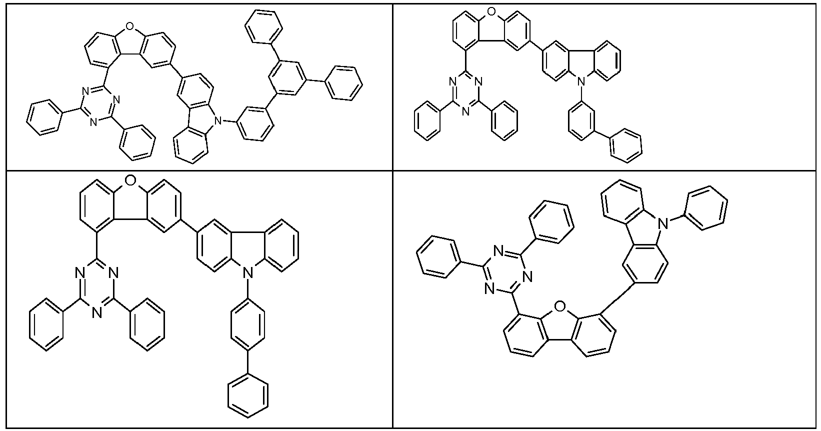

Beispiele für Lactame, welche als elektronentransportierende Matrixmaterialien eingesetzt werden können sind die folgenden Verbindungen:

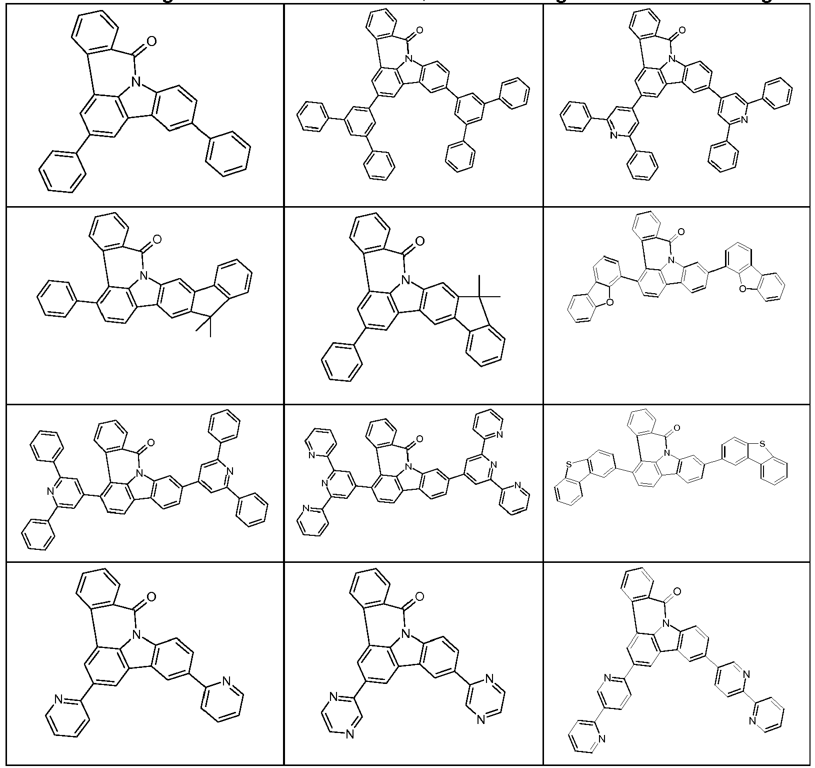

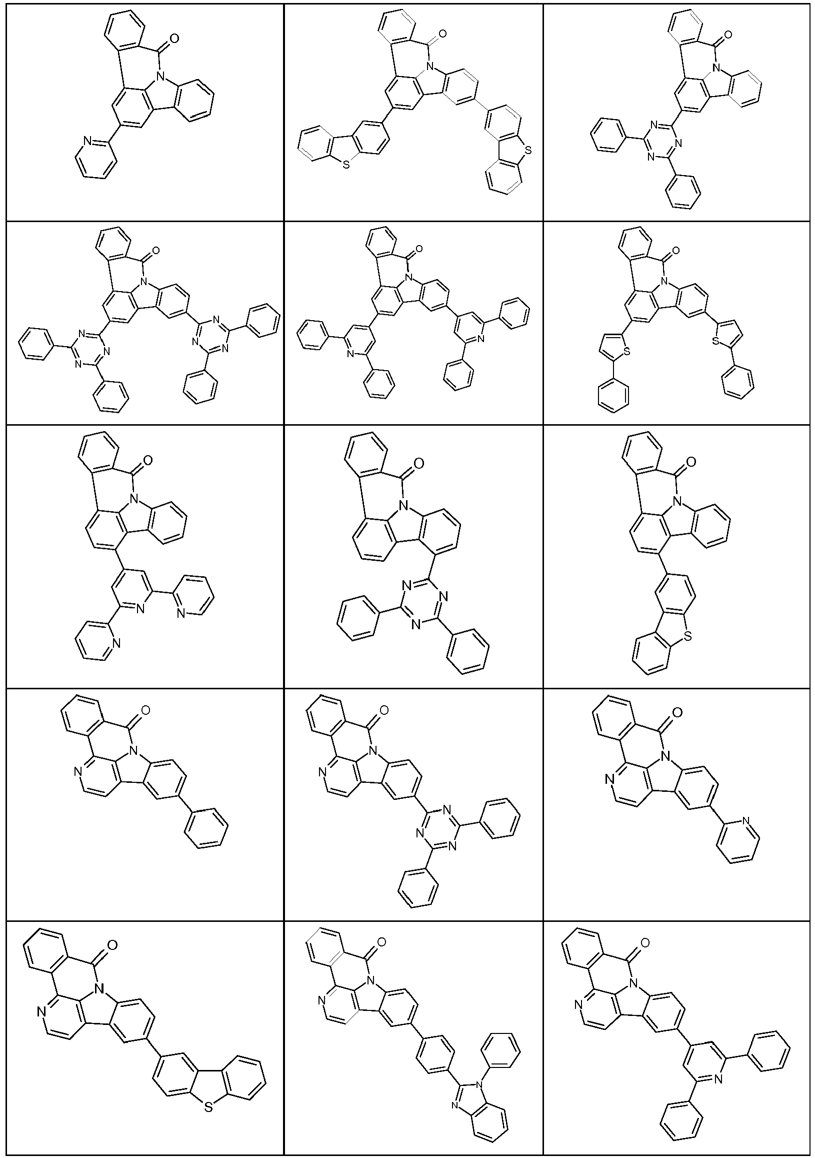

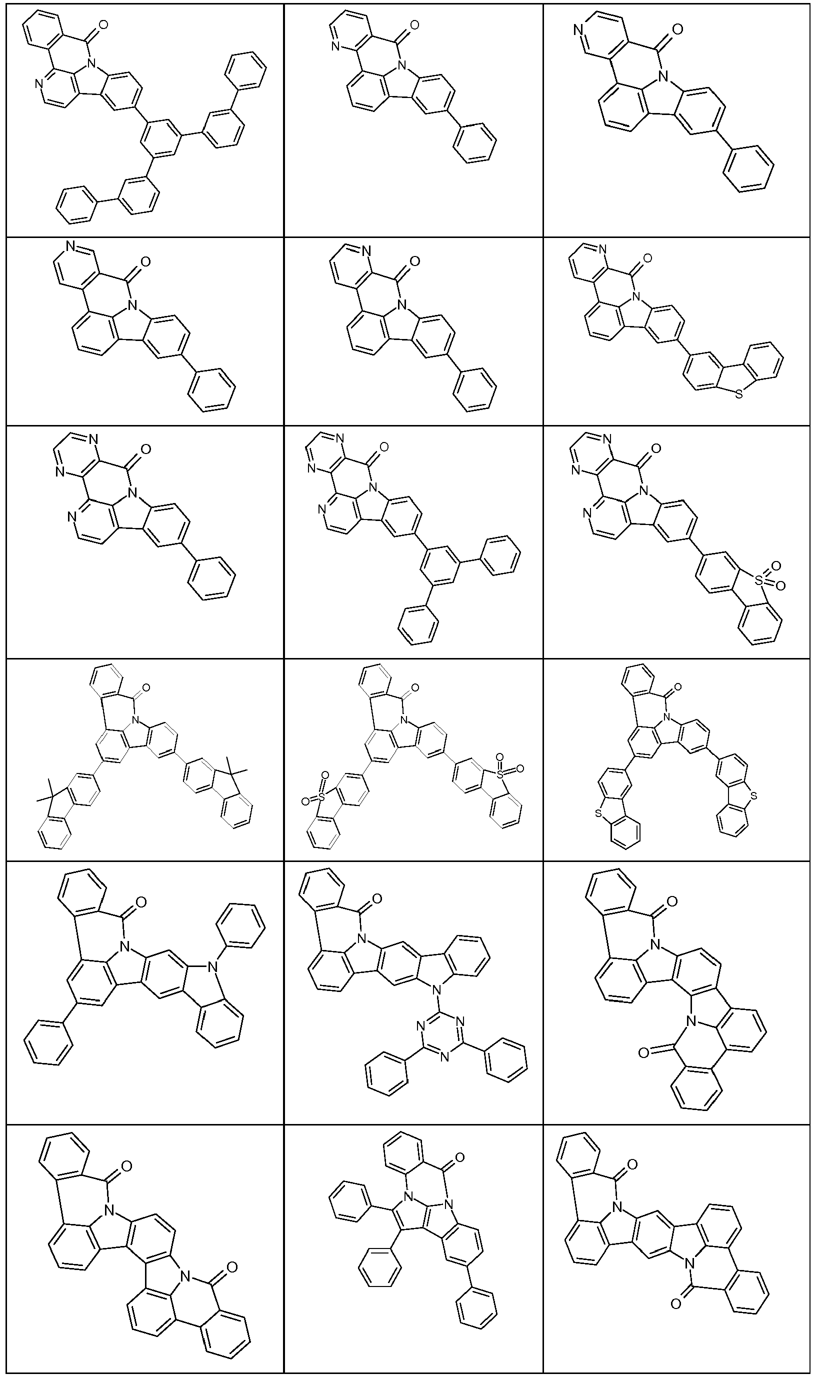

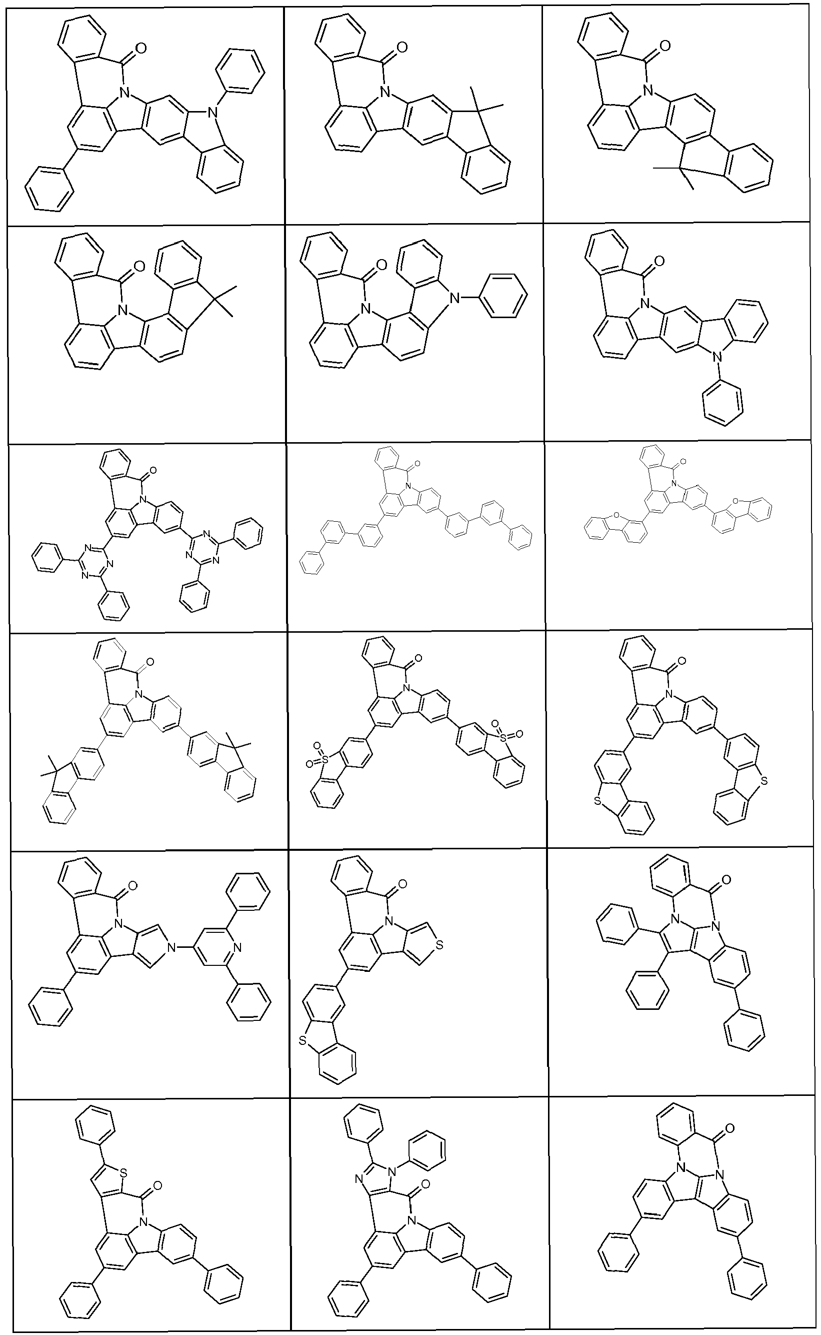

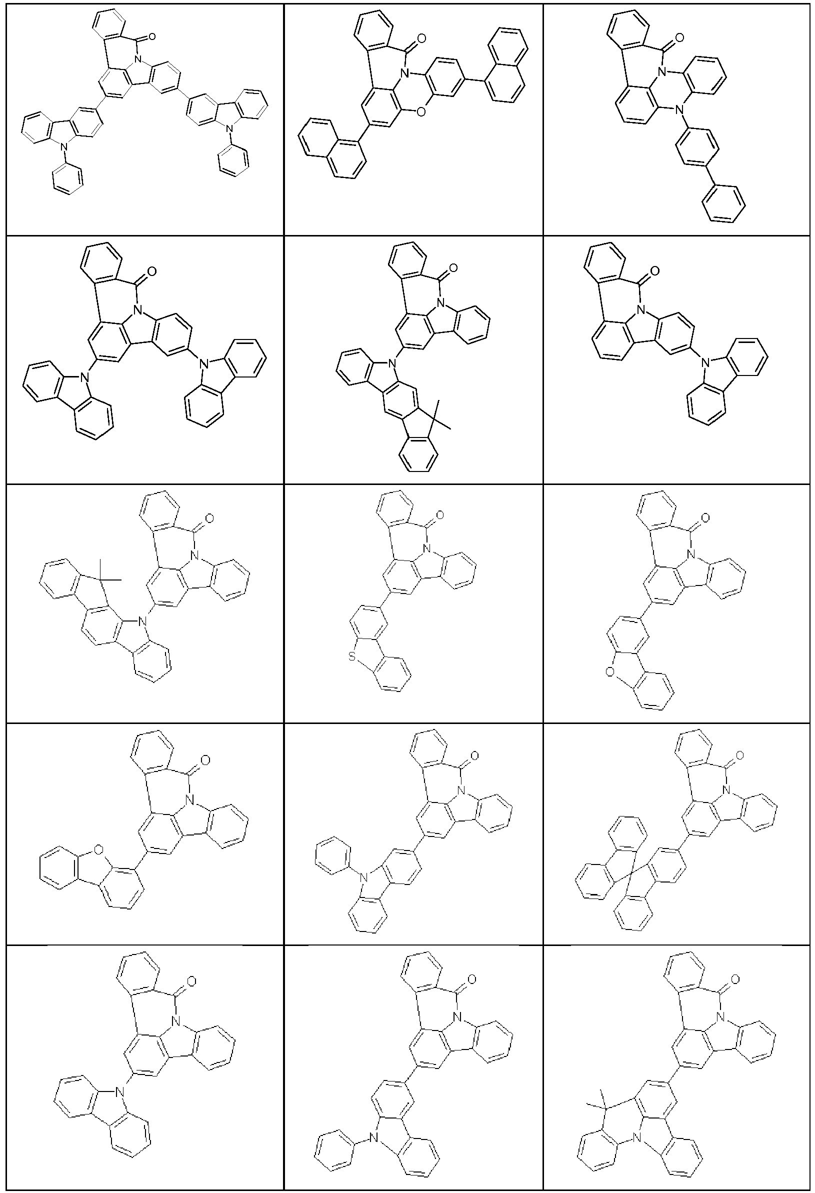

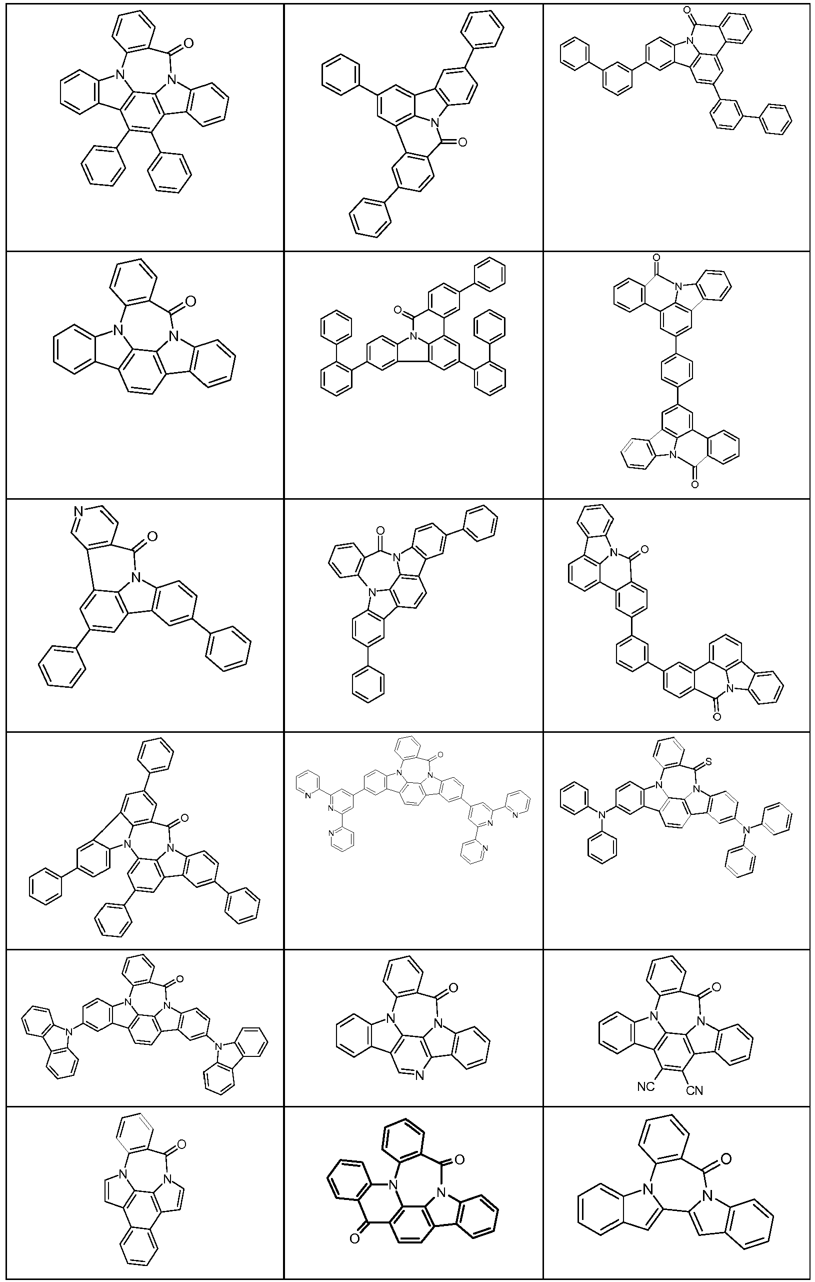

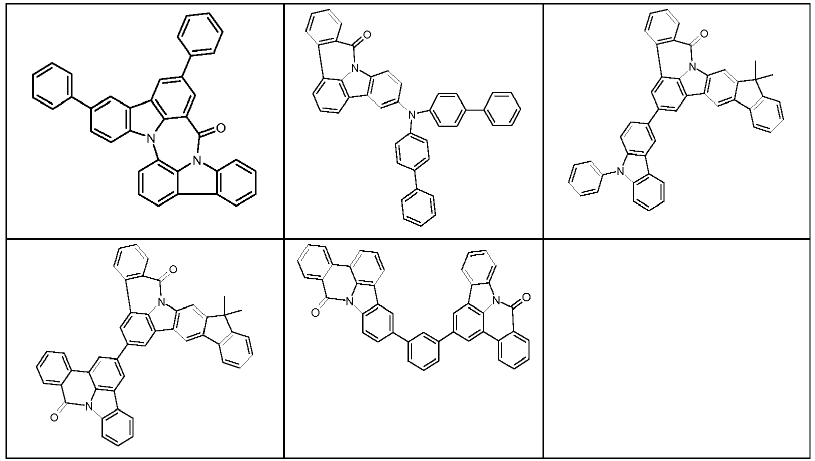

Beispiele für Ketone, welche als elektronentransportierende Matrixmaterialien eingesetzt werden können sind die folgenden Verbindungen:

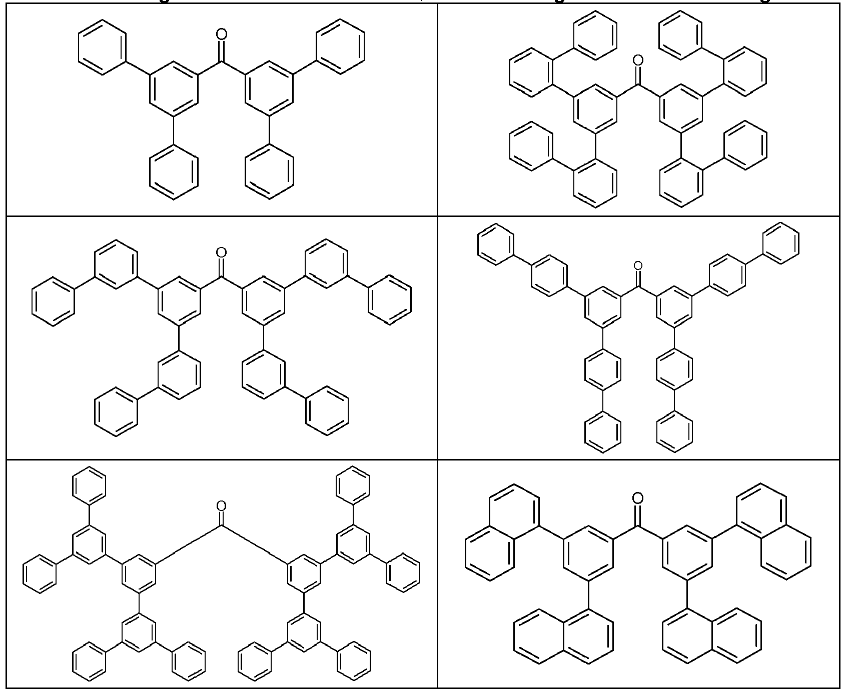

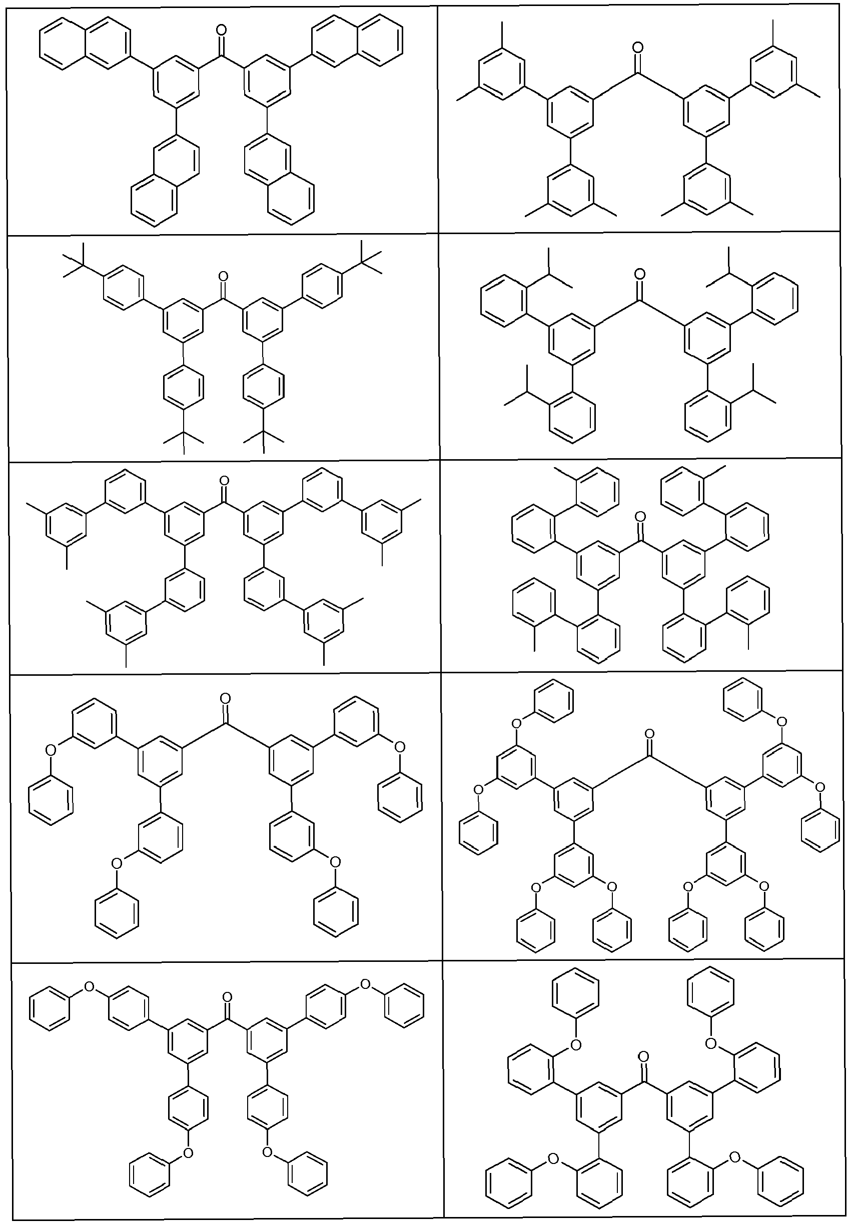

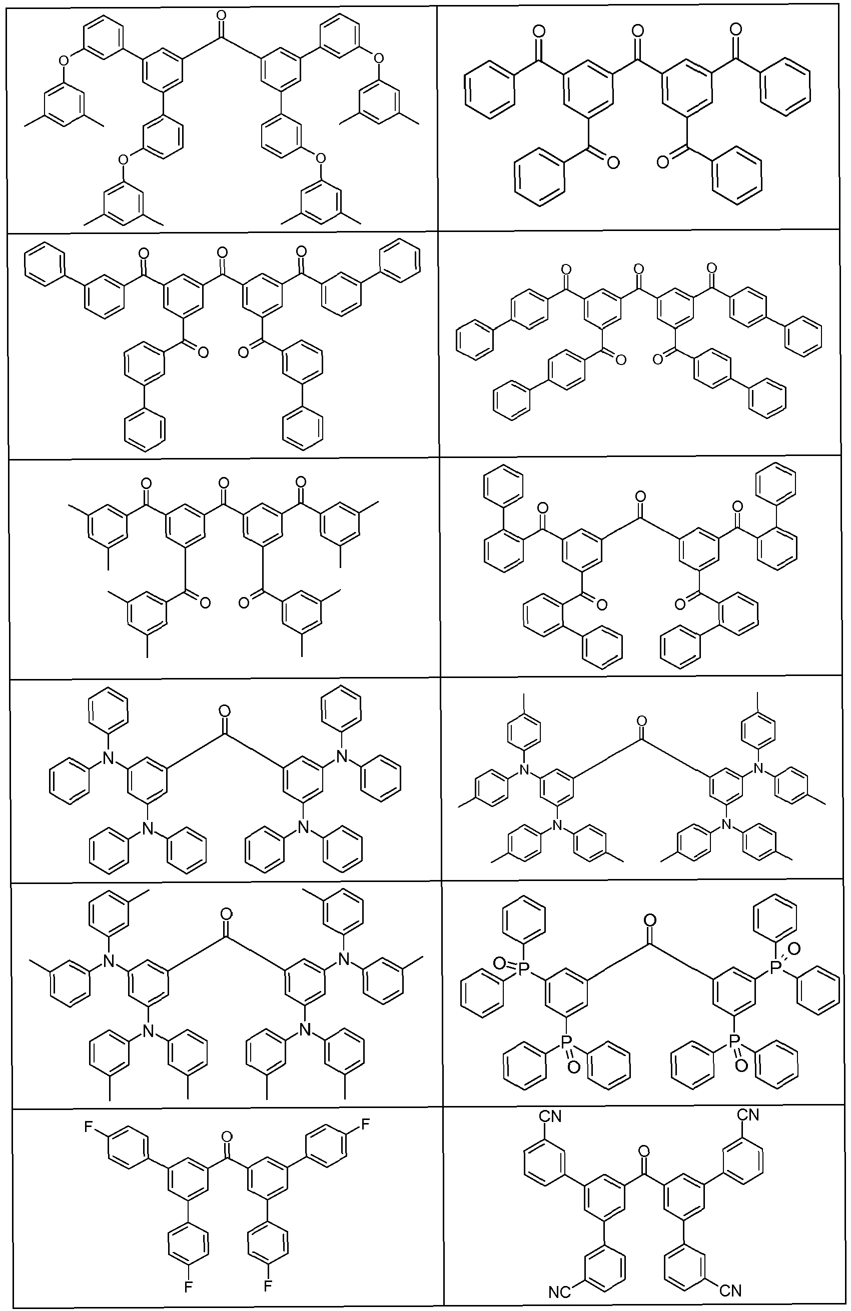

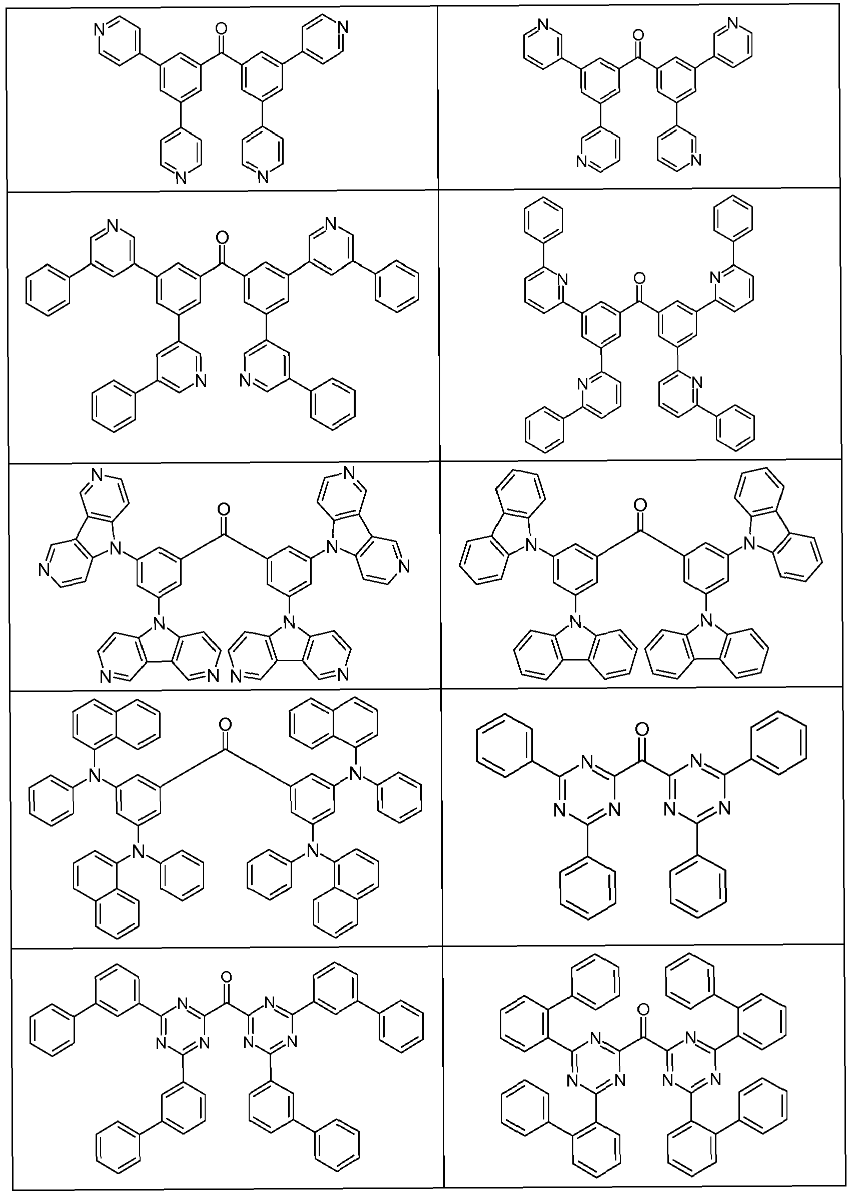

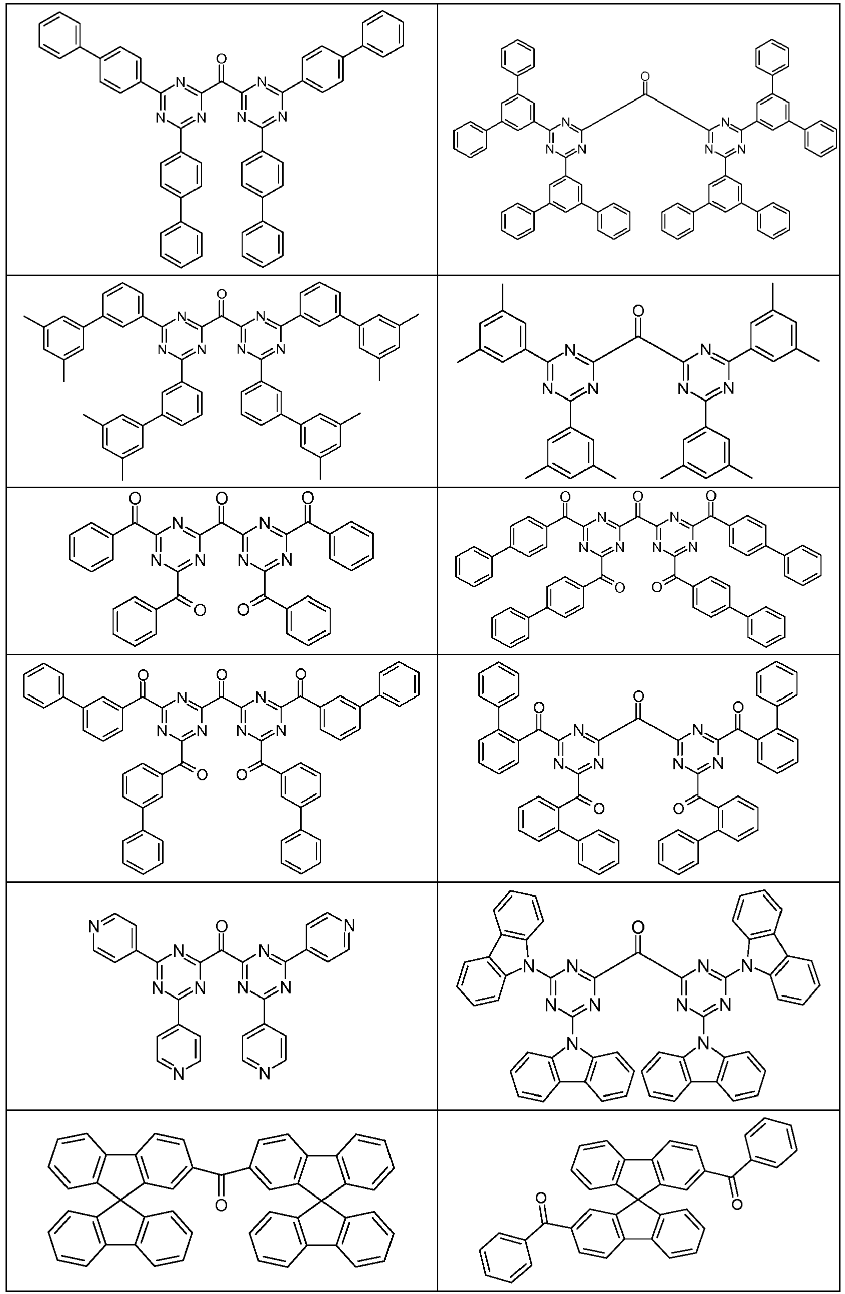

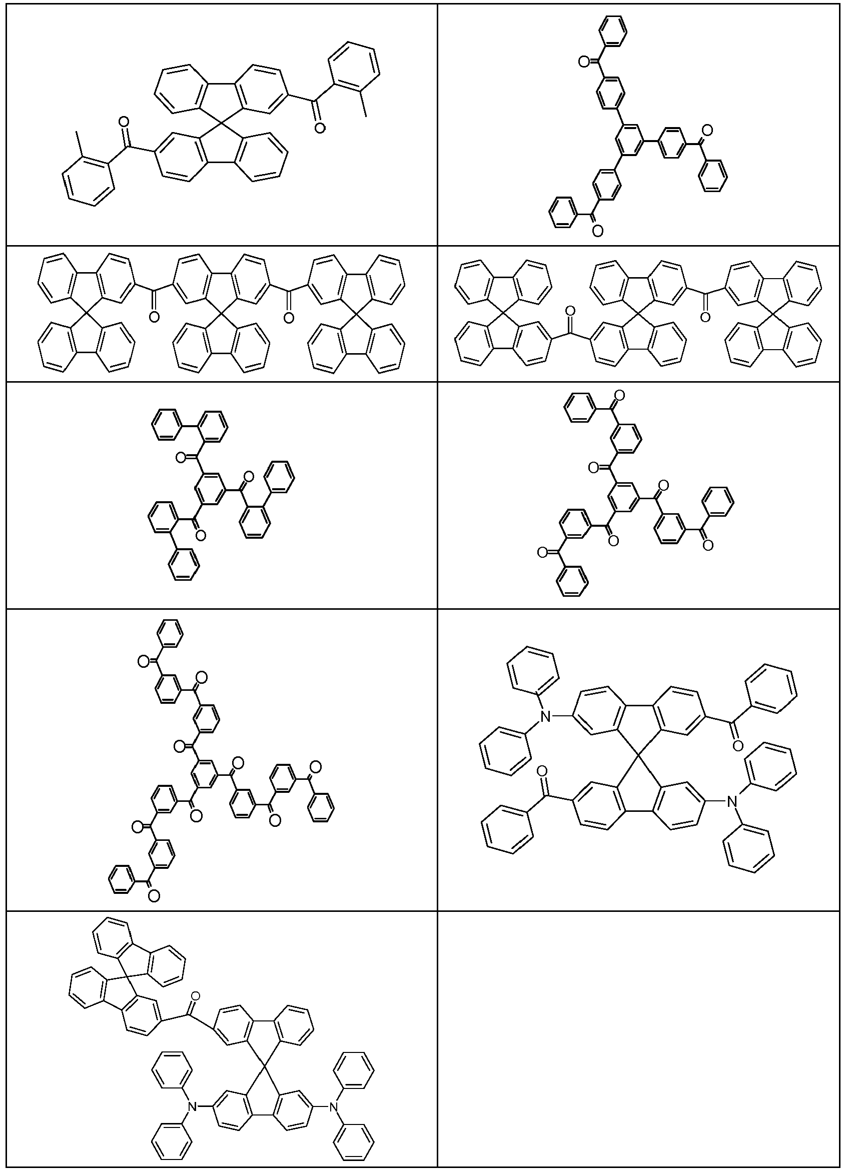

Beispiele für Metallkomplexe, welche als elektronentransportierende Matrixmaterialien eingesetzt werden können, sind die folgenden Verbindungen:

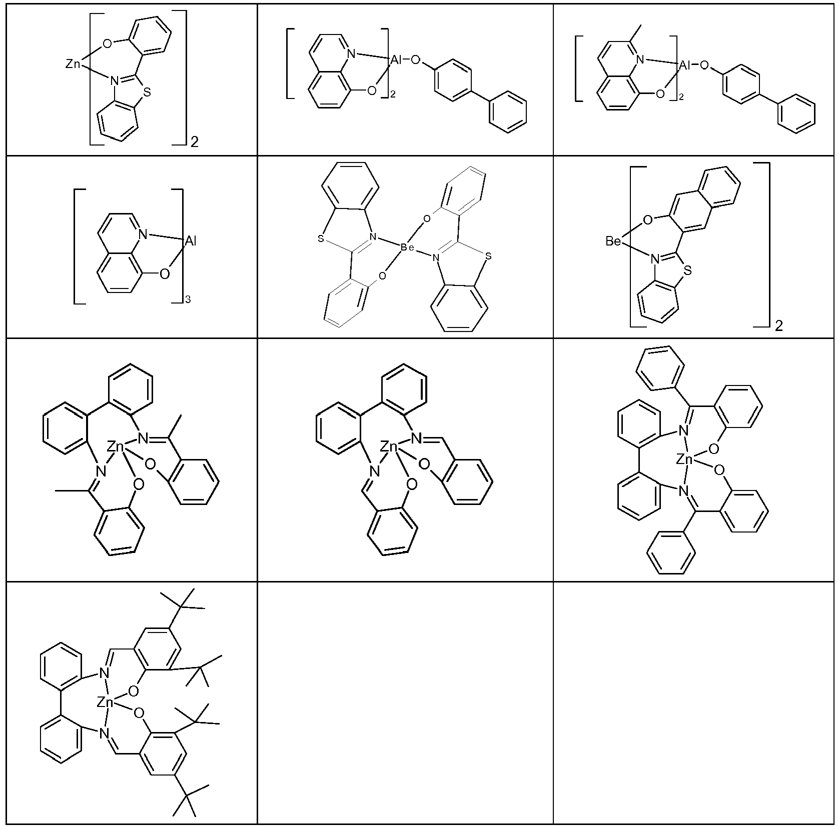

Beispiele für Phosphinoxide, welche als elektronentransportierende Matrixmaterialien eingesetzt werden können, sind die folgenden Verbindungen:

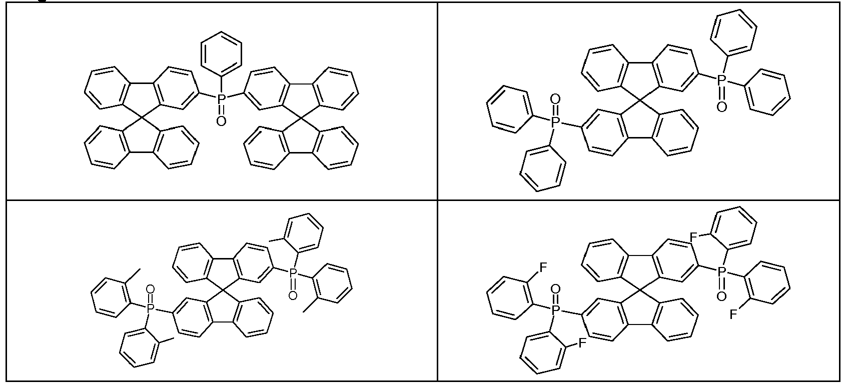

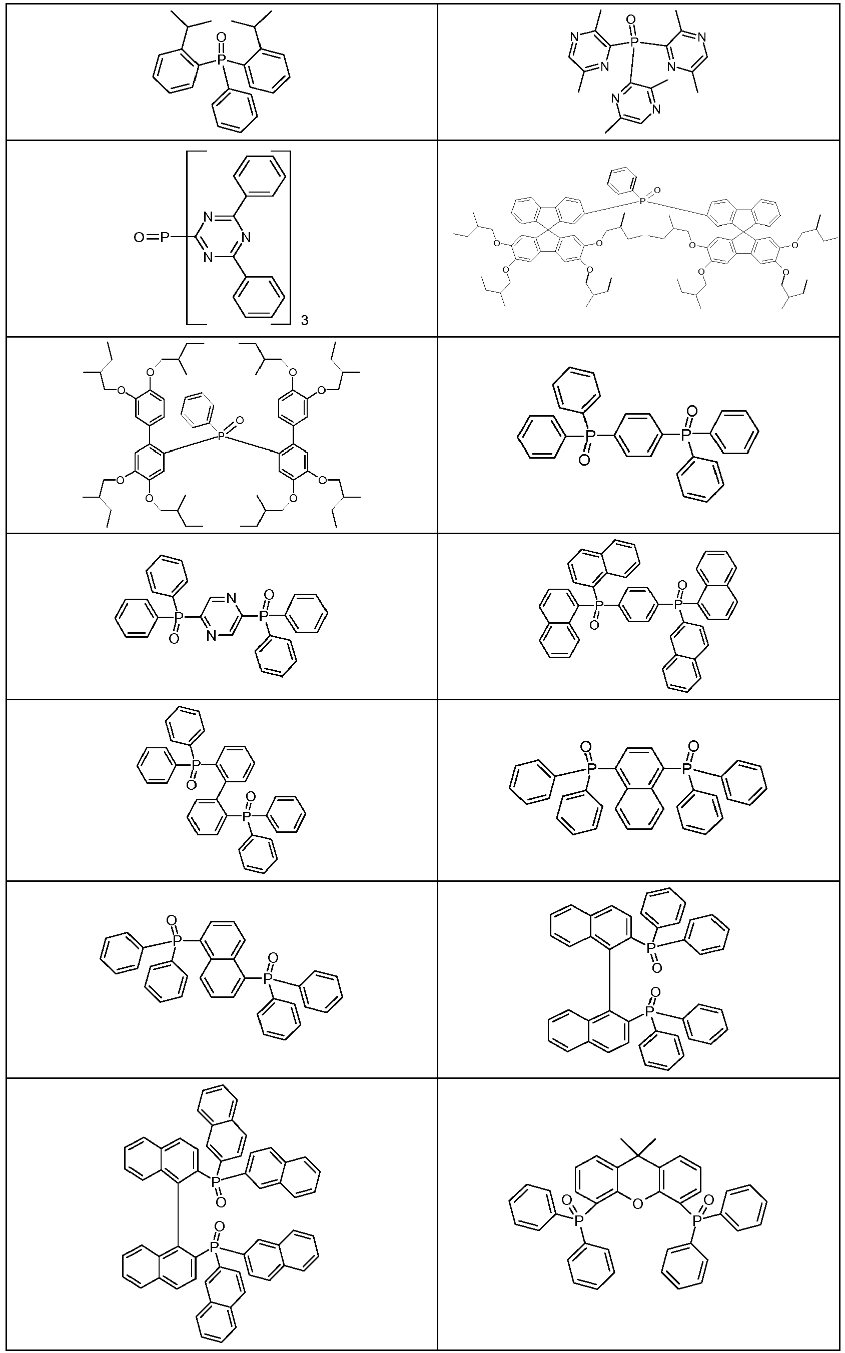

Beispiele für Indolo- und Indenocarbazolderivate im weitesten Sinn, welche je nach Substitutionsmuster als loch- oder elektronentransportierende Matrixmaterialien eingesetzt werden können, sind die folgenden Verbindungen:

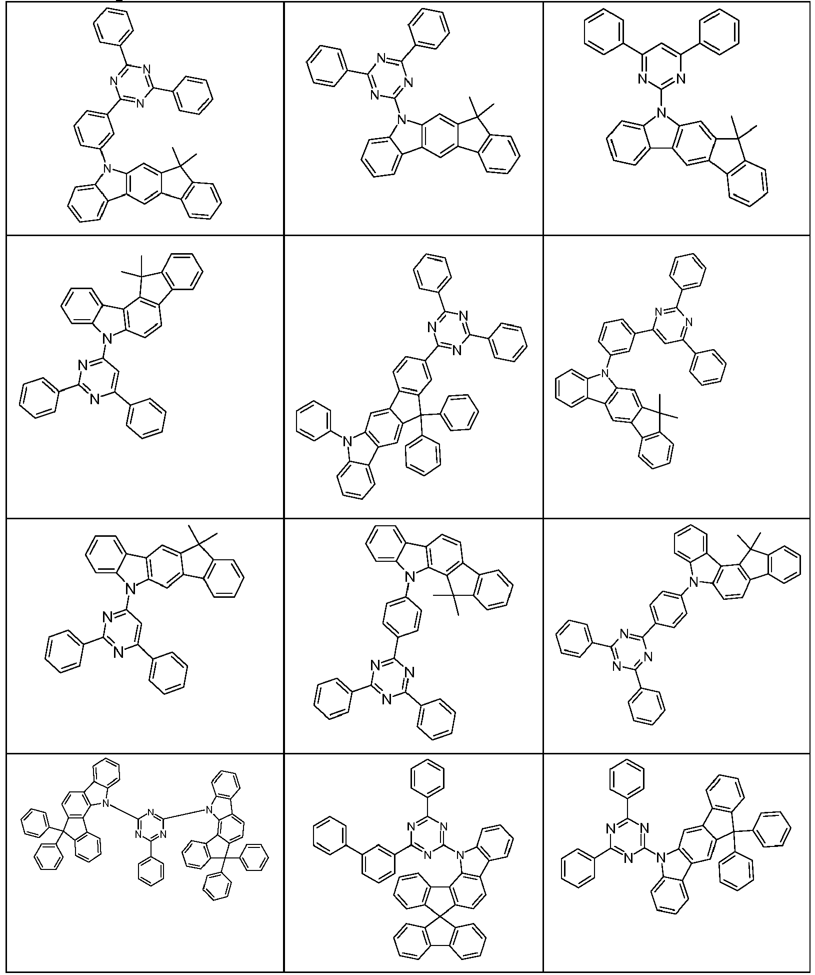

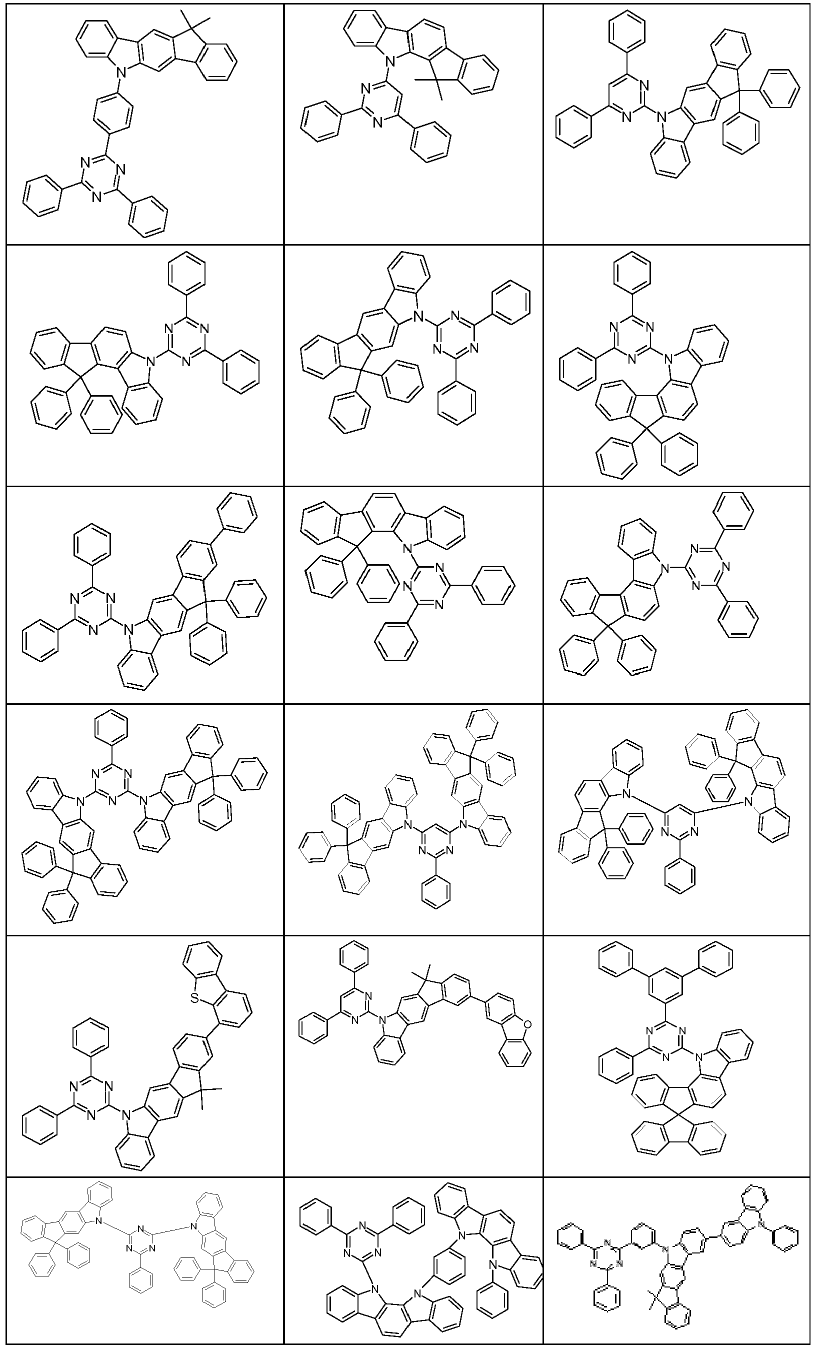

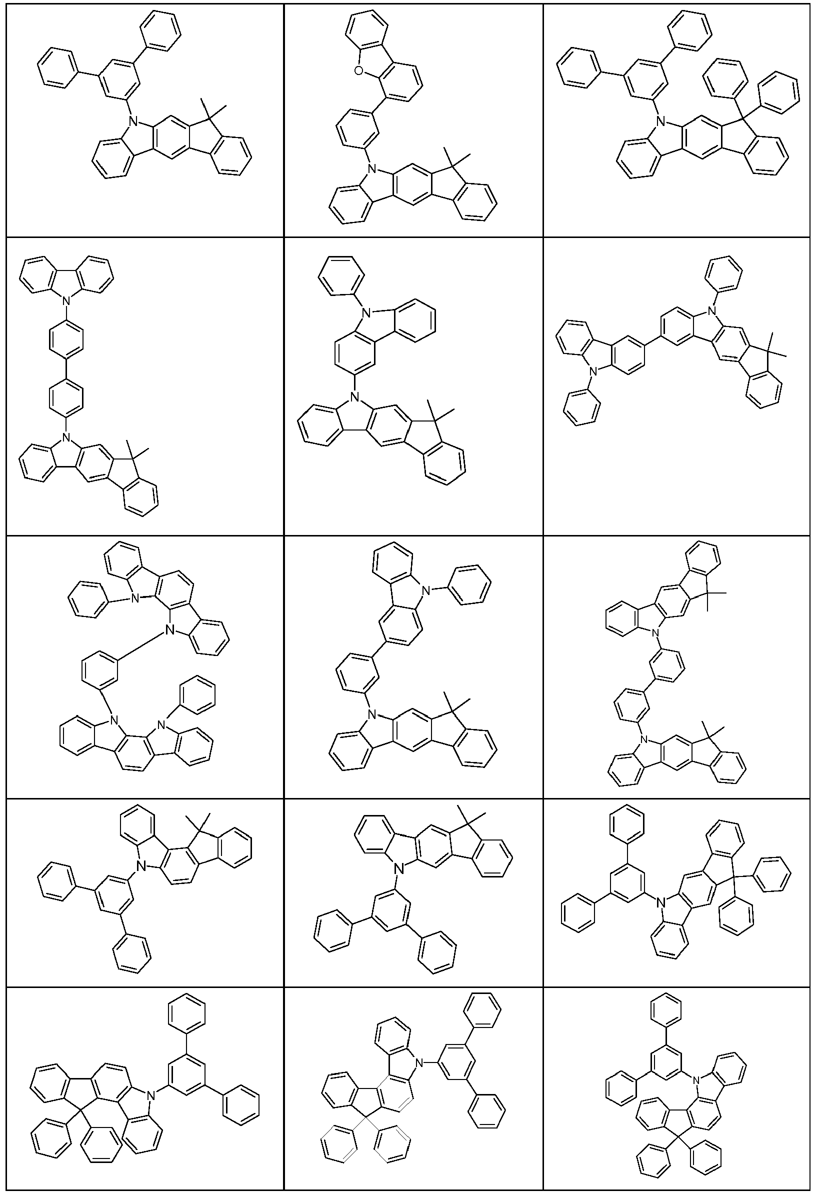

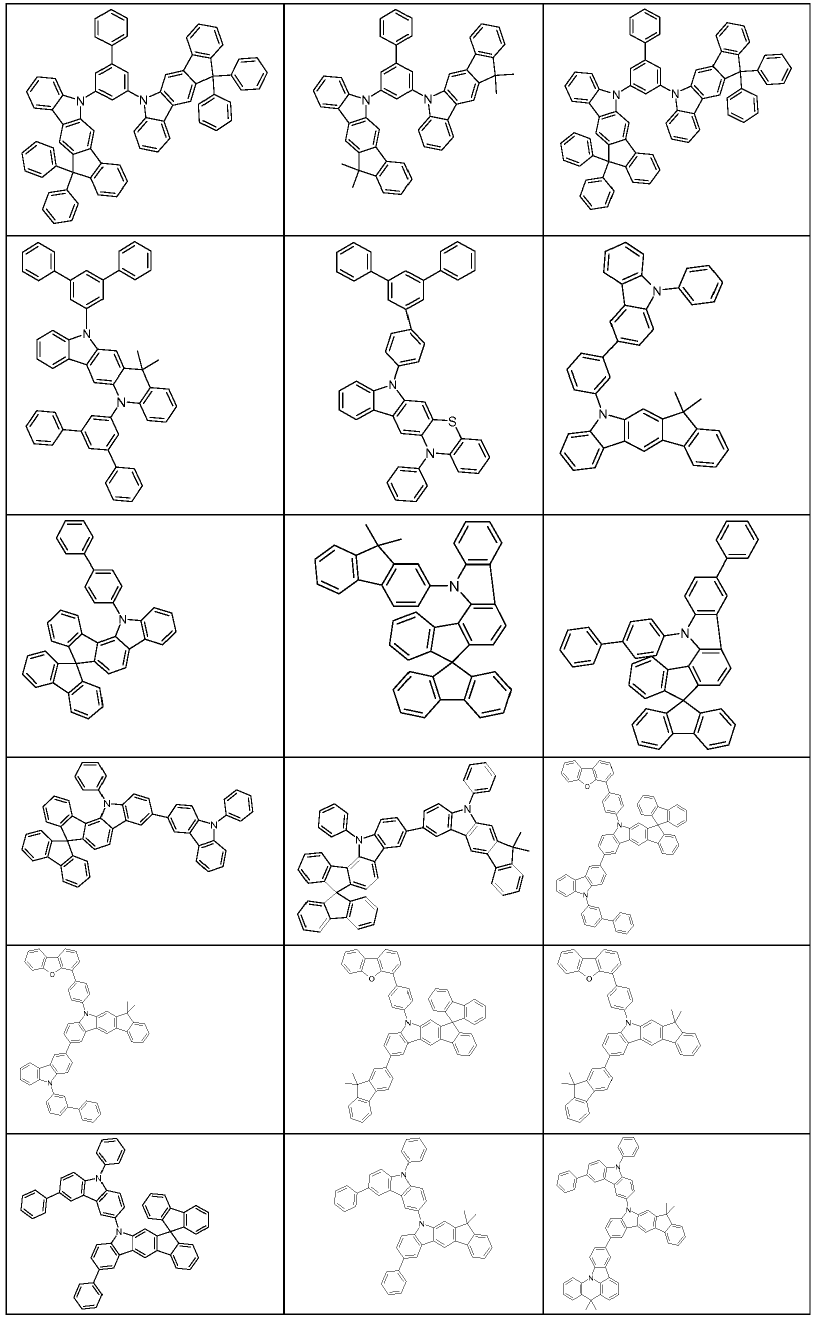

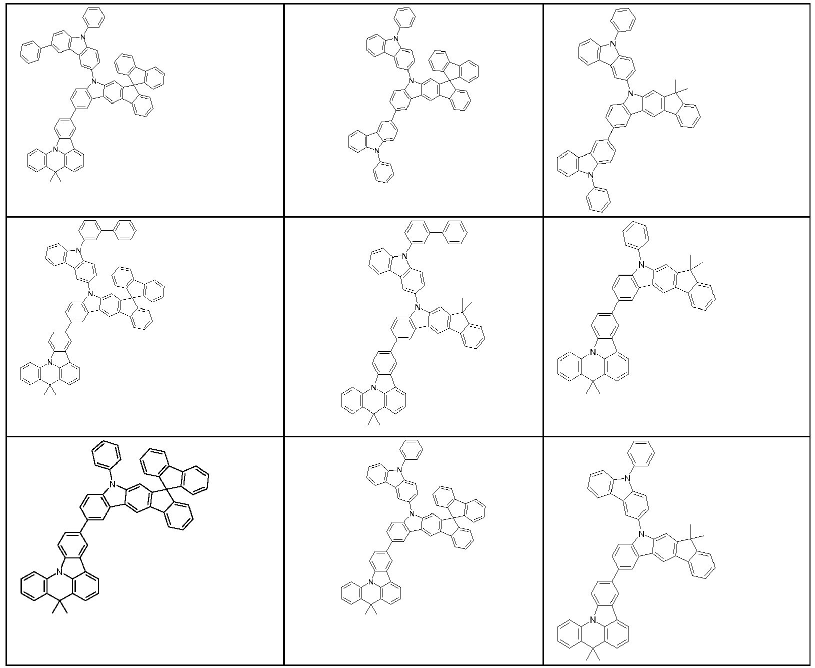

Beispiele für Carbazolderivate, welche je nach Substitutionsmuster als loch- oder elektronentransportierende Matrixmaterialien eingesetzt werden können, sind die folgenden Verbindungen:

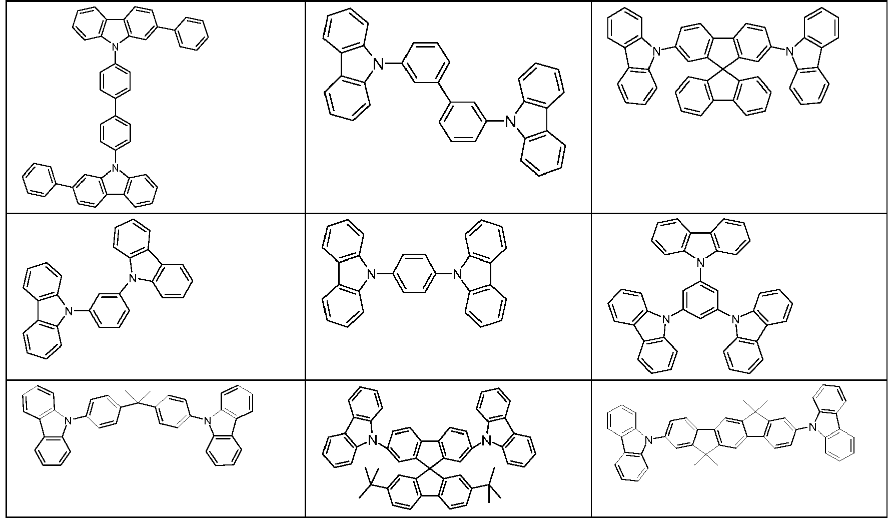

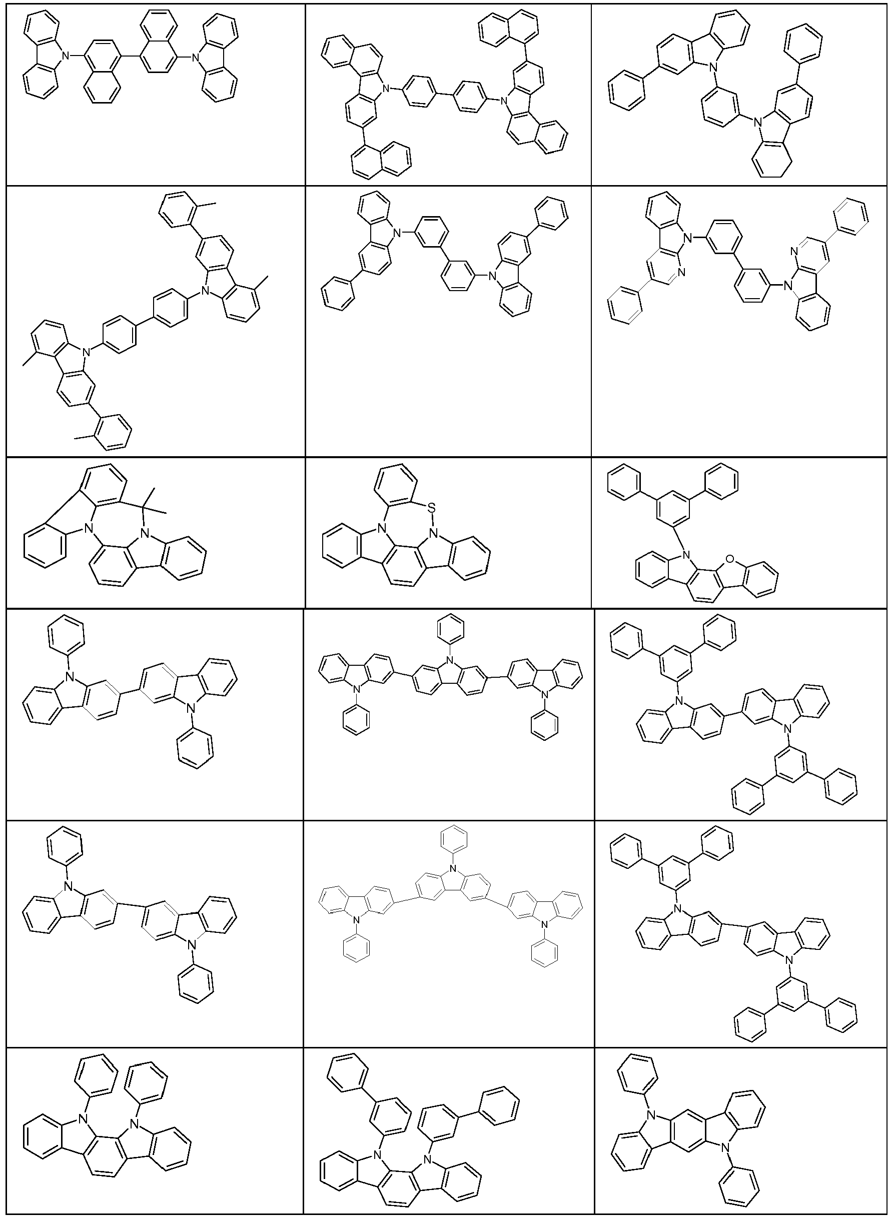

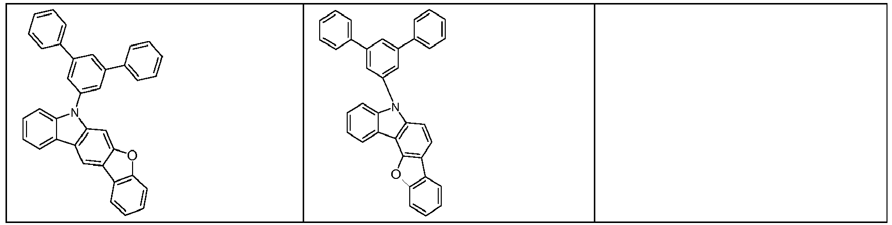

Beispiele für verbrückte Carbazolderivate, welche als lochtransportierende Matrixmaterialien eingesetzt werden können, sind die folgenden Verbindungen:

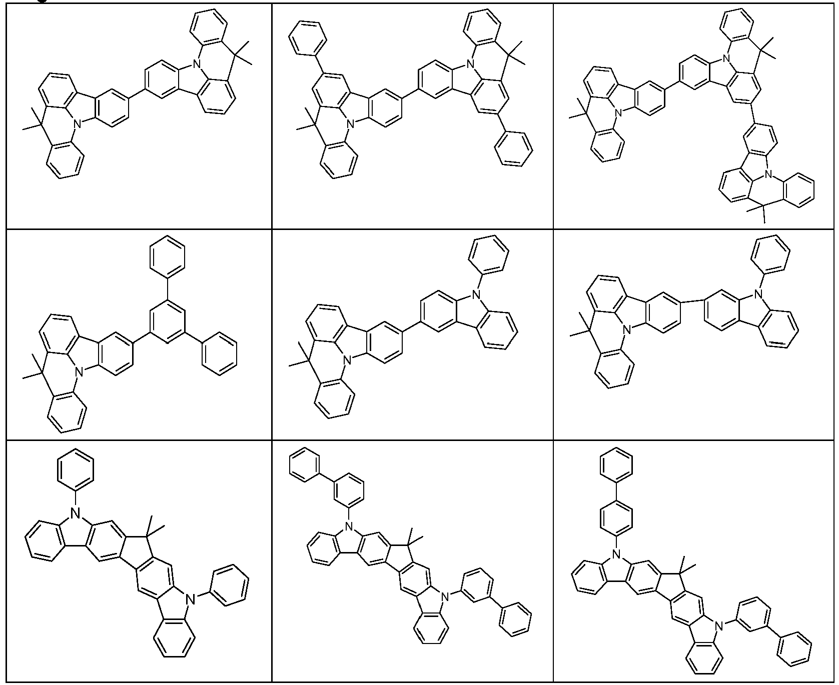

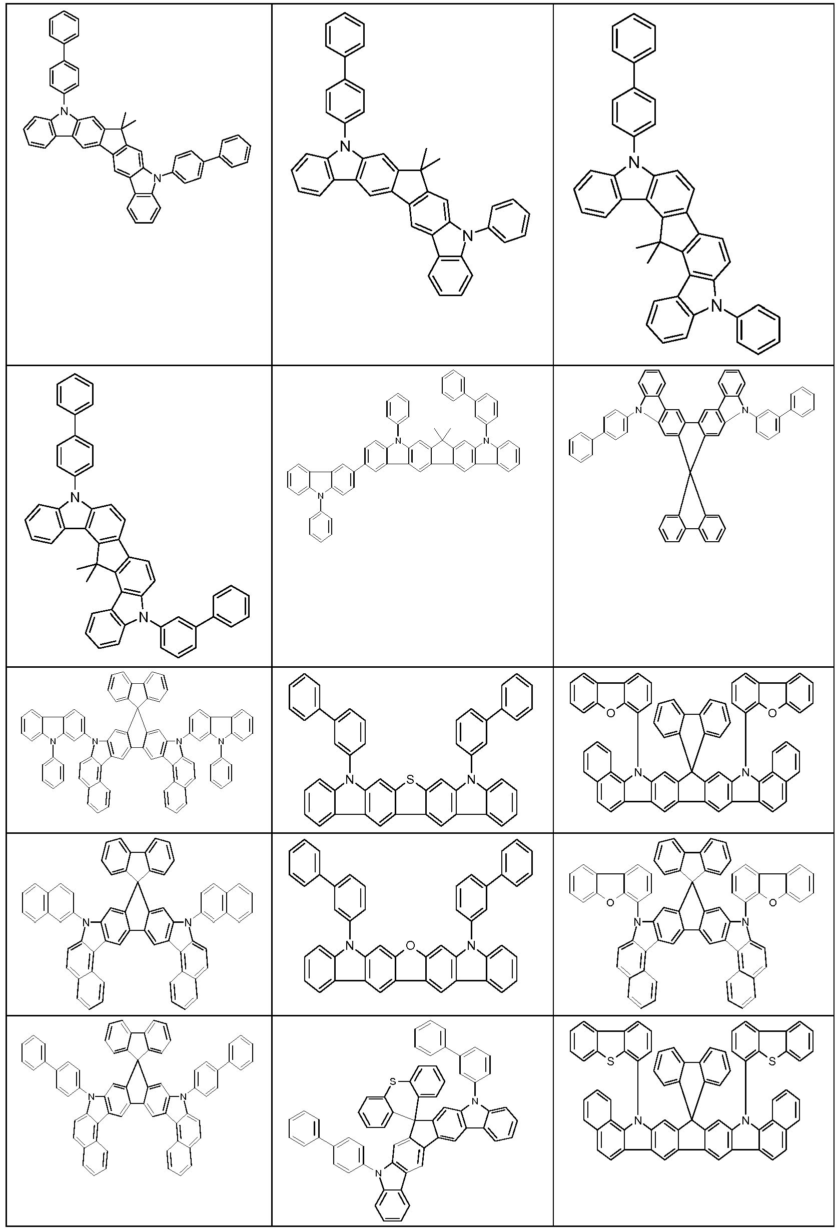

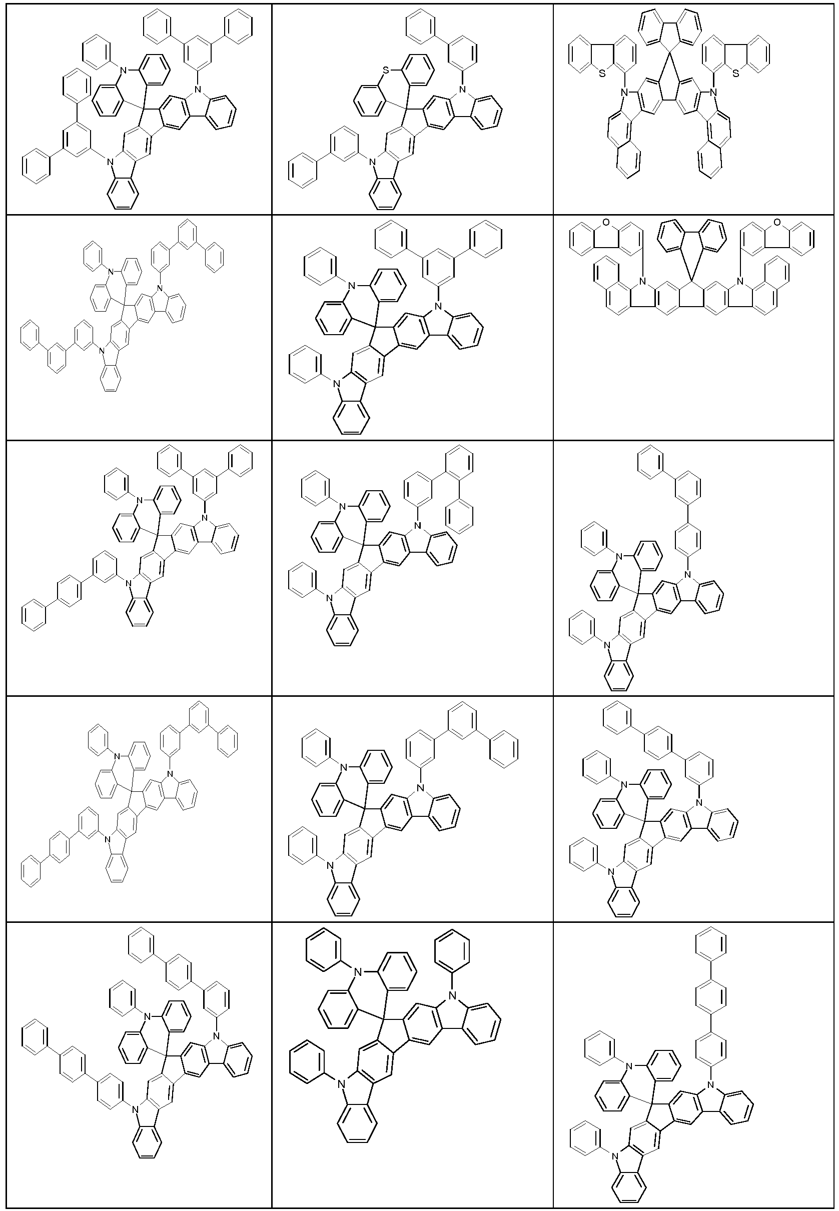

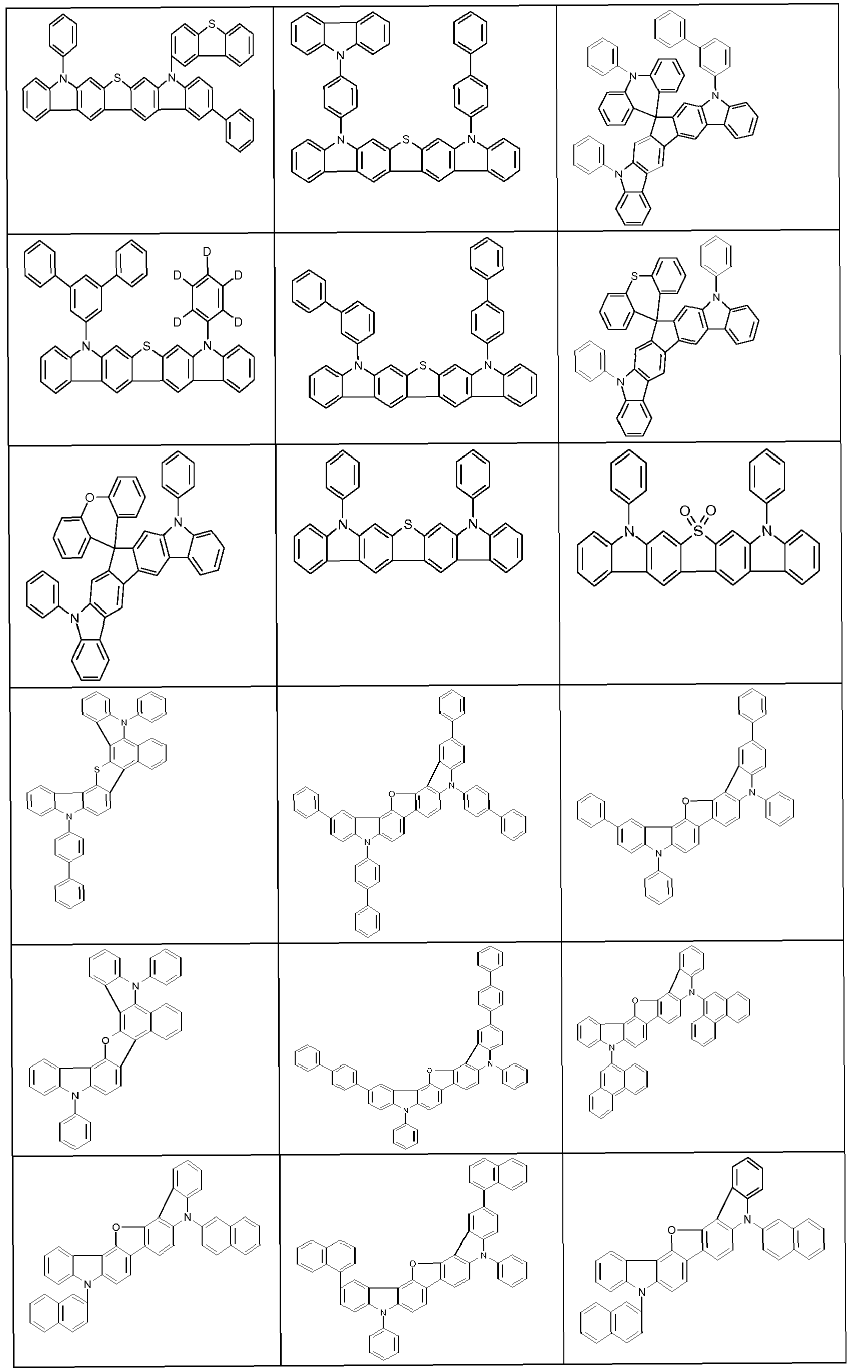

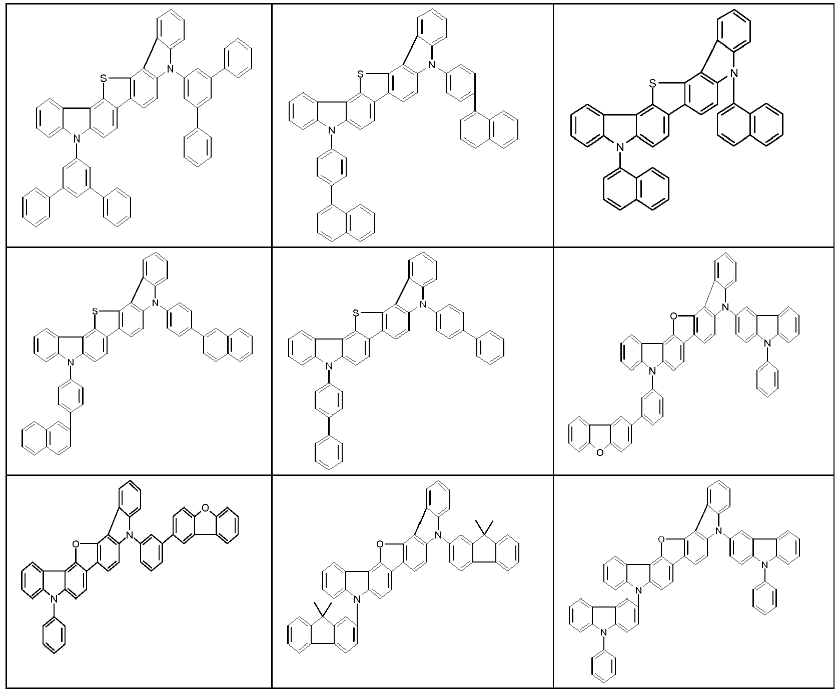

Beispiele für Biscarbazole, welche als lochtransportierende Matrixmaterialien eingesetzt werden können, sind die folgenden Verbindungen:

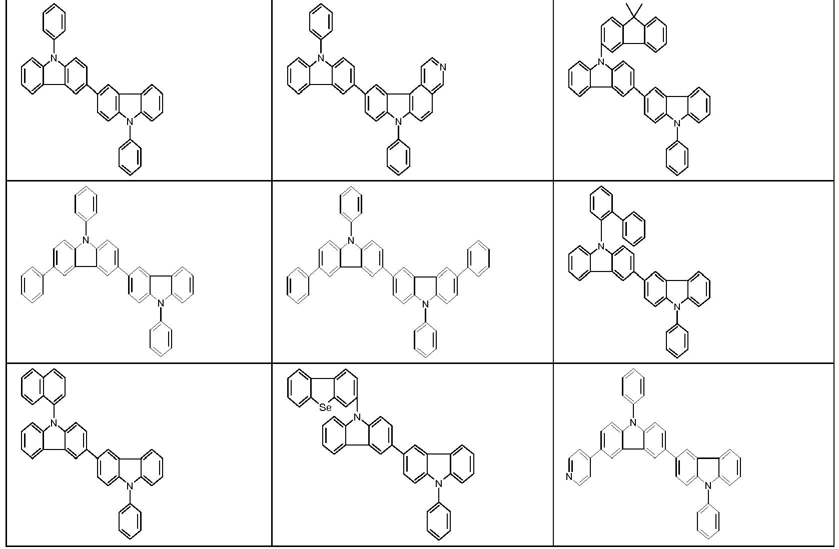

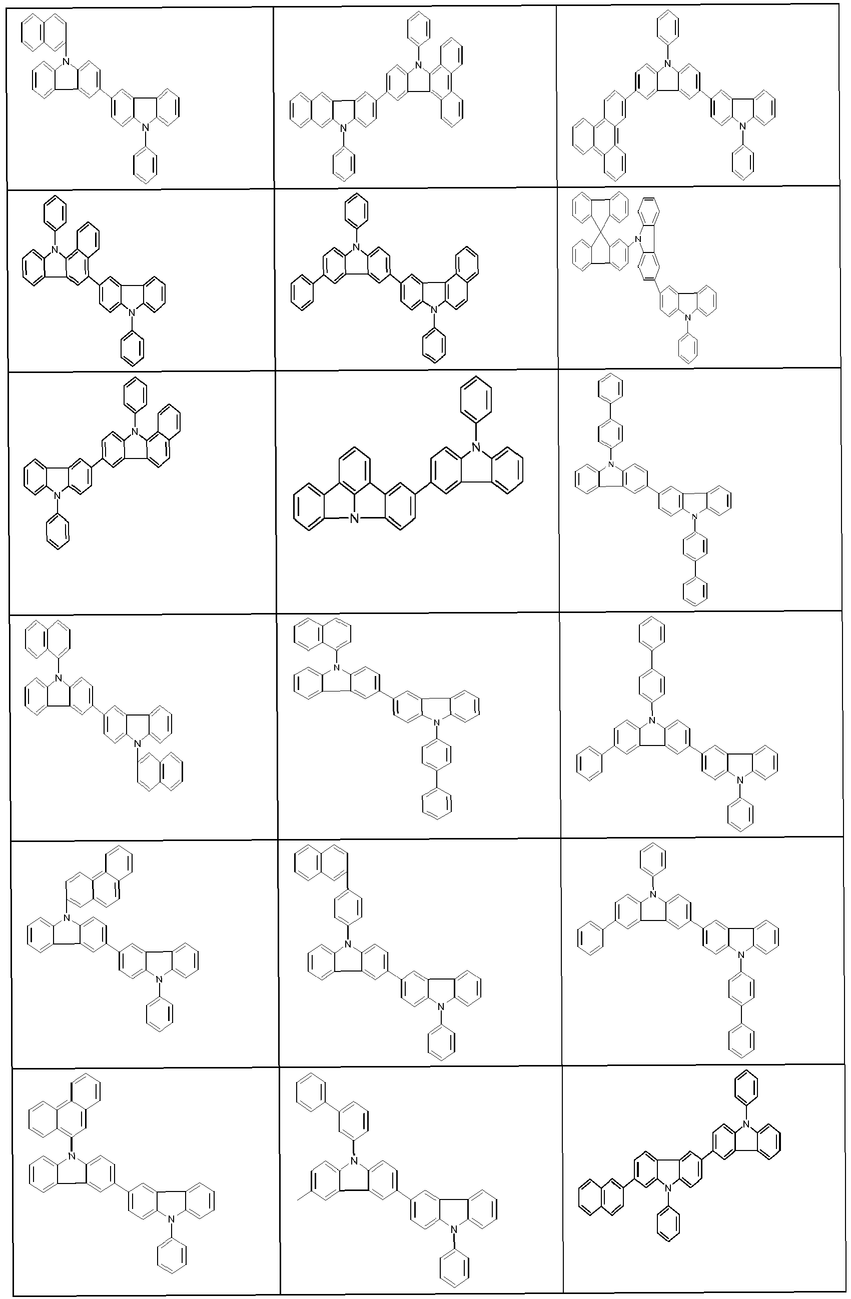

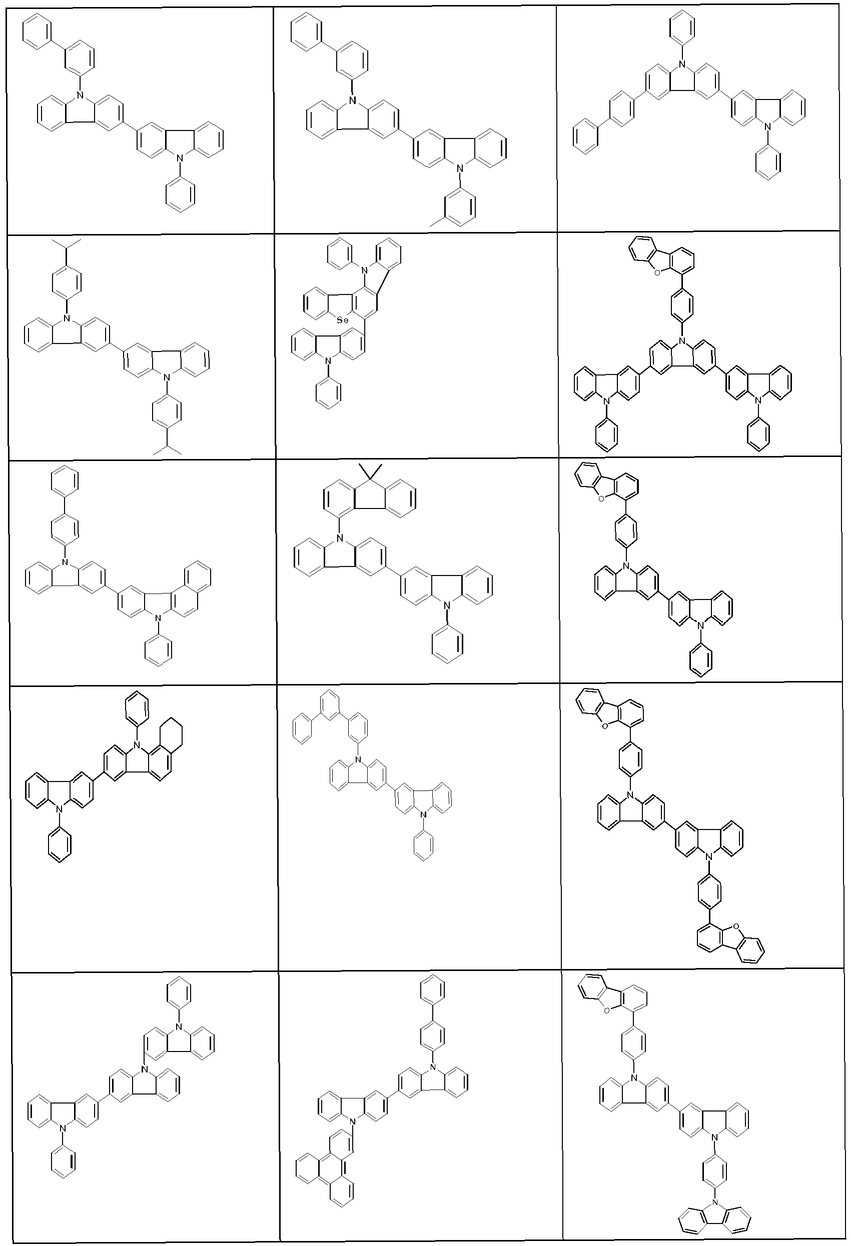

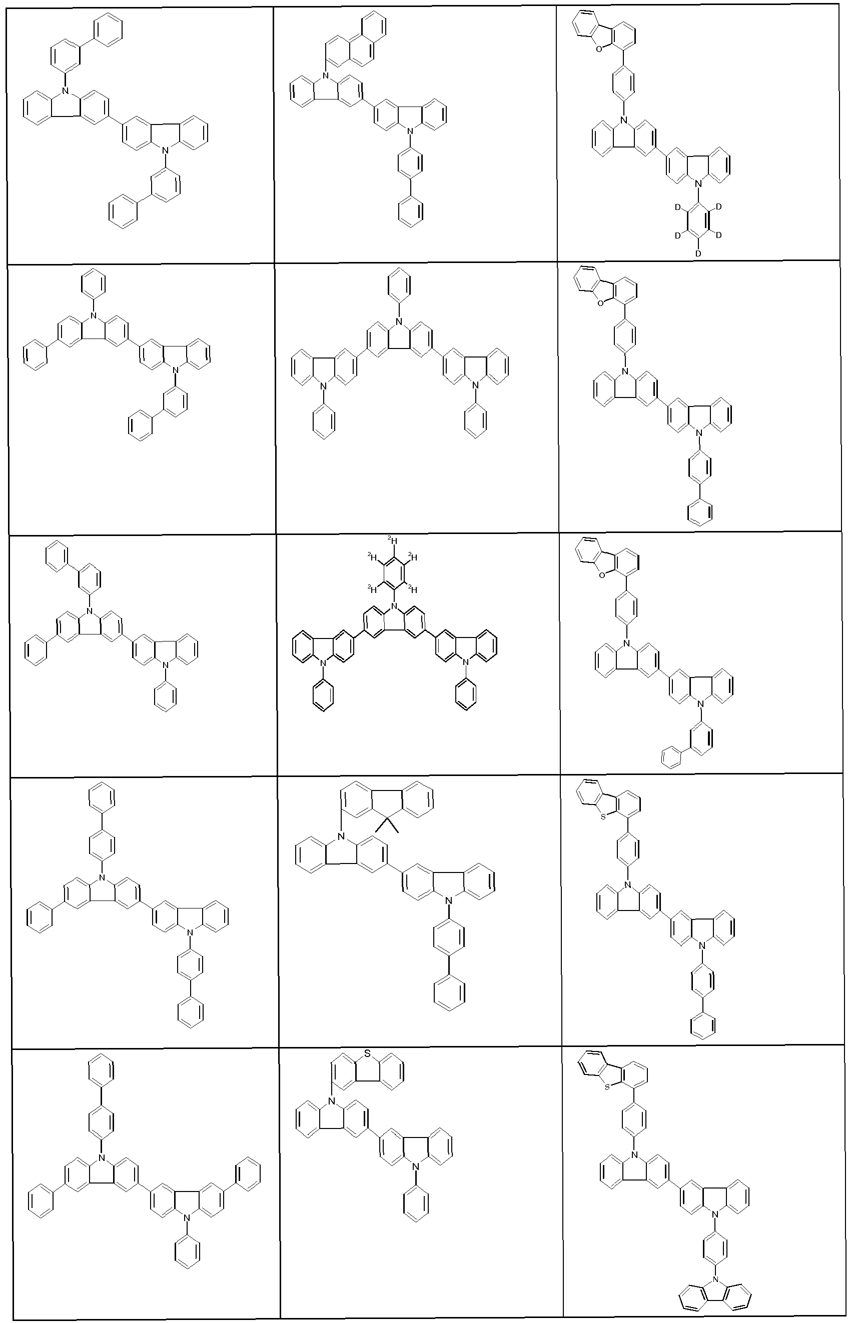

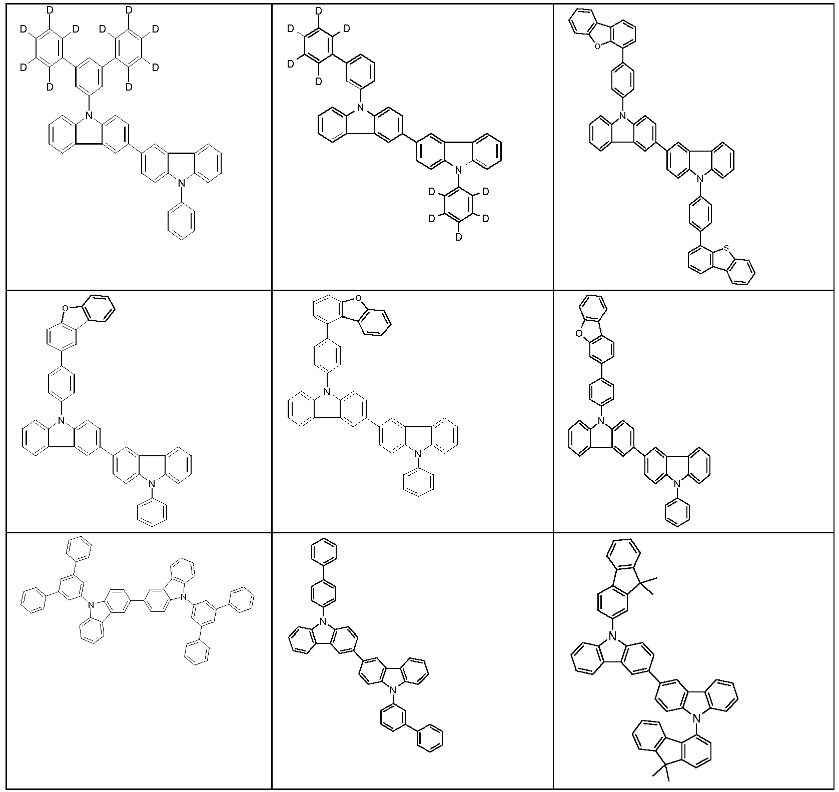

Beispiele für Amine, welche als lochtransportierende Matrixmaterialien eingesetzt werden können, sind die folgenden Verbindungen:

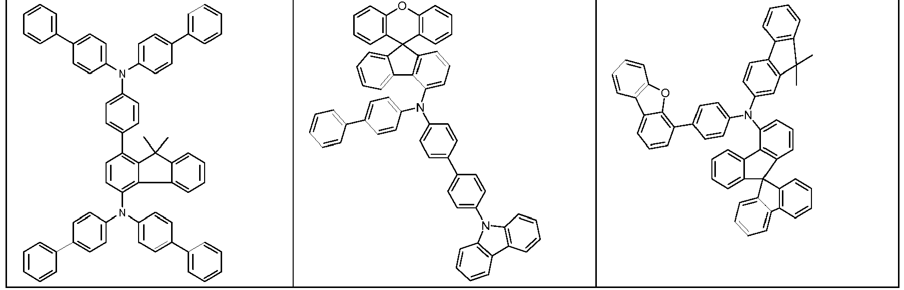

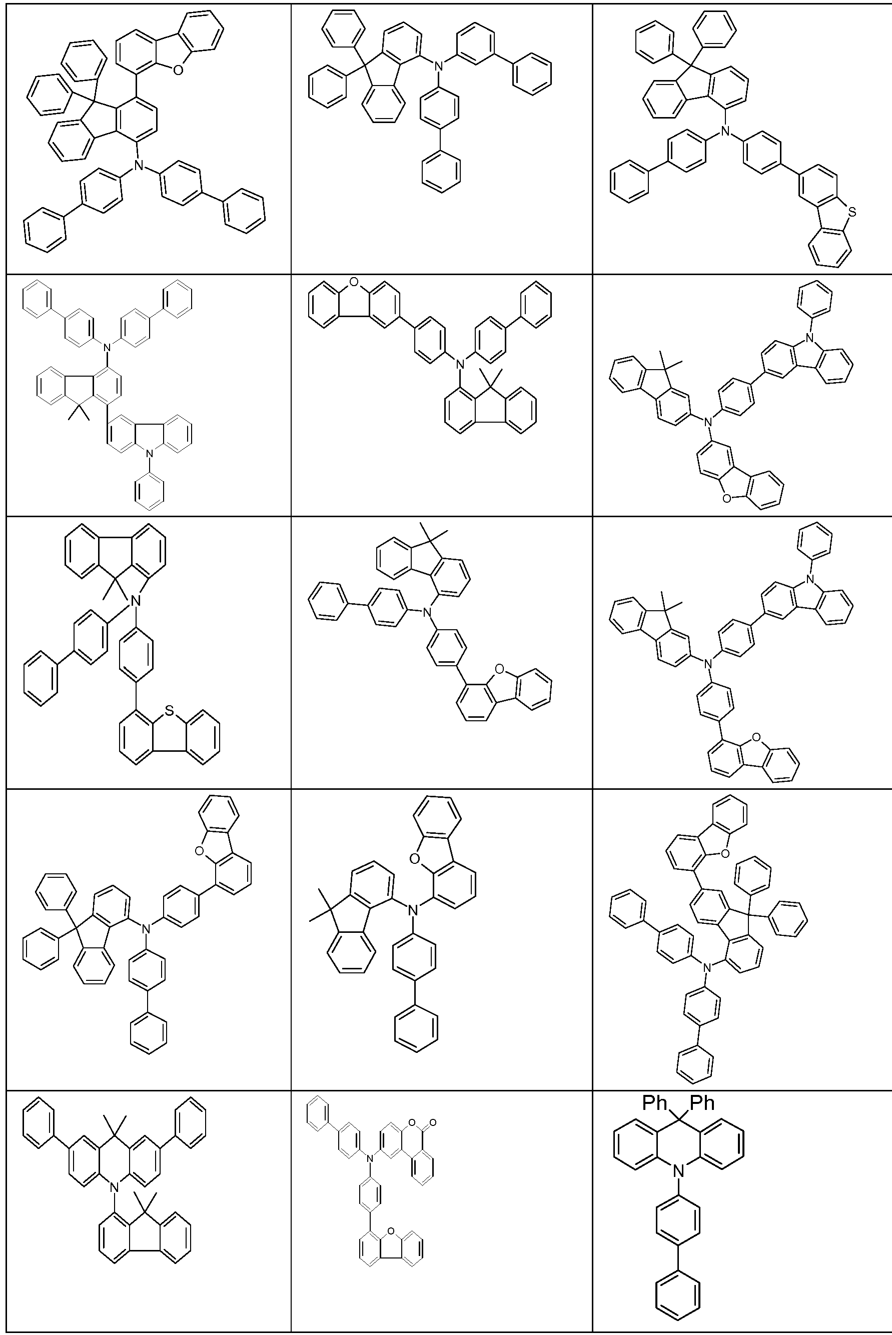

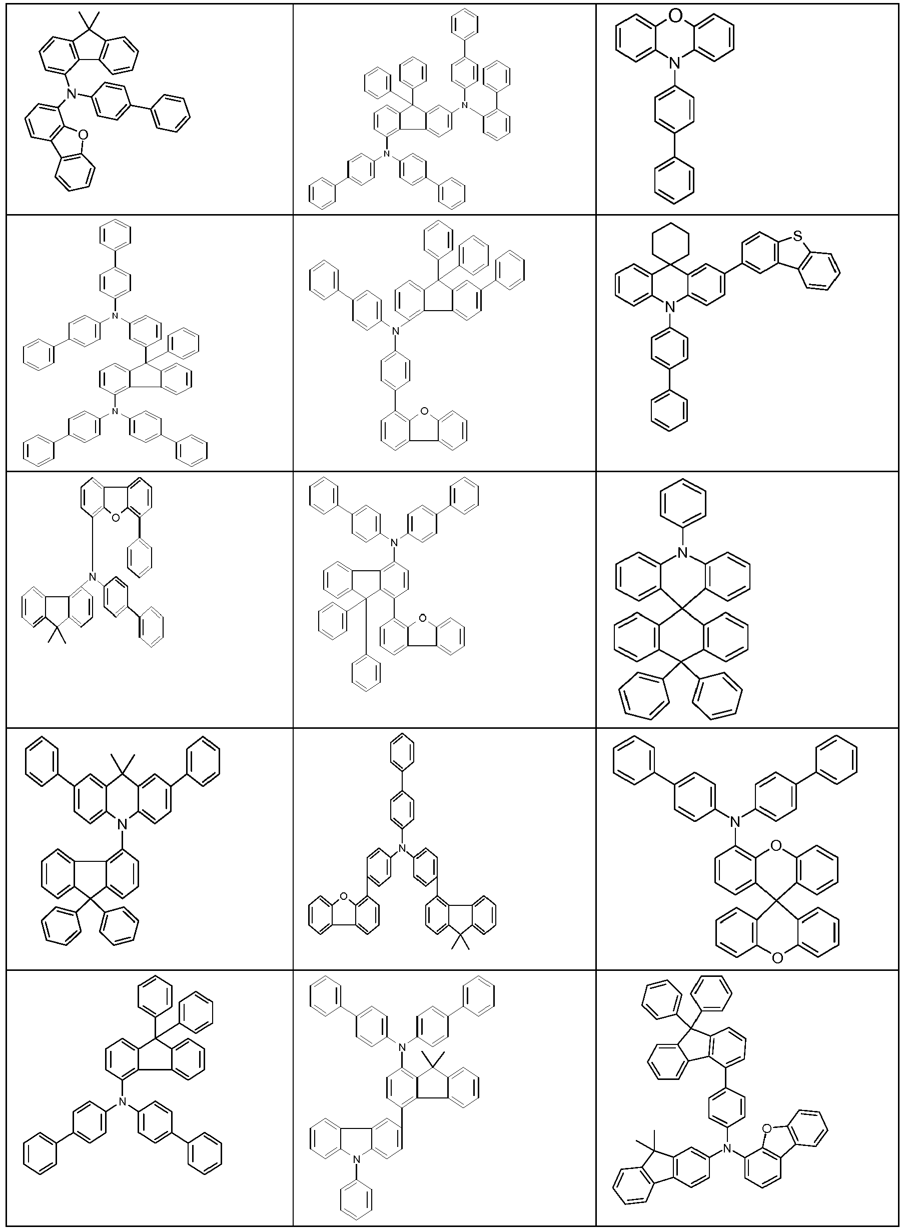

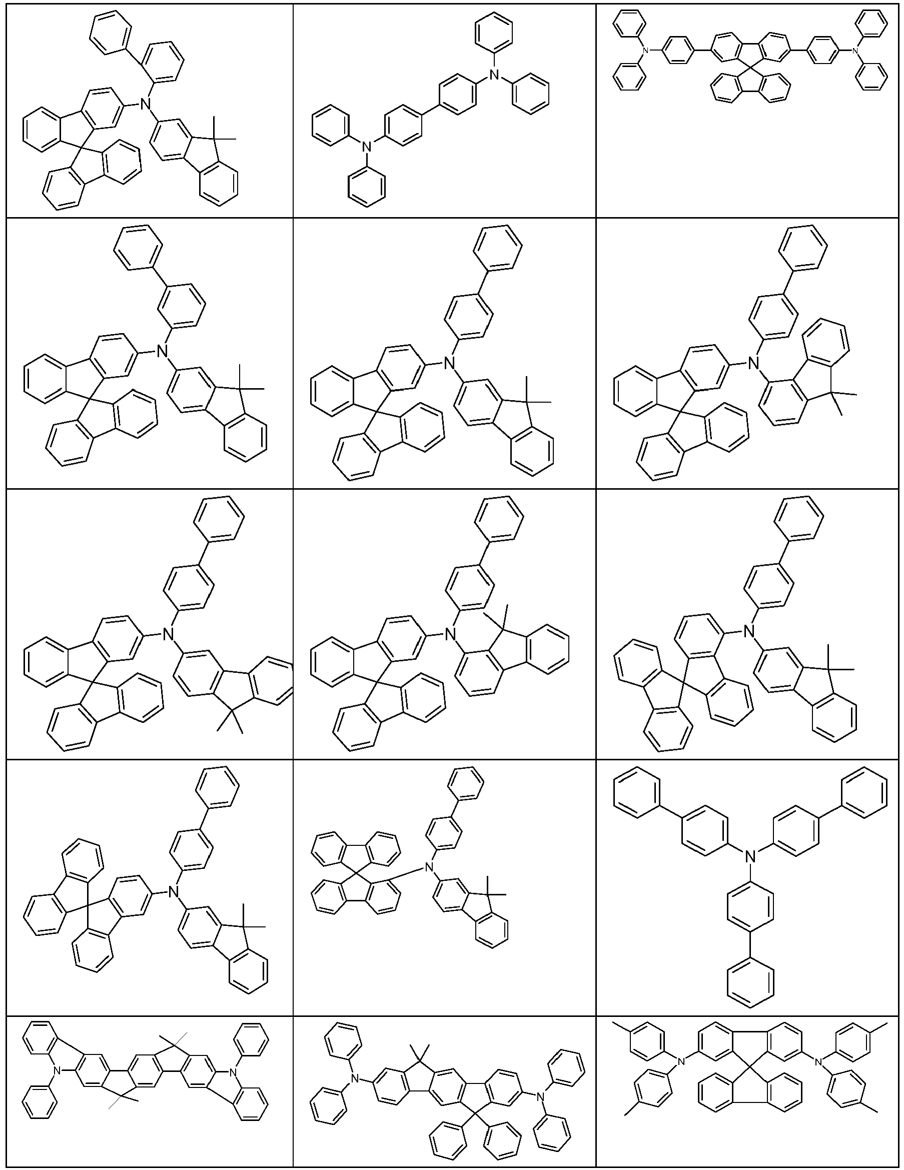

Beispiele für Materialien, welche als Wide Bandgap Matrixmaterialien eingesetzt werden können, sind die folgenden Verbindungen:

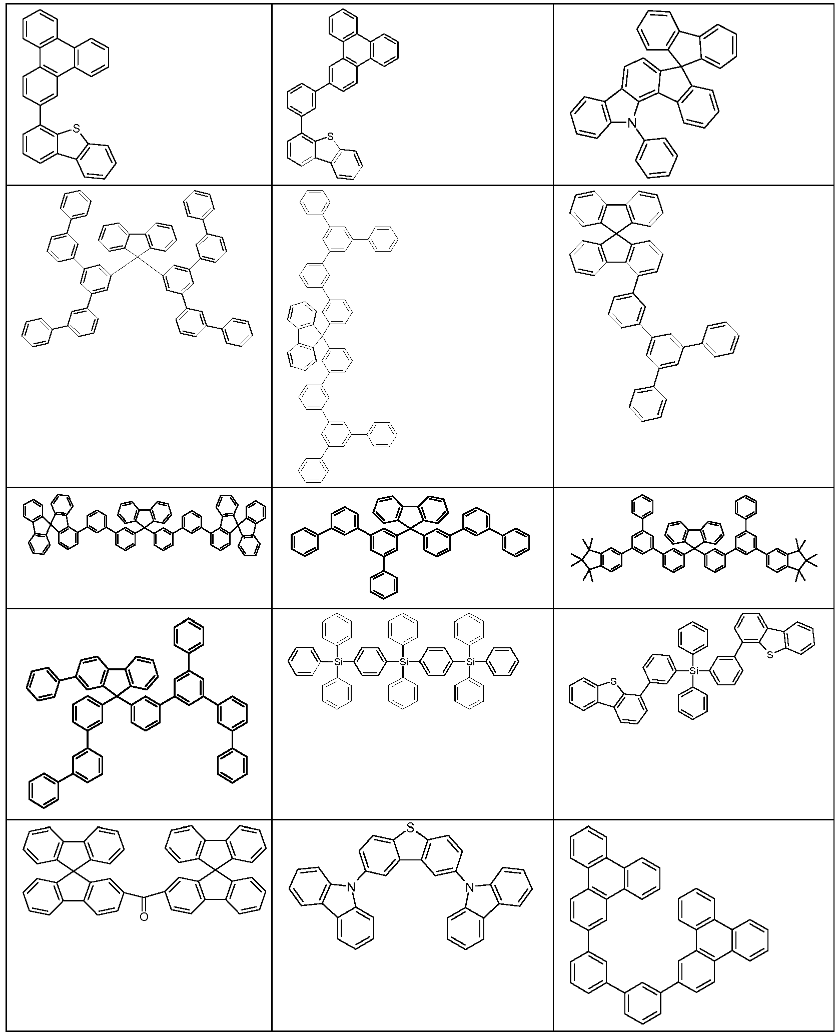

Weiterhin bevorzugt ist es, eine Mischung aus zwei oder mehr Triplett-Emittern zusammen mit einer Matrix einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe als Co-Matrix für längerwellig emittierende Triplettemitter, beispielsweise für grün oder rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist. Hierfür eignen sich insbesondere auch die Verbindungen, die in WO 2016/124304 und WO 2017/032439 offenbart sind.

Beispiele für geeignete Triplettemitter, welche als Co-Dotanden für die erfindungsgemäßen Verbindungen eingesetzt werden können, sind in der folgenden Tabelle abgebildet.

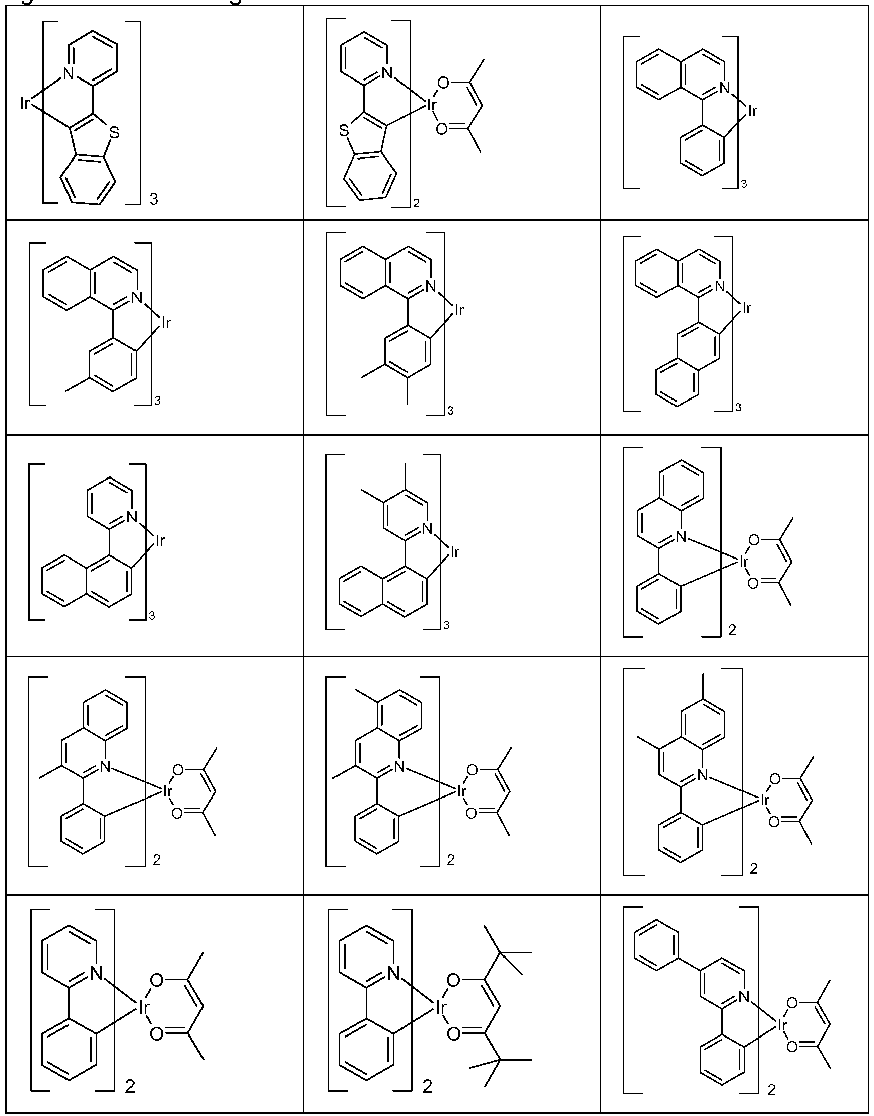

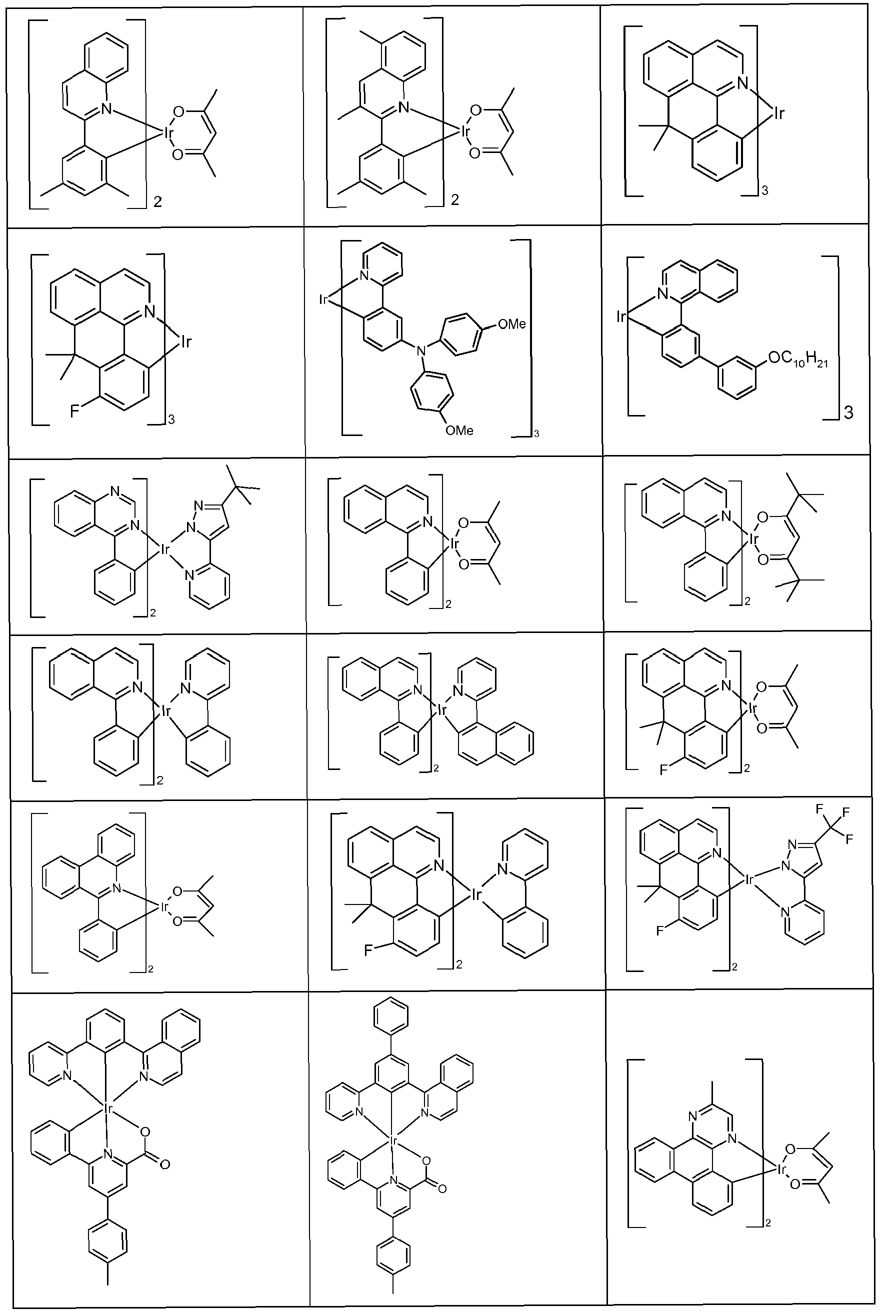

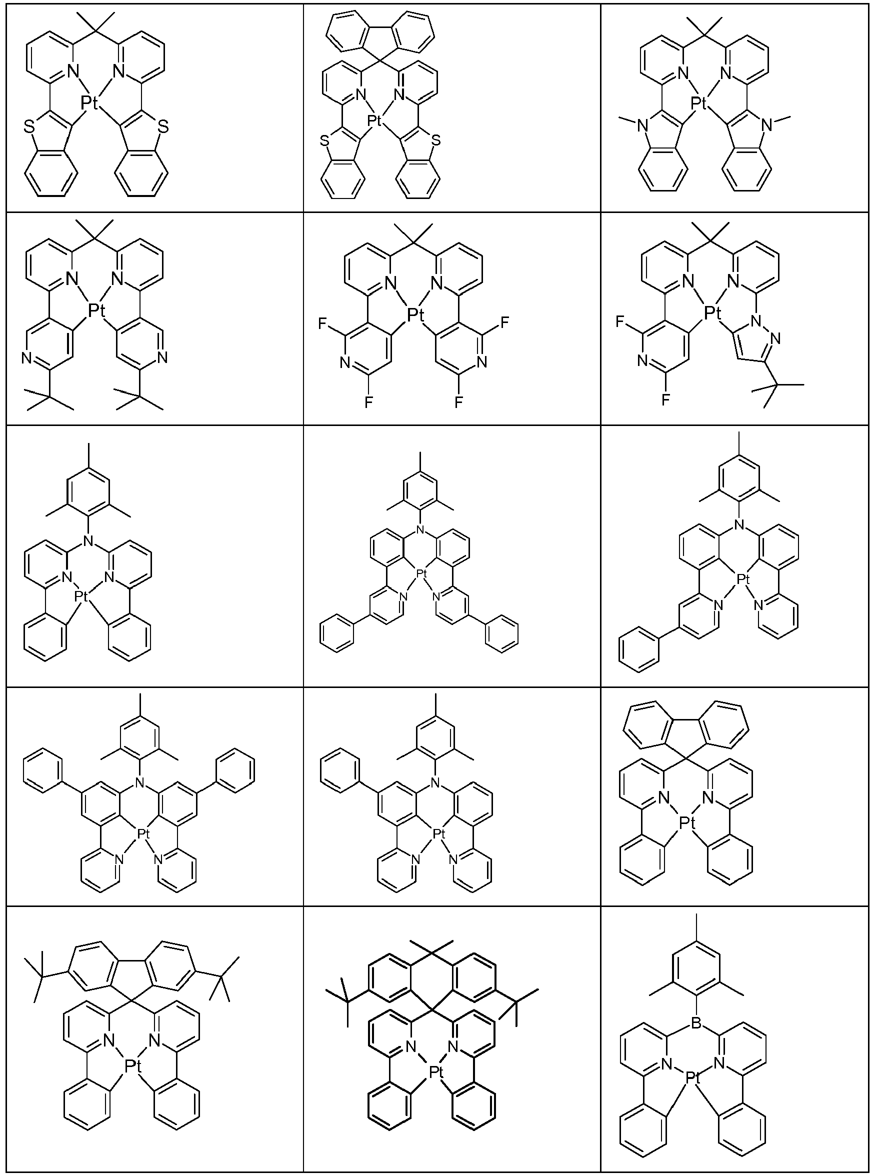

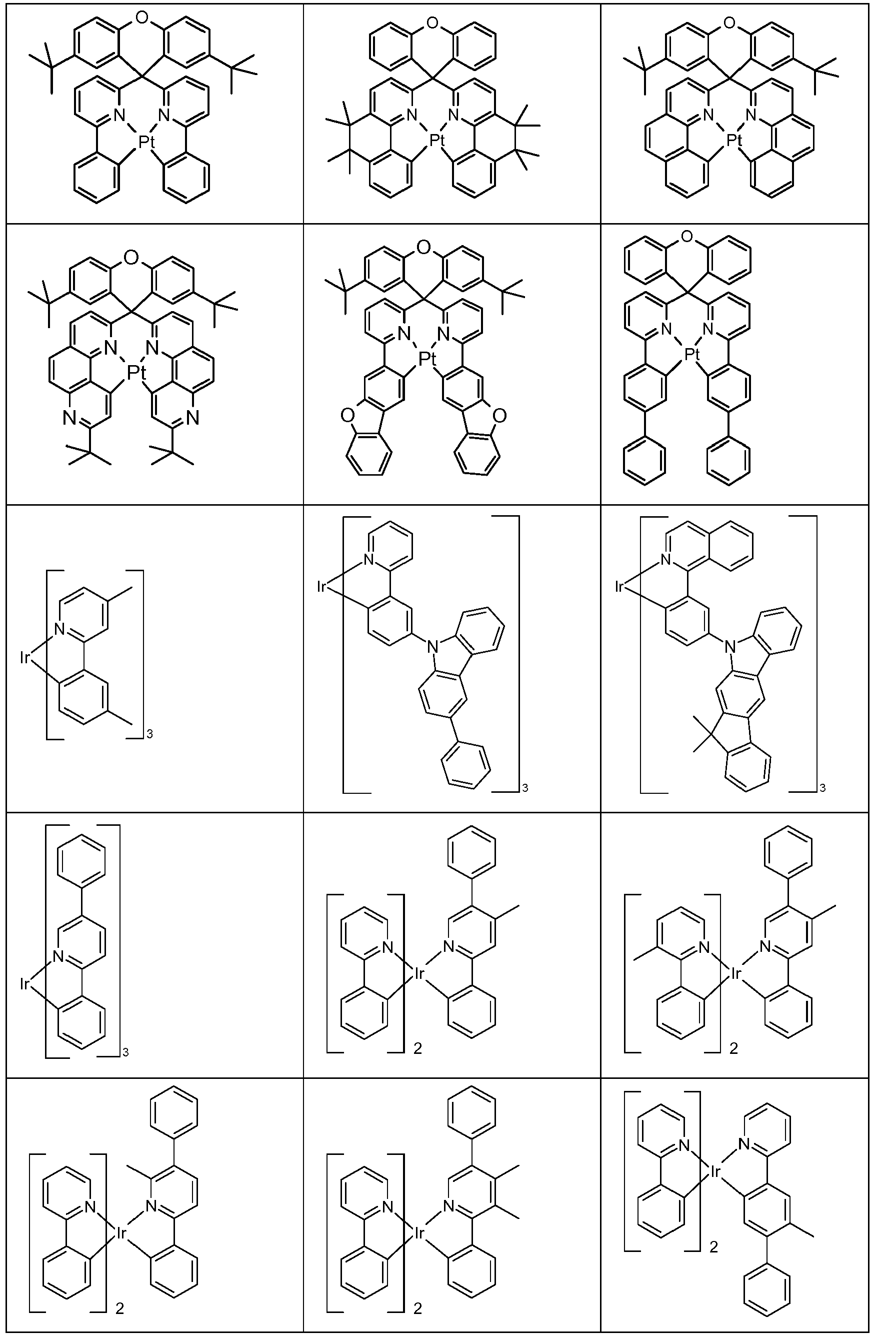

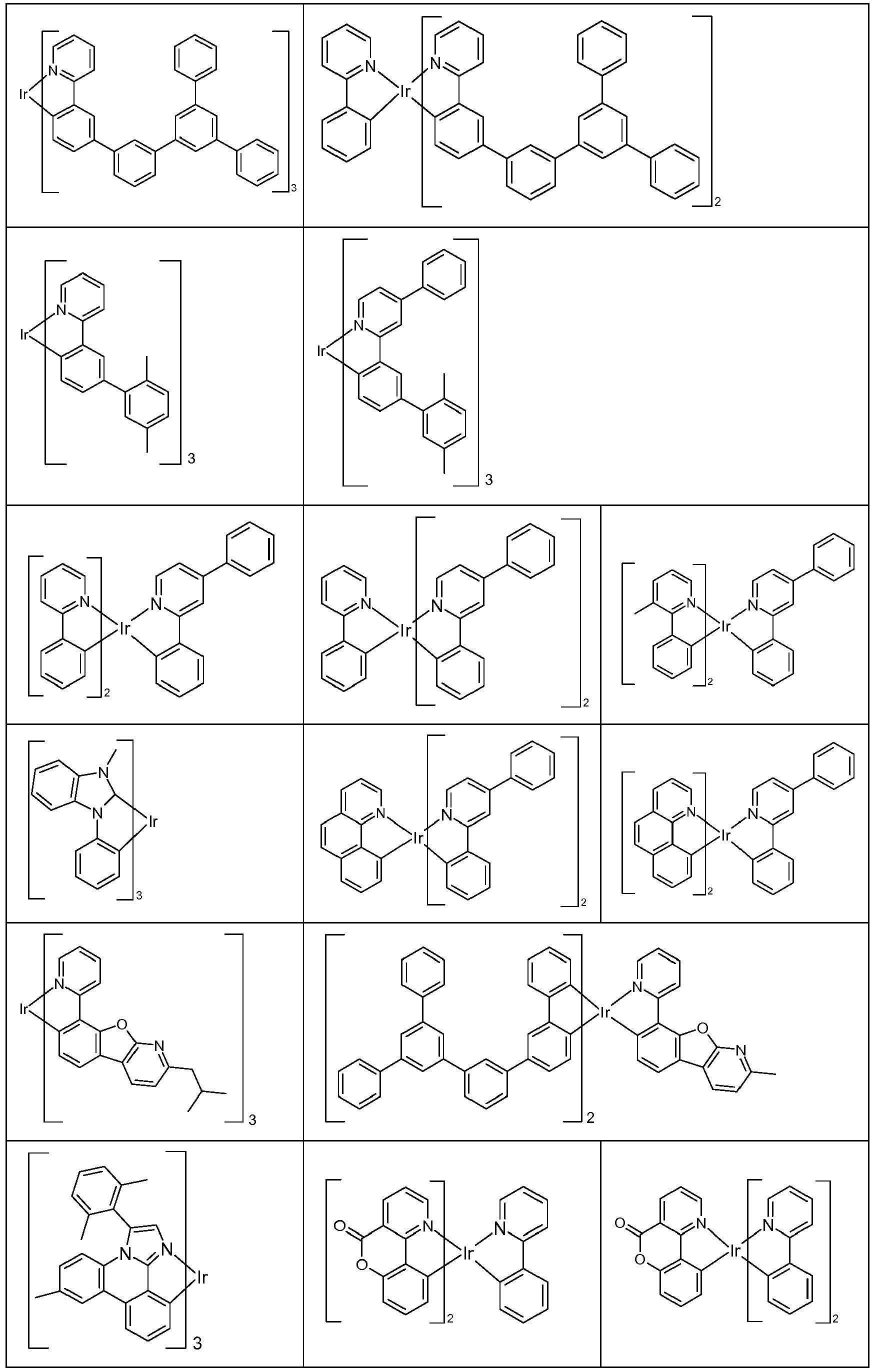

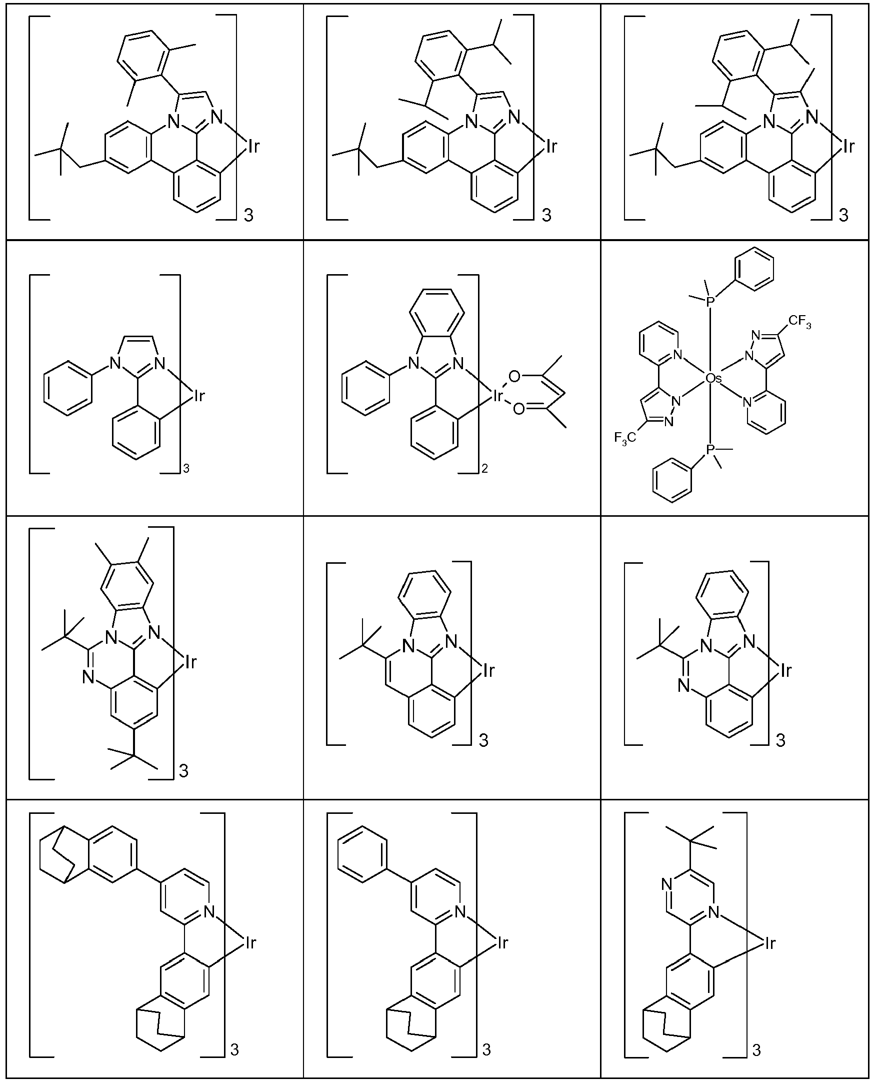

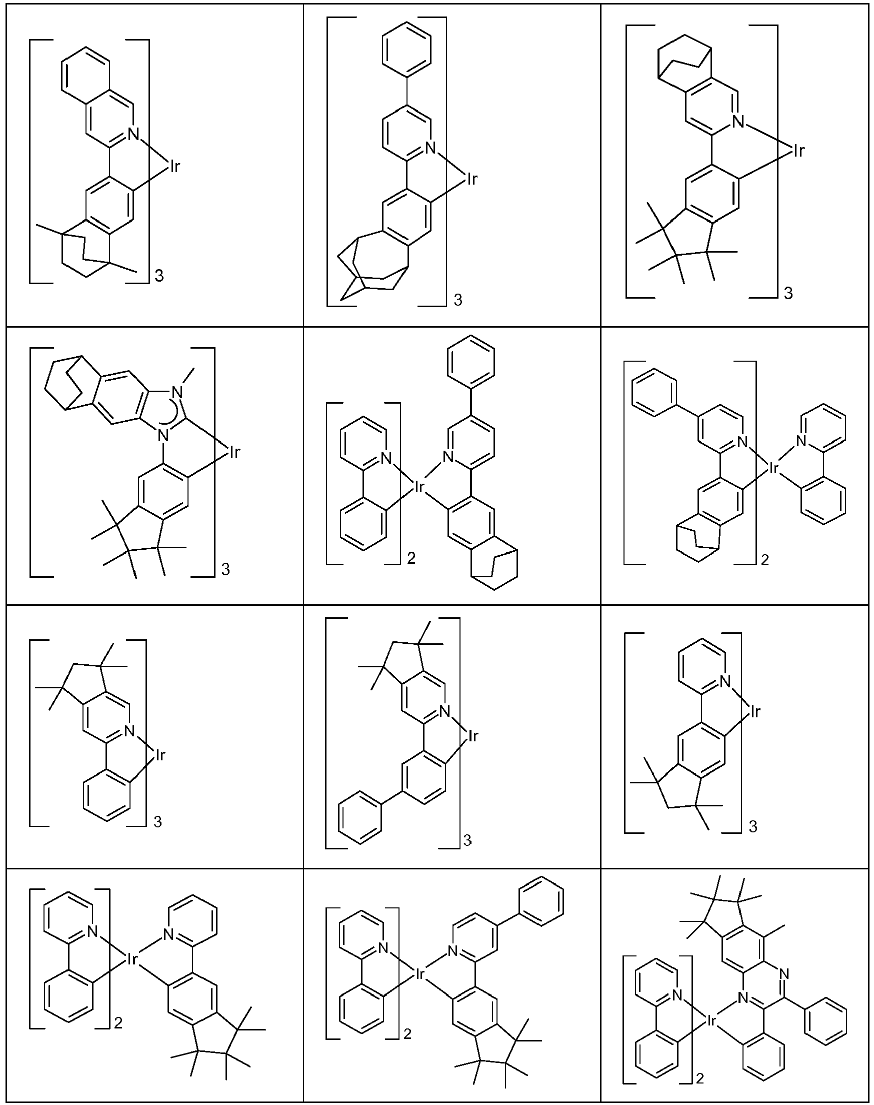

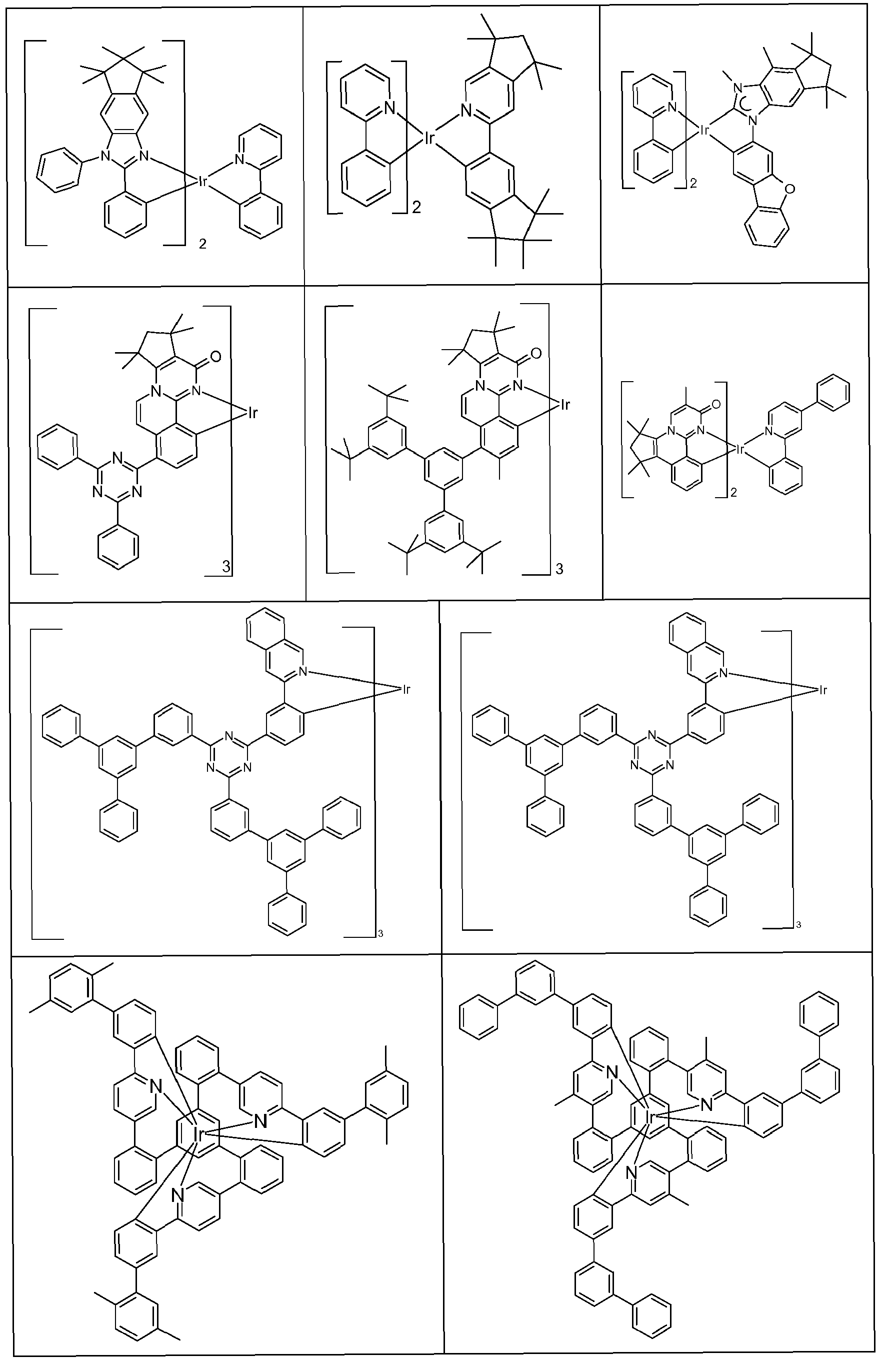

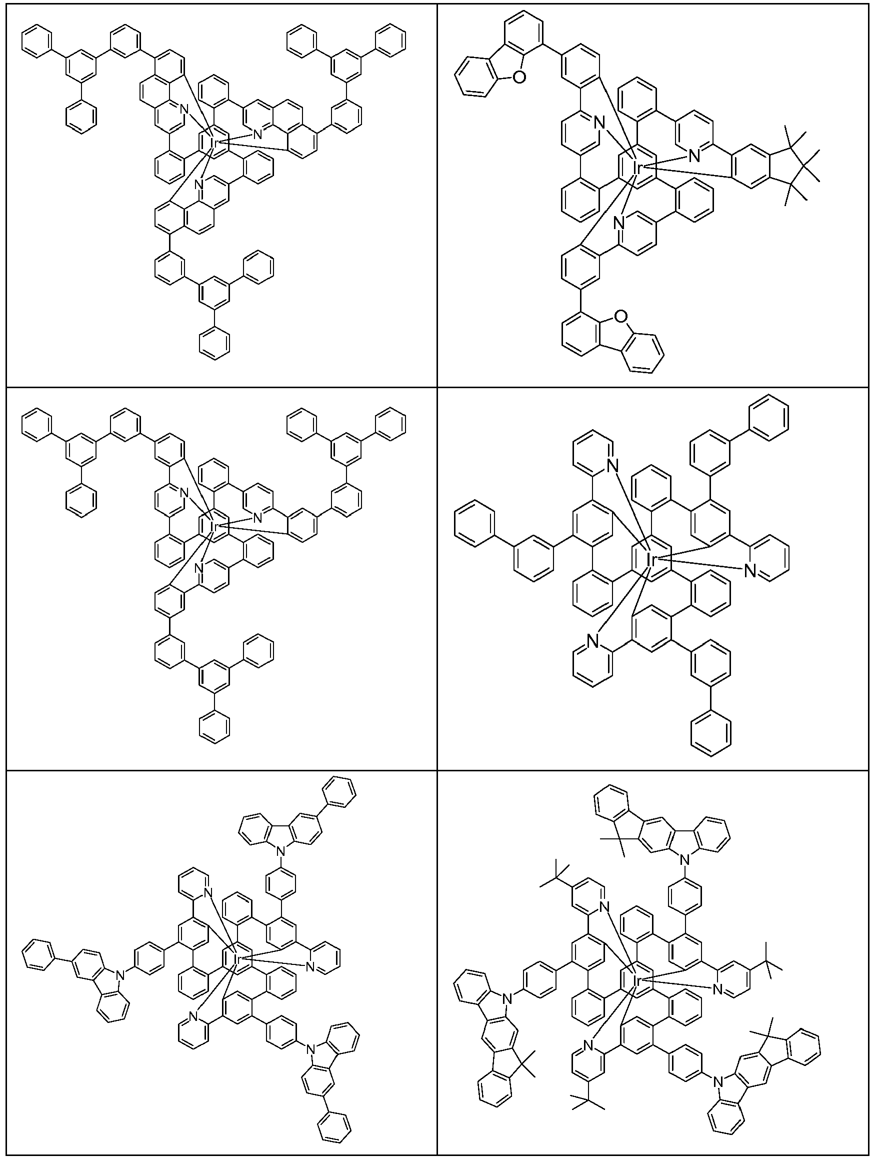

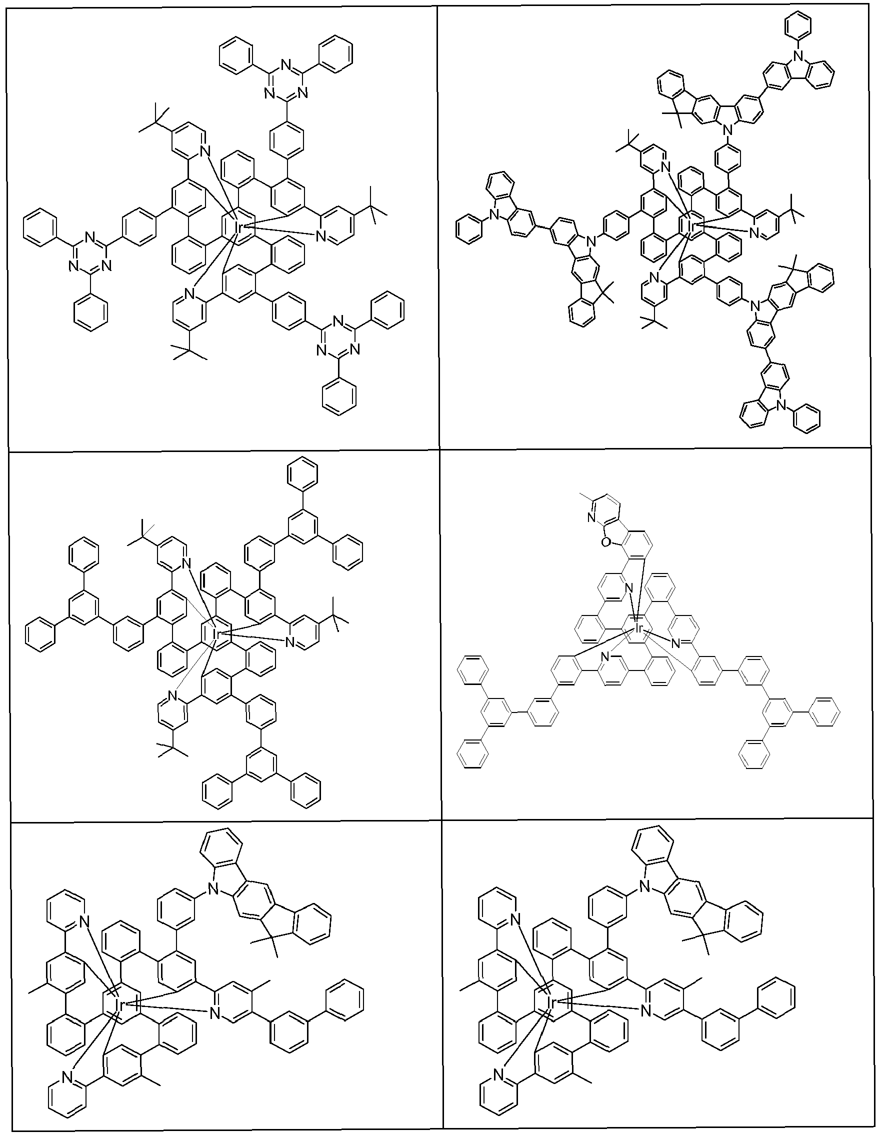

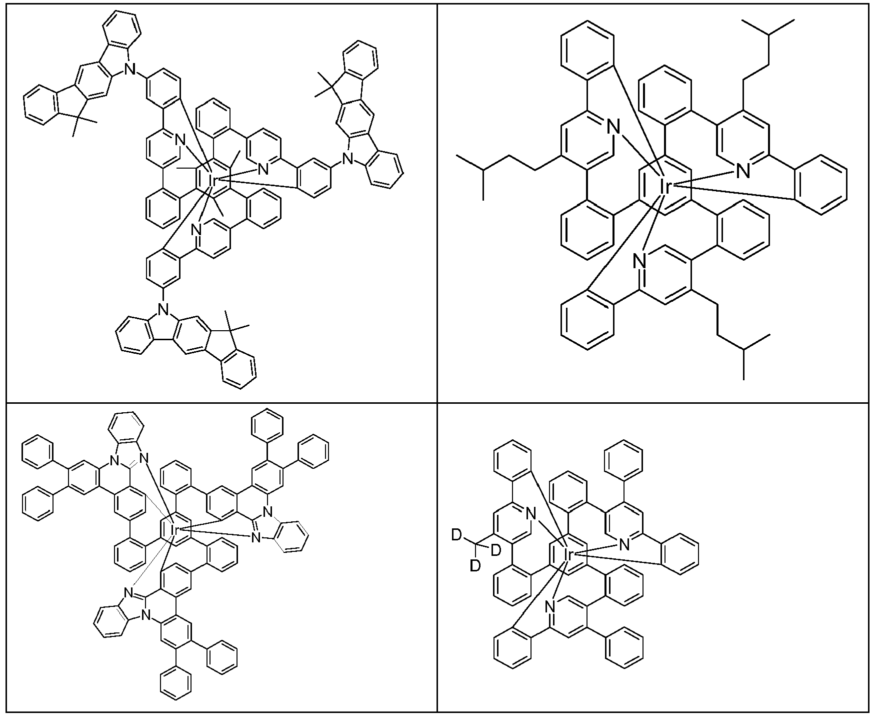

Die erfindungsgemäßen Metallkomplexe lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht, je nach Wahl des Metalls und genauer Struktur des Liganden. Wenn es sich bei dem erfindungsgemäßen Metallkomplex um einen Aluminiumkomplex handelt, so wird dieser bevorzugt in einer Elektronentransportschicht eingesetzt. Ebenso lassen sich die erfindungsgemäßen Metallkomplexe als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden. In einer bevorzugten Ausführungsform der Erfindung wird die Schicht, die die erfindungsgemäße Verbindung enthält, aus Lösung aufgebracht.

Die organische Elektrolumineszenzvorrichtung kann auch als Hybrid-system hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Es ist bevorzugt, wenn die erfindungsgemäßen Verbindungen aus Lösung verarbeitet werden.

Diese Verfahren sind dem Fachmann generell bekannt und können von ihm ohne Probleme auf organische Elektrolumineszenzvorrichtungen enthaltend Verbindungen gemäß Formel (1) bzw. (2) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Die erfindungsgemäßen Verbindungen weisen eine sehr hohe Photolumineszenz-Quantenausbeute auf. Dies führt bei Verwendung in einer organischen Elektrolumineszenzvorrichtung zu hervorragenden Effizienzen.
2. Die erfindungsgemäßen Verbindungen führen zu einer hohen Lebensdauer der OLED.
3. Die erfindungsgemäßen Verbindungen weisen schmale Emissionsspektren auf, was zu einer höheren Farbreinheit der OLED führt.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen.

### A: Darstellung der Synthone:

### Beispiel S1:

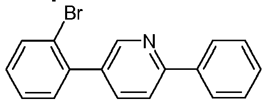

Ein Gemisch aus 28.1 g (100 mmol) 2-Phenyl-5-(4,4,5,5-tetramethyl-1,3,2-dioxaborolan-2-yl)-pyridin [789291-27-7], 28.2 g (100 mmol) 1-Brom-2-iod-benzol [583-55-1], 31.8 g (300 mmol) Natriumcarbonat, 787 mg (3 mmol) Triphenylphosphin, 225 mg (1 mmol) Palladium(II)acetat, 300 ml Toluol, 150 mol Ethanol und 300 ml Wasser wird 60 h unter Rückfluss erhitzt. Nach Erkalten wird mit 500 ml Toluol erweitert, die organische Phase wird abgetrennt, einmal mit 500 ml Wasser und einmal mit 500 ml gesättigter Kochsalzlösung gewaschen und über Magnesiumsulfat getrocknet. Nach Entfernen des Lösungsmittels wird der Rückstand aus Ethylacetat/ n-Heptan umkristallisiert oder an Kieselgel (Toluol/Ethylacetat, 9:1 vv) chromatographiert. Ausbeute: 22.7 g (73 mmol), 73 %. Reinheit: ca. 97 %ig nach ¹H-NMR.

Analog können folgende Verbindungen dargestellt werden, wobei zur Umkristallisation Lösemittel wie z. B. Ethylacetat, Cyclohexan, Toluol, Acetonitril, n-Heptan, Ethanol oder Methanol verwendet werden können. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Boronester | Produkt | Ausbeute |
|---|---|---|---|
| S2 | 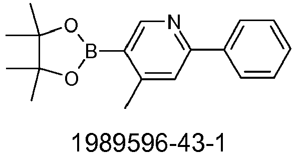 | 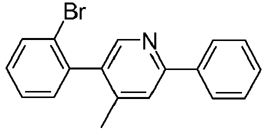 | 56 % |
| S3 | 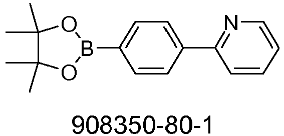 | 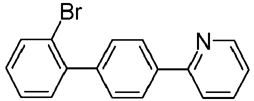 | 72 % |
| S4 | 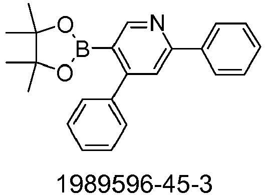 | 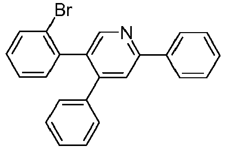 | 71 % |
| S5 | 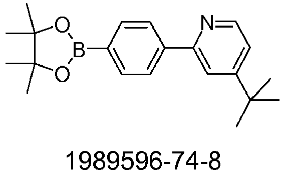 | 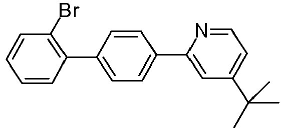 | 70 % |
| S6 | 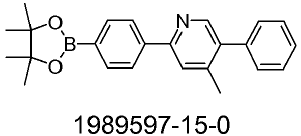 | 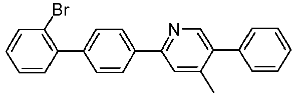 | 69 % |
| S7 | 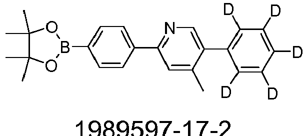 | 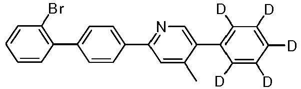 | 67 % |
| S8 | 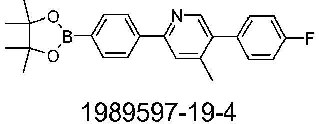 | 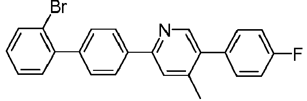 | 63 % |
| S9 | 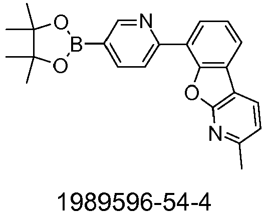 | 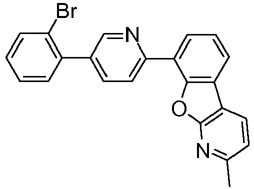 | 70 % |
| S10 | 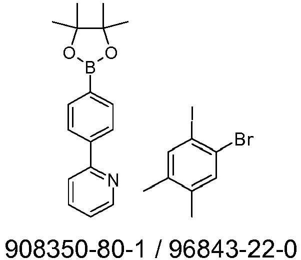 | 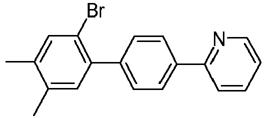 | 73 % |
| S11 | 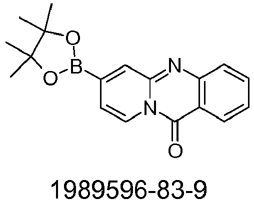 | 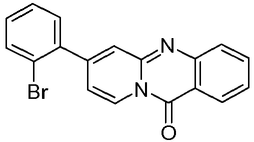 | 72 % |
| S12 | 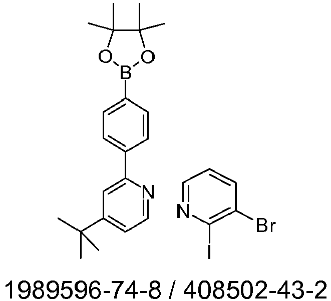 | 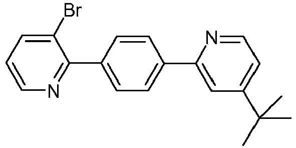 | 48 % |
| S13 | 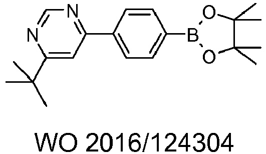 | 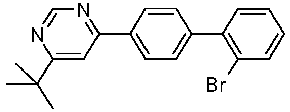 | 65% |
| S14 | 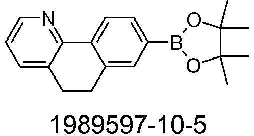 | 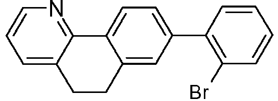 | 65 % |
| S15 | 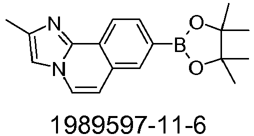 | 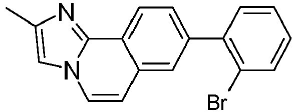 | 68% |
| S16 | 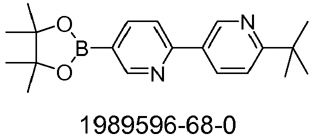 | 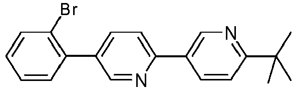 | 77% |
| S17 | 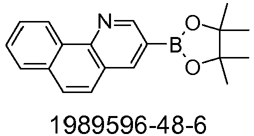 | 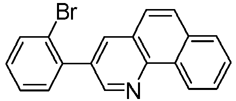 | 70% |
| S18 | 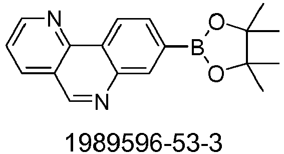 | 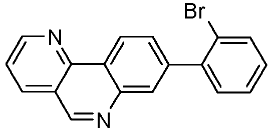 | 66% |
| S19 | 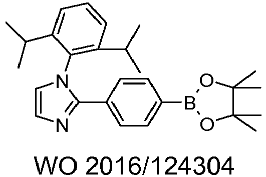 | 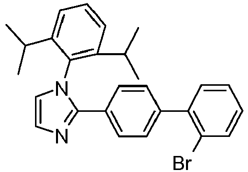 | 71% |
| S20 | 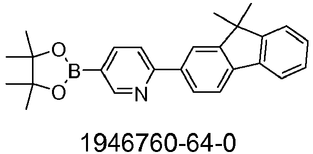 | 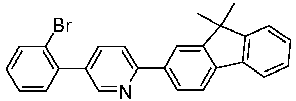 | 64% |
| S21 | 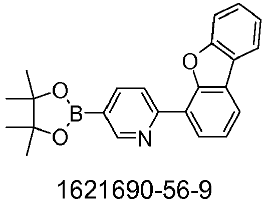 | 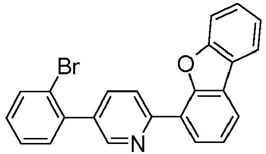 | 58 % |
| S22 | 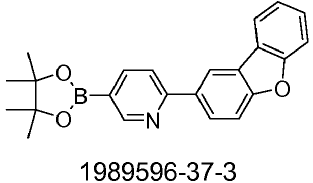 | 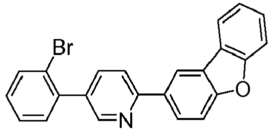 | 62 % |
| S23 | 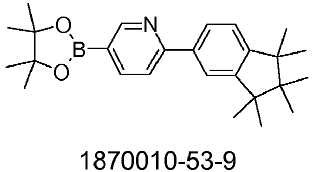 | 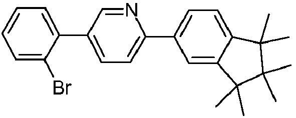 | 75% |
| S24 | 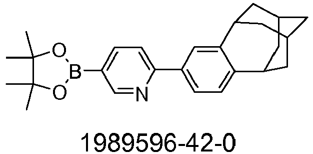 | 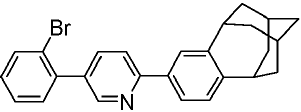 | 78 % |
| S25 | 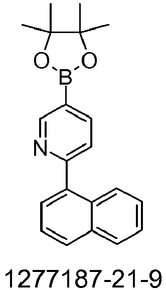 | 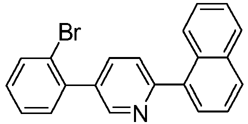 | 82% |
| Literaturbekannte Bromide | | | |
| S26 | 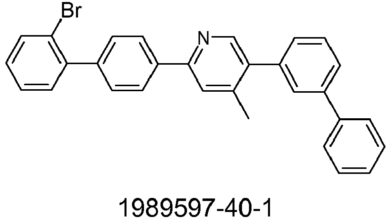 | | |
| S27 | 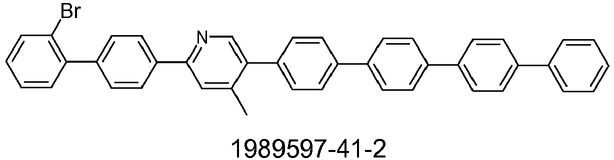 | | |
| S28 | 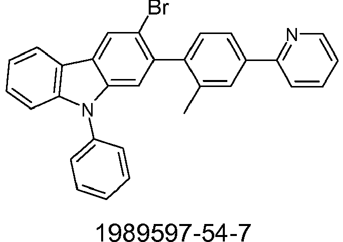 | | |

### Beispiel S100:

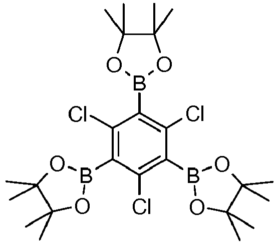

Ein Gemisch aus 41.8 g (100 mmol) 1,3,5-Tribrom-2,4,6-trichlorbenzol [13075-02-0], 91.4 g (360 mmol) Bis(pinacolato)diboran [73183-34-3], 88.3 g (900 mmol) Kaliumacetat, [1,1'-Bis(diphenylphosphino)ferrocen]-dichloropalladium(II) [72287-26-4], 1300 ml 1,4-Dioxan und 100 g Glaskugeln (3 mm Durchmesser) wird 50 h unter Rückfluss erhitzt. Das Dioxan wird am Rotationsverdampfer abrotiert, und der schwarze Rückstand wird mit 1000 ml Ethylacetat und 500 mL Wasser extraktiv im Scheidetrichter aufgearbeitet. Die organische Phase wird einmal mit 300 mL Wasser und einmal mit 150 mL gesättigter Natriumchloridlösung gewaschen und über ein Kieselgelbett filtriert. Das Kieselgel wird mit zweimal mit je 250 mL Essigsäureethylester nachgewaschen. Das Filtrat wird über Natriumsulfat getrocknet und eingeengt. Der Rückstand wird mit Heptan/Ethylacetat an Kieselgel chromatographiert. Ausbeute: 10.6 g (19 mmol), 19 %. Reinheit: ca. 98 %ig nach ¹H-NMR.

### Beispiel S200:

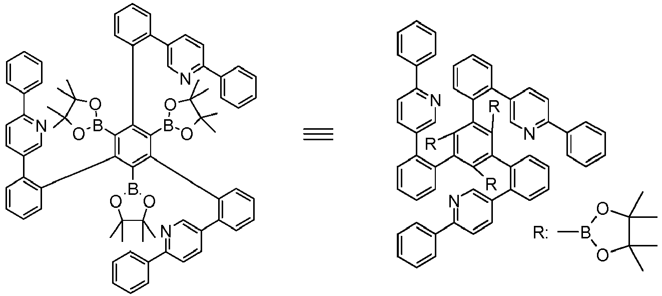

### a) S200a - Suzuki-Kupplung:

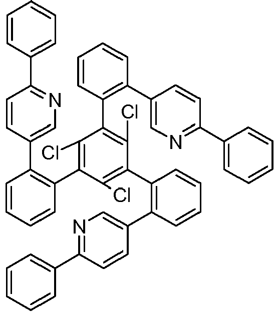

Ein Gemisch aus 55.9 g (100 mmol) S100, 102.4 g (330 mmol) S1, 63.3 g (600 mmol) Natriumcarbonat, 4.6 g (4 mmol) Tetrakis(triphenylphosphin)-palladium(0), 1500 ml 1,2-Dimethoxyethan und 750 ml Wasser wird 48 h unter Rückfluss erhitzt. Nach Erkalten wird der ausgefallene Feststoff abgesaugt und zweimal mit 20 mL Ethanol gewaschen. Der Feststoff wird in 500 mL Dichlormethan gelöst und über ein Celitebett filtriert. Das Filtrat wird bis auf 100 mL eingeengt, dann werden 400 mL Ethanol zugegeben und der ausgefallene Feststoff abgesaugt. Das Rohprodukt wird einmal aus Ethylacetat umkristallisiert. Ausbeute: 24.3 g (28 mmol), 28 %. Reinheit: ca. 96 %ig nach ¹H-NMR.

### b) S200 - Borylierung:

Ein gut gerührtes Gemisch aus 17.4 g (20 mmol) S200a, 16.8 g (66 mmol) Bis(pinacolato)diboran [73183-34-3], 19.6 g (120 mmol) Kaliumacetat (wasserfrei), 50 g Glaskugeln (3 mm Durchmesser), 1027 mg (2.4 mmol) SPhos [657408-07-6], 270 g (1.2 mmol) Palladium(II)acetat und 300 ml 1,4-Dioxan werden 16 h unter Rückfluss erhitzt. Das Dioxan wird am Rotationsverdampfer abrotiert, und der schwarze Rückstand wird mit 300 ml Toluol und 200 mL Wasser extraktiv im Scheidetrichter aufgearbeitet. Die organische Phase wird einmal mit 100 mL Wasser und einmal mit 50 mL gesättigter Natriumchloridlösung gewaschen und über ein Celite-Bett filtriert. Das Filtrat wird über Natriumsulfat getrocknet und anschließend zur Trockene eingeengt. Der Rückstand wird mit Dichlormethan/Ethylacetat an Kieselgel chromatographiert (Torrent Säulenautomat der Fa. A. Semrau). Ausbeute: 13.8 g (12 mmol), 60%. Reinheit: ca. 95%ig nach ¹H-NMR.

Analog können folgende Verbindungen dargestellt werden, wobei zur Umkristallisation Lösemittel wie z. B. Ethylacetat, Cyclohexan, Toluol, Acetonitril, n-Heptan, Ethanol oder Methanol verwendet werden können. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Bromid | Produkt | Ausbeute |
|---|---|---|---|
| | | R: 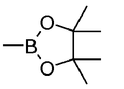 | |
| S201 | S2 | 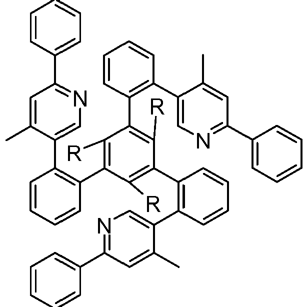 | 16 % |
| S202 | S3 | 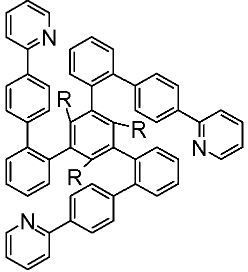 | 19 % |
| S203 | S4 | 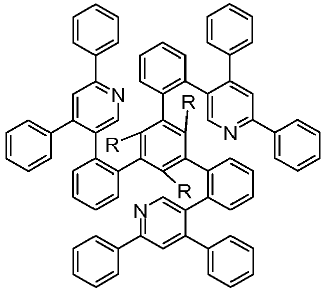 | 15 % |
| S204 | S5 | 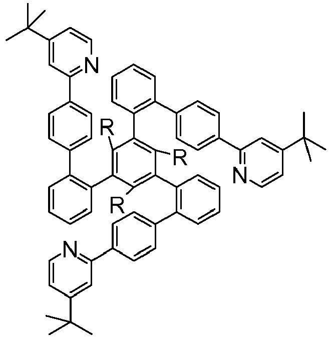 | 17 % |
| S205 | S6 | 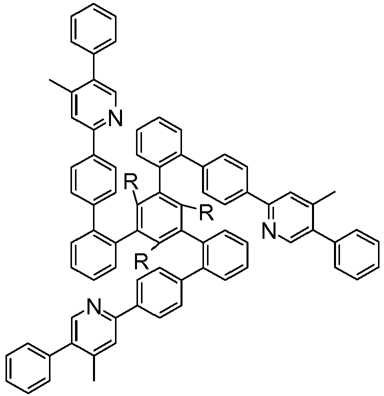 | 22 % |
| S206 | S7 | 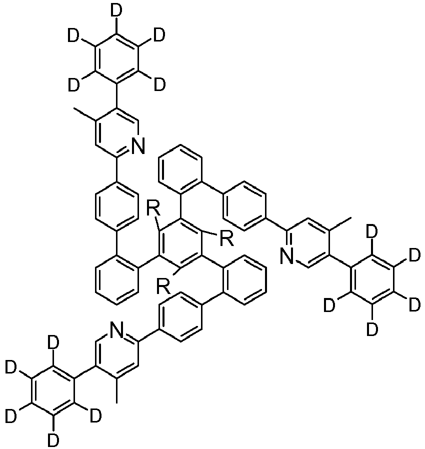 | 20 % |
| S207 | S8 | 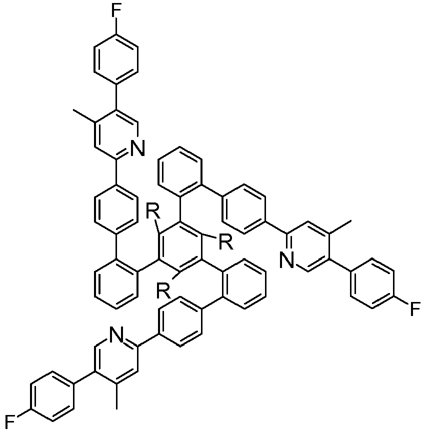 | 18 % |
| S208 | S9 | 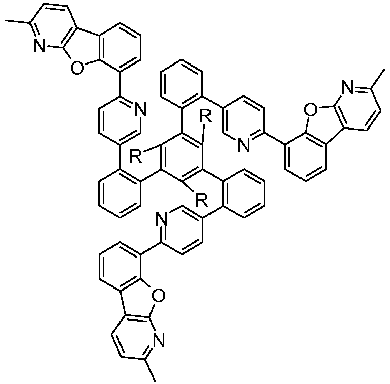 | 17 % |
| S209 | S10 | 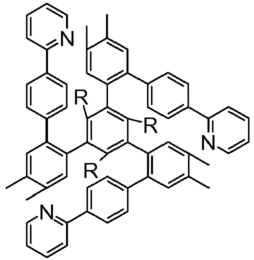 | 22 % |
| S210 | S11 | 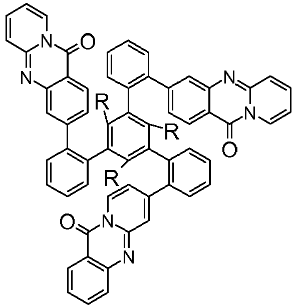 | 23 % |
| S211 | S12 | 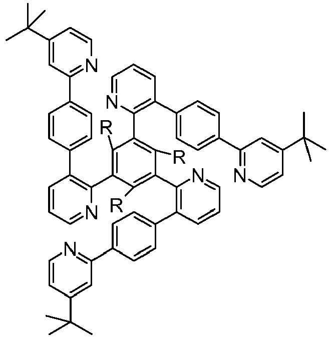 | 21 % |
| S212 | S13 | 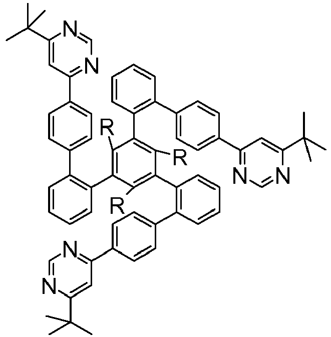 | 20 % |
| S213 | S14 | 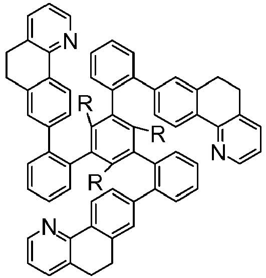 | 17 % |
| S214 | S15 | 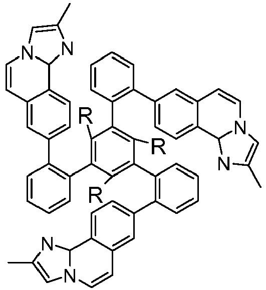 | 21 % |
| S215 | S16 | 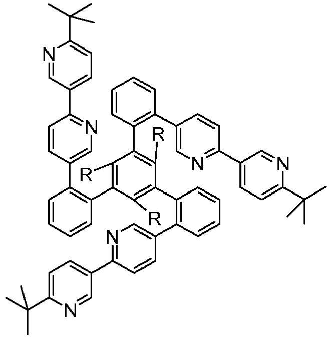 | 20 % |
| S216 | S17 | 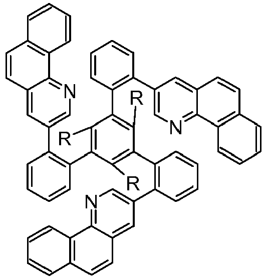 | 18 % |
| S217 | S18 | 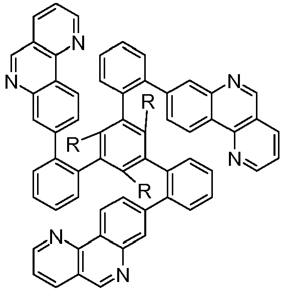 | 20 % |
| S218 | S19 | 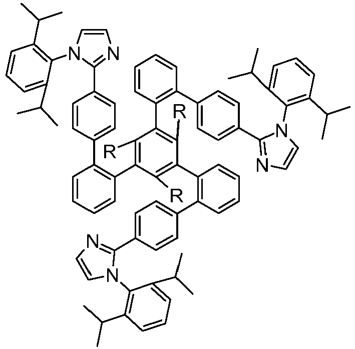 | 20 % |
| S219 | S20 | 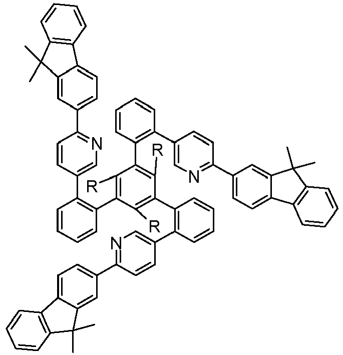 | 23 % |
| S220 | S21 | 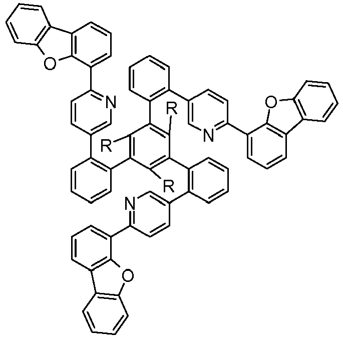 | 17 % |
| S221 | S22 | 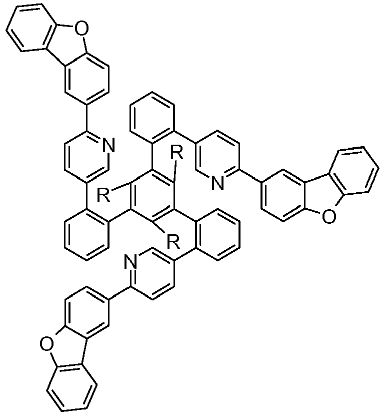 | 19 % |
| S222 | S23 | 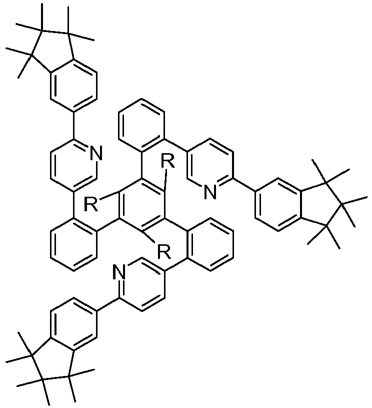 | 19 % |
| S223 | S24 | 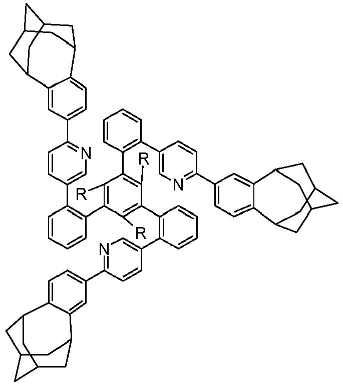 | 22 % |
| S224 | S25 | 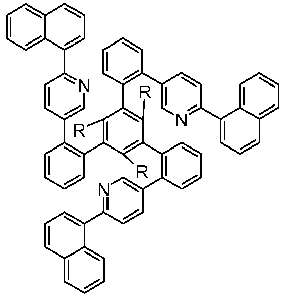 | 20 % |

### B: Synthese der Liganden:

### Beispiel L1:

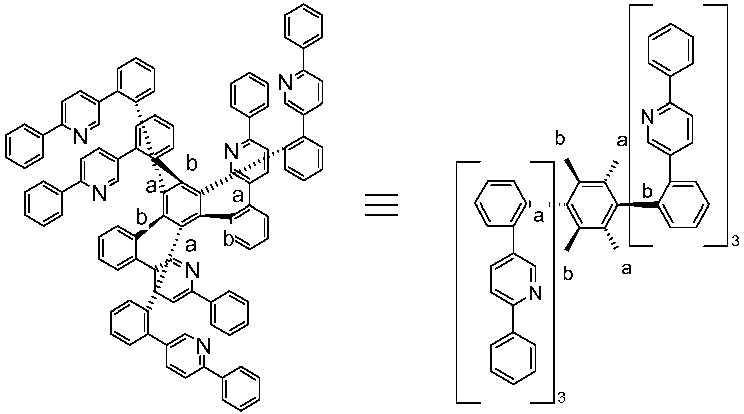

Ein Gemisch aus 11.4 g (10.0 mmol) S200, 12.4 g (40.0 mmol) S1, 20.7 g (90 mmol) Kaliumphosphoat Monohydrat, 507 mg (0.6 mmol) XPhos Palladacycle Gen.3 [1445085-55-1], 200 ml Tetrahydrofuran und 100 ml Wasser wird 20 h unter Rückfluss erhitzt. Nach Abkühlen wird der ausgefallene Feststoff abgesaugt, zweimal mit je 30 mL Wasser und zweimal mit je 30 mL Ethanol gewaschen. Der Feststoff wird in 200 ml Dichlormethan (DCM) gelöst und über ein mit DCM vorgeschlämmtes Kieselgelbett filtriert. Das Filtrat wird eingeengt, der Rückstand wird mit Dichlormethan/ Ethylacetat an Kieselgel chromatographiert (Torrent Säulenautomat der Fa. A. Semrau). Ausbeute: 2.5 g (2.2mmol) 22%. Reinheit: ca. 95%ig nach ¹H-NMR.

Analog können folgende Verbindungen dargestellt werden, wobei zur Umkristallisation Lösemittel wie z. B. Ethylacetat, Cyclohexan, Toluol, Acetonitril, n-Heptan, Ethanol oder Methanol verwendet werden können. Es kann auch mit diesen Lösungsmittel heißextrahiert werden, oder die Aufreinigung kann chromatographisch an Kieselgel auf einem Säulenautomaten (Torrent der Firma Axel Semrau) erfolgen.

| Bsp. | Ed u kte | Produkt | Ausbeute |
|---|---|---|---|
| L2 | S200 S3 | 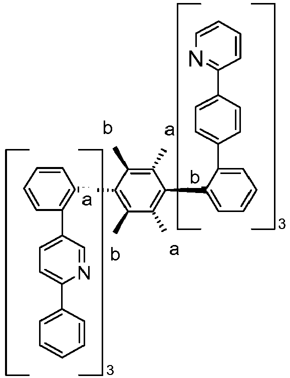 | 26 % |
| L3 | S201 S2 | 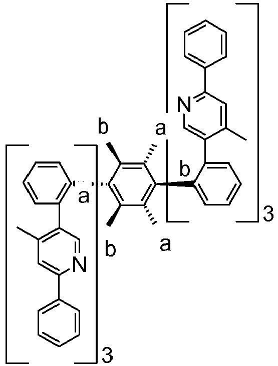 | 25 % |
| L4 | S202 S3 | 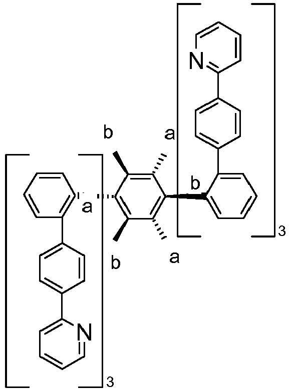 | 27 % |
| L5 | S203 S4 | 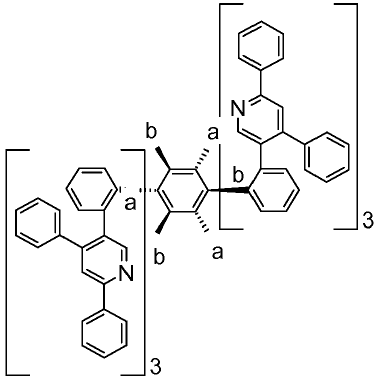 | 20 % |
| L6 | S204 S5 | 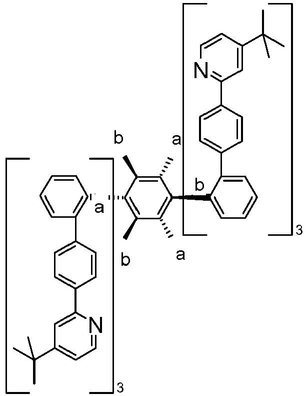 | 22 % |
| L7 | S205 S5 | 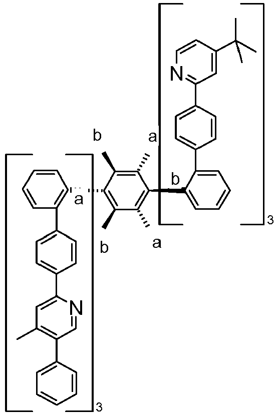 | 25 % |
| L8 | S206 S10 | 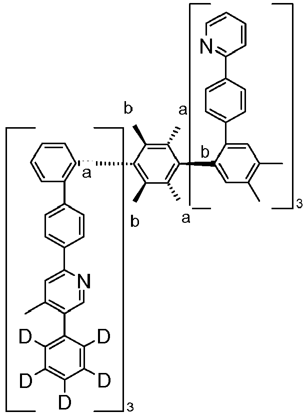 | 23 % |
| L9 | S207 S5 | 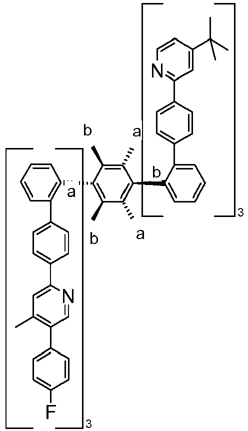 | 19 % |
| L10 | S208 S4 | 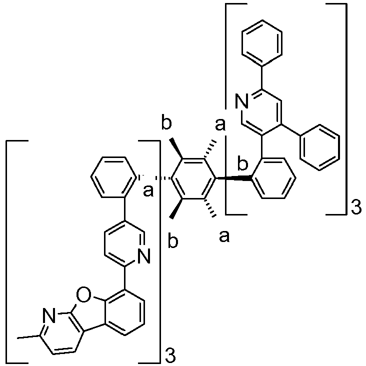 | 26 % |
| L11 | S209 S4 | 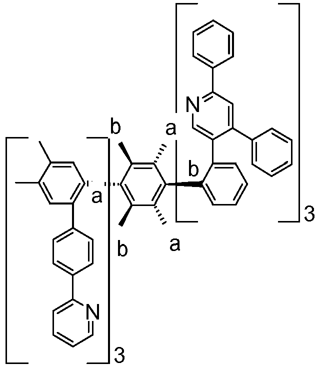 | 21 % |
| L12 | S210 S4 | 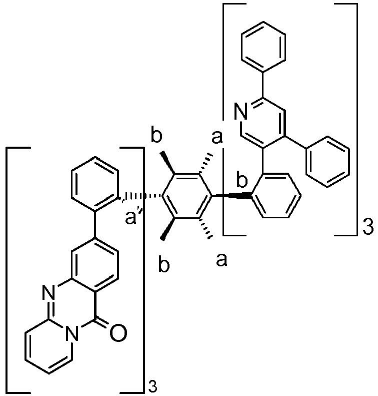 | 20 % |
| L13 | S211 S5 | 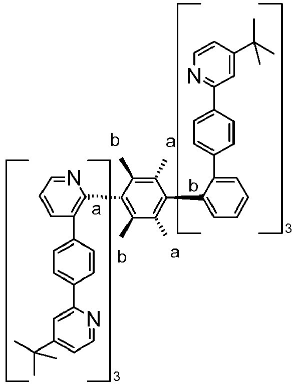 | 22% |
| L14 | S212 S6 | 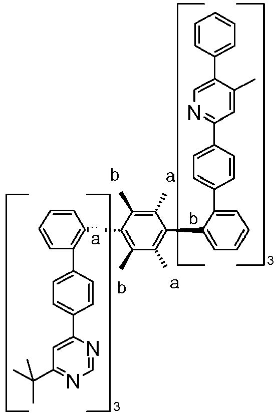 | 20 % |
| L15 | S213 S17 | 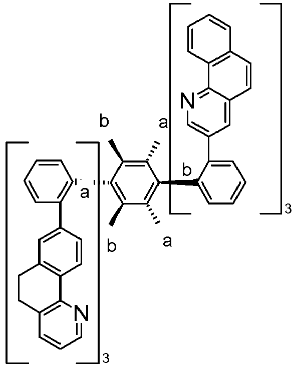 | 26 % |
| L16 | S214 S5 | 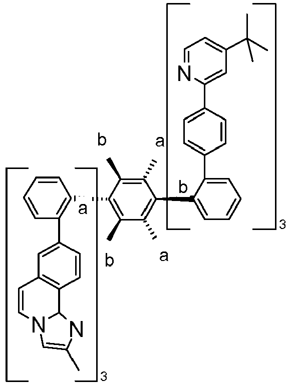 | 25 % |
| L17 | S215 S6 | 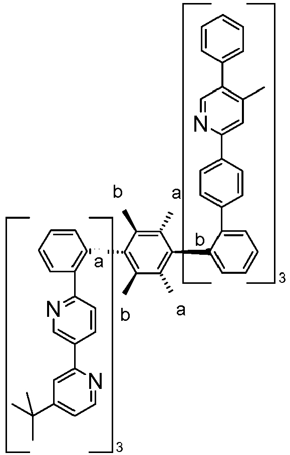 | 23 % |
| L18 | S216 S4 | 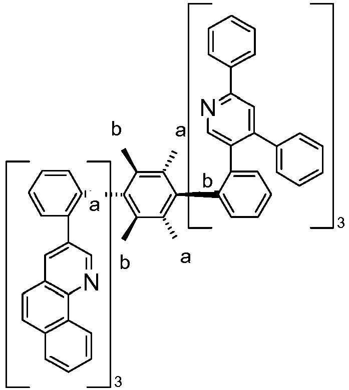 | 19 % |
| L19 | S217 S5 | 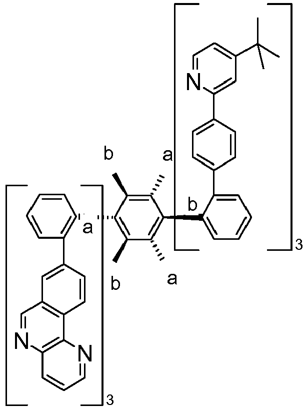 | 20 % |
| L20 | S218 S15 | 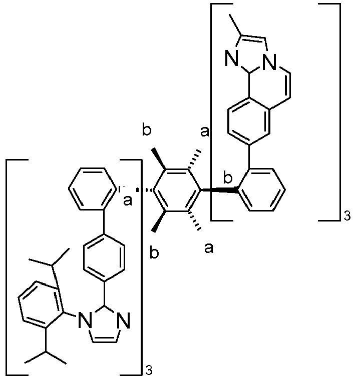 | 23 % |
| L21 | S219 S4 | 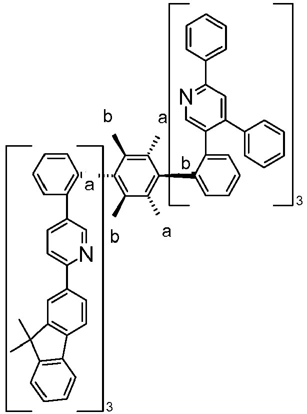 | 24 % |
| L22 | S220 S5 | 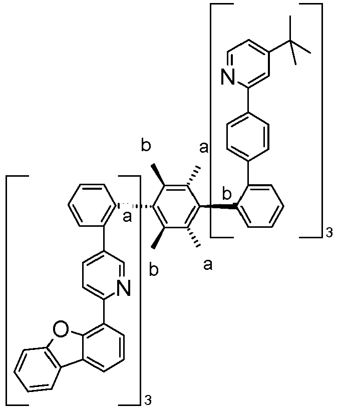 | 21 % |
| L23 | S221 S4 | 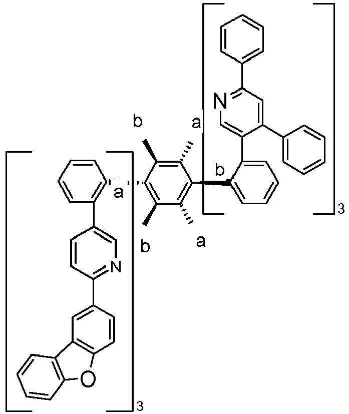 | 20 % |
| L24 | S222 S9 | 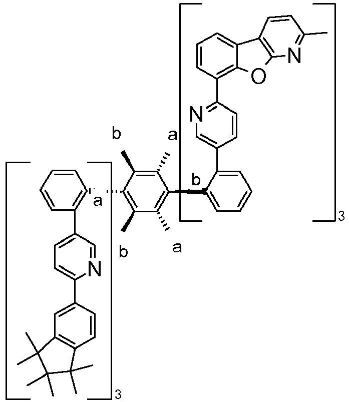 | 24 % |
| L25 | S223 S9 | 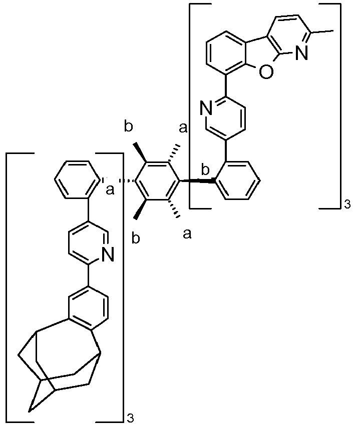 | 25 % |
| L26 | S224 S25 | 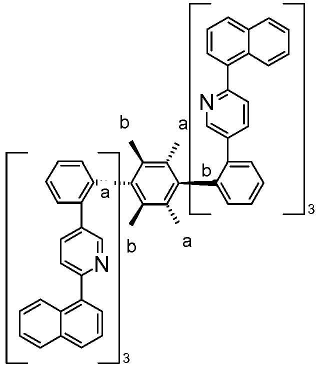 | 18 % |
| L27 | S204 S26 | 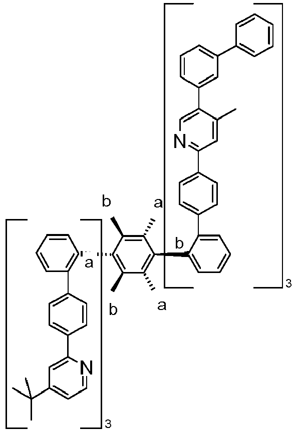 | 21 % |
| L28 | S205 S27 | 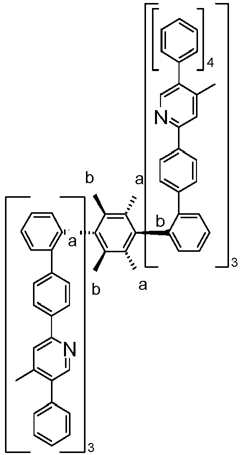 | 23 % |
| L29 | S205 S28 | 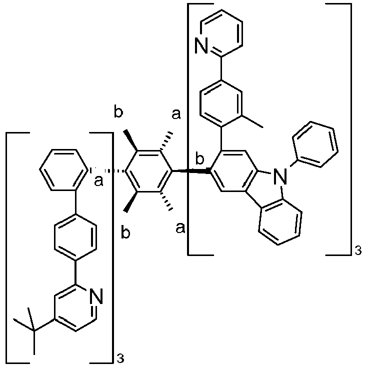 | 20 % |

### C: Synthese der Metallkomplexe:

### Ir₂(L1)

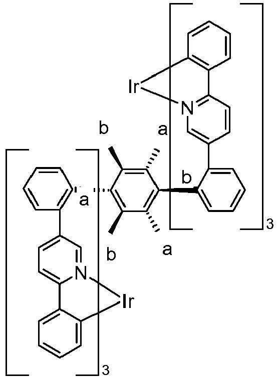

Ein Gemisch aus 14.6 g (10 mmol) des Liganden L1, 9.9 g (20 mmol) Tris-acetylacetonato-iridium(III) [15635-87-7] und 150 g Hydrochinon [123-31-9] werden in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen und in einer Metallheizschale platziert. Die Apparatur wird über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Dann wird die Apparatur mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250 °C, gemessen am Pt-100 Thermofühler, der in die aufgeschmolzene, gerührte Reaktionsmischung eintaucht, erhitzt. Während der nächsten 2 h wird das Reaktionsgemisch bei 250 °C gehalten, wobei wenig Kondensat abdestilliert und sich im Wasserabscheider sammelt. Die Reaktionsmischung wird bis auf 190 °C abkühlen gelassen, dann werden 100 mL Ethylenglycol zugetropft. Man lässt weiter bis auf 80 °C abkühlen, tropft dann 500 mL Methanol zu und erhitzt 1 h auf Rückfluss. Die so erhaltene Suspension wird über eine Umkehrfritte filtriert, der Feststoff wird zweimal mit 50 ml Methanol gewaschen und dann im Vakuum getrocknet. Die weitere Reinigung erfolgt durch fünfmalige Heißextraktion mit Dichlormethan (Vorlagemenge jeweils ca. 350 ml, Extraktionshülse: Standard Soxhletthülsen aus Cellulose der Fa. Whatman) unter sorgfältigem Luft- und Lichtausschluss. Abschließend wird im Hochvakuum bei 300 °C getempert. Ausbeute: 10.5 g (5.7 mmol), 57 %. Reinheit: > 99.9 %ig nach ¹H NMR.

Es fallen ΔΔ- und ΛΛ-Isomere an, welche enantiomer sind und ein Racemat bilden. Die Racemattrennung in die beiden Enantiomere ist nach gängigen Methoden, wie Chromatographie an chiralen Medien oder fraktionierte Kristallisation, z. B. mit chiralen Säuren (z. B. Camphersulfonsäure), möglich.

Analog können die nachfolgende gezeigten Verbindungen synthetisiert werden. Die Verbindungen können prinzipiell durch Chromatographie (typischerweise Verwendung eines Säulenautomaten (Torrent der Firma Axel Semrau), Umkristallisation oder Heißextraktion gereinigt werden. Restlösemittel kann durch Tempern im Hochvakuum bei typischerweise 250 - 330 °C entfernt werden.

| Bsp. | Ligand | Produkt Heißextraktionsmittel | Ausbeute |
|---|---|---|---|
| Ir₂(L2) | L2 | 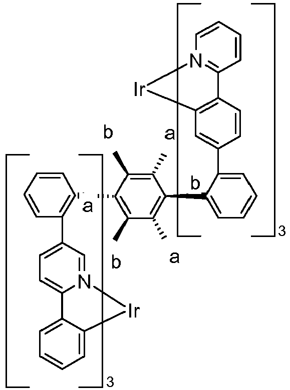 | 55% |
| | | Ir₂(L2) Toluol | |
| Rh₂(L2) | L2 | 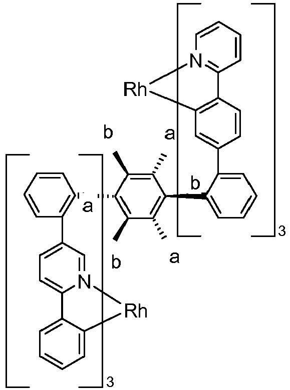 | 40 % |
| | | Einsatz von Rh(acac)₃ [14284-92-5] | |
| | | Rh₂(L2) | |
| | | Toluol | |
| Ir₂(L3) | L3 | Ir₂(L3) | |
| | | Toluol | |
| Ir₂(L4) | L4 | 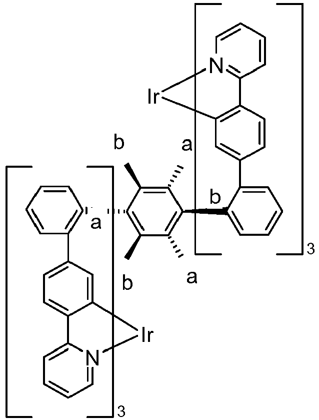 | 60 % |
| | | Ir₂(L4) | |
| | | Toluol | |
| Ir₂(L5) | L5 | Ir₂(L5) | 57 % |
| | | o-Xylol | |
| Ir₂(L6) | L6 | Ir₂(L6) | 53 % |
| | | Toluol | |
| Ir₂(L7) | L7 | 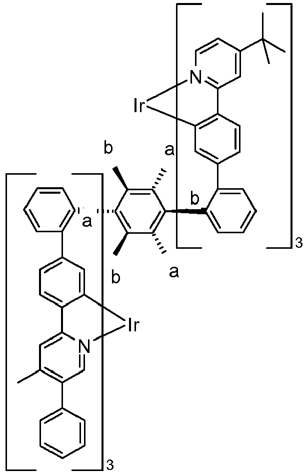 | 61 % |
| | | Ir₂(L7) | |
| | | Toluol | |
| Ir₂(L8) | L8 | Ir₂(L8) | 55% |
| | | Toluol | |
| Ir₂(L9) | L9 | Ir₂(L9) | 57 % |
| | | Toluol | |
| Ir₂(L0) | L10 | Ir₂(L10) | 51 % |
| | | o-Xylol | |
| Ir₂(L11) | L11 | Ir₂(L11) | 49 % |
| | | Toluol | |
| Ir₂(L1 2) | L12 | 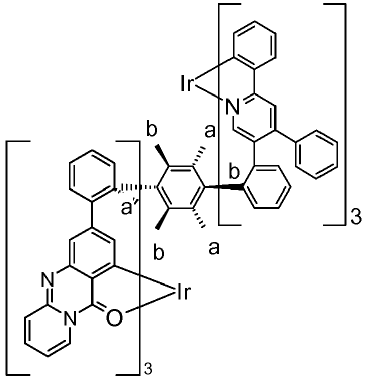 | 36 % |
| | | Ir₂(L12) | |
| | | Toluol | |
| Ir₂(L13) | L13 | 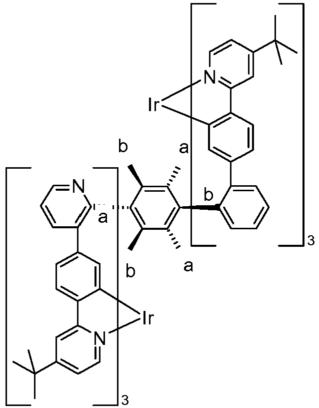 | 63 % |
| | | Ir₂(L1 3) | |
| | | Toluol | |
| Ir₂(L14) | L14 | Ir₂(L14) | 57 % |
| | | Toluol | |
| Ir₂(L1 5) | L15 | Ir₂(L1 5) | 54 % |
| | | Toluol | |
| Ir₂(L1 6) | L16 | 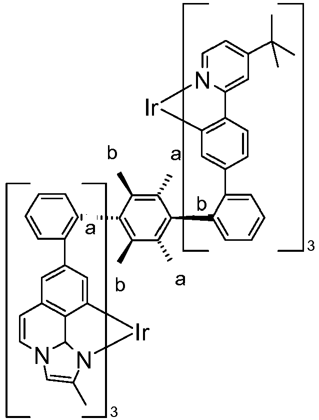 | 50 % |
| | | Ir₂(L1 6) | |
| | | o-Xylol | |
| Ir₂(L17) | L17 | 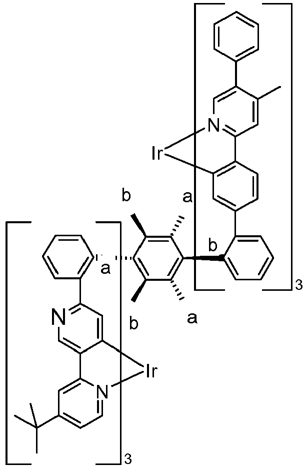 | 52 % |
| | | Ir₂(L1 7) | |
| | | Toluol | |
| Ir₂(L1 8) | L18 | Ir₂(L1 8) | 57 % |
| | | Toluol | |
| Ir₂(L1 9) | L19 | Ir₂(L1 9) | 58 % |
| | | Toluol | |
| Ir₂(L20) | L20 | 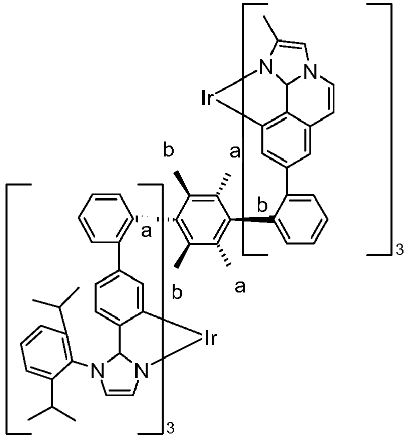 | 53 % |
| | | Ir₂(L20) | |
| | | Toluol | |
| Ir₂(L21) | L21 | Ir₂(L21) | 53 % |
| | | Toluol | |
| Ir₂(L22) | L22 | Ir₂(L22) | 59 % |
| | | o-Xylol | |
| Ir₂(L23) | L23 | 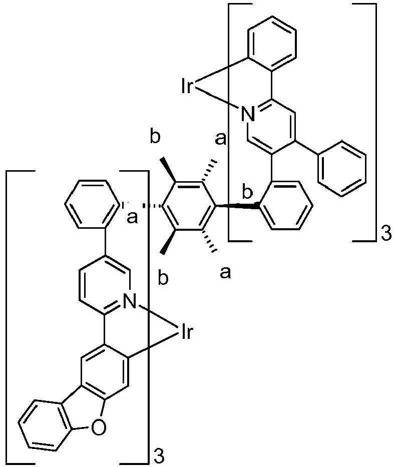 Ir₂(L23) | 57 % |
| | | Toluol | |
| Ir₂(L24) | L24 | Ir₂(L24) | 54 % |
| | | Toluol | |
| Ir₂(L25) | L25 | Ir₂(L25) | 48 % |
| | | Toluol | |
| Ir₂(L26) | L26 | Ir₂(L26) | 51 % |
| | | o-Xylol | |
| Ir₂(L27) | L27 | Ir₂(L27) | 56 % |
| | | Toluol | |
| Ir₂(L28) | L28 | Ir₂(L28) | 50 % |
| | | Chlorbenzol | |
| Ir₂(L29) | L29 | Ir₂(L29) | 61 % |
| | | Butylacetat | |

| | | | |
|---|---|---|---|
| * sofern abweichend von Standardvorschrift. | | | |

Analog können durch die Zugabe von zunächst 10 mmol Ir(acac)₃ und Reaktionsführung von 1 h bei 250 °C und dann Zugabe von 10 mmol Rh(acac)₃ [14284-92-5] und weitere Reaktionsführung von 1 h bei 250 °C und anschließender Aufarbeitung und Reinigung, wie oben angegeben, gemischt metallische Rh-Ir-Komplexe erhalten werden.

| | | | |
|---|---|---|---|
| Rh-Ir(L4) | L4 1) 10 mmol Ir(acac)₃ [15635-87 - 7] 2) 10 mmol Rh(acac)3 [14284-92-5] | 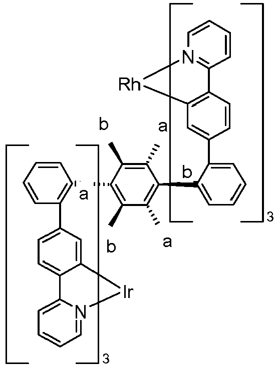 | 61 % |
| | | Rh-Ir(L4) Toluol | |

### D: Funktionalisierung der Metallkomplexe

### 1) Halogenierung der Iridium-Komplexe:

Eine Lösung bzw. Suspension von 1 mmol eines Komplexes, der in para-Position zum Iridium am bidentaten Teilliganden A x C-H-Gruppen (mit A = 1-6) trägt, in 200 ml bis 2000 ml Dichlormethan, je nach Löslichkeit der Metallkomplexe, wird unter Licht- und Luftausschluss bei -30 bis +30 °C mit A x 1.05 mmol N-Halogensuccinimid (Halogen: Cl, Br, I) versetzt und 20 h gerührt. In DCM schlecht lösliche Komplexe können auch in anderen Lösungsmitteln (TCE, THF, DMF, Chlorbenzol, etc.) und bei erhöhter Temperatur umgesetzt werden. Anschließend wird das Lösungsmittel im Vakuum weitgehend entfernt. Der Rückstand wird mit 30-100 ml Methanol ausgekocht, der Feststoff wird abgesaugt, dreimal mit 20 ml Methanol gewaschen und dann im Vakuum getrocknet. Man erhält so die in para-Position zum Iridium bromierten/halogenierten Iridium-Komplexe. Komplexe mit einem HOMO (CV) von ca. -5.1 bis -5.0 eV und betragsmäßig kleiner neigen zur Oxidation (Ir(III) → Ir(IV)), wobei das Oxidationsmittel Brom, freigesetzt aus NBS, ist. Diese Oxidationsreaktion ist durch eine deutliche Grünfärbung oder Braunfärbung der ansonsten gelben bis roten Lösungen bzw. Suspensionen der Emitter zu erkennen. In solchen Fällen werden 1-2 weitere Äquivalente NBS zugesetzt. Zur Aufarbeitung setzt man 30-100 ml Methanol und 0.5 ml Hydrazin Hydrat als Reduktionsmittel zu, wodurch sich die grüne bzw. braune Lösung bzw. Suspension gelb bzw. rot verfärbt (Reduktion Ir(IV) → Ir(III)). Dann zieht man im Vakuum das Lösungsmittel weitgehend ab, versetzt mit 50 ml Methanol, saugt den Feststoff ab, wäscht dreimal mit je 20 ml Methanol und trocknet im Vakuum.

Unterstöchiometrische Bromierungen, z. B. Mono-, Dibromierungen, etc. von Komplexen mit 6 C-H-Gruppen para-Position den Iridiumatomen, verlaufen meist weniger selektiv als die stöchiometrischen Bromierungen. Die Rohprodukte dieser Bromierungen können chromatographisch (CombiFlash Torrent der Fa. A. Semrau) getrennt werden.

### Synthese von Ir₂(L1-6Br):

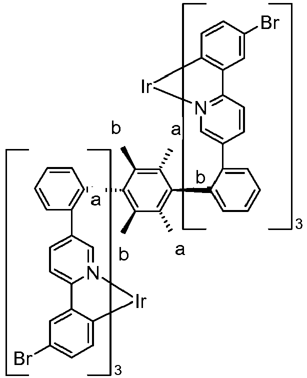

Eine Suspension von 1.61 g (1.0 mmol) Ir₂(L1) in 200 ml DCM wird auf einmal mit 1.16 g (6.5 mmol) N-Bromsuccinimid (NBS) versetzt und dann 20 h gerührt. Es werden 0.5 mL Hydrazinhydrat in 30 mL MeOH zugegeben. Nach Entfernen von ca. 180 ml des Lösungsmittels im Vakuum wird der gelbe Feststoff abgesaugt, dreimal mit ca. 20 ml Methanol gewaschen und dann im Vakuum getrocknet. Ausbeute: 2.02 g (0.97 mmol), 97 %; Reinheit: > 99.5 %ig nach NMR.

Analog können folgende Verbindungen synthetisiert werden:

| Bsp. | Edukte | Produkt | Ausbeute |
|---|---|---|---|
| Ir₂(L2-Br6) | Ir₂(L2) | 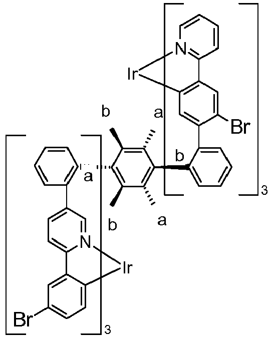 | 95 % |
| Ir₂(L4-Br6) | Ir₂(L4) | 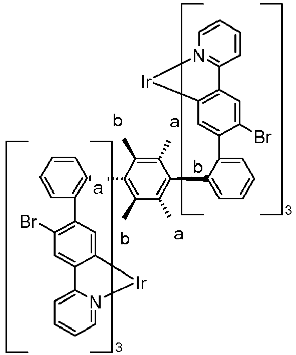 | 95 % |
| Ir₂(L6-Br6) | Ir₂(L6) | 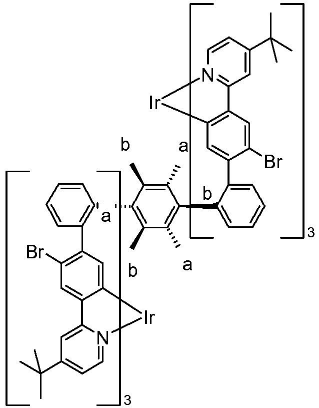 | 96 % |
| Ir₂(L7-Br6) | Ir₂(L7) | 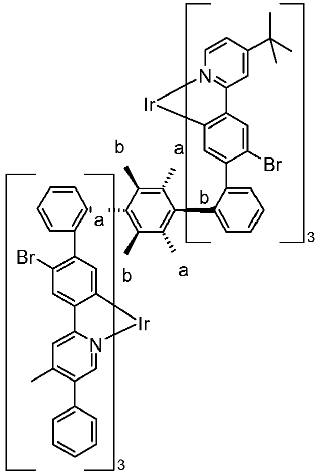 | 95 % |
| Ir₂(L1 0-Br3) | Ir₂(L10) 3.3 eq NBS | 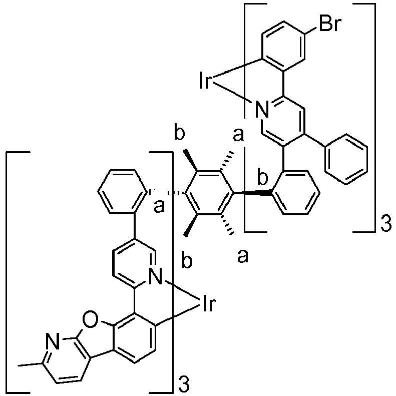 | 97% |
| Ir₂(L 14-Br6) | Ir₂(L14) | 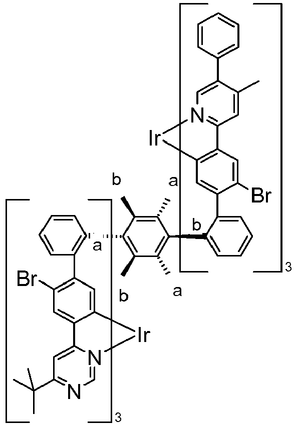 | 94 % |
| Ir₂(L 16-Br6) | Ir₂(L1 6) | 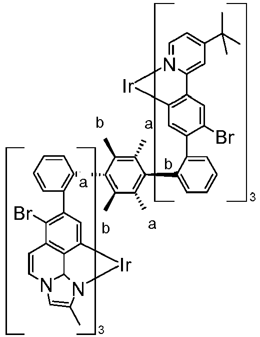 | 89% |
| Ir₂(L 17-Br3) | Ir₂(L17) 3.3 eq NBS | 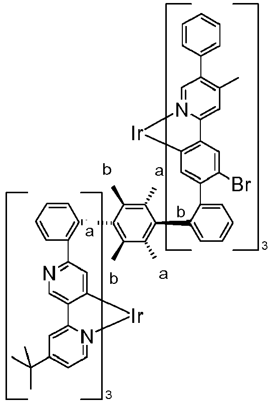 | 94 % |
| Ir₂(L 18-Br6) | Ir₂(L1 8) | 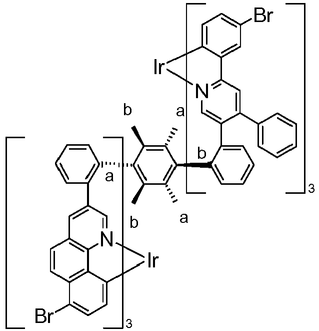 | 96 % |
| Ir₂(L22-Br3) | Ir₂(L22) 3.3 eq NBS | 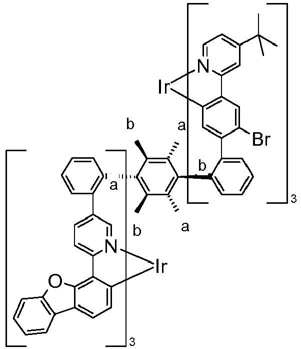 | 91 % |
| Ir₂(L28-Br6) | Ir₂(L28) | 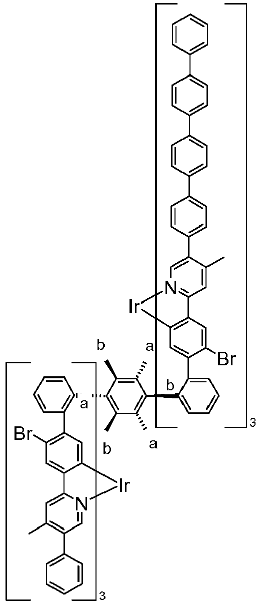 | 88 % |
| Ir₂(L29-Br6) | Ir₂(L29) | 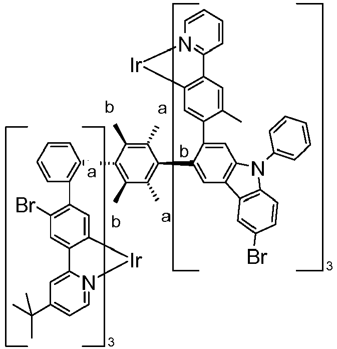 | 94 |

### 2) Suzuki-Kupplung an den bromierten Iridium-Komplexen:

### Variante A, zweiphasige Reaktionsmischung:

Eine Suspension von 1 mmol eines bromierten Komplexes, 1.2-2 mmol Boronsäure bzw. Boronsäureester pro Br-Funktion und 6-10 mmol Trikaliumphosphat in einem Gemisch aus 50 ml Toluol, 20 ml Dioxan und 50 ml Wasser wird mit 0.36 mmol Tri-o-tolylphosphin und dann mit 0.06 mmol Palladium(II)acetat versetzt und 16 h unter Rückfluss erhitzt. Nach Erkalten gibt man 50 ml Wasser und 50 ml Toluol zu, trennt die wässrige Phase ab, wäscht die organische Phase dreimal mit 50 ml Wasser, einmal mit 50 ml gesättigter Kochsalzlösung und trocknet über Magnesiumsulfat. Man filtriert über ein mit Toluol vorgeschlämmtes Celite-Bett ab, wäscht dieses mit Toluol nach, entfernt das Toluol fast vollständig im Vakuum, gibt 50 ml Methanol zu, saugt vom ausgefallenen Rohprodukt ab, wäscht dieses dreimal mit je 30 ml Methanol und trocknet im Vakuum. Das Rohprodukt wird an Kieselgel gesäult auf einem Säulenautomaten (Torrent der Firma Semrau). Anschließend wird der Komplex durch Heißextraktion in Lösungsmitteln wie Ethylacetat, Toluol, Dioxan, Acetonitril, Cyclohexan, ortho- oder para-Xylol, n-Butylacetat, Chlorbenzol etc. weiter gereinigt. Alternativ kann aus diesen Lösungsmitteln sowie Hochsiedern wie Dimethylformamid, Dimethylsulfoxid oder Mesitylen umkristallisiert werden. Der Metallkomplex wird abschließend getempert oder sublimiert. Das Tempern erfolgt im Hochvakuum (p ca. 10⁻⁶ mbar) im Temperaturbereich von ca. 200 - 300 °C.

### Variante B, einphasige Reaktionsmischung:

Eine Suspension von 1 mmol eines bromierten Komplexes, 1.2-2 mmol Boronsäure bzw. Boronsäureester pro Br-Funktion und 2-4 mmol der Base pro Br-Funktion (Kaliumfluorid, Trikaliumphosphat (wasserfrei, Monohydrat oder Trihydrat), Kaliumcarbonat, Cäsiumcarbonat etc.) und 10 g Glaskugeln (3 mm Durchmesser) in 30-50 ml eines aprotischen Lösungsmittels (THF, Dioxan, Xylol, Mesitylen, Dimethylacetamid, NMP, DMSO, etc.) wird mit 0.01 mmol pro Br-Funktion Tetrakis(triphenylphosphin)palladium(0) [14221-01-3] versetzt und 24 h unter Rückfluss erhitzt. Alternativ können andere Phosphine wie Triphenylphosphin, Tri-tert-butylphosphin, SPhos, XPhos, RuPhos, XanthPhos, etc. in Kombination mit Pd(OAc)₂ eingesetzt werden, wobei bei diesen Phosphinen das bevorzugte Phosphin: Palladium-Verhältnis 3:1 bis 1.2:1 beträgt. Man entfernt das Lösungsmittel im Vakuum, nimmt das Produkt in einem geeigneten Lösungsmittel (Toluol, Dichlormethan, Ethylacetat, etc.) auf und reinigt wie unter Variante A beschrieben.

Bei schwer löslichen Edukt-Komplexen kann es von Vorteil sein, zunächst die Suzuki-Kupplung nach Variante B durchzuführen und das erhaltene Rohprodukt einer erneuten Suzuki-Kupplung nach Variante A zu unterziehen, um einen möglichst vollständigen Umsatz zu erreichen. Nach der Isolierung des Rohproduktes können Spurenverunreinigungen durch verbliebenes Brom durch 16 h Kochen des Rohproduktes in 100 ml Toluol unter Zusatz von 10 mg Palladium(II)acetat und 1 ml Hydrazinhydrat entfernt werden. Im Anschluss wird das Rohprodukt wie oben beschrieben gereinigt.

### Synthese von Ir₂1:

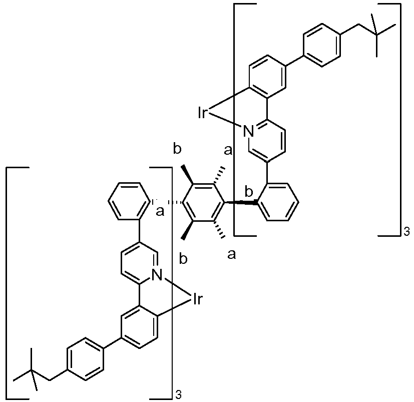

### Variante B:

Einsatz von 2.08 g (1.0 mmol) Ir(L1-6Br) und 2.31 g (12.0 mmol) [4-(2,2-Dimethylpropyl)phenyl]-boronsäure [186498-04-4], 4.15 g (18.0 mmol) Trikaliumphosphat Monohydrat, 70 mg (0.06 mmol) Tetrakis(triphenylphosphin)palladium(0), 50 mL trockenes Dimethylsulfoxid, 100 °C, 16 h. Chromatographische Trennung an Kieselgel mit DCM/n-Heptan (Säulenautomat, Torrent der Firma Axel Semrau), anschließend fünfmalige Heißextraktion mit Toluol. Ausbeute: 1.44 g (0.53 mmol), 53 %. Reinheit: ca. 99.9 %ig nach HPLC.

Analog können folgende Verbindungen dargestellt werden:

| **Bsp.** | **Edukte Variante** | **Produkt Heißextraktionslösungsmittel** | **Ausbeute** |
|---|---|---|---|
| Ir₂2 | Ir₂(L2-Br6) 912844-88-4 B | 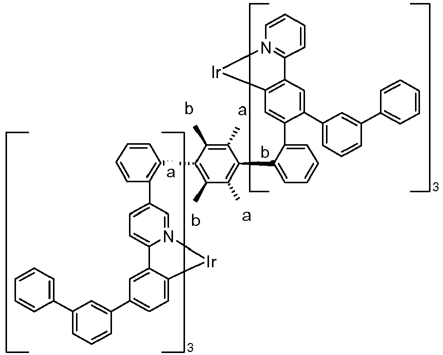 | 48 % |
| | | Butylacetat | |
| Ir₂3 | Ir₂(L4-Br6) 912844-88-4 B, dann A, dann Debromierung mit Hydrazinhydrat | 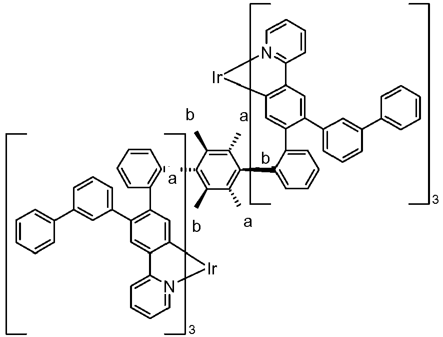 | 44 % |
| | | Toluol | |
| Ir₂4 | Ir₂(L6-Br6) 627526-15-2 B | 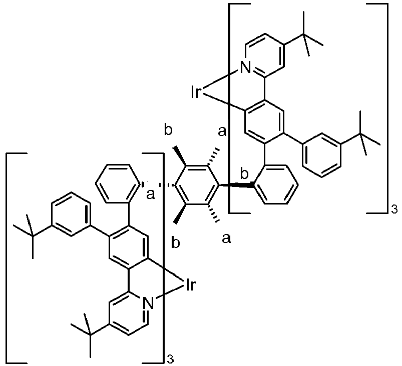 | 53 % 49 % |
| | | Ethylacetat | |
| Ir₂5 | Ir₂(L7-Br6) 888330-89-0 B, dann A, dann Debromierung mit Hydrazinhydrat | 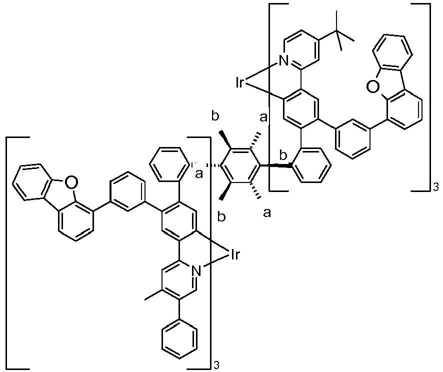 | |
| | | Butylacetat | |
| Ir₂6 | Ir₂(L1 0-Br3) 6 eq 1257248-43-3 B | 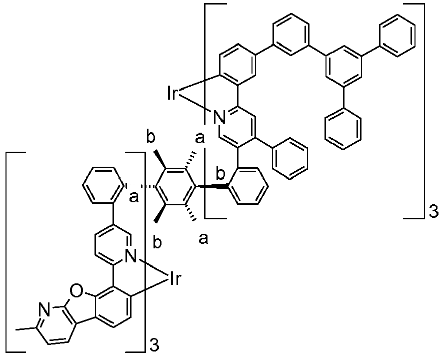 | 51 % |
| | | Toluol | |
| Ir₂7 | Ir₂(L 14-Br6) 796071-96-0 B | 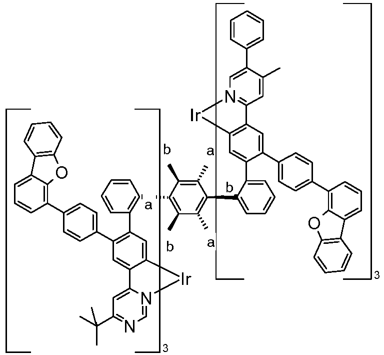 | 55 % |
| | | Toluol | |
| Ir₂8 | Ir₂(L 16-Br6) 84110-40-7 A S-Phos / Pd(ac)2 2/1 | 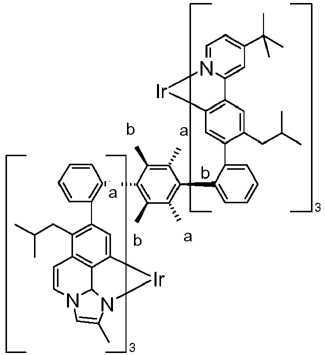 | 47 % |
| | | Acetonitril / Ethylacetat 1:1 (vv) | |
| Ir₂9 | Ir₂(L 17-Br3) 6 eq 1126522-69-7 A | 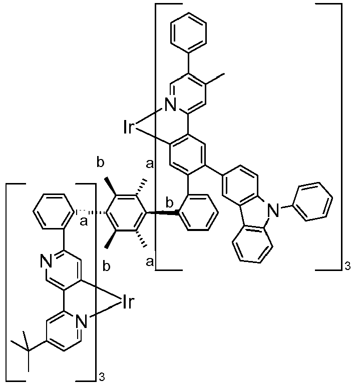 | 54 % |
| | | Toluol | |
| Ir₂10 | Ir₂(L 18-Br6) 186498-04-4 B | 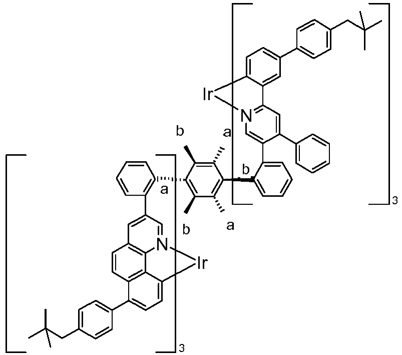 | 49 % |
| | | Butylacetat | |
| Ir₂11 | Ir₂(L22-Br3) 6 eq 912844-88-4 B | 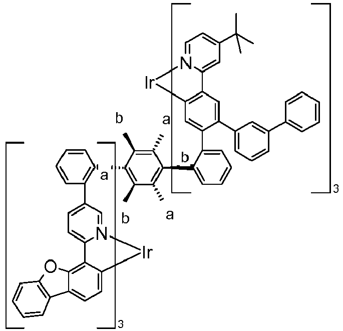 | 55 % |
| | | Butylacetat | |
| Ir₂12 | Ir₂(L28-Br6) 912844-88-4 B, dann A, dann Debromierung mit Hydrazinhydrat | 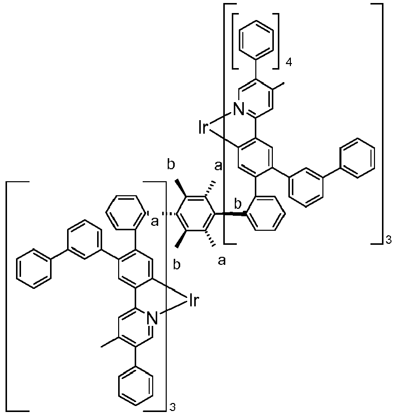 | 57 % |
| | | Toluol | |
| Ir₂14 | Ir₂(L29-Br6) 98-80-6 B, dann A, dann Debromierung mit Hydrazinhydrat | 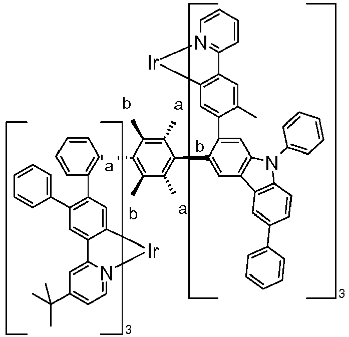 | 51 % |
| | | Ethylacetat | |
| Ir₂15 | Ir₂(L29-Br6) 1126522-69-7 B, dann A, dann Debromierung mit Hydrazinhydrat | 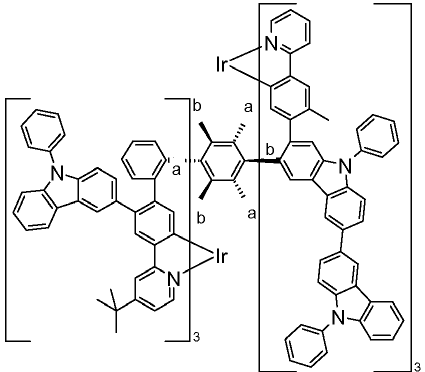 | 49 % |

### Beispiel: Thermische und photophysikalische Eigenschaften sowie Oxidations- und Reduktionspotentiale

Tabelle 1 fasst die thermischen und photochemischen Eigenschaften sowie Oxidationspotentiale der Vergleichsmaterialien und die ausgewählter erfindungsgemäßer Materialien zusammen. Die erfindungsgemäßen Verbindungen weisen eine im Vergleich zu den nicht-polypodalen Materialien nach Stand der Technik verbesserte thermische Stabilität und Photostabilität auf. Während nicht-polypodale Materialien nach Stand der Technik nach siebentägiger thermischer Auslagerung bei 380 °C Braunverfärbungen und Veraschung zeigen und man im ¹H-NMR Nebenkomponenten im Bereich > 2 mol % nachweisen kann, sind die erfindungsgemäßen Komplexe unter diesen Bedingungen inert. Außerdem weisen die erfindungsgemäßen Verbindungen eine sehr gute Photostabilität in wasserfreien C₆D₆-Lösung unter Bestrahlung mit Licht der Wellenlänge von ca. 455 nm auf. Insbesondere ist im Gegensatz zu nicht-polypodalen Komplexen nach Stand der Technik, die zweizähnige Liganden enthalten, im ¹H-NMR keine facial-meridional Isomerisierung nachzuweisen. Wie Tabelle 1 entnommen werden kann, zeichnen sich die erfindungsgemäßen Verbindungen in Lösung durch durchweg sehr hohe Photolumineszenz-Quanteneffizienzen (PLQE) aus.

**Tabelle 1:**

| **Komplex** | **HOMO [eV]** | **PL-max [nm]. FWHM [nm]** | **PLQE Lösungsmittel** | **Abklingzeit T [µs]** | **Therm. Stabilität Photochem. Stab.** |
|---|---|---|---|---|---|
| **Vergleichsbeispiele, Strukturen s. Device-Beispiele, Tabelle 2** | | | | | |
| Ref1 | -5.10 | 509 | 0.97 | 1.3 | Zers. |
| IrPPy | | 67 | Toluol | | Zers. |
| Ref2 | -5.12 | 520 | 0.98 | 1.6 | Keine Zers. |
| | | 64 | Toluol | | Keine Zers. |

| **Erfindungsgemäße Beispiele** | | | | | |
|---|---|---|---|---|---|
| Ir₂(L1) | -5.17 | 540 | 0.98 | 1.2 | Keine Zers. |
| | | 65 | Toluol | | Keine Zers. |
| Ir₂(L4) | -5.02 | 528 | 0.99 | 1.1 | Keine Zers. |
| | | 62 | Toluol | | Keine Zers. |
| Ir₂3 | -5.01 | 527 | 0.97 | 1.2 | Keine Zers. |
| | | 56 | Toluol | | Keine Zers. |

### Legende:

### - Therm. Stab. (thermische Stabilität):

Auslagerung in unter Vakuum abgeschmolzenen Ampullen, 7 Tage bei 380 °C. Visuelle Begutachtung auf Farbveränderung / Braunverfärbung / Veraschung und Analyse mittels ¹H-NMR Spektroskopie.

### - Photo. Stab. (photochemische Stabilität):

Bestrahlung ca. 1 mmolarer Lösungen in wasserfreiem C₆D₆ (entgaste und abgeschmolzene NMR-Röhrchen) mit blauem Licht (ca. 455 nm, 1.2 W Lumispot der Fa. Dialight Corporation, USA) bei Raumtemperatur.

### - PL-max.:

Maximum des PL-Spektrums in [nm] einer entgasten ca. 10⁻⁵ molaren Lösung bei RT, Anregungswellenlänge 370 nm, Lösungsmittel s. Spalte PLQE.

### - FWHM:

Halbwertsbreite des PL-Spektrums in [nm] bei RT.

### - PLQE.:

Absolute Photolumisenzenz-Quanteneffizienz einer entgasten, ca. 10⁻⁵ molaren Lösung im angegebenen Lösungsmittel bei RT gemessen als Absolutwert via Ulbrichtkugel.

### Abklingzeit:

T₁-Lebensdauermessungen werden durch time correlated single photon counting einer entgasten 10⁻⁵ molaren Lösung in Toluol bei Raumtemperatur bestimmt.

### - HOMO, LUMO:

in [eV] vs. Vakuum, bestimmt in Dichlormethan-Lösung (Oxidation) bzw. THF (Reduktion) mit interner Ref. Ferrocen (- 4.8 eV vs. Vakuum).

### Device-Beispiele:

### Herstellung der OLEDs

Die erfindungsgemäßen Komplexe können aus Lösung verarbeitet werden und führen gegenüber vakuumprozessierten OLEDs zu einfacher herstellbaren OLEDs mit dennoch guten Eigenschaften. Die Herstellung vollständig lösungsbasierter OLEDs ist in der Literatur bereits vielfach beschrieben, z. B. in WO 2004/037887. Die Herstellung vakuumbasierter OLEDs ist ebenfalls vielfach vorbeschrieben, u. a. in WO 2004/058911. In den im Folgenden diskutierten Beispielen werden lösungsbasiert und vakuumbasiert aufgebrachte Schichten innerhalb einer OLED kombiniert, so dass die Prozessierung bis einschließlich zur Emissionsschicht aus Lösung und der darauffolgenden Schichten (Lochblockierschicht und Elektronentransportschicht) aus dem Vakuum erfolgt. Die vorbeschriebenen allgemeinen Verfahren werden dafür wie folgt auf die hier beschriebenen Gegebenheiten (Schichtdickenvariation, Materialien) angepasst und kombiniert. Der generelle Aufbau ist wie folgt: Substrat / ITO (50 nm) / Lochinjektionsschicht (HIL) / Lochtransportschicht (HTL) / Emissionsschicht (EML) / Lochblockierschicht (HBL) / Elektronentransportschicht (ETL) / Kathode (Aluminium, 100 nm). Als Substrat dienen Glasplättchen, die mit strukturiertem ITO (Indium Zinn Oxid) der Dicke 50 nm beschichtet sind. Zur besseren Prozessierung werden diese mit PEDOT:PSS beschichtet (Poly(3,4-ethylendioxy-2,5-thiophen) : Polystyrolsulfonat, bezogen von Heraeus Precious Metals GmbH & Co. KG, Deutschland). PEDOT:PSS wird an Luft aus Wasser aufgeschleudert und nachfolgend an Luft bei 180 °C für 10 Minuten ausgeheizt, um Restwasser zu entfernen. Auf diese beschichteten Glasplättchen werden die Lochtransportschicht sowie die Emissionsschicht aufgebracht. Die verwendete Lochtransportschicht ist vernetzbar. Es wird ein Polymer gemäß der nachfolgenden abgebildeten Strukturen verwendet, das gemäß WO 2010/097155 bzw. WO 2013/156130 synthetisiert werden kann:

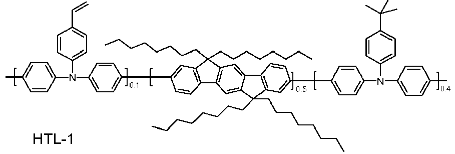

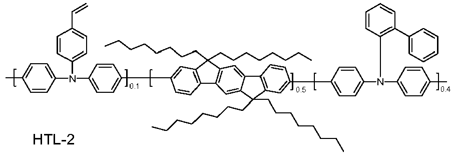

Das Lochtransport-Polymer wird in Toluol gelöst. Der typische Feststoffgehalt solcher Lösungen liegt bei ca. 5 g/l, wenn, wie hier, die für eine Device typische Schichtdicke von 20 nm mittels Spincoating erzielt werden soll. Die Schichten werden in einer Inertgasatmosphäre, im vorliegenden Fall Argon, aufgeschleudert und 60 Minuten bei 180 °C ausgeheizt. Die Emissionsschicht setzt sich immer aus mindestens einem Matrixmaterial (Hostmaterial, Wirtsmaterial) und einem emittierenden Dotierstoff (Dotand, Emitter) zusammen. Weiterhin aufreten können Mischungen aus mehreren Matrixmaterialien sowie Co-Dotanden. Eine Angabe wie TMM-A (92%) : Dotand (8%) bedeutet hierbei, dass das Material TMM-A in einem Gewichtsanteil von 92% und Dotand in einem Gewichtsanteil von 8% in der Emissionsschicht vorliegt. Die Mischung für die Emissionsschicht wird in Toluol oder ggf. Chlorbenzol gelöst. Der typische Feststoffgehalt solcher Lösungen liegt bei ca. 17 g/l, wenn, wie hier, die für eine Device typische Schichtdicke von 60 nm mittels Spincoating erzielt werden soll. Die Schichten werden in einer Inertgasatmosphäre, im vorliegenden Fall Argon, aufgeschleudert und 10 Minuten bei 150 °C ausgeheizt. Die im vorliegenden Fall verwendeten Materialien sind in Tabelle 2 gezeigt.

**Tabelle 2: Verwendete EML-Materialien**

| | | |
|---|---|---|
| 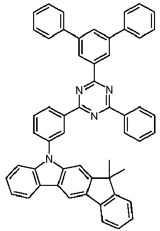 | 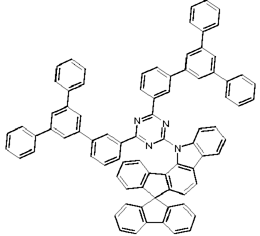 | 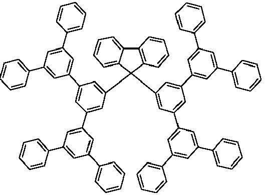 |
| A-1 | A-2 | B-1 |
| [1616231-83-4] | s. WO 2014/094963 | [1257248-89-7] |
| 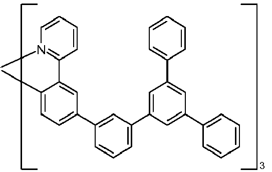 | 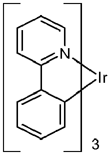 | 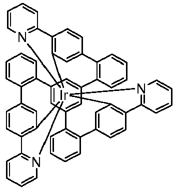 |
| G-1 | Ref1 | Ref2 |
| [1269508-30-6] | | |
| 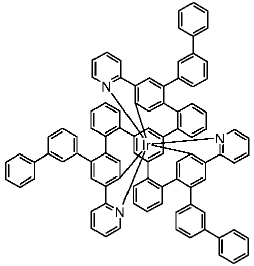 | 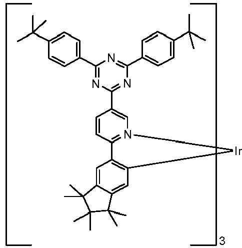 | 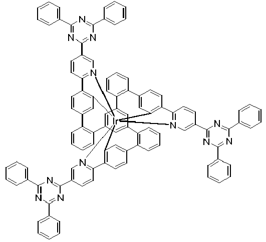 |
| G-2 | R-1 | R-2 |
| s. WO 2016/124304 | 1870013-87-8 | s. WO 2016/124304 |

Die Materialien für die Lochblockierschicht und Elektronentransportschicht werden in einer Vakuumkammer thermisch aufgedampft. Dabei kann z. B. die Elektronentransportschicht aus mehr als einem Material bestehen, wobei die Materialien einander durch Co-Verdampfung in einem bestimmten Volumenanteil beigemischt werden. Eine Angabe wie ETM1:ETM2 (50%:50%) bedeutet hierbei, dass die Materialien ETM1 und ETM2 in einem Volumenanteil von je 50% in der Schicht vorliegen. Die im vorliegenden Fall verwendeten Materialien sind in Tabelle 3 gezeigt.

**Tabelle 3: Verwendete HBL- und ETL-Materialien**

| | |
|---|---|
| 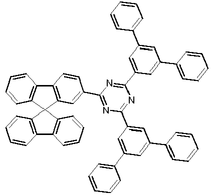 | 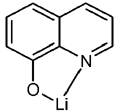 |
| ETM1 | ETM2 |
| [1233200-52-6] | [25387-93-3] |

Die Kathode wird durch die thermische Verdampfung einer 100 nm Aluminiumschicht gebildet. Die OLEDs werden standardmäßig charakterisiert. Hierfür werden die Elektrolumineszenzspektren, Strom-Spannungs-Leuchtdichte-Kennlinien (IUL-Kennlinien) unter Annahme einer Lambert'schen Abstrahlcharakteristik sowie die Betriebslebensdauer bestimmt. Aus den IUL-Kennlinien werden Kennzahlen bestimmt wie die Betriebsspannung (in V) und die Effizienz (cd/A) bei einer bestimmten Helligkeit. Die Elektrolumineszenzspektren werden bei einer Leuchtdichte von 1000 cd/m² gemessen und daraus die CIE 1931 x und y Farbkoordinaten berechnet. Als Lebensdauer wird die Zeit definiert, nach der die Leuchtdichte von einer bestimmten Startleuchtdichte aus auf einen gewissen Anteil abgesunken ist. Die Angabe LT90 bedeutet, dass es sich bei der genannten Lebensdauer um die Zeit handelt, bei der die Leuchtdichte auf 90% der Startleuchtdichte abgefallen ist, also von z. B. 1000 cd/m² auf 900 cd/m². Je nach Emissionsfarbe werden unterschiedliche Starthelligkeiten gewählt. Die Werte für die Lebensdauer können mit Hilfe dem Fachmann bekannten Umrechnungsformeln auf eine Angabe für andere Startleuchtdichten umgerechnet werden. Hierbei ist die Lebensdauer für eine Startleuchtdichte von 1000 cd/m² eine übliche Angabe. Alternativ können Lebensdauern bei einen bestimmten initialen Strom, z.B. 60 mA/cm², bestimmt werden. Die EML-Mischungen und Aufbauten der untersuchten OLED-Bauteile sind in Tabelle 4 und 5 dargestellt. Die zugehörigen Ergebnisse finden sich in Tabelle 6.

**Tabelle 4: EML-Mischungen der untersuchten OLED-Bauteile**

| Bsp. | Matrix A | | Co-Matrix B | | Co-Dotand C | | Dotand D | |
|---|---|---|---|---|---|---|---|---|
| | material | % | material | % | material | % | material | % |
| Rot | | | | | | | | |
| VR1 | A-2 | 30 | B-1 | 47 | G-1 | 17 | R-1 | 6 |
| VR2 | A-2 | 30 | B-1 | 34 | G-1 | 30 | R-2 | 6 |
| ER1 | A-2 | 30 | B-1 | 47 | Ir₂1 | 17 | R-1 | 6 |
| ER2 | A-2 | 30 | B-1 | 34 | Ir₂1 | 30 | R-2 | 6 |

| Grün - Gelb | | | | | | | | |
|---|---|---|---|---|---|---|---|---|
| VG1 | A-2 | 20 | B-1 | 60 | --- | --- | G1 | 20 |
| VG2 | A-2 | 20 | B-1 | 60 | --- | --- | G2 | 20 |
| EG1 | A-2 | 20 | B-1 | 60 | --- | --- | Ir₂(L5) | 20 |
| EG2 | A-2 | 20 | B-1 | 60 | --- | --- | Ir₂(L27) | 20 |
| EG3 | A-2 | 20 | B-1 | 60 | --- | --- | Ir₂1 | 20 |
| EG4 | A-2 | 20 | B-1 | 60 | --- | --- | Ir₂3 | 20 |
| EG5 | A-2 | 20 | B-1 | 60 | --- | --- | Ir₂4 | 20 |
| EG6 | A-1 | 20 | B-1 | 60 | --- | --- | Ir₂6 | 20 |
| EG7 | A-1 | 20 | B-1 | 60 | --- | --- | Ir₂9 | 20 |
| EG8 | A-1 | 20 | B-1 | 60 | --- | --- | Ir₂12 | 20 |

**Tabelle 5: Aufbau der untersuchten OLED-Bauteile**

| Bsp. | HIL (Dicke) | HTL (Dicke) | EML (Dicke) | HBL (Dicke) | ETL (Dicke) |
|---|---|---|---|---|---|
| Rot | | | | | |
| VR1 | PEDOT (60nm) | HTL2 (20nm) | 60nm | ETM-1 (10nm) | ETM-1 (50%) : ETM-2 (50%) (40nm) |
| VR2 | PEDOT (60nm) | HTL2 (20nm) | 60nm | ETM-1 (10nm) | ETM-1 (50%) : ETM-2 (50%) (40nm) |
| ER1 | PEDOT (60nm) | HTL2 (20nm) | 60nm | ETM-1 (10nm) | ETM-1 (50%) : ETM-2 (50%) (40nm) |
| ER2 | PEDOT (60nm) | HTL2 (20nm) | 60nm | ETM-1 (10nm) | ETM-1 (50%) : ETM-2 (50%) (40nm) |

| Gelb - Grün | | | | | |
|---|---|---|---|---|---|
| VG1 | PEDOT (60nm) | HTL2 (20nm) | 60nm | ETM-1 (10nm) | ETM-1 (50%) : ETM-2 (50%) (40nm) |
| VG2 | PEDOT (60nm) | HTL2 (20nm) | 60nm | ETM-1 (10nm) | ETM-1 (50%) : ETM-2 (50%) (40nm) |
| EG1 | PEDOT (60nm) | HTL2 (20nm) | 60nm | ETM-1 (10nm) | ETM-1 (50%) : ETM-2 (50%) (40nm) |
| EG2 | PEDOT (60nm) | HTL2 (20nm) | 60nm | ETM-1 (10nm) | ETM-1 (50%) : ETM-2 (50%) (40nm) |
| EG3 | PEDOT (60nm) | HTL2 (20nm) | 60nm | ETM-1 (10nm) | ETM-1 (50%) : ETM-2 (50%) (40nm) |
| EG4 | PEDOT (60nm) | HTL2 (20nm) | 60nm | ETM-1 (10nm) | ETM-1 (50%) : ETM-2 (50%) (40nm) |
| EG5 | PEDOT (60nm) | HTL2 (20nm) | 60nm | ETM-1 (10nm) | ETM-1 (50%) : ETM-2 (50%) (40nm) |
| EG6 | PEDOT (60nm) | HTL2 (20nm) | 60nm | ETM-1 (10nm) | ETM-1 (50%) : ETM-2 (50%) (40nm) |
| EG7 | PEDOT (60nm) | HTL2 (20nm) | 60nm | ETM-1 (10nm) | ETM-1 (50%) : ETM-2 (50%) (40nm) |
| EG8 | PEDOT (60nm) | HTL2 (20nm) | 60nm | ETM-1 (10nm) | ETM-1 (50%) : ETM-2 (50%) (40nm) |

**Tabelle 6: Ergebnisse lösungsprozessierter OLEDs (bei einer Helligkeit von 1000 cd/m²)**

| Bsp. | EQE [%] | CIE x | CIE y | LT90 @60mA/cm² |
|---|---|---|---|---|
| Rot | | | | |
| VR1 | 16.2 | 0.66 | 0.34 | 276 |
| VR2 | 18.2 | 0.64 | 0.36 | 298 |
| ER1 | 16.8 | 0.66 | 0.34 | 300 |
| ER2 | 19.0 | 0.66 | 0.34 | 346 |

| Gelb-Grün | | | | |
|---|---|---|---|---|
| Bsp. | EQE [%] | CIE x | CIE y | LT90 @1000cd/m² |
| VG1 | 19.9 | 0.32 | 0.63 | 20000 |
| VG2 | 21.5 | 0.32 | 0.65 | 28000 |
| EG1 | 21.3 | 0.49 | 0.50 | 55000 |
| EG2 | 20.6 | 0.34 | 0.63 | 33000 |
| EG3 | 20.8 | 0.38 | 0.61 | 38000 |
| EG4 | 21.8 | 0.33 | 0.64 | 32000 |
| EG5 | 22.0 | 0.33 | 0.63 | 33000 |
| EG6 | 21.7 | 0.45 | 0.48 | 47000 |
| EG7 | 21.3 | 0.34 | 0.63 | 35000 |
| EG8 | 22.3 | 0.35 | 0.62 | 34000 |

Die folgenden erfindungsgemäßen Verbindungen Ir₂(L2), Ir₂(L3), Ir₂(L4), Ir₂(L6), Ir₂(L7), Ir₂(L8), Ir₂(L9), Ir₂(L10), Ir₂(L11), Ir₂(L12), Ir₂(L13), Ir₂(L14), Ir₂(L15), Ir₂(L16), Ir₂(L17), Ir₂(L18), Ir₂(L19), Ir₂(L20), Ir₂(L21), Ir₂(L22), Ir₂(L23), Ir₂(L24), Ir₂(L25), Ir₂(L26), Ir₂(L27), Ir₂(L28), Ir₂(L29), Rh-Ir(L4), Ir₂2, Ir₂4, Ir₂5, Ir₂7, Ir₂8, Ir₂9, Ir₂10, Ir₂11, Ir₂13, Ir₂14, Ir₂15 können ebenfalls in OLED Devices verbaut werden und zeigen gelb-grüne bzw. rote Elektrolumineszenz, gute Effizienzen und lange Lebensdauern.

## Patentansprüche

1. Verbindung gemäß Formel (1), 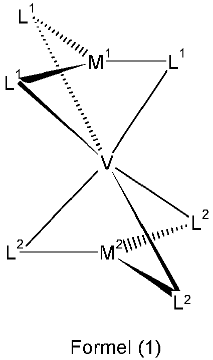 wobei für die verwendeten Symbole gilt:
M¹, M² ist gleich oder verschieden Iridium oder Rhodium;
V ist eine Gruppe der Formel (2) oder (3), 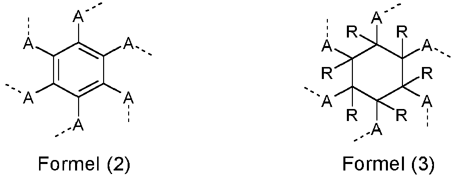
wobei die gestrichelten Bindungen in 1-, 3- und 5-Position die Bindungen zu L¹ darstellen und die gestrichelten Bindungen in 2-, 4- und 6-Position die Bindungen zu L² darstellen;
L¹, L² ist bei jedem Auftreten gleich oder verschieden ein bidentater, monoanionischer Teilligand;
A ist bei jedem Auftreten gleich oder verschieden -CR=CR-, -C(=O)-NR'-, -C(=O)-O-, -CR₂-CR₂-, -CR₂-O- oder eine Gruppe der Formel (4), 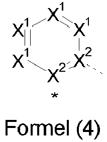
wobei die gestrichelte Bindung die Position der Bindung eines bidentaten Teilliganden L¹ bzw. L² an diese Struktur darstellt und * die Position der Verknüpfung der Einheit der Formel (4) mit der Benzol- bzw. Cyclohexangruppe in Formel (2) bzw. (3) darstellt;
X¹ ist bei jedem Auftreten gleich oder verschieden CR oder N oder zwei benachbarte Gruppen X¹ stehen zusammen für NR, O oder S, so dass ein Fünfring entsteht, und die verbleibenden X¹ stehen gleich oder verschieden bei jedem Auftreten für CR oder N; oder zwei benachbarte Gruppen X¹ stehen zusammen für CR oder N, wenn in dem Cyclus eine der Gruppen X² für N steht, so dass ein Fünfring entsteht; mit der Maßgabe, dass maximal zwei benachbarte Gruppen X¹ für N stehen;
X² ist bei jedem Auftreten C oder eine Gruppe X² steht für N und die andere Gruppe X² in demselben Cyclus steht für C; mit der Maßgabe, dass zwei benachbarte Gruppen X¹ zusammen für CR oder N stehen, wenn in dem Cyclus eine der Gruppen X² für N steht;
R ist bei jedem Auftreten gleich oder verschieden H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, COO(Kation), SO₃(Kation), OSO₃(Kation), OPO₃(Kation)₂, O(Kation), N(R¹)₃(Anion), P(R¹)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann, wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein Ringsystem bilden;
R' ist bei jedem Auftreten gleich oder verschieden H, D, eine geradkettige Alkylgruppe mit 1 bis 20 C-Atomen oder eine verzweigte oder cyclische Alkylgruppe mit 3 bis 20 C-Atomen, wobei die Alkylgruppe jeweils mit einem oder mehreren Resten R¹ substituiert sein kann und wobei eine oder mehrere nicht benachbarte CH₂-Gruppen durch Si(R¹)₂ ersetzt sein können, oder ein aromatisches oder heteroaromatisches Ringsystem mit 5 bis 40 aromatischen Ringatomen, das jeweils durch einen oder mehrere Reste R¹ substituiert sein kann;
R¹ ist bei jedem Auftreten gleich oder verschieden H, D, F, Cl, Br, I, N(R²)₂, CN, NO₂, OR², SR², Si(R²)₃, B(OR²)₂, C(=O)R², P(=O)(R²)₂, S(=O)R², S(=O)₂R², OSO₂R², COO(Kation), SO₃(Kation), OSO₃(Kation), OPO₃(Kation)₂, O(Kation), N(R²)₃(Anion), P(R²)₃(Anion), eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann, wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein Ringsystem bilden;
R² ist bei jedem Auftreten gleich oder verschieden H, D, F oder ein aliphatischer, aromatischer oder heteroaromatischer organischer Rest, insbesondere ein Kohlenwasserstoffrest, mit 1 bis 20 C-Atomen, in dem auch ein oder mehrere H-Atome durch F ersetzt sein können;
Kation ist bei jedem Auftreten gleich oder verschieden ausgewählt aus der Gruppe bestehend aus Proton, Deuteron, Alkaliionen, Erdalkaliionen, Ammonium, Tetraalkylammonium und Tetraalkylphosphonium;
Anion ist bei jedem Auftreten gleich oder verschieden ausgewählt aus der Gruppe bestehend aus Halogeniden, Carboxylaten R²-COO⁻, Cyanid, Cyanat, Isocyanat, Thiocyanat, Thioisocyanat, Hydroxid, BF₄⁻, PF₆⁻, B(C₆F₅)₄⁻, Carbonat und Sulfonaten.

2. Verbindung nach Anspruch 1, **dadurch gekennzeichnet, dass** M¹ und M² für Ir(III) stehen und die Verbindung ungeladen ist.

3. Verbindung nach Anspruch 1 oder 2, **dadurch gekennzeichnet, dass** die Gruppe der Formel (4) ausgewählt ist aus den Strukturen der Formeln (5) bis (29), 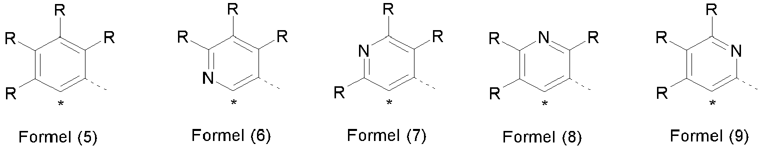 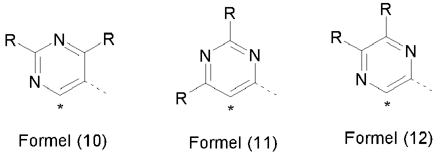 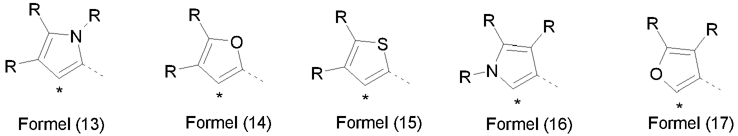 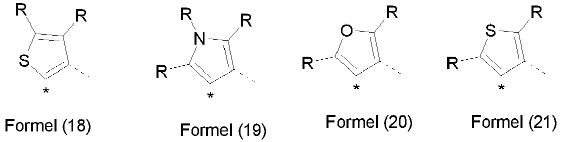 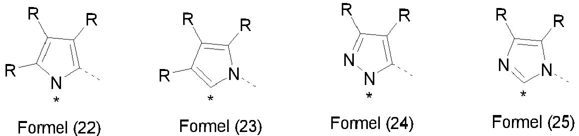 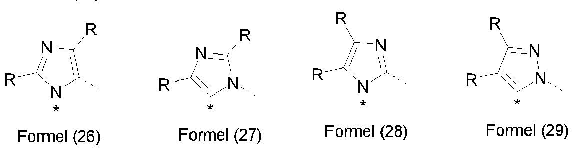 wobei die Symbole die in Anspruch 1 genannten Bedeutungen aufweisen.

4. Verbindung nach einem oder mehreren der Ansprüche 1 bis 3, **dadurch gekennzeichnet, dass** die Gruppe der Formel (2) ausgewählt ist aus den Gruppen der Formeln (2a) bis (2e) und dass die Gruppe der Formel (3) ausgewählt ist aus den Gruppen der Formeln (3a) bis (3e), 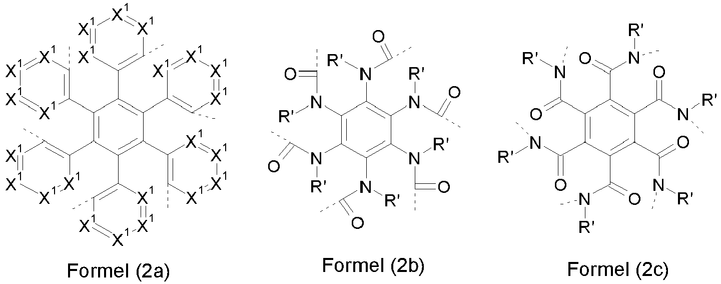 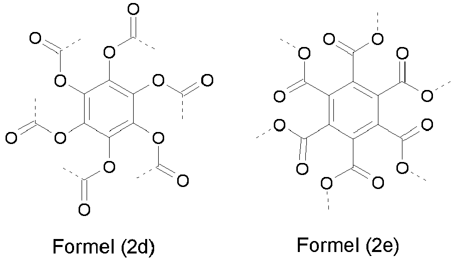 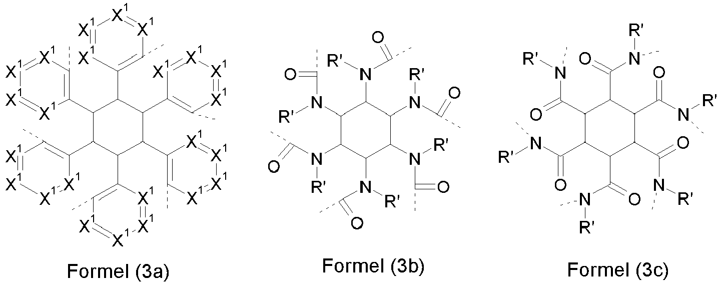 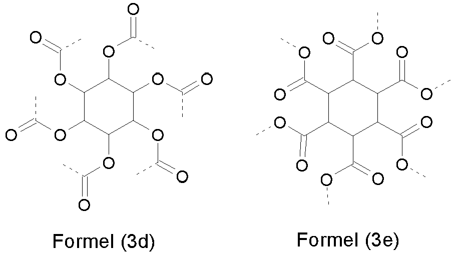 wobei die Symbole die in Anspruch 1 genannten Bedeutungen aufweisen.

5. Verbindung nach einem oder mehreren der Ansprüche 1 bis 4, **dadurch gekennzeichnet, dass** die Gruppe der Formel (2) ausgewählt ist aus den Gruppen der Formeln (2a') und die Gruppe der Formel (3) ausgewählt ist aus den Gruppen der Formeln (3a'), 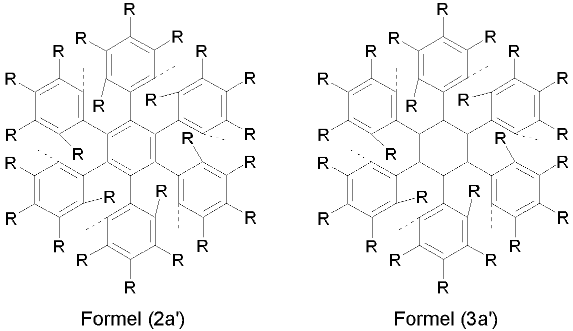 wobei die Symbole die in Anspruch 1 genannten Bedeutungen aufweisen.

6. Verbindung nach einem oder mehreren der Ansprüche 1 bis 5, **dadurch gekennzeichnet, dass** die Gruppe der Formel (2) ausgewählt ist aus den Gruppen der Formeln (2a") und die Gruppe der Formel (3) ausgewählt ist aus den Gruppen der Formeln (3a"),

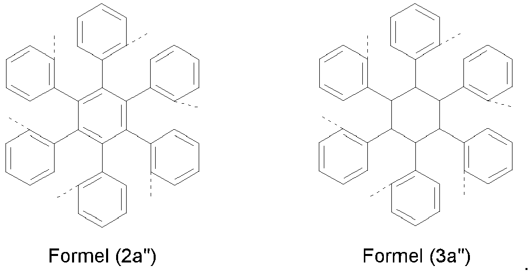

7. Verbindung nach einem oder mehreren der Ansprüche 1 bis 6, **dadurch gekennzeichnet, dass** alle drei Teilliganden L¹ gleich sind und alle drei Teilliganden L² sind gleich, wobei L¹ = L² oder L¹ ≠ L² sein kann.

8. Verbindung nach einem oder mehreren der Ansprüche 1 bis 7, **dadurch gekennzeichnet, dass** alle Teilliganden L¹ und L² ein Kohlenstoffatom und ein Stickstoffatom oder zwei Kohlenstoffatome als koordinierende Atome aufweisen.

9. Verbindung nach einem oder mehreren der Ansprüche 1 bis 8, **dadurch gekennzeichnet, dass** mindestens zwei der Teilliganden L¹ und mindestens zwei der Teilliganden L² gleich oder verschieden bei jedem Auftreten ausgewählt sind aus den Strukturen der Formeln (L-1), (L-2) oder (L-3), 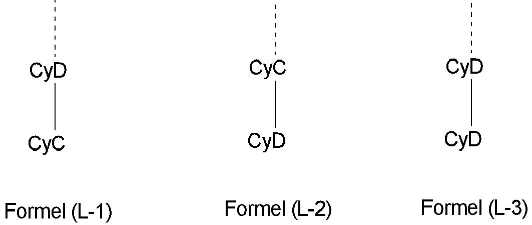 wobei die gestrichelte Bindung die Bindung des Teilliganden L¹ bzw. L² an V darstellt und für die weiteren verwendeten Symbole gilt:
CyC ist gleich oder verschieden bei jedem Auftreten eine substituierte oder unsubstituierte Aryl- oder Heteroarylgruppe mit 5 bis 14 aromatischen Ringatomen, welche über ein Kohlenstoffatom an M koordiniert und welche über eine kovalente Bindung mit CyD verbunden ist;
CyD ist gleich oder verschieden bei jedem Auftreten eine substituierte oder unsubstituierte Heteroarylgruppe mit 5 bis 14 aromatischen Ringatomen, welche über ein Stickstoffatom oder über ein Carben-Kohlenstoffatom an M koordiniert und welche über eine kovalente Bindung mit CyC verbunden ist;
dabei können mehrere der Substituenten miteinander ein Ringsystem bilden.

10. Verbindung nach einem oder mehreren der Ansprüche 1 bis 9, **dadurch gekennzeichnet, dass** die Gruppe CyC ausgewählt ist aus den Strukturen der Formeln (CyC-1) bis (CyC-20) und dass die Gruppe CyD ausgewählt ist aus den Strukturen der Formeln (CyD-1) bis (CyD-14), 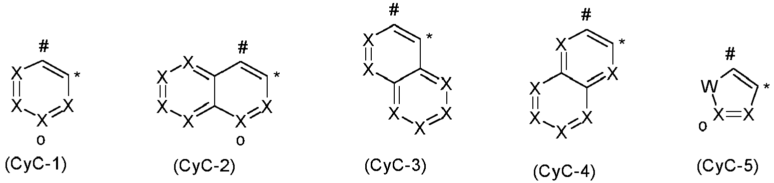 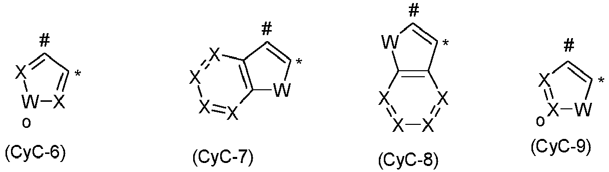 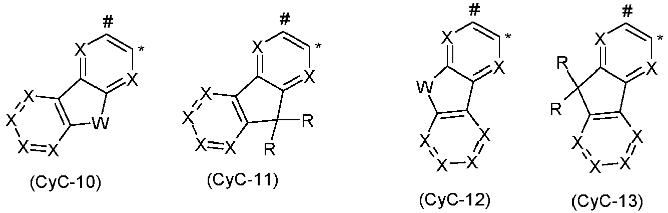 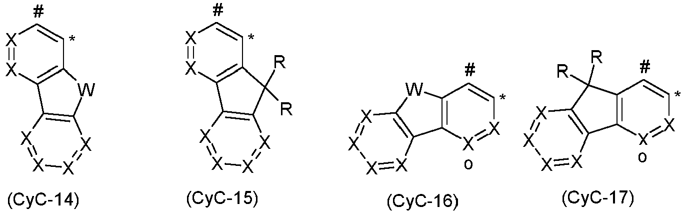 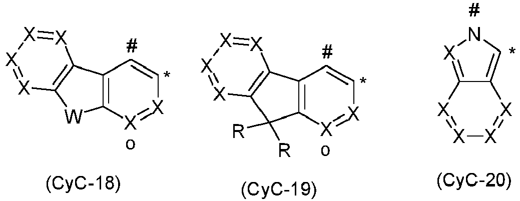 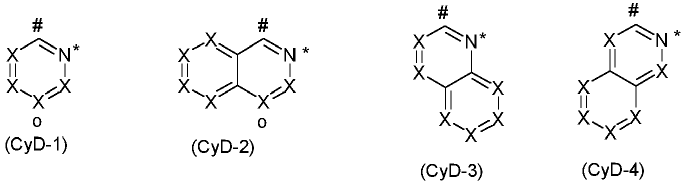 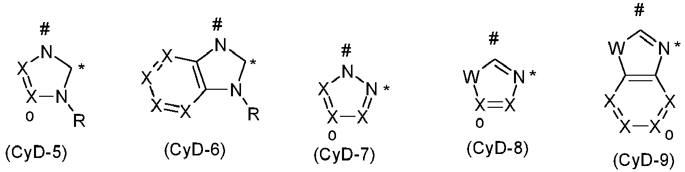 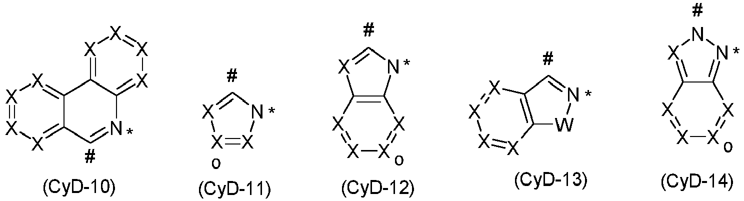 wobei die Gruppen CyC und CyD jeweils an der durch # gekennzeichneten Position aneinander binden und an der durch * gekennzeichneten Position an das Metall koordinieren und "o" die mögliche Position der Bindung an V darstellt, falls diese Gruppe an V gebunden ist, und die weiteren Symbole die folgenden Bedeutungen aufweisen:
X ist bei jedem Auftreten gleich oder verschieden CR oder N mit der Maßgabe, dass maximal zwei Symbole X pro Cyclus für N stehen;
W ist NR, O oder S;
mit der Maßgabe, dass das Symbol X in CyC oder CyD, über das der Teilligand an V gebunden ist, für C steht und V an dieses Kohlenstoffatom gebunden ist.

11. Verbindung nach einem oder mehreren der Ansprüche 1 bis 10, **dadurch gekennzeichnet, dass** die Teilliganden L¹ und L² gleich oder verschieden bei jedem Auftreten ausgewählt sind aus den Strukturen der Formeln (L-1-1), (L-1-2), (L-2-1) bis (L-2-3) und (L-4) bis (L-38), 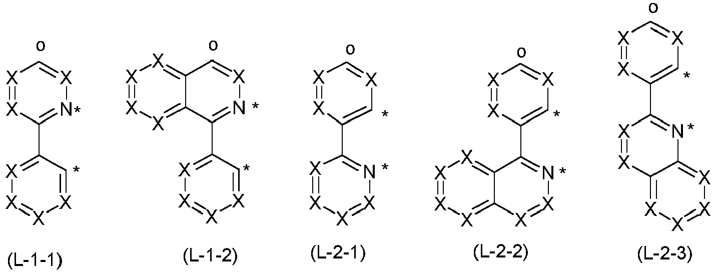 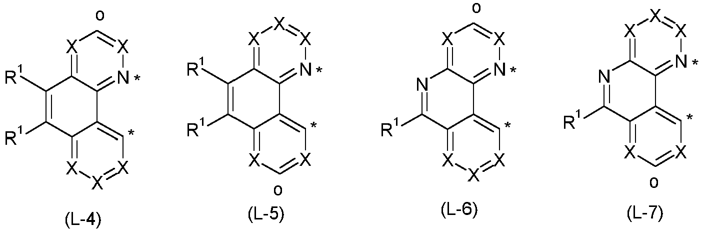 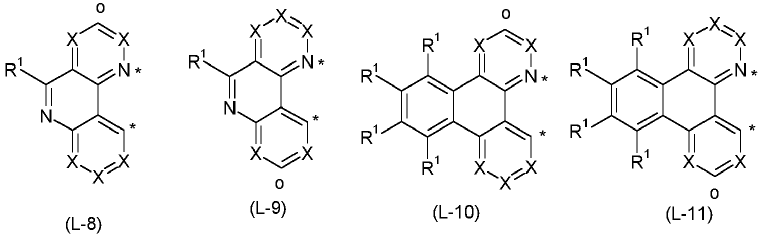 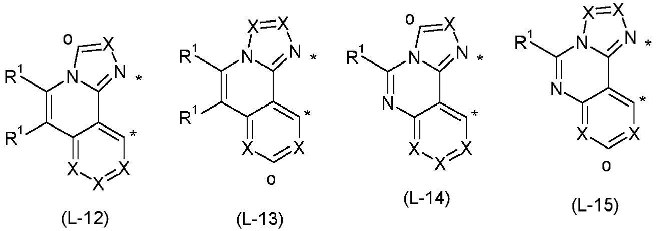 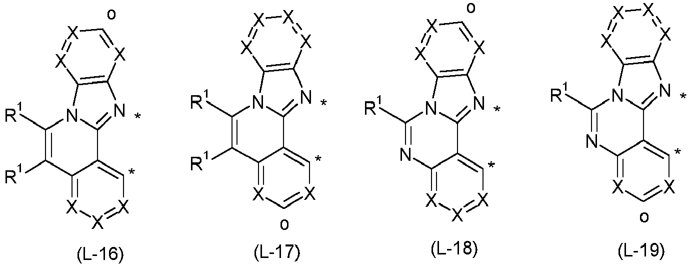 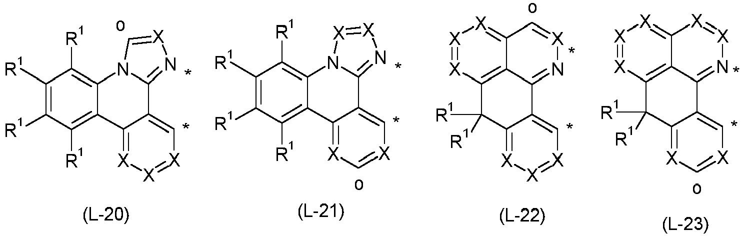 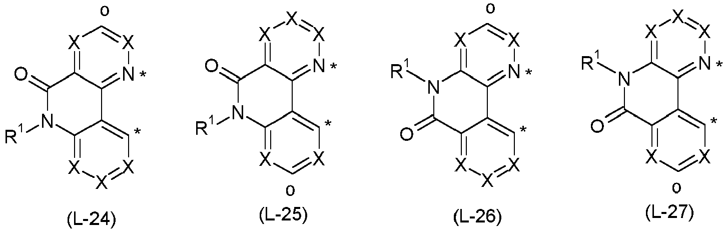 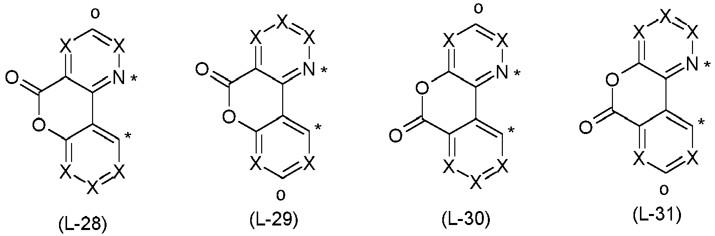 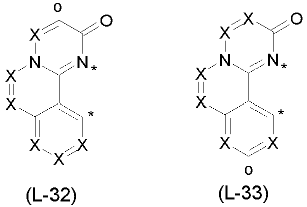 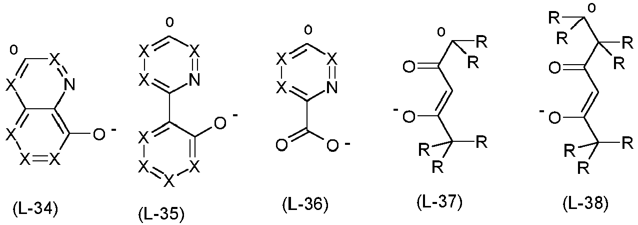 wobei die verwendeten Symbole die in Anspruch 1 und 10 genannten Bedeutungen aufweisen, * die Position der Koordination an das Iridium andeutet und "o" die Position der Bindung an V darstellt; dabei koordinieren die Teilliganden (L-34) bis (L-36) jeweils über das explizit eingezeichnete Stickstoffatom und das negativ geladene Sauerstoffatom und die Teilliganden (L-37) und (L-38) koordinieren über die beiden Sauerstoffatome.

12. Verfahren zur Herstellung einer Verbindung nach einem oder mehreren der Ansprüche 1 bis 11 durch Umsetzung des Liganden mit Metallalkoholaten der Formel (48), mit Metallketoketonaten der Formel (49), mit Metallhalogeniden der Formel (50), mit Metallcarboxylaten der Formel (51) oder mit Iridium- bzw. Rhodiumverbindungen, die sowohl Alkoholat- und/oder Halogenid- und/oder Hydroxy- wie auch Ketoketonatreste tragen,
| | | | |
|---|---|---|---|
| M(OR)₃ Formel (48) | 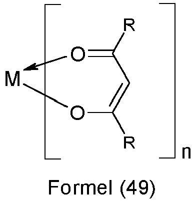 | MHal₃ Formel (50) | M(OOCR)₃ Formel (51) |
wobei M für Iridium oder Rhodium steht, R die in Anspruch 1 angegebenen Bedeutungen aufweist, Hal = F, Cl, Br oder I ist und die Iridium- bzw. Rhodiumedukte auch als die entsprechenden Hydrate vorliegen können.

13. Formulierung, enthaltend mindestens eine Verbindung nach einem oder mehreren der Ansprüche 1 bis 11 und mindestens eine weitere Verbindung, wobei die weitere Verbindung ausgewählt ist aus mindestens einem Lösemittel und/oder mindestens einem Matrixmaterial.

14. Verwendung einer Verbindung nach einem oder mehreren der Ansprüche 1 bis 11 in einer elektronischen Vorrichtung oder als Sauerstoff-Sensibilisator oder in der Photokatalyse.

15. Elektronische Vorrichtung enthaltend mindestens eine Verbindung nach einem oder mehreren der Anspsrüche 1 bis 11, wobei die elektronische Vorrichtung bevorzugt ausgewählt ist aus der Gruppe bestehend aus organischen Elektrolumineszenzvorrichtungen, organischen integrierten Schaltungen, organischen Feld-Effekt-Transistoren, organischen Dünnfilmtransistoren, organischen lichtemittierenden Transistoren, organischen Solarzellen, organischen optischen Detektoren, organischen Photorezeptoren, organischen Feld-Quench-Devices, lichtemittierenden elektrochemischen Zellen, Sauerstoff-Sensoren oder organischen Laserdioden.

16. Elektronische Vorrichtung nach Anspruch 15, wobei es sich um eine organische Elektrolumineszenzvorrichtung handelt, **dadurch gekennzeichnet, dass** die Verbindung nach einem oder mehreren der Ansprüche 1 bis 11 als emittierende Verbindung in einer oder mehreren emittierenden Schichten vorliegt.

## Claims

1. Compound of formula (1) 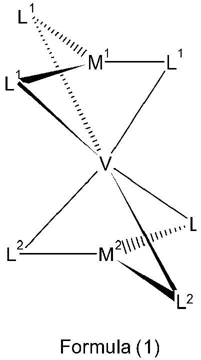 where the symbols used are as follows:
M¹, M² is the same or different and is iridium or rhodium;
V is a group of the formula (2) or (3) 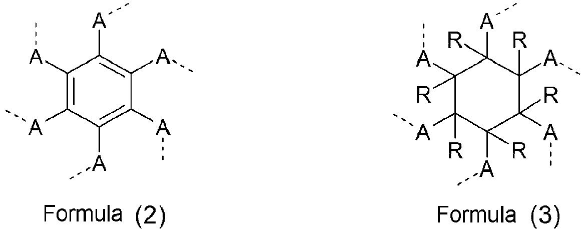
where the dotted bonds in the 1, 3 and 5 positions represent the bonds to L¹ and the dotted bonds in the 2, 4 and 6 positions represent the bonds to L²;
L¹, L² is the same or different at each instance and is a bidentate monoanionic sub-ligand;
A is the same or different at each instance and is -CR=CR-, -C(=O)-NR'-, -C(=O)-O-, -CR₂-CR₂-, -CR₂-O- or a group of the formula (4) 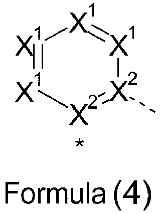
where the dotted bond represents the position of the bond of one bidentate sub-ligand L¹ or L² to this structure and * represents the position of the linkage of the unit of the formula (4) to the benzene or cyclohexane group in formula (2) or (3) ;
X¹ is the same or different at each instance and is CR or N or two adjacent X¹ groups together are NR, O or S, thus forming a five-membered ring, and the remaining X¹ are the same or different at each instance and are CR or N; or two adjacent X¹ groups together are CR or N when one of the X² groups in the cycle is N, thus forming a five-membered ring; with the proviso that not more than two adjacent X¹ groups are N;
X² is C at each instance or one X² group is N and the other X² group in the same cycle is C; with the proviso that two adjacent X¹ groups together are CR or N when one of the X² groups in the cycle is N;
R is the same or different at each instance and is H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, COO(cation), SO₃(cation), OSO₃(cation), OPO₃(cation)₂, O(cation), N(R¹)₃(anion), P(R¹)₃(anion), a straight-chain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R¹ radicals, where one or more nonadjacent CH₂ groups may be replaced by Si(R¹)₂, C=O, NR¹, O, S or CONR¹, or an aromatic or heteroaromatic ring system which has 5 to 40 aromatic ring atoms and may be substituted in each case by one or more R¹ radicals; at the same time, two R radicals together may also form a ring system;
R' is the same or different at each instance and is H, D, a straight-chain alkyl group having 1 to 20 carbon atoms or a branched or cyclic alkyl group having 3 to 20 carbon atoms, where the alkyl group in each case may be substituted by one or more R¹ radicals and where one or more nonadjacent CH₂ groups may be replaced by Si(R¹)₂, or an aromatic or heteroaromatic ring system which has 5 to 40 aromatic ring atoms and may be substituted in each case by one or more R¹ radicals;
R¹ is the same or different at each instance and is H, D, F, Cl, Br, I, N(R²)₂, CN, NO₂, OR², SR², Si(R²)₃, B(OR²)₂, C(=O)R², P(=O)(R²)₂, S(=O)R², S(=O)₂R², OSO₂R², COO(cation), SO₃(cation), OSO₃(cation), OPO₃(cation)₂, O(cation), N(R²)₃(anion), P(R²)₃(anion), a straight-chain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R² radicals, where one or more nonadjacent CH₂ groups may be replaced by Si(R²)₂, C=O, NR², O, S or CONR², or an aromatic or heteroaromatic ring system which has 5 to 40 aromatic ring atoms and may be substituted in each case by one or more R² radicals; at the same time, two or more R¹ radicals together may form a ring system;
R² is the same or different at each instance and is H, D, F or an aliphatic, aromatic or heteroaromatic organic radical, especially a hydrocarbyl radical, having 1 to 20 carbon atoms, in which one or more hydrogen atoms may also be replaced by F;
cation is the same or different at each instance and is selected from the group consisting of proton, deuteron, alkali metal ions, alkaline earth metal ions, ammonium, tetraalkylammonium and tetraalkylphosphonium;
anion is the same or different at each instance and is selected from the group consisting of halides, carboxylates R²-COO⁻, cyanide, cyanate, isocyanate, thiocyanate, thioisocyanate, hydroxide, BF₄⁻, PF₆⁻, B(C₆F₅)₄⁻, carbonate and sulfonates.

2. Compound according to Claim 1, **characterized in that** M¹ and M² are Ir(III) and the compound is uncharged.

3. Compound according to Claim 1 or 2, **characterized in that** the group of the formula (4) is selected from the structures of the formulae (5) to (29): 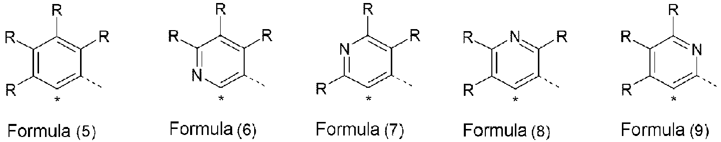 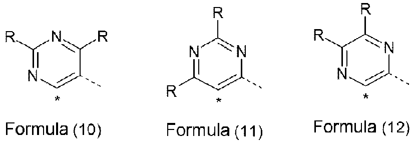 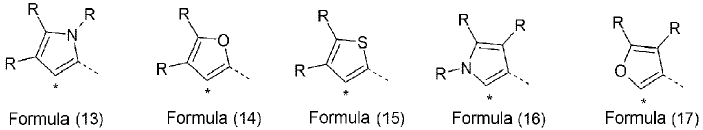 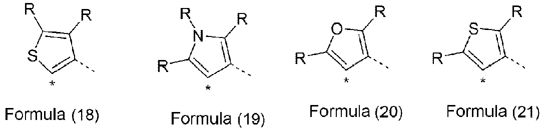 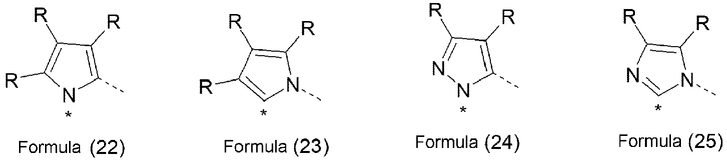 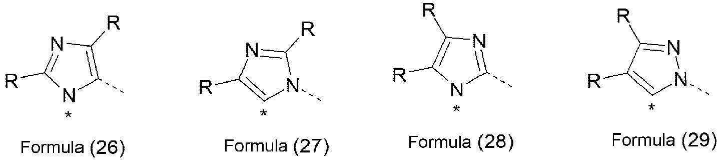 where the symbols have the definitions given in Claim 1.

4. Compound according to one or more of Claims 1 to 3, **characterized in that** the group of the formula (2) is selected from the groups of the formulae (2a) to (2e) and **in that** the group of the formula (3) is selected from the groups of the formulae (3a) to (3e) 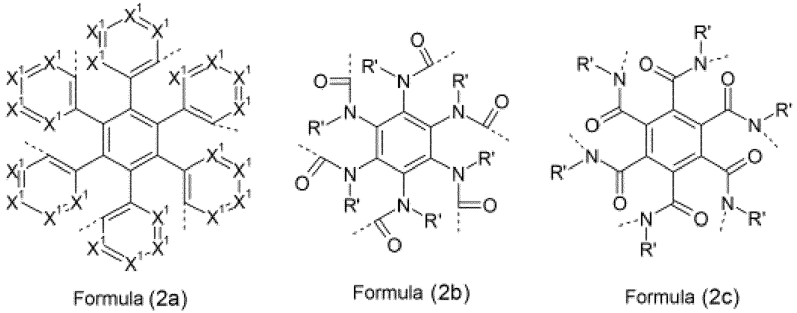 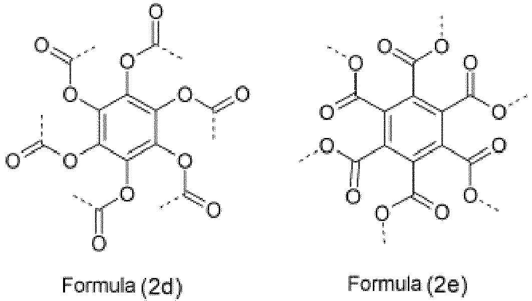 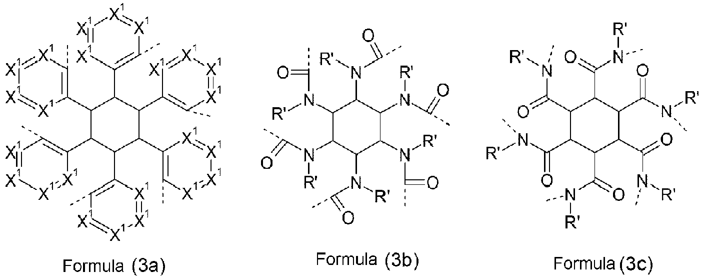 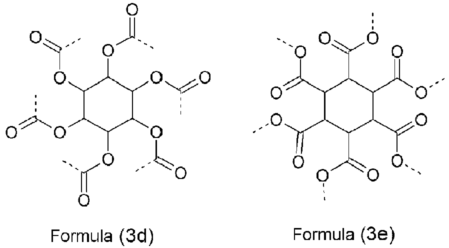 where the symbols have the definitions given in Claim 1.

5. Compound according to one or more of Claims 1 to 4, **characterized in that** the group of the formula (2) is selected from the groups of the formula (2a') and the group of the formula (3) is selected from the groups of the formula (3a') 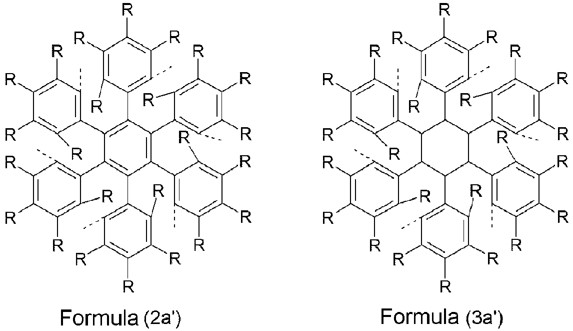 where the symbols have the definitions given in Claim 1.

6. Compound according to one or more of Claims 1 to 5, **characterized in that** the group of the formula (2) is selected from the groups of the formula (2a'') and the group of the formula (3) is selected from the groups of the formula (3a'')

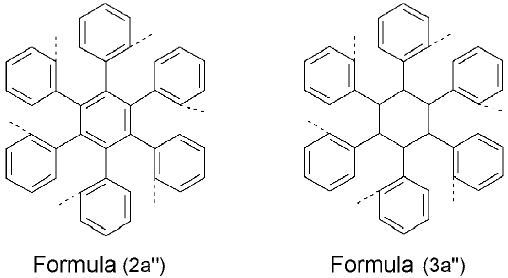

7. Compound according to one or more of Claims 1 to 6, **characterized in that** all three sub-ligands L¹ are the same and all three sub-ligands L² are the same, where L¹ = L² or L¹ ≠ L²_{.}

8. Compound according to one or more of Claims 1 to 7, **characterized in that** all sub-ligands L¹ and L² have one carbon atom and one nitrogen atom or two carbon atoms as coordinating atoms.

9. Compound according to one or more of Claims 1 to 8, **characterized in that** at least two of the sub-ligands L¹ and at least two of the sub-ligands L² are the same or different at each instance and are selected from the structures of the formulae (L-1), (L-2) and (L-3) 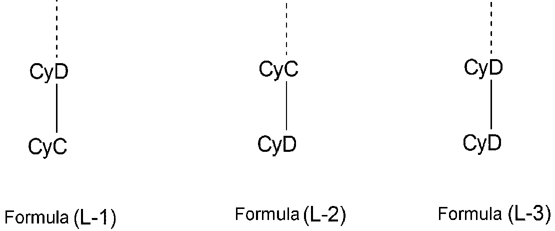 where the dotted bond represents the bond of the sub-ligand L¹ or L² to V and the other symbols used are as follows:
CyC is the same or different at each instance and is a substituted or unsubstituted aryl or heteroaryl group which has 5 to 14 aromatic ring atoms and coordinates to M via a carbon atom and is bonded to CyD via a covalent bond;
CyD is the same or different at each instance and is a substituted or unsubstituted heteroaryl group which has 5 to 14 aromatic ring atoms and coordinates to M via a nitrogen atom or via a carbene carbon atom and is bonded to CyC via a covalent bond;
at the same time, two or more of the substituents together may form a ring system.

10. Compound according to one or more of Claims 1 to 9, **characterized in that** the CyC group is selected from the structures of the formulae (CyC-1) to (CyC-20) and **in that** the CyD group is selected from the structures of the formulae (CyD-1) to (CyD-14) 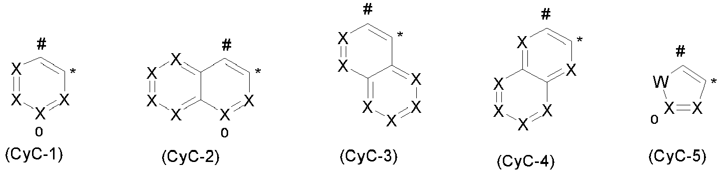 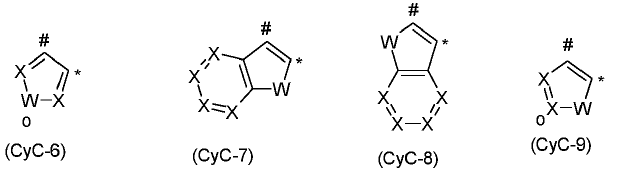 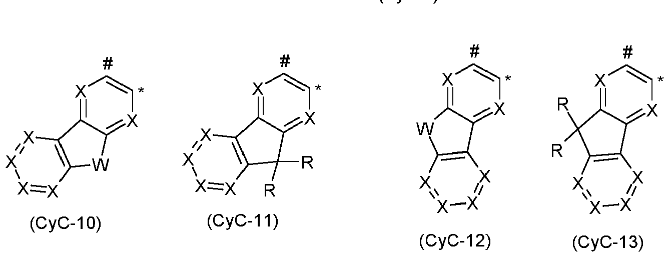 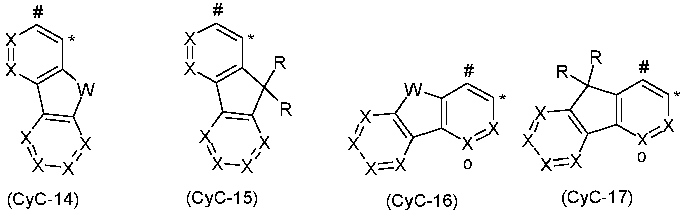 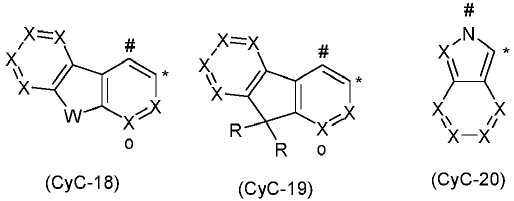 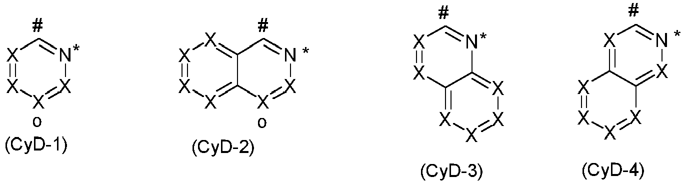 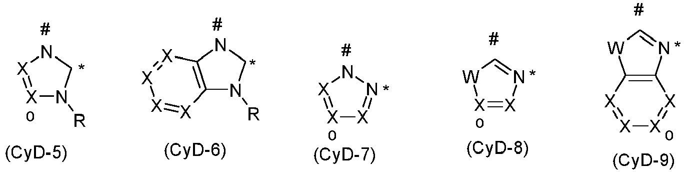 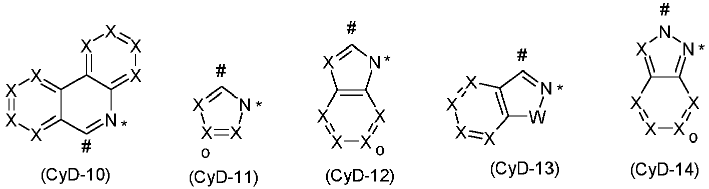 where the CyC and CyD groups each bind at the position identified by # and coordinate to the metal at the position indicated by *, and "o" represents the possible position of the bond to V if this group is bonded to V, and the other symbols have the following definitions:
X is the same or different at each instance and is CR or N, with the proviso that not more than two symbols X per cycle are N;
W is NR, O or S;
with the proviso that the symbol X in CyC or CyD via which the sub-ligand is bonded to V is C and V is bonded to this carbon atom.

11. Compound according to one or more of Claims 1 to 10, **characterized in that** the sub-ligands L¹ and L² are the same or different at each instance and are selected from the structures of the formulae (L-1-1), (L-1-2), (L-2-1) to (L-2-3) and (L-4) to (L-38) 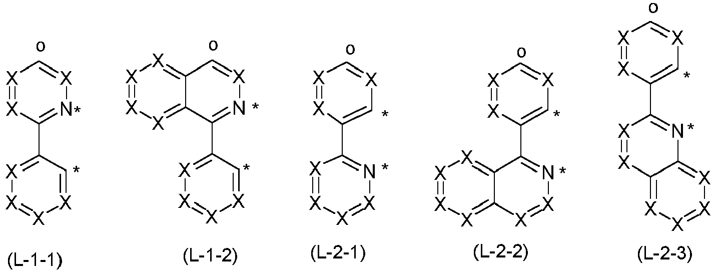 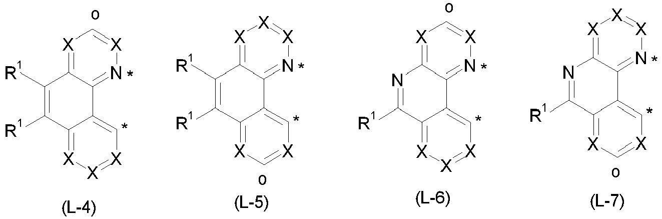 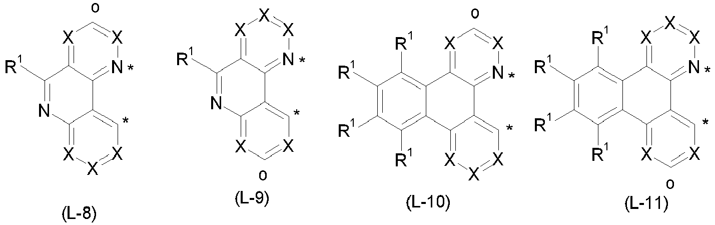 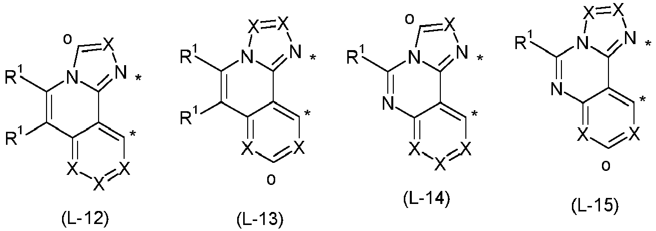 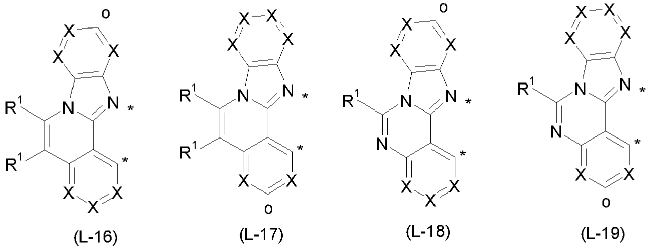 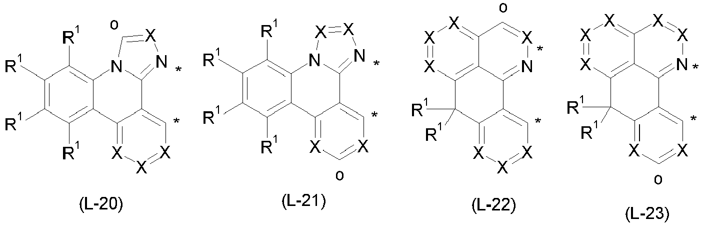 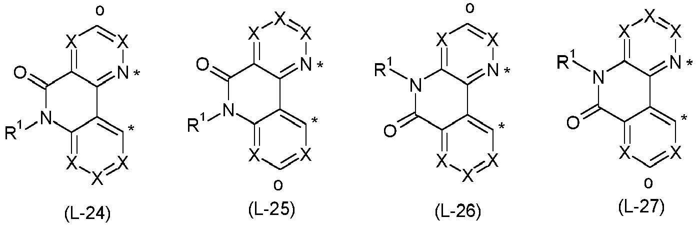 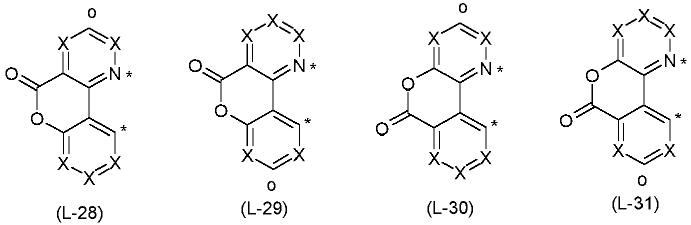 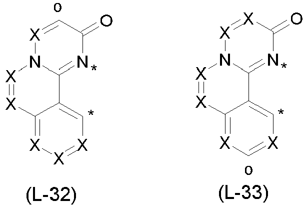 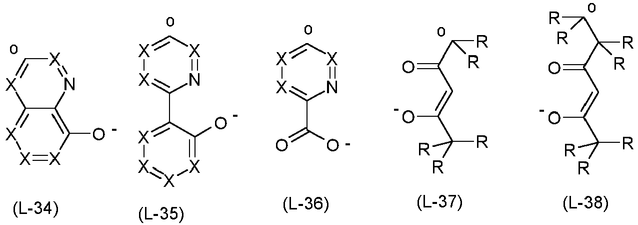 where the symbols used have the definitions given in Claims 1 and 10, * indicates the position of coordination to the iridium and "o" represents the position of the bond to V; at the same time, the sub-ligands (L-34) to (L-36) each coordinate via the nitrogen atom explicitly shown and the negatively charged oxygen atom and the sub-ligands (L-37) and (L-38) coordinate via the two oxygen atoms.

12. Process for preparing a compound according to one or more of Claims 1 to 11, by reaction of the ligand with metal alkoxides of the formula (48), with metal ketoketonates of the formula (49), with metal halides of the formula (50), with metal carboxylates of the formula (51) or with iridium compounds or rhodium compounds bearing both alkoxide and/or halide and/or hydroxyl radicals and ketoketonate radicals 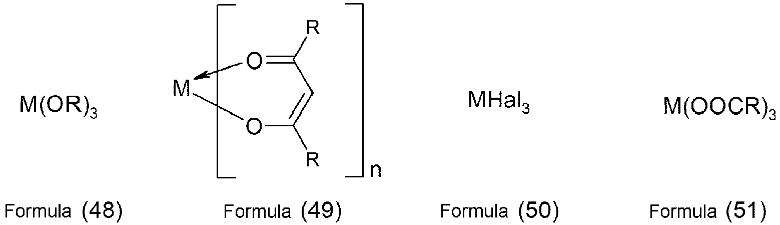 where M is iridium or rhodium, R has the definitions given in Claim 1, Hal = F, Cl, Br or I and the iridium reactants or rhodium reactants may also take the form of the corresponding hydrates.

13. Formulation comprising at least one compound according to one or more of Claims 1 to 11 and at least one further compound, wherein the further compound is selected from at least one solvent and/or at least one matrix material.

14. Use of a compound according to one or more of Claims 1 to 11 in an electronic device or as oxygen sensitizer or in photocatalysis.

15. Electronic device comprising at least one compound according to one or more of Claims 1 to 11, wherein the electronic device is preferably selected from the group consisting of organic electroluminescent devices, organic integrated circuits, organic field-effect transistors, organic thin-film transistors, organic light-emitting transistors, organic solar cells, organic optical detectors, organic photoreceptors, organic field-quench devices, light-emitting electrochemical cells, oxygen sensors and organic laser diodes.

16. Electronic device according to Claim 15 which is an organic electroluminescent device, **characterized in that** the compound according to one or more of Claims 1 to 11 is present as emitting compound in one or more emitting layers.

## Revendications

1. Composé correspondant à la formule (1), 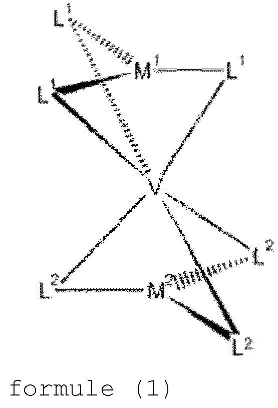 ce qui suit s'appliquant pour les symboles utilisés
M¹, M², identiques ou différents, étant iridium ou rhodium ;
V étant un groupe de formule (2) ou (3), 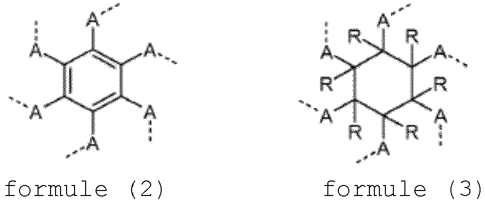
les liaisons en pointillés en position 1, 3 et 5 indiquant les liaisons à L¹ et les liaisons en pointillés en position 2, 4 et 6 indiquant les liaisons à L² ;
L¹, L², identiques ou différents en chaque occurrence, étant un ligand partiel monoanionique, bidentate ;
A, identique ou différent chaque occurrence, étant -CR=CR-, -C(=O)-NR'-, -C(=O)-O-, -CR₂-CR₂-, -CR₂-O- ou un groupe de formule (4), 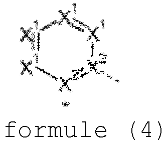
la liaison en pointillés indiquant la position de la liaison d'un ligand partiel bidentate L¹ ou L² à cette structure et * indiquant la position de la liaison de l'unité de formule (4) avec le groupe benzène ou cyclohexane dans la formule (2) ou (3) ;
X¹, identique ou différent en chaque occurrence, étant CR ou N ou deux groupes X¹ voisins représentant ensemble NR, O ou S, de sorte qu'un cycle à cinq chaînons est formé, et les X¹ restants, identiques ou différents en chaque occurrence, représentant CR ou N ; ou deux groupes X¹ voisins représentant ensemble CR ou N, lorsque dans le cycle un des groupes X² représente N, de sorte qu'un cycle à cinq chaînons est formé ; étant entendu qu'au maximum deux groupes X¹ voisins représentent N ;
X² étant en chaque occurrence C ou un groupe X² représentant N et l'autre groupe X² dans le même cycle représentant C ; étant entendu que deux groupes X¹ voisins représentent CR ou N, lorsque dans le cycle un des groupes X² représente N ;
R, identique ou différent en chaque occurrence, étant H, D, F, Cl, Br, I, N(R¹)₂, CN, NO₂, OR¹, SR¹, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, COO(cation), SO₃(cation), OSO₃(cation), OPO₃ (cation)₂, O (cation), N(R¹)₃(anion), P(R¹)₃(anion), un groupe alkyle linéaire comportant 1 à 20 atome (s) de C ou un groupe alcényle ou alcynyle comportant 2 à 20 atomes de C ou un groupe alkyle ramifié ou cyclique comportant 3 à 20 atomes de C, le groupe alkyle, alcényle ou alcynyle pouvant à chaque fois être substitué par un ou plusieurs radicaux R¹, un ou plusieurs groupes CH₂ non voisins pouvant être remplacés par Si(R¹)₂, C=O, NR¹, O, S ou CONR¹, ou un système cyclique aromatique ou hétéroaromatique comportant 5 à 40 atomes de cycle aromatiques, qui peut à chaque fois être substitué par un ou plusieurs radicaux R¹ ; à cet égard, deux radicaux R pouvant former également ensemble un système cyclique ;
R', identique ou différent en chaque occurrence, étant H, D, un groupe alkyle linéaire comportant 1 à 20 atome (s) de C ou un groupe alkyle ramifié ou cyclique comportant 3 à 20 atomes de C, le groupe alkyle pouvant à chaque fois être substitué par un ou plusieurs radicaux R¹ et un ou plusieurs groupes CH₂ non voisins pouvant être remplacés par Si(R¹)₂, ou un système cyclique aromatique ou hétéroaromatique comportant 5 à 40 atomes de cycle aromatiques, qui peut à chaque fois être substitué par un ou plusieurs radicaux R¹ ;
R¹, identique ou différent en chaque occurrence, étant H, D, F, Cl, Br, I, N(R²)₂, CN, NO₂, OR², SR², Si(R²)₃, B(OR²)₂, C(=O)R², P(=O)(R²)₂, S(=O)R², S(=O)₂R², OSO₂R², COO(cation), SO₃ (cation), OSO₃ (cation), OPO₃(cation)₂, O (cation), N(R²)₃(anion), P(R²)₃(anion), un groupe alkyle linéaire comportant 1 à 20 atome(s) de C ou un groupe alcényle ou alcynyle comportant 2 à 20 atomes de C ou un groupe alkyle ramifié ou cyclique comportant 3 à 20
R², atomes de C, le groupe alkyle, alcényle ou alcynyle pouvant à chaque fois être substitué par un ou plusieurs radicaux R², un ou plusieurs groupes CH₂ non voisins pouvant être remplacés par Si(R²)₂, C=O, NR², O, S ou CONR², ou un système cyclique aromatique ou hétéroaromatique comportant 5 à 40 atomes de cycle aromatiques, qui peut à chaque fois être substitué par un ou plusieurs radicaux R² ; à cet égard, deux radicaux R¹ ou plus pouvant former ensemble un système cyclique ; identique ou différent en chaque occurrence, étant H, D, F ou un radical organique aliphatique, aromatique ou hétéroaromatique, en particulier un radical hydrocarboné, comportant 1 à 20 à atome(s) de carbone, dans lequel également un ou plusieurs atomes de H peuvent être remplacés par F ;
cation, identique ou différent en chaque occurrence, étant choisi dans le groupe constitué par proton, deutéron, des ions alcalins, des ions alcalino-terreux, un ammonium, tétraalkylammonium et tétraalkylphosphonium ;
anion, identique ou différent en chaque occurrence, étant choisi dans le groupe constitué par les halogénures, les carboxylates R²-COO⁻, cyanure, cyanate, isocyanate, thiocyanate, thioisocyanate, hydroxyde, BF₄⁻, PF₆⁻, B(C₆F₅)₄⁻, carbonate et sulfonates.

2. Composé selon la revendication 1, **caractérisé en ce que** M¹ et M² représentent Ir(III) et le composé est non chargé.

3. Composé selon la revendication 1 ou 2, **caractérisé en ce que** le groupe de formule (4) est choisi parmi les structures de formules (5) à (29), 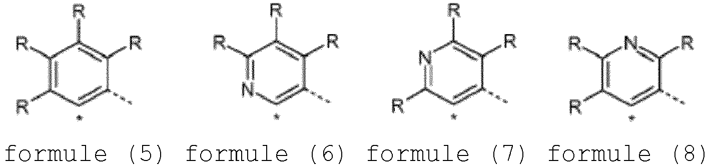 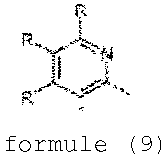 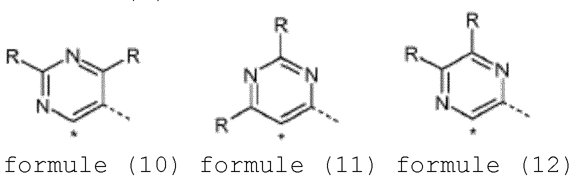 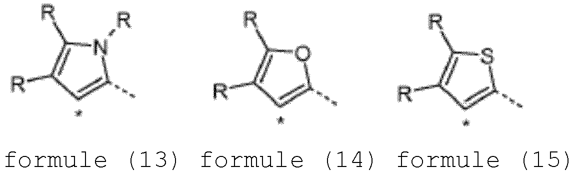 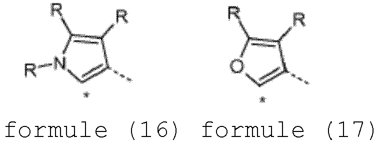 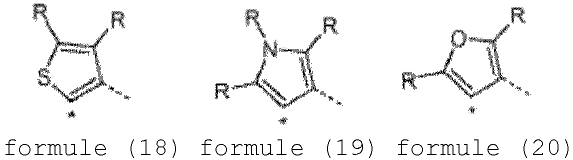 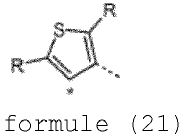 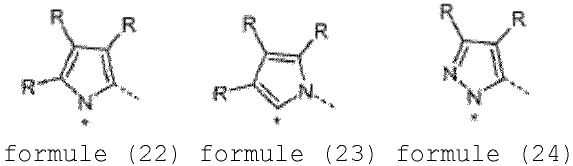 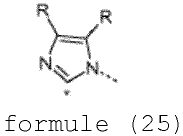 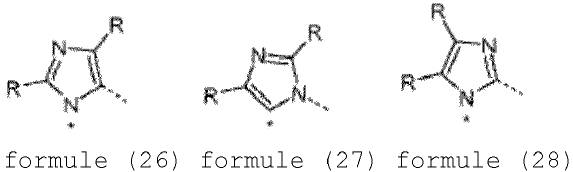 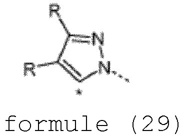 les symboles présentant les significations mentionnées dans la revendication 1.

4. Composé selon l'une ou plusieurs des revendications 1 à 3, **caractérisé en ce que** le groupe de formule (2) est choisi parmi les groupes de formules (2a) à (2e) et **en ce que** le groupe de formule (3) est choisi parmi les groupes de formules (3a) à (3e), 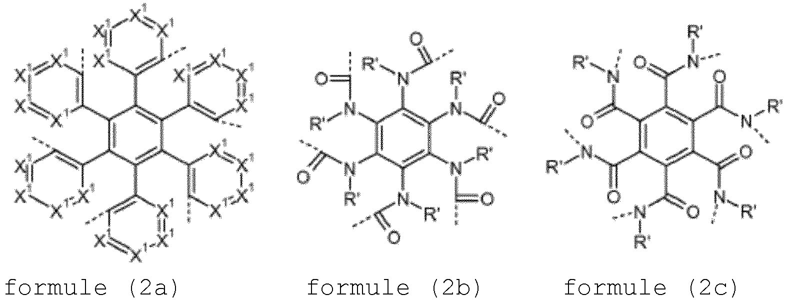 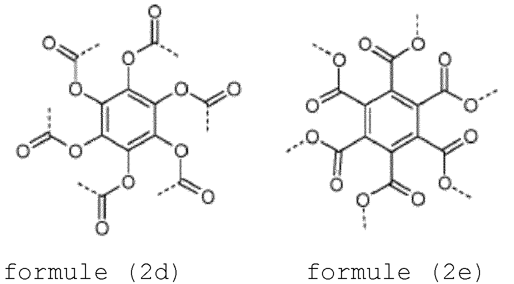 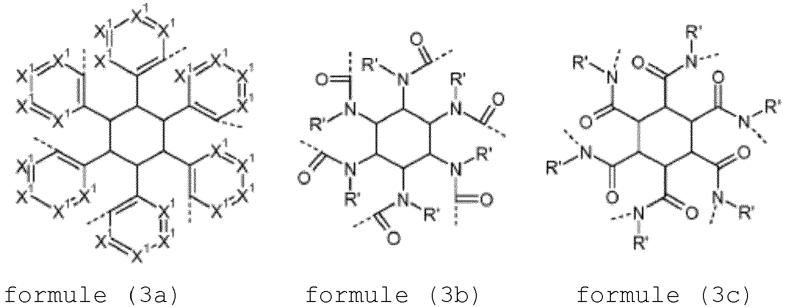 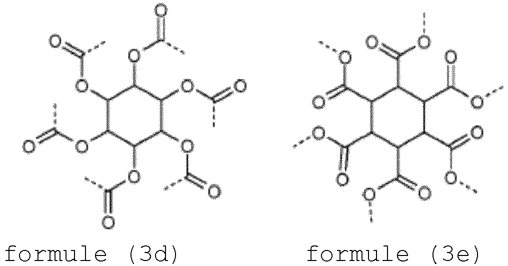 les symboles présentant les significations mentionnées dans la revendication 1.

5. Composé selon l'une ou plusieurs des revendications 1 à 4, **caractérisé en ce que** le groupe de formule (2) est choisi parmi les groupes de formules (2a') et le groupe de formule (3) est choisi parmi les groupes de formules (3a'), 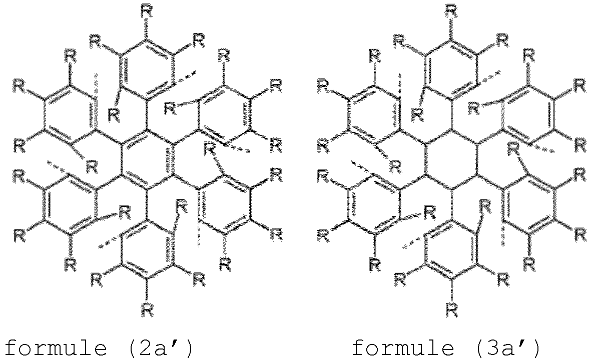 les symboles présentant les significations mentionnées dans la revendication 1.

6. Composé selon l'une ou plusieurs des revendications 1 à 5, **caractérisé en ce que** le groupe de formule (2) est choisi parmi les groupes de formules (2a'') et le groupe de formule (3) est choisi parmi les groupes de formules (3a"),

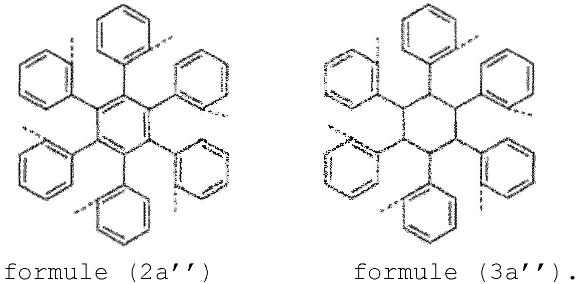

7. Composé selon l'une ou plusieurs des revendications 1 à 6, **caractérisé en ce que** tous les trois ligands partiels L¹ sont les mêmes et tous les trois ligands partiels L² sont les mêmes, et dans lequel on peut avoir L¹ = L² ou L¹ ≠ L².

8. Composé selon l'une ou plusieurs des revendications 1 à 7, **caractérisé en ce que** tous les ligands partiels L¹ et L² présentent un atome de carbone et un atome d'azote ou deux atomes de carbone en tant qu'atomes coordinants.

9. Composé selon l'une ou plusieurs des revendications 1 à 8, **caractérisé en ce qu'**au moins deux des ligands partiels L¹ et au moins deux des ligands partiels L², identiques ou différents en chaque occurrence, sont choisis parmi les structures des formules (L-1), (L-2) et (L-3), 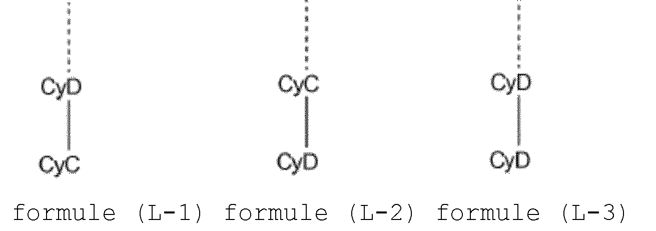 la liaison en pointillés indiquant la liaison du ligand partiel L¹ ou L² à V et ce qui suit s'appliquant aux autres symboles utilisés :
CyC, identique ou différent en chaque occurrence, est un groupe aryle ou hétéroaryle substitué ou non substitué comportant 5 à 14 atomes de cycle aromatiques, qui coordine à M par l'intermédiaire d'un atome de carbone et qui est lié à CyD par l'intermédiaire d'une liaison covalente ;
CyD, identique ou différent en chaque occurrence, est un groupe hétéroaryle substitué ou non substitué comportant 5 à 14 atomes de cycle aromatiques, qui coordine à M par l'intermédiaire d'un atome d'azote ou par l'intermédiaire d'un atome de carbone de carbène et qui est lié à CyC par l'intermédiaire d'une liaison covalente ;
à cet égard, plusieurs des substituants peuvent former ensemble un système cyclique.

10. Composé selon l'une ou plusieurs des revendications 1 à 9, **caractérisé en ce que** le groupe CyC est choisi parmi les structures des formules (CyC-1) à (CyC-20) et **en ce que** le groupe CyD est choisi parmi les structures des formules (CyD-1) à (CyD-14), 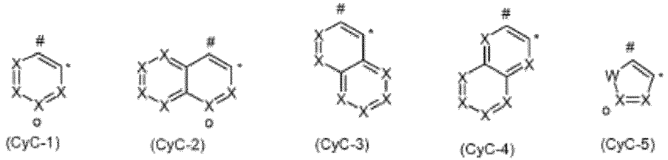 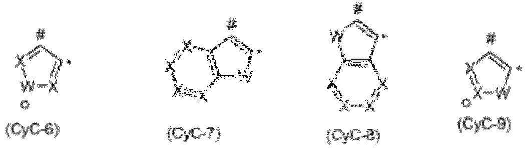 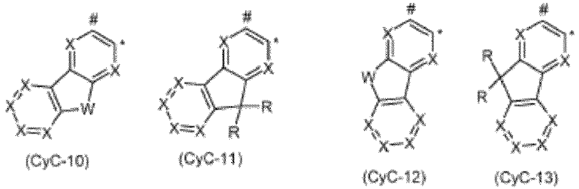 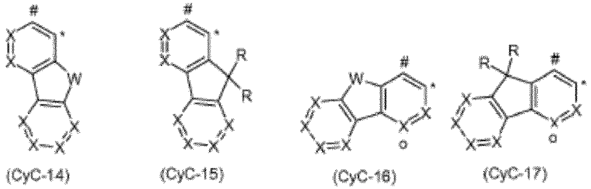 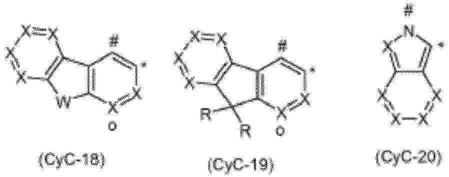 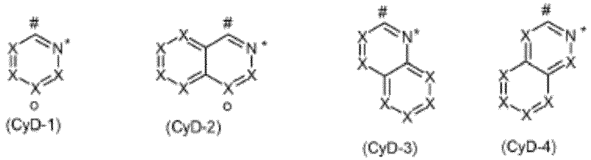 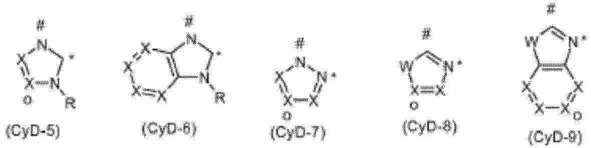 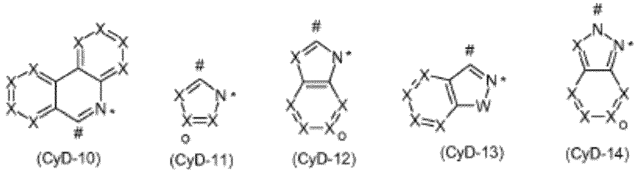 les groupes CyC et CyD étant liés l'un à l'autre à chaque fois au niveau de la position marquée par # et coordinant au métal au niveau de la position marquée par * et « o » indiquant la position possible de la liaison à V, dans le cas où ce groupe est lié à V, et les autres symboles présentant les significations suivantes :
X, identique ou différent en chaque occurrence, étant CR ou N, étant entendu qu'au maximum deux symboles X par cycle représentent N ;
W étant NR, O ou S ;
étant entendu que le symbole X dans CyC et CyD, par l'intermédiaire duquel le ligand partiel est lié à V, représente C et V est lié à cet atome de carbone.

11. Composé selon l'une ou plusieurs des revendications 1 à 10, **caractérisé en ce que** les ligands partiels L¹ et L², identiques ou différents en chaque occurrence, sont choisis parmi les structures de formules (L-1-1), (L-1-2), (L-2-1) à (L-2-3) et (L-4) à (L-38), 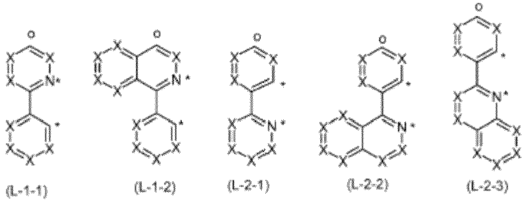 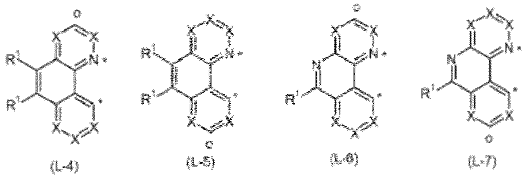 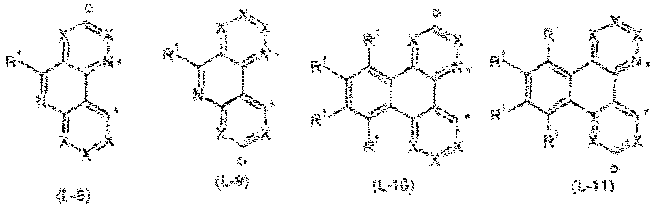 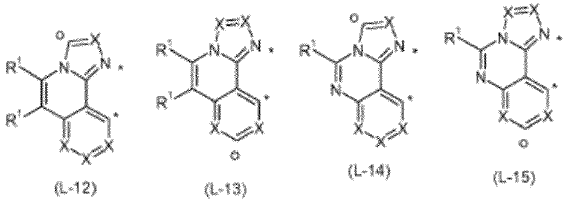 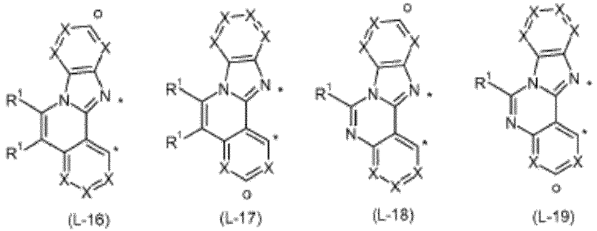 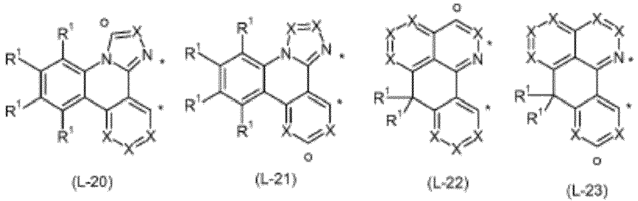 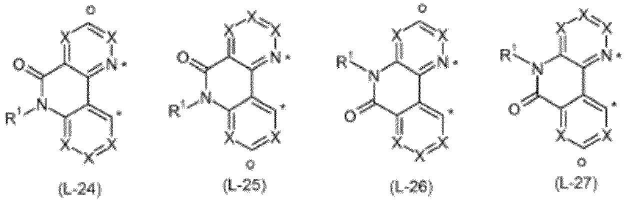 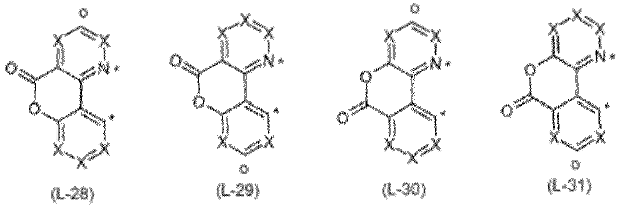 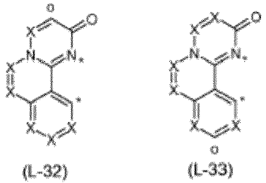 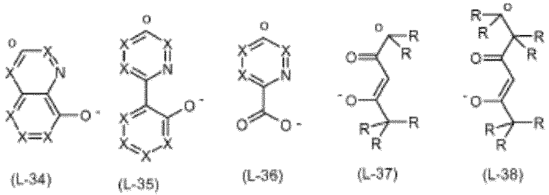 les symboles utilisés présentant les significations mentionnées dans les revendications 1 et 10, * suggérant la position de la coordination à l'iridium et « o » indiquant la position de la liaison à V ; à cet égard, les ligands partiels (L-34) à (L-36) coordinant à chaque fois par l'intermédiaire de l'atome d'azote explicitement écrit et de l'atome d'oxygène chargé négativement et les ligands partiels (L-37) et (L-38) coordinant par l'intermédiaire des deux atomes d'oxygène.

12. Procédé pour la préparation d'un composé selon l'une ou plusieurs des revendications 1 à 11 par la transformation du ligand avec des alcoolates de formule (48), avec des cétocétonates métalliques de formule (49), avec des halogénures métalliques de formule (50), avec des carboxylates métalliques de formule (51) ou avec des composés de l'iridium ou du rhodium, qui portent aussi bien des radicaux alcoolate et/ou halogénure et/ou hydroxy que des radicaux cétocétonate, 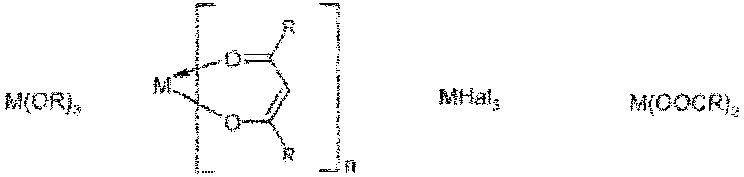 formule (48) formule (49) formule (50) formule (51) M représentant iridium ou rhodium, R présentant les significations indiquées dans la revendication 1, Hal = F, Cl, Br ou I et les éduits d'iridium ou de rhodium pouvant également être présents en tant qu'hydrates correspondants.

13. Formulation contenant au moins un composé selon l'une ou plusieurs des revendications 1 à 11 et au moins un composé supplémentaire, le composé supplémentaire étant choisi parmi au moins un solvant et/ou au moins un matériau de matrice.

14. Utilisation d'un composé selon l'une ou plusieurs des revendications 1 à 11 dans un dispositif électronique ou en tant que sensibilisateur d'oxygène ou dans la photocatalyse.

15. Dispositif électronique contenant au moins un composé selon l'une ou plusieurs des revendications 1 à 11, le dispositif électronique étant préférablement choisi dans le groupe constitué par des dispositifs organiques d'électroluminescence, des circuits intégrés organiques, des transistors organiques à effet de champ, des transistors organiques à film mince, les transistors organiques luminescents, des cellules solaires organiques, les détecteurs optiques organiques, des photorécepteurs organiques, des dispositifs organiques d'extinction de champ, des cellules électrochimiques luminescentes, des capteurs d'oxygène ou des diodes laser organiques.

16. Dispositif électronique selon la revendication 15, qui est un dispositif organique d'électroluminescence, **caractérisé en ce que** le composé selon l'une ou plusieurs des revendications 1 à 11 est présent en tant que composé émetteur dans une ou plusieurs couches émettrices.
